(19) Europäisches Patentamt
European Patent Office
Office européen des brevets

(11) EP 4 186 959 A1

(12) EUROPEAN PATENT APPLICATION

(43) Date of publication:
**31.05.2023 Bulletin 2023/22**

(21) Application number: **22209463.3**

(22) Date of filing: **24.11.2022**

(51) International Patent Classification (IPC):
***C09K 11/00*** $^{(2006.01)}$ ***H10K 85/00*** $^{(2023.01)}$
***C07F 15/00*** $^{(2006.01)}$

(52) Cooperative Patent Classification (CPC):
**C07F 15/0086; C09K 11/06; H10K 85/346;**
C09K 2211/185; H10K 50/11; H10K 2101/10

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2021 KR 20210169402**

(71) Applicant: **Samsung Display Co., Ltd.**
**Yongin-si, Gyeonggi-do 17113 (KR)**

(72) Inventors:
- **KO, Soobyung**
  **17113 Yongin-si (KR)**
- **SHIN, Sujin**
  **17113 Yongin-si (KR)**
- **LEE, Hyunjung**
  **17113 Yongin-si (KR)**
- **KIM, Sungbum**
  **17113 Yongin-si (KR)**
- **AHN, Eunsoo**
  **17113 Yongin-si (KR)**
- **JEON, Mina**
  **17113 Yongin-si (KR)**
- **JU, Jinhee**
  **17113 Yongin-si (KR)**

(74) Representative: **Russell, Tim et al**
**Venner Shipley LLP**
**200 Aldersgate**
**London EC1A 4HD (GB)**

# (54) COMPOSITION, LIGHT-EMITTING DEVICE, ELECTRONIC APPARATUS, CONSUMER PRODUCT, AND ORGANOMETALLIC COMPOUND

(57) Provided are a composition and a light-emitting device including an organometallic compound represented by Formula 1, an electronic apparatus and a consumer product including the light-emitting device. The detailed description of Formula 1 is the same as described in the present specification. Also provided is the organometallic compound represented by Formula 1 below:

EP 4 186 959 A1

Formula 1

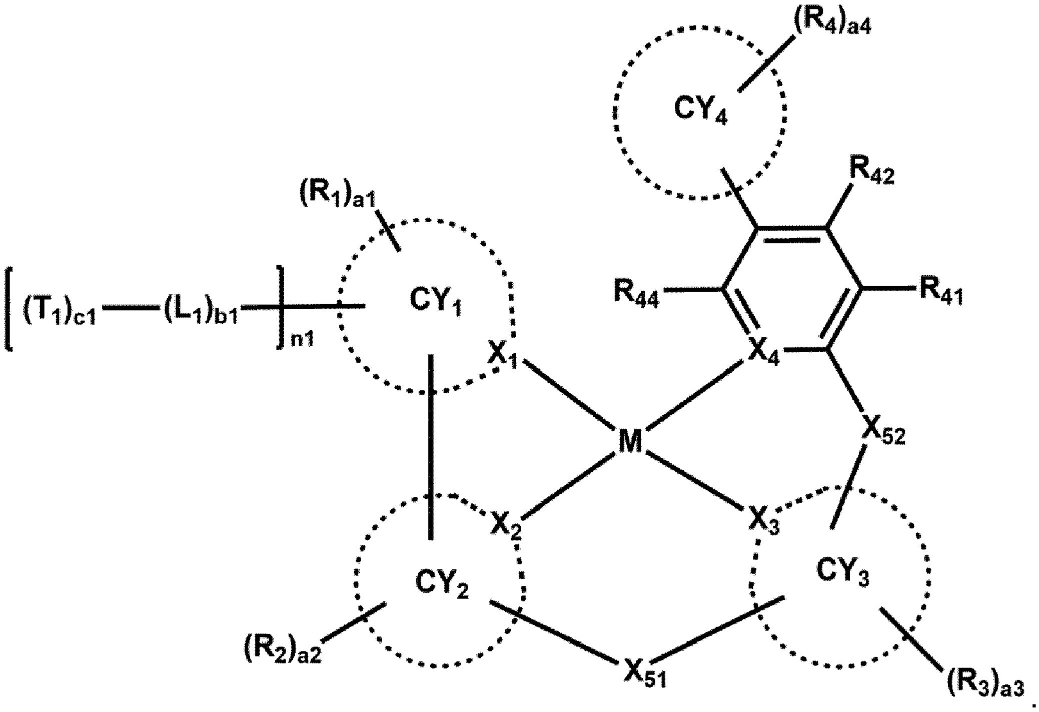

## Description

### CROSS-REFERENCE TO RELATED APPLICATION

This application claims priority to and the benefit of Korean Patent Application No. 10-2021-0169402, filed on November 30, 2021, in the Korean Intellectual Property Office, the entire content of which is hereby incorporated by reference.

### BACKGROUND

One or more embodiments of the present disclosure relate to a composition, a light-emitting device, an electronic apparatus including the light-emitting device, a consumer product, and an organometallic compound.

Self-emissive devices (for example, organic light-emitting devices) in light-emitting devices have wide viewing angles, short response times, and excellent characteristics in terms of luminance, driving voltage, and response speed.

In a light-emitting device, a first electrode is on a substrate, and a hole transport region, an emission layer, an electron transport region, and a second electrode are sequentially on the first electrode. Holes provided from the first electrode may move toward the emission layer through the hole transport region, and electrons provided from the second electrode may move toward the emission layer through the electron transport region. Carriers, such as holes and electrons, may recombine in such an emission layer to produce excitons. These excitons transition from an excited state to a ground state to thereby generate light.

### SUMMARY

The invention is defined by the claims.

Provided are a composition capable of providing high luminescence efficiency and a long lifespan, an organometallic compound, a light-emitting device having high luminescence efficiency and a long lifespan, an electronic apparatus including the light-emitting device, and a consumer product.

Additional aspects of embodiments will be set forth in part in the description which follows and, in part, will be apparent from the description, or may be learned by practice of the presented embodiments of the disclosure.

According to one or more embodiments,

provided is a composition including an organometallic compound represented by Formula 1, and
a second compound including at least one $\pi$ electron-deficient nitrogen-containing $C_1$-$C_{60}$ cyclic group, a third compound including a group represented by Formula 3, a fourth compound capable of emitting delayed fluorescence, or any combination thereof,
wherein the organometallic compound, the second compound, the third compound, and the fourth compound are different from each other,
wherein Formula 1 is:

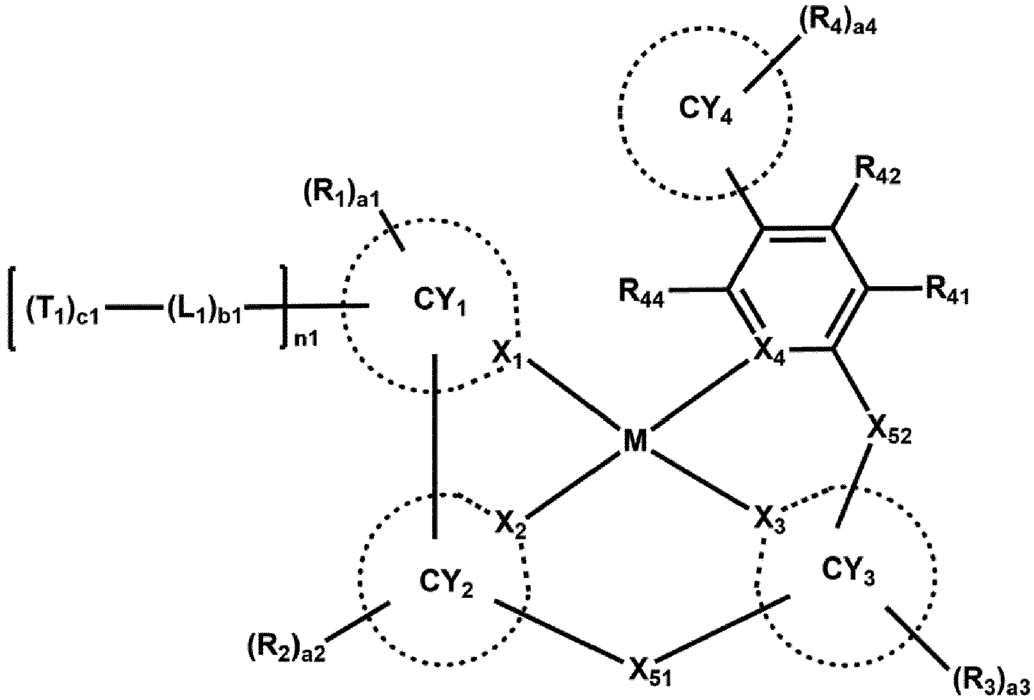

In Formula 1,

M may be platinum (Pt), palladium (Pd), gold (Au), nickel (Ni), silver (Ag), or copper(Cu),
$X_1$ to $X_4$ may each independently be C or N,
i) a bond between $X_1$ and M may be a coordinate bond, and ii) one selected from a bond between $X_2$ and M, a bond between $X_3$ and M, and a bond between $X_4$ and M may be a coordinate bond, and the other two may each be a covalent bond,
rings $CY_1$, $CY_2$, $CY_3$, and $CY_4$ may each independently be a $C_3$-$C_{60}$ carbocyclic group or a $C_1$-$C_{60}$ heterocyclic group,
$X_{51}$ may be a single bond, *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', *-O-*', *-C(=O)-*', *-S(=O)-*', *-S(=O)$_2$-*', *-C($R_{51a}$)=*', *=C($R_{51a}$)-*', *-C($R_{51a}$)=C($R_{51b}$)-*', *-C(=S)-*', or *-C≡C-*',
$X_{52}$ may be a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', *-O-*', *-C(=O)-*', *-S(=O)-*', *-S(=O)$_2$-*', *-C($R_{52a}$)=*', *=C($R_{52a}$)-*', *-C($R_{52a}$)=C($R_{52b}$)-*', *-C(=S)-*', or *-C≡C-*',
$L_1$ may be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
b1 may be an integer selected from 1 to 5,
$R_1$ to $R_4$, $R_{51a}$, $R_{51b}$, $R_{52a}$, $R_{52b}$, and $T_1$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),
$R_{42}$ is -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or

$-P(=O)(Q_1)(Q_2)$,
$R_{41}$ and $R_{44}$ may each independently be hydrogen or deuterium,
a1, a2, a3, a4, c1, and n1 may each independently be an integer selected from 0 to 20,
when a1 is an integer from 2 to 20, two or more of $R_1$(s) in the number of a1 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a2 is an integer from 2 to 20, two or more of $R_2$(s) in the number of a2 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a3 is an integer from 2 to 20, two or more of $R_3$(s) in the number of a3 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a4 is an integer from 2 to 20, two or more of $R_4$(s) in the number of a4 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
two or more of $R_1$ to $R_4$, $R_{51a}$, $R_{51b}$, $R_{52a}$, and $R_{52b}$ may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$R_{10a}$ may be:

deuterium (-D), -F, -Cl, -Br, -I, a hydroxyl group, a cyano group, or a nitro group,
a $C_1$-$C_{60}$ alkyl group, a $C_2$-$C_{60}$ alkenyl group, a $C_2$-$C_{60}$ alkynyl group, or a C1-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof,
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a C2-C60 alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof, or
$-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, or $-P(=O)(Q_{31})(Q_{32})$, and
$Q_1$ to $Q_3$, $Q_{11}$ to $Q_{13}$, $Q_{21}$ to $Q_{23}$, and $Q_{31}$ to $Q_{33}$ may each independently be hydrogen, deuterium, -F, -Cl, -Br, -I, a hydroxyl group, a cyano group, a nitro group, or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof,
wherein Formula 3 is

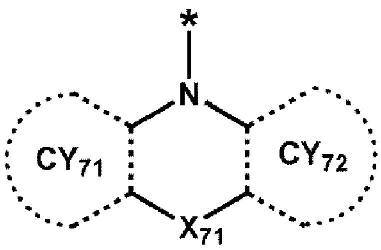

In Formula 3,

ring $CY_{71}$ and ring $CY_{72}$ may each independently be a π electron-rich $C_3$-$C_{60}$ cyclic group or a pyridine group,
$X_{71}$ may be a single bond or a linking group including O, S, N, B, C, Si, or any combination thereof, and
* indicates a binding site to a neighboring atom in Formula 3.

Optionally, $X_{71}$ may be a single bond.

Optionally, $X_{71}$ may be a linking group including O, S, N, B, C, or Si or a combination thereof.
Optionally, $X_{71}$ may be a single bond or a linking group including O, S, N, B, C, or Si.
According to one or more embodiments,

provided is a light-emitting device including a first electrode,
a second electrode facing the first electrode,
an interlayer between the first electrode and the second electrode and including an emission layer, and
the organometallic compound represented by Formula 1 as described herein.

According to one or more embodiments, provided is an electronic apparatus including the light-emitting device.
According to one or more embodiments, provided is a consumer product including the light-emitting device.
According to one or more embodiments, provided is the organometallic compound represented by Formula 1 as described herein.
According to one or more embodiments, provided is an organometallic compound including platinum (Pt), and

a tetradentate ligand,
wherein the tetradentate ligand includes:

a pyridine group, and
a carbazole group or an azacarbazole group,
N in the pyridine group is bonded to the platinum,
N in the carbazole group or the azacarbazole group is bonded to a carbon in the 2-position of the pyridine group,
a carbon in the 3-position and a carbon in the 6-position of the pyridine group are each bonded to hydrogen or deuterium,
a substituent bonded to a carbon in the 4-position of the pyridine group is neither hydrogen nor deuterium,
a substituent bonded to a carbon in the 5-position of the pyridine group is a phenyl group, a naphthyl group, a dibenzofuranyl group, or a dibenzothiophenyl group (or, a dibenzothienyl group), each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof, and
an absolute value ($\Delta$CS) of a difference between a chemical shift value of hydrogen or deuterium bonded to the carbon in the 6-position of the pyridine group and a chemical shift value of hydrogen or deuterium bonded to the carbon in the 3-position of the pyridine group of the organometallic compound, as measured by proton nuclear magnetic resonance (NMR) spectroscopy, is in a range of 480 Hz to 600 Hz.

## BRIEF DESCRIPTION OF THE DRAWINGS

The above and other aspects and features of certain embodiments of the disclosure will be more apparent from the following description taken in conjunction with the accompanying drawings, in which:

FIG. 1 is a schematic view of a structure of a light-emitting device according to an embodiment;
FIG. 2 is a cross-sectional schematic view of a structure of an electronic apparatus according to an embodiment;
FIG. 3 is a cross-sectional schematic view of a structure of an electronic apparatus according to another embodiment;
FIG. 4 is a phase transition diagram of each of i) Compound ETH18, ii) Compound BD02, and iii) a mixture obtained by mixing Compound ETH18 and Compound BD02 together at a weight ratio of 2.7:1;
FIG. 5 shows an electroluminescence (EL) spectrum of each of organic light-emitting devices manufactured in Examples 1 to 4;
FIG. 6 shows an electroluminescence spectrum of each of organic light-emitting devices manufactured in Examples 5 to 8;
FIG. 7 shows an electroluminescence spectrum of each of organic light-emitting devices manufactured in Examples 9 to 11;
FIG. 8 shows an electroluminescence spectrum of each of organic light-emitting devices manufactured in Examples 12 and 13;
FIG. 9 shows an electroluminescence spectrum of each of organic light-emitting devices manufactured in Comparative Examples A to C;
FIG. 10 shows a graph of luminance versus luminescence efficiency of each of organic light-emitting devices manufactured in Examples 1 to 4;
FIG. 11 shows a graph of luminance versus luminescence efficiency of each of organic light-emitting devices manufactured in Examples 5 to 8;

FIG. 12 shows a graph of luminance versus luminescence efficiency of each of organic light-emitting devices manufactured in Examples 9 to 11;

FIG. 13 shows a graph of luminance versus luminescence efficiency of each of organic light-emitting devices manufactured in Examples 12 and 13;

FIG. 14 shows a graph of luminance versus luminescence efficiency of each of organic light-emitting devices manufactured in Comparative Examples A to C;

FIG. 15 shows a graph of time versus luminance of each of organic light-emitting devices manufactured in Examples 1 to 4;

FIG. 16 shows a graph of time versus luminance of each of organic light-emitting devices manufactured in Examples 5 to 8;

FIG. 17 shows a graph of time versus luminance of each of organic light-emitting devices manufactured in Examples 9 to 11;

FIG. 18 shows a graph of time versus luminance of each of organic light-emitting devices manufactured in Examples 12 and 13; and

FIG. 19 shows a graph of time versus luminance of each of organic light-emitting devices manufactured in Comparative Examples A to C.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

According to one or more embodiments,

provided is a composition including: an organometallic compound represented by Formula 1 as described herein or an organometallic compound including platinum (Pt) and a tetradentate ligand as described herein; and

a second compound including at least one $\pi$ electron-deficient nitrogen-containing $C_1$-$C_{60}$ cyclic group, a third compound including a group represented by Formula 3 below, a fourth compound capable of emitting delayed fluorescence, or any combination thereof, and

the organometallic compound, the second compound, the third compound, and the fourth compound are different from each other:

Formula 3

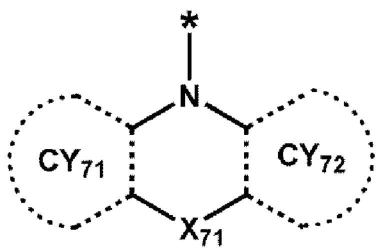

wherein, in Formula 3,

ring $CY_{71}$ and ring $CY_{72}$ may each independently be a $\pi$ electron-rich $C_3$-$C_{60}$ cyclic group or a pyridine group,

$X_{71}$ may be a single bond or a linking group including O, S, N, B, C, Si, or any combination thereof, and

* indicates a binding site to a neighboring atom in Formula 3.

In an embodiment, the composition may be included in a layer including 1) the organometallic compound and 2) the second compound, the third compound, the fourth compound, or any combination thereof. The layer including the composition may include a mixture including 1) the organometallic compound and 2) the second compound, the third compound, the fourth compound, or any combination thereof. Therefore, the layer including the composition is clearly differentiated from, for example, a double layer including 1) a first layer including the organometallic compound and 2)

a second layer including the second compound, the third compound, the fourth compound, or any combination thereof.

In an embodiment, the composition may be a composition prepared to form a layer including 1) the organometallic compound and 2) the second compound, the third compound, the fourth compound, or any combination thereof by using various suitable methods such as a deposition method and/or a wet process. In an embodiment, the composition may be a pre-mixed mixture prepared for use in a deposition method (for example, a vacuum deposition method). The pre-mixed mixture may be charged, for example, into a deposition source within a vacuum chamber, and two or more compounds included in the pre-mixed mixture may be co-deposited.

In an embodiment, the composition may include:

the organometallic compound; and
the second compound.

In an embodiment, an absolute value of a difference between a phase transition temperature of the organometallic compound represented by Formula 1 under a pressure of about $5.0 \times 10^{-5}$ torr to about $1.0 \times 10^{-3}$ torr and a phase transition temperature of the second compound under a pressure of about $5.0 \times 10^{-5}$ torr to about $1.0 \times 10^{-3}$ torr may be in a range of about 10 °C or less, about 0 °C to about 10 °C, about 1 °C to about 10 °C, about 2 °C to about 10 °C, about 3 °C to about 10 °C, about 4 °C to about 10 °C, about 0 °C to about 8 °C, about 1 °C to about 8 °C, about 2 °C to about 8 °C, about 3 °C to about 8 °C, about 4 °C to about 8 °C, about 0 °C to about 5 °C, about 1 °C to about 5 °C, about 2 °C to about 5 °C, about 3 °C to about 5 °C, about 4 °C to about 5 °C, about 0 °C to about 4.5 °C, about 1 °C to about 4.5 °C, about 2 °C to about 4.5 °C, about 3 °C to about 4.5 °C, or about 4 °C to about 4.5 °C (for example, see Evaluation Example 5 and Table 7 below).

In an embodiment, an absolute value of a difference between a phase transition temperature of the organometallic compound represented by Formula 1 and a phase transition temperature of the second compound may be in a range of about 10 °C or less, about 0 °C to about 10 °C, about 1 °C to about 10 °C, about 2 °C to about 10 °C, about 3 °C to about 10 °C, about 4 °C to about 10 °C, about 0 °C to about 8 °C, about 1 °C to about 8 °C, about 2 °C to about 8 °C, about 3 °C to about 8 °C, about 4 °C to about 8 °C, about 0 °C to about 5 °C, about 1 °C to about 5 °C, about 2 °C to about 5 °C, about 3 °C to about 5 °C, about 4 °C to about 5 °C, about 0 °C to about 4.5 °C, about 1 °C to about 4.5 °C, about 2 °C to about 4.5 °C, about 3 °C to about 4.5 °C, or about 4 °C to about 4.5 °C, the phase transition temperature is evaluated under the same pressure, and the pressure may be in a range of about $5.0 \times 10^{-5}$ torr to about $1.0 \times 10^{-3}$ torr.

The organometallic compound and the second compound satisfy a phase transition temperature relationship as described above, and thus, phase transitions of the organometallic compound and the second compound in the composition (for example, a pre-mixed mixture) including the organometallic compound and the second compound may be made at substantially the same temperature within the range of the pressure. Therefore, when a deposition process is performed after the composition including the organometallic compound and the second compound is charged to a deposition source, the organometallic compound and the second compound in the composition may be vaporized at substantially the same temperature, and thus, the organometallic compound and the second compound may be effectively co-deposited, and various suitable electrical characteristics and durability of a layer prepared as a result of the co-deposition may be improved.

In an embodiment, a weight ratio of the organometallic compound to the second compound in the composition may be in a range of 2 : 1 to 4 : 1, or 2.5 : 1 to 3.5 :1.

According to one or more embodiments,

provided is a light-emitting device including: a first electrode;
a second electrode facing the first electrode;
an interlayer between the first electrode and the second electrode and including an emission layer; and
an organometallic compound represented by Formula 1 below or an organometallic compound including platinum (Pt) and a tetradentate ligand:

Formula 1

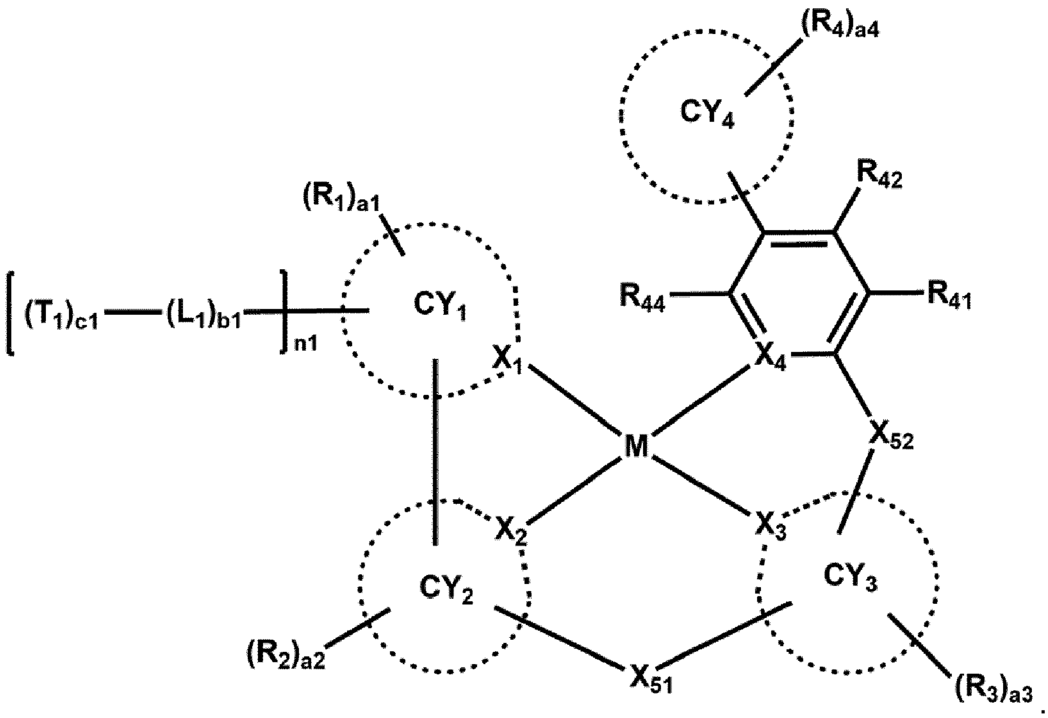

Formula 1 is the same as described in the present specification.
The tetradentate ligand in the organometallic compound is the same as described in the present specification.
The light-emitting device includes an organometallic compound represented by Formula 1 below or an organometallic compound including platinum (Pt) and a tetradentate ligand, and thus, may have excellent luminescence efficiency and long lifespan characteristics.
In an embodiment, the interlayer in the light-emitting device may include the organometallic compound.
In an embodiment, the emission layer in the light-emitting device may include the organometallic compound.
In an embodiment, the light-emitting device may further include a second compound including at least one $\pi$ electron-deficient nitrogen-containing $C_1$-$C_{60}$ cyclic group, a third compound including a group represented by Formula 3 below, a fourth compound capable of emitting delayed fluorescence, or any combination thereof, and the organometallic compound, the second compound, the third compound, and the fourth compound in the light-emitting device may be different from each other.
The second compound to the fourth compound in the composition and the light-emitting device are respectively the same as described in the present specification.
In an embodiment, the organometallic compound may include at least one deuterium.
In an embodiment, the second compound to the fourth compound may each include at least one deuterium.
In an embodiment, the composition and the light-emitting device (for example, the emission layer in the light-emitting device) may each further include a second compound, in addition to the organometallic compound. At least one selected from the organometallic compound and the second compound may include at least one deuterium. In an embodiment, the composition and the light-emitting device (for example, the emission layer in the light-emitting device) may each further include a third compound, a fourth compound, or any combination thereof, in addition to the organometallic compound and the second compound.
In an embodiment, the composition and the light-emitting device (for example, the emission layer in the light-emitting device) may each further include a third compound, in addition to the organometallic compound. At least one selected from the organometallic compound and the third compound may include at least one deuterium. In an embodiment, the composition and the light-emitting device (for example, the emission layer in the light-emitting device) may each further include a second compound, a fourth compound, or any combination thereof, in addition to the organometallic compound and the third compound.
In an embodiment, the composition and the light-emitting device (for example, the emission layer in the light-emitting device) may each further include a fourth compound, in addition to the organometallic compound. At least one selected from the organometallic compound and the fourth compound may include at least one deuterium. The fourth compound may serve to improve color purity, luminescence efficiency, and lifespan characteristics of the light-emitting device. In an embodiment, the composition and the light-emitting device (for example, the emission layer in the light-emitting device) may each further include a second compound, a third compound, or any combination thereof, in addition

to the organometallic compound and the fourth compound.

In an embodiment, the composition and the light-emitting device (for example, the emission layer in the light-emitting device) may each further include a second compound and a third compound, in addition to the organometallic compound. The second compound and the third compound may form an exciplex. At least one selected from the organometallic compound, the second compound, and the third compound may include at least one deuterium.

In an embodiment, a highest occupied molecular orbital (HOMO) energy level of the organometallic compound may be in a range of about -5.35 eV to about - 5.15 eV or about -5.30 eV to about -5.20 eV.

In an embodiment, a lowest unoccupied molecular orbital (LUMO) energy level of the organometallic compound may be in a range of about -2.20 eV to about - 1.80 eV or about -2.15 eV to about -1.90 eV.

The HOMO and LUMO energy levels may be evaluated via cyclic voltammetry analysis (for example, Evaluation Example 1) for the organometallic compound.

In an embodiment, a maximum emission wavelength (or an emission peak wavelength) of a photoluminescence spectrum in a film including the organometallic compound may be in a range of about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In an embodiment, an emission full width at half maximum (FWHM) of a photoluminescence spectrum in a film including the organometallic compound may be in a range of about 40 nm or less, about 5 nm to about 40 nm, about 10 nm to about 40 nm, about 15 nm to about 40 nm, about 20 nm to about 40 nm, about 5 nm to about 35 nm, about 10 nm to about 35 nm, about 15 nm to about 35 nm, about 20 nm to about 35 nm, about 5 nm to about 30 nm, about 10 nm to about 30 nm, about 15 nm to about 30 nm, about 20 nm to about 30 nm, about 5 nm to about 25 nm, about 10 nm to about 25 nm, about 15 nm to about 25 nm, or about 20 nm to about 25 nm.

In an embodiment, a photoluminescence quantum yield (PLOY) in a film including the organometallic compound may be in a range of about 90% to about 99% or about 90% to about 97%.

In an embodiment, a decay time of the organometallic compound may be in a range of about 2.42 μs to about 3.5 μs, about 2.42 μs to about 3.0 μs, about 2.50 μs to about 3.5 μs, or about 2.50 μs to about 3.0 μs.

The maximum emission wavelength, emission FWHM, PLOY, and decay time of the organometallic compound were evaluated for a film including the organometallic compound, and an evaluation method thereof is the same as described in connection with, for example, Evaluation Examples 2 and 3.

In an embodiment, the emission layer of the light-emitting device may include: i) the organometallic compound; and ii) the second compound, the third compound, the fourth compound, or any combination thereof, and the emission layer may emit blue light.

In an embodiment, a maximum emission wavelength of the blue light may be in a range of about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, or about 450 nm to about 465 nm.

In an embodiment, an emission FWHM of the blue light may be in a range of about 40 nm or less, about 5 nm to about 40 nm, about 10 nm to about 40 nm, about 15 nm to about 40 nm, about 20 nm to about 40 nm, about 5 nm to about 35 nm, about 10 nm to about 35 nm, about 15 nm to about 35 nm, about 20 nm to about 35 nm, about 5 nm to about 30 nm, about 10 nm to about 30 nm, about 15 nm to about 30 nm, about 20 nm to about 30 nm, about 5 nm to about 25 nm, about 10 nm to about 25 nm, about 15 nm to about 25 nm, or about 20 nm to about 25 nm.

In an embodiment, the blue light may be deep blue light.

In an embodiment, a CIE_x coordinate (for example, a bottom emission CIE_x coordinate) of the blue light may be in a range of about 0.125 to about 0.140 or about 0.130 to about 0.140.

In an embodiment, a CIE_y coordinate (for example, a bottom emission CIE_y coordinate) of the blue light may be in a range of about 0.120 to about 0.200.

Examples of the maximum emission wavelength and the CIE_x and CIE_y coordinates of the blue light may be referred to in Table 9 in the present specification.

In an embodiment, the second compound may include a pyridine group, a pyrimidine group, a pyrazine group, a pyridazine group, a triazine group, or any combination thereof.

In an embodiment, the following compounds may be excluded from the third compound.

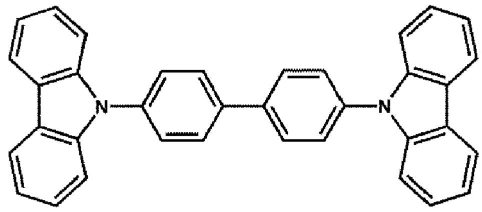

CBP

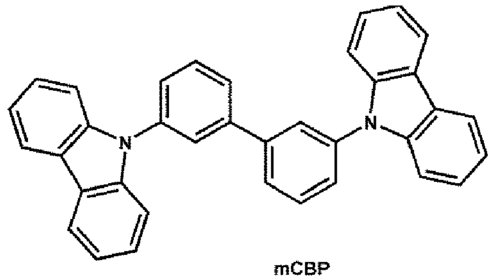

mCBP

In an embodiment, a difference between a triplet energy level (eV) of the fourth compound and a singlet energy level (eV) of the fourth compound may be about 0 eV or higher and about 0.5 eV or lower (or, about 0 eV or higher and about 0.3 eV or lower).

In an embodiment, the fourth compound may be a compound including at least one cyclic group including each of boron (B) and nitrogen (N) as a ring-forming atom.

In an embodiment, the fourth compound may be a $C_8$-$C_{60}$ polycyclic group-containing compound including at least two condensed cyclic groups that share boron (B).

In an embodiment, the fourth compound may include a condensed ring in which at least one third ring may be condensed together with at least one fourth ring,

the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1,1]hexane group, a bicyclo[2.2.2]octane group, a benzene group, a pyridine group, a pyrimidine group, a pyridazine group, a pyrazine group, or a triazine group, and

the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In an embodiment, the third compound may not include a compound represented by Formula 3-1 described in the present specification.

In an embodiment, the second compound may include a compound represented by Formula 2:

Formula 2

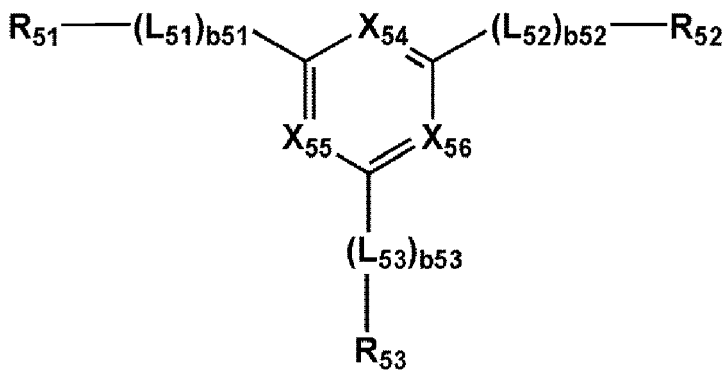

wherein, in Formula 2,

$L_{51}$ to $L_{53}$ may each independently be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

b51 to b53 may each independently be an integer selected from 1 to 5,

$X_{54}$ may be N or C(R54), $X_{55}$ may be N or C(R55), $X_{56}$ may be N or C(R56), and at least one selected from $X_{54}$ to $X_{56}$ may be N, and

$R_{51}$ to $R_{56}$ and $R_{10a}$ are respectively the same as described in the present specification.

In an embodiment, the third compound may include a compound represented by Formula 3-1, a compound represented by Formula 3-2, a compound represented by Formula 3-3, a compound represented by Formula 3-4, a compound represented by Formula 3-5, or any combination thereof:

Formula 3-1

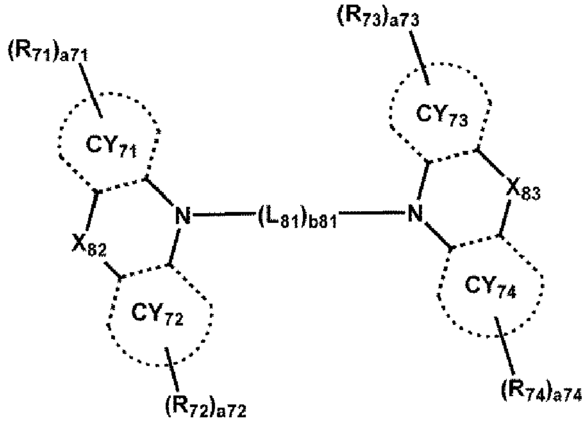

Formula 3-2

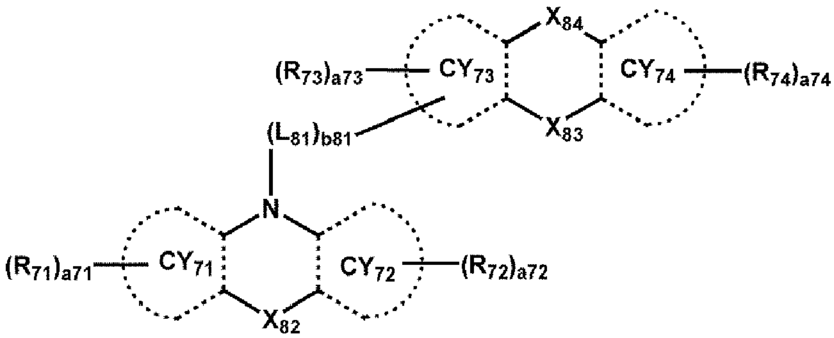

Formula 3-3

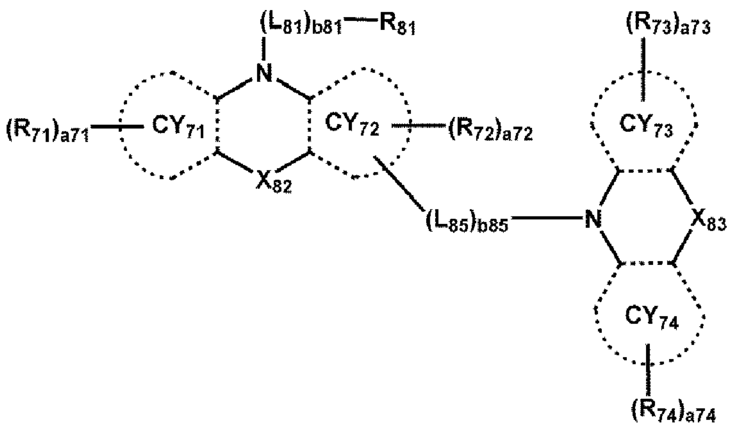

Formula 3-4

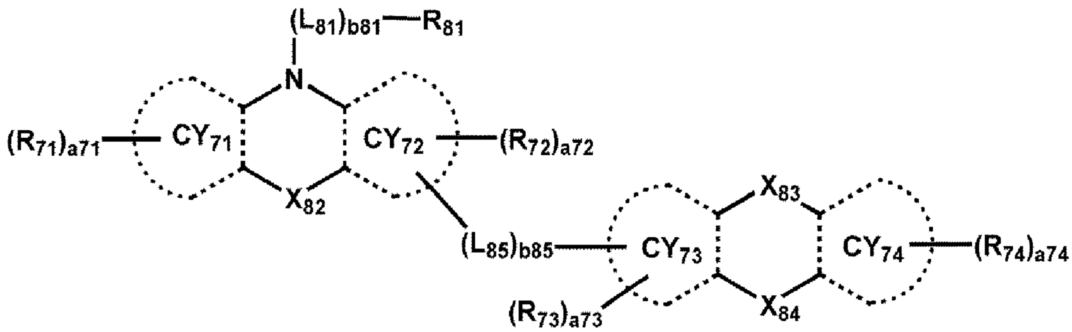

Formula 3-5

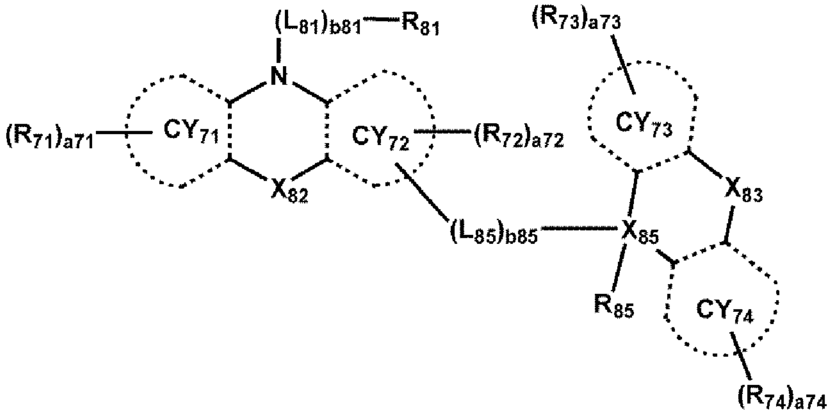

wherein, in Formulae 3-1 to 3-5,

ring $CY_{71}$ to ring $CY_{74}$ may each independently be a $\pi$ electron-rich $C_3$-$C_{60}$ cyclic group or a pyridine group,

$X_{82}$ may be a single bond, O, S, N-[$(L_{82})_{b82}$-$R_{82}$], C($R_{82a}$)($R_{82b}$), or Si($R_{82a}$)($R_{82b}$),

$X_{83}$ may be a single bond, O, S, N-[$(L_{83})b_{83}$-$R_{83}$], C($R_{83a}$)($R_{83b}$), or Si($R_{83a}$)($R_{83b}$),

$X_{84}$ may be O, S, N-[$(L_{84})_{b84}$-$R_{84}$], C($R_{84a}$)($R_{84b}$), or Si($R_{84a}$)($R_{84b}$),

$X_{85}$ may be C or Si,

$L_{81}$ to $L_{85}$ may each independently be a single bond, *-C($Q_4$)($Q_5$)-*', *-Si($Q_4$)($Q_5$)-*', a $\pi$ electron-rich $C_3$-$C_{60}$ cyclic group unsubstituted or substituted with at least one $R_{10a}$, or a pyridine group unsubstituted or substituted with at least one $R_{10a}$, wherein $Q_4$ and $Q_5$ may each be understood by referring to the description of $Q_1$ provided herein,

b81 to b85 may each independently be an integer selected from 1 to 5,

$R_{71}$ to $R_{74}$, $R_{81}$ to $R_{85}$, $R_{82a}$, $R_{82b}$, $R_{83a}$, $R_{83b}$, $R_{84a}$, and $R_{84b}$ are respectively the same as described in the present specification,

a71 to a74 may each independently be an integer selected from 0 to 20, and

$R_{10a}$ may be the same as described in the present specification.

In an embodiment, the fourth compound may be a compound represented by Formula 502, a compound represented by Formula 503, or any combination thereof:

Formula 502

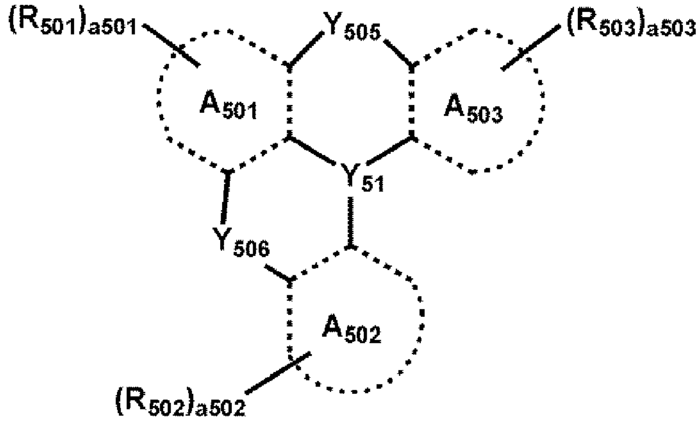

Formula 503

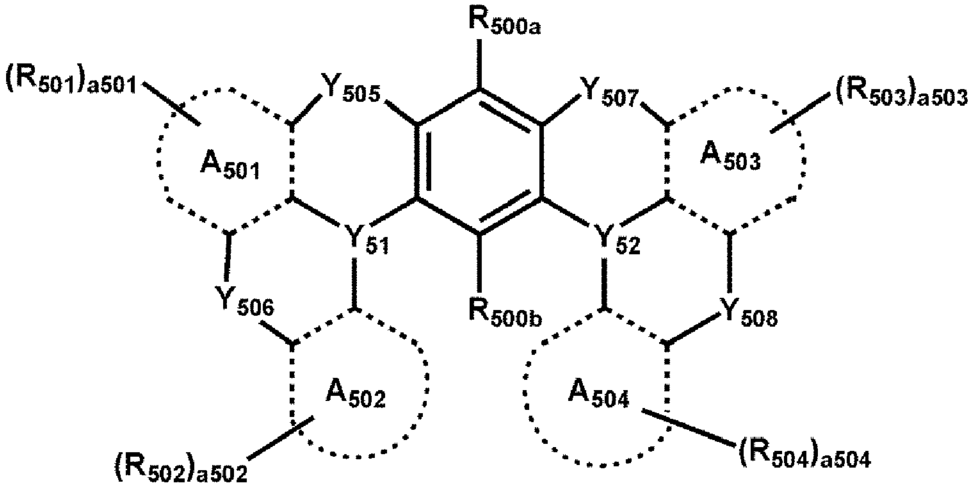

wherein, in Formulae 502 and 503,

ring $A_{501}$ to ring $A_{504}$ may each independently be a $C_3$-$C_{60}$ carbocyclic group or a $C_1$-$C_{60}$ heterocyclic group,

Y505 may be O, S, $N(R_{505})$, $B(R_{505})$, $C(R_{505a})(R_{505b})$, or $Si(R_{505a})(R_{505b})$,

Y506 may be O, S, $N(R_{506})$, $B(R_{506})$, $C(R_{506a})(R_{506b})$, or $Si(R_{506a})(R_{506b})$,

Y507 may be O, S, $N(R_{507})$, $B(R_{507})$, $C(R_{507a})(R_{507b})$, or $Si(R_{507a})(R_{507b})$,

Y508 may be O, S, $N(R_{508})$, $B(R_{508})$, $C(R_{508a})(R_{508b})$, or $Si(R_{508a})(R_{508b})$,

$Y_{51}$ and $Y_{52}$ may each independently be B, P(=O), or S(=O),

$R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ are respectively the same as described in the present specification, and

a501 to a504 may each independently be an integer selected from 0 to 20.

In an embodiment, the light-emitting device may satisfy at least one selected from Conditions 1 to 4:

Condition 1

LUMO energy level (eV) of third compound > LUMO energy level (eV) of organometallic compound

Condition 2

LUMO energy level (eV) of organometallic compound > LUMO energy level (eV) of second compound

Condition 3

HOMO energy level (eV) of organometallic compound > HOMO energy level (eV) of third compound

Condition 4

HOMO energy level (eV) of the third compound > HOMO energy level (eV) of the second compound

wherein each of the HOMO energy level and the LUMO energy level of each of the organometallic compound, the second compound, and the third compound may be a negative value, and may be measured according to any suitable method generally used in the art. In some embodiments, a method described in Evaluation Example 1 in

the present specification may be used to measure each of the HOMO energy level and the LUMO energy level of each of the organometallic compound, the second compound, and the third compound.

In an embodiment, an absolute value of a difference between a LUMO energy level of the organometallic compound and a LUMO energy level of the second compound may be about 0.1 eV or higher and about 1.0 eV or lower, an absolute value of a difference between a LUMO energy level of the organometallic compound and a LUMO energy level of the third compound may be about 0.1 eV or higher and about 1.0 eV or lower, an absolute value of a difference between a HOMO energy level of the organometallic compound and a HOMO energy level of the second compound may be about 1.25 eV or lower (for example, about 1.25 eV or lower and about 0.2 eV or higher), and an absolute value of a difference between a HOMO energy level of the organometallic compound and a HOMO energy level of the third compound may be about 1.25 eV or lower (for example, about 1.25 eV or lower and about 0.2 eV or higher).
When the relationships between LUMO energy level and HOMO energy level satisfy the conditions as described above, the balance between holes and electrons injected into the emission layer can be made.
The light-emitting device may have a structure of a first embodiment or a second embodiment.

**First embodiment**

According to the first embodiment, the organometallic compound may be included in the emission layer in the interlayer of the light-emitting device, wherein the emission layer may further include a host, the organometallic compound may be different from the host, and the emission layer may emit phosphorescence or fluorescence emitted from the organometallic compound. According to the first embodiment, the organometallic compound may be a dopant or an emitter. In an embodiment, the organometallic compound may be a phosphorescent dopant or a phosphorescent emitter.
Phosphorescence or fluorescence emitted from the organometallic compound may be blue light.
The emission layer may further include an auxiliary dopant. The auxiliary dopant may serve to improve luminescence efficiency from the first compound by effectively transferring energy to the organometallic compound as a dopant or an emitter.
The auxiliary dopant may be different from the organometallic compound and the host.
In some embodiments, the auxiliary dopant may be a delayed fluorescence-emitting compound.
In some embodiments, the auxiliary dopant may be a compound including at least one cyclic group including each of boron (B) and nitrogen (N) as a ring-forming atom.

**Second embodiment**

According to the second embodiment, the organometallic compound may be included in the emission layer in the interlayer of the light-emitting device, wherein the emission layer may further include a host and a dopant, the organometallic compound, the host and the dopant may be different from one another, and the emission layer may emit phosphorescence or fluorescence (e.g., delayed fluorescence) from the dopant.
In an embodiment, the organometallic compound in the second embodiment may serve as an auxiliary dopant that transfers energy to a dopant (or an emitter), not as a dopant.
In an embodiment, the organometallic compound in the second embodiment may serve as an emitter and as an auxiliary dopant that transfers energy to a dopant (or an emitter).
In an embodiment, phosphorescence or fluorescence emitted from the dopant (or the emitter) in the second embodiment may be blue phosphorescence or blue fluorescence (e.g., blue delayed fluorescence).
The dopant (or the emitter) in the second embodiment may be any phosphorescent dopant material (e.g., the organometallic compound represented by Formula 1, the organometallic compound represented by Formula 401, or any combination thereof) or any fluorescent dopant material (e.g., the compound represented by Formula 501, the compound represented by Formula 502, the compound represented by Formula 503, or any combination thereof).
In the first embodiment and the second embodiment, the blue light may have a maximum emission wavelength in a range of about 390 nm to about 500 nm, about 410 nm to about 490 nm, about 430 nm to about 480 nm, about 430 nm to about 475 nm, about 440 nm to about 475 nm, or about 455 nm to about 470 nm.
The auxiliary dopant in the first embodiment may include, for example, the fourth compound represented by Formula 502 or 503.
The host in the first embodiment and the second embodiment may be any suitable host material (e.g., the compound represented by Formula 301, the compound represented by 301-1, the compound represented by Formula 301-2, or any combination thereof).
In some embodiments, the host in the first embodiment and the second embodiment may be the second compound, the third compound, or any combination thereof described in the present specification.
In an embodiment, the light-emitting device may further include a capping layer outside the first electrode and/or

outside the second electrode.

In an embodiment, the light-emitting device may further include at least one selected from a first capping layer outside the first electrode and a second capping layer outside the second electrode, and the at least one selected from the first capping layer and the second capping layer may include the organometallic compound represented by Formula 1. More details for the first capping layer and/or second capping layer are the same as described in the present specification.

In an embodiment, the light-emitting device may further include:

a first capping layer outside the first electrode and including the organometallic compound represented by Formula 1;
a second capping layer outside the second electrode and including the organometallic compound represented by Formula 1; or
the first capping layer and the second capping layer.

The expression "(interlayer and/or capping layer) includes the organometallic compound represented by Formula 1," as used herein, may be understood as "(interlayer and/or capping layer) may include one kind of organometallic compound represented by Formula 1 or two or more different kinds of organometallic compounds, each represented by Formula 1.

In an embodiment, the interlayer and/or capping layer may include only Compound BD01 as the organometallic compound. In this regard, Compound BD02 may exist in the emission layer of the light-emitting device. In some embodiments, the interlayer may include, as the organometallic compound, Compound BD02 and Compound BD04. In this regard, Compound BD02 and Compound BD04 may exist in an identical layer (for example, Compound BD02 and Compound BD04 may all exist in an emission layer), or different layers (for example, Compound BD02 may exist in an emission layer and Compound BD04 may exist in an electron transport region).

The term "interlayer," as used herein, refers to a single layer and/or all of a plurality of layers between the first electrode and the second electrode of the light-emitting device.

According to one or more embodiments, provided is an electronic apparatus including the light-emitting device. The electronic apparatus may further include a thin-film transistor. In an embodiment, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or any combination thereof. More details for the electronic apparatus are as described in the present specification.

According to one or more embodiments, provided is a consumer product including the light-emitting device.

In an embodiment, the consumer product may be one selected from a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.

According to one or more embodiments, provided is the organometallic compound represented by Formula 1. Formula 1 is the same as described in the present specification.

According to one or more embodiments, provided is an organometallic compound including platinum and a tetradentate ligand.

Methods of synthesizing the organometallic compound may be easily understood to those of ordinary skill in the art by referring to Synthesis Examples and/or Examples described herein.

**Description of Formula**

In Formula 1, M may be platinum (Pt), palladium (Pd), gold (Au), nickel (Ni), silver (Ag), or copper (Cu).

In an embodiment, M may be Pt.

In Formula 1, $X_1$ to $X_4$ may each independently be C or N.

In an embodiment, $X_1$ may be C. In an embodiment, $X_1$ in Formula 1 may be C, and C may be carbon of a carbene moiety.

In an embodiment, $X_1$ in Formula 1 may be N.

In an embodiment, $X_2$ and $X_3$ may each be C, and $X_4$ may be N.

In Formula 1, i) a bond between $X_1$ and M may be a coordinate bond, and ii) one selected from a bond between $X_2$ and M, a bond between $X_3$ and M, and a bond between $X_4$ and M may be a coordinate bond, and the other two may each be a covalent bond. As described herein, "a coordinate bond" may also be referred to as a coordinate covalent

bond or a dative bond. As described herein, when a bond is referred to as a "covalent bond", the bond may not be a coordinate bond.

In an embodiment, a bond between $X_2$ and M and a bond between $X_3$ and M may each be a covalent bond, and a bond between $X_4$ and M may be a coordinate bond.

In an embodiment, $X_4$ may be N, and a bond between $X_4$ and M may be a coordinate bond.

In Formula 1, rings $CY_1$, $CY_2$, $CY_3$, and $CY_4$ may each independently be a C3-C60 carbocyclic group or a $C_1$-$C_{60}$ heterocyclic group.

In an embodiment, ring $CY_1$ may be a $C_1$-$C_{60}$ nitrogen-containing heterocyclic group.

Ring $CY_1$ in Formula 1 may be i) an Xi-containing 5-membered ring, ii) an Xi-containing 5-membered ring in which at least one 6-membered ring is condensed, or iii) an Xi-containing 6-membered ring. In an embodiment, ring $CY_1$ in Formula 1 may be i) an Xi-containing 5-membered ring or ii) an Xi-containing 5-membered ring in which at least one 6-membered ring is condensed. In some embodiments, ring $CY_1$ may include a 5-membered ring bonded to M in Formula 1 via $X_1$. Here, the $X_1$-containing 5-membered ring may be a pyrrole group, a pyrazole group, an imidazole group, a triazole group, an oxazole group, an iso-oxazole group, a thiazole group, an isothiazole group, an oxadiazole group, or a thiadiazole group, and the $X_1$-containing 6-membered ring and the 6-membered ring which may be optionally condensed to the Xi-containing 5-membered ring may each independently be a benzene group, a pyridine group, or a pyrimidine group.

In an embodiment, ring $CY_1$ may be an Xi-containing 5-membered ring, and the Xi-containing 5-membered ring may be an imidazole group or a triazole group.

In an embodiment, ring $CY_1$ may be an Xi-containing 5-membered ring in which at least one 6-membered ring is condensed, and the Xi-containing 5-membered ring in which the at least one 6-membered ring is condensed may be a benzimidazole group or an imidazopyridine group.

In an embodiment, ring $CY_1$ may be an imidazole group, a triazole group, a benzimidazole group, or an imidazopyridine group.

Rings $CY_2$, $CY_3$, and $CY_4$ in Formula 1 may each independently be a $C_3$-$C_{60}$ carbocyclic group or a $C_1$-$C_{60}$ heterocyclic group.

In an embodiment, rings $CY_2$, $CY_3$, and $CY_4$ may each independently be a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group.

In an embodiment, ring $CY_2$ may be a benzene group, a pyridine group, a pyrimidine group, a naphthalene group, a dibenzofuran group, a dibenzothiophene group, a carbazole group, a fluorene group, or a dibenzosilole group.

$X_{51}$ in Formula 1 may be a single bond, *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', *-O-*', *-C(=O)-*', *-S(=O)-*', *-S(=O)$_2$-*', *-C($R_{51a}$)=*', *=C($R_{51a}$)-*', *-C($R_{51a}$)=C($R_{51b}$)-*', *-C(=S)-*', or *-C≡C-*'. $R_{51a}$ and $R_{51b}$ are respectively the same as described in the present specification. $R_{51a}$ and $R_{51b}$ may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one Rioa.

In an embodiment, $X_{51}$ may be *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', or *-O-*'.

$X_{52}$ in Formula 1 may be a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', *-O-*', *-C(=O)-*', *-S(=O)-*', *-S(=O)$_2$-*', *-C($R_{52a}$)=*', *=C($R_{52a}$)-*', *-C($R_{52a}$)=C($R_{52b}$)-*', *-C(=S)-*', or *-C≡C-*'. $R_{52a}$ and $R_{52b}$ are respectively the same as described in the present specification.

$X_{52}$ in Formula 1 may be a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', or *-O-*'.

In an embodiment, in Formula 1,

i) $X_{52}$ may be a single bond, and a group represented by

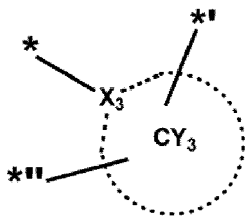

in Formula 1 may be a group represented by Formula CY3A or CY3B below,

ii) $X_{52}$ may not be a single bond, and a group represented by

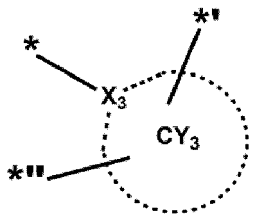

in Formula 1 may be a group represented by Formula CY3C below, or

iii) $X_{52}$ may be *-N($R_{52a}$)-*', and $R_{52a}$ and $R_3$ may be bonded to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$:

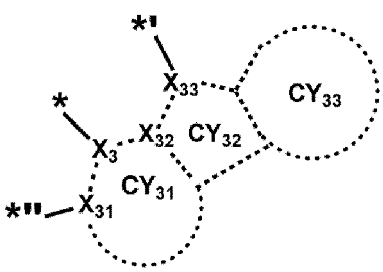

CY3A

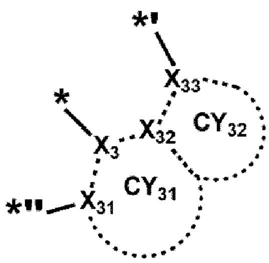

CY3B

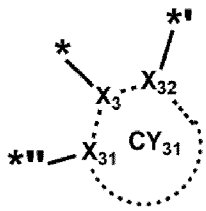

CY3C

wherein, in Formulae CY3A to CY3C,

$X_3$ and $X_{31}$ to $X_{33}$ may each independently be C or N,

rings $CY_{31}$, $CY_{32}$, and $CY_{33}$ are respectively the same as described in connection with ring $CY_3$ in the present specification,

a bond between $X_{31}$ and $X_3$, a bond between $X_3$ and $X_{32}$, and a bond between $X_{32}$ and $X_{33}$ may each be a chemical bond,

*" indicates a binding site to $X_{51}$,

* indicates a binding site to M in Formula 1, and

*' indicates a binding site to $X_{52}$.

In an embodiment, $X_{31}$, $X_3$, and $X_{32}$ in Formulae CY3A and CY3B may each be C, and $X_{33}$ may be N.

In an embodiment, $X_{31}$, $X_3$, and $X_{32}$ in Formula CY3C may each be C.

In Formula 1, $L_1$ may be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$.

In an embodiment, $L_1$ may be a benzene group, a naphthalene group, a dibenzofuran group, or a dibenzothiophene group, each unsubstituted or substituted with at least one $R_{10a}$.

b1 in Formula 1 indicates the number of $L_1$(s), and may be an integer selected from 1 to 5. When b1 is 2 or more, two or more of $L_1$(s) may be identical to or different from each other. In an embodiment, b1 may be 1 or 2.

In Formula 1, $R_1$ to $R_4$, $R_{42}$, $R_{51a}$, $R_{51b}$, $R_{52a}$, $R_{52b}$, and $T_1$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one

$R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$), wherein $R_{42}$ is neither hydrogen nor deuterium.

In Formula 1, $R_{42}$ is -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, - C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or - P(=O)($Q_1$)($Q_2$).

In Formula 1, $R_{41}$ and $R_{44}$ may each independently be hydrogen or deuterium.

In an embodiment, $R_1$ to $R_4$, $R_{51a}$, $R_{51b}$, $R_{52a}$, $R_{52b}$, and $T_1$ in Formula 1 may each independently be:

hydrogen, deuterium, -F, or a cyano group;
a $C_1$-$C_{20}$ alkyl group or a $C_3$-$C_{10}$ cycloalkyl group, each unsubstituted or substituted with deuterium, -F, a cyano group, or any combination thereof; or
a phenyl group, a naphthyl group, a dibenzofuranyl group, or a dibenzothiophenyl group (or a thienyl group), each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl) phenyl group, or any combination thereof.

In an embodiment, $R_{42}$ in Formula 1 may be a $C_1$-$C_{20}$ alkyl group unsubstituted or substituted with deuterium, -F, a cyano group, or any combination thereof.

In an embodiment, $R_{42}$ in Formula 1 may be a group represented by *-C(R42a)(R42b)(R42c), and $R_{42a}$, $R_{42b}$, and $R_{42c}$ may each independently be a $C_1$-$C_{20}$ alkyl group unsubstituted or substituted with deuterium, -F, a cyano group, or any combination thereof, wherein at least one selected from $R_{42a}$, $R_{42b}$, and R42c may be hydrogen or deuterium. Therefore, an angular deviation between a plane including ring $CY_4$ in Formula 1 and a plane including $R_{42}$ in Formula 1 may be minimized or reduced to improve electrical characteristics and/or thermostability of the organometallic compound represented by Formula 1.

In an embodiment, $T_1$ in Formula 1 may be a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl) phenyl group, or any combination thereof.

a1, a2, a3, a4, c1, and n1 in Formula 1 may respectively indicate the numbers of groups represented by $R_1$, $R_2$, $R_3$, $R_4$, $T_1$, and *-($L_1$)$_{b1}$-($T_1$)$_{c1}$, and may each independently be an integer selected from 0 to 20.

In an embodiment, a1, a2, a3, and a4 may each independently be 0, 1, 2, 3, 4, or 5.

In an embodiment, c1 may be 1 or 2.

In an embodiment, n1 may be 0 or 1.

In an embodiment, c1 may be 2, and n1 may be 1.

In an embodiment, the organometallic compound may be represented by Formula 1-1 or 1-2:

Formula 1-1

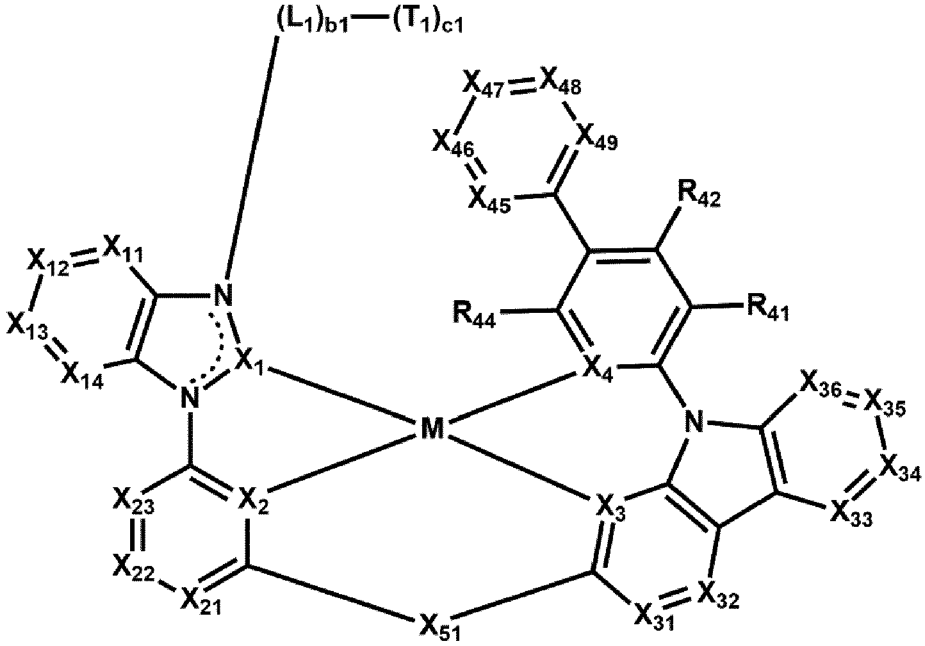

Formula 1-2

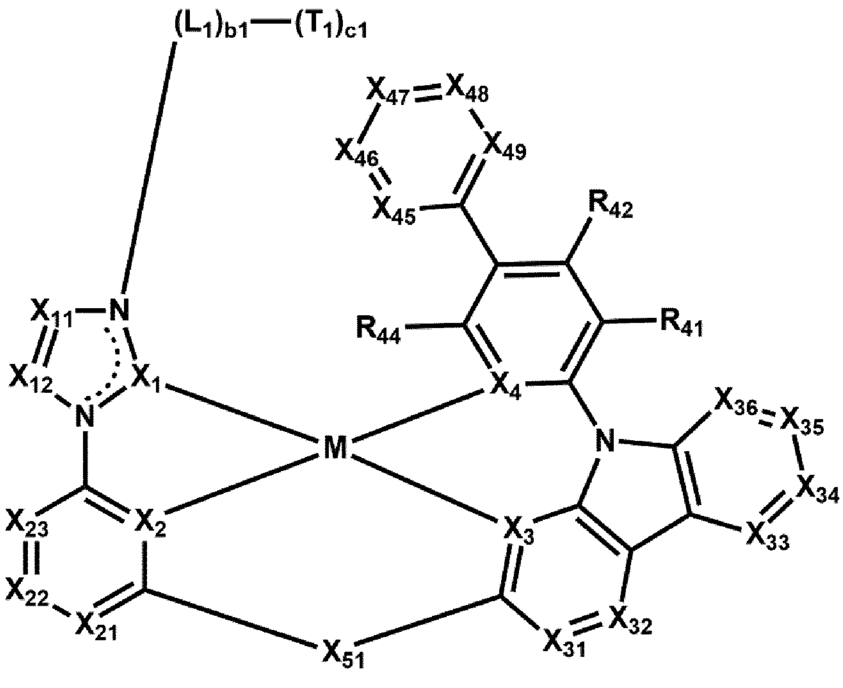

wherein, in Formulae 1-1 and 1-2,

M, $X_1$ to $X_4$, $X_{51}$, $L_1$, b1, $T_1$, c1, $R_{41}$, $R_{42}$, and $R_{44}$ are respectively the same as described in the present specification,

$X_{11}$ may be $C(R_{11})$ or N, $X_{12}$ may be $C(R_{12})$ or N, $X_{13}$ may be $C(R_{13})$ or N, and $X_{14}$ may be $C(R_{14})$ or N,

$R_{11}$ to $R_{14}$ are respectively the same as described in connection with $R_1$ in the present specification, and two or more of $R_{11}$ to $R_{14}$ may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$X_{21}$ may be $C(R_{21})$ or N, $X_{22}$ may be C(R22) or N, and $X_{23}$ may be C(R23) or N,

$R_{21}$ to $R_{23}$ are respectively the same as described in connection with $R_2$ in the present specification, and two or more of $R_{21}$ to $R_{23}$ may optionally be bonded together to form a $C_3$-$C_{60}$ carbocyclic group unsubstituted or substituted

with at least one $R_{10a}$ or a $C_1$-$C_{60}$ heterocyclic group unsubstituted or substituted with at least one $R_{10a}$,
$X_{31}$ may be $C(R_{31})$ or N, $X_{32}$ may be C(R32) or N, $X_{33}$ may be C(R33) or N, $X_{34}$ may be C(R34) or N, $X_{35}$ may be C(R35) or N, and $X_{36}$ may be C(R36) or N,
$R_{31}$ to $R_{36}$ are respectively the same as described in connection with $R_3$ in the present specification, and two or more of $R_{31}$ to $R_{36}$ may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{45}$ may be C(R45) or N, $X_{46}$ may be C(R46) or N, $X_{47}$ may be C(R47) or N, $X_{48}$ may be C(R48) or N, and $X_{49}$ may be C(R49) or N, and
$R_{45}$ to $R_{49}$ are respectively the same as described in connection with $R_4$ in the present specification, and two or more of $R_{45}$ to $R_{49}$ may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$.

In an embodiment a group represented by

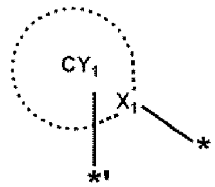

in Formula 1 may be a group represented by one selected from Formulae CY1-1 to CY1-42:

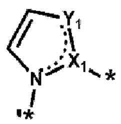
CY1-1
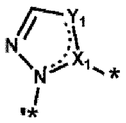
CY1-2
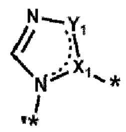
CY1-3
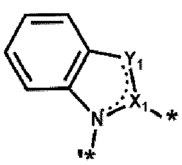
CY1-4
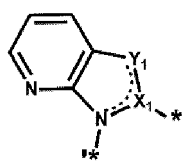
CY1-5
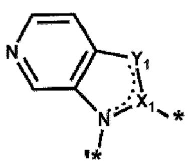
CY1-6
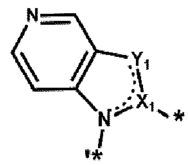
CY1-7

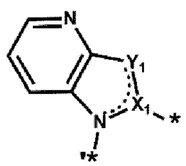
CY1-8
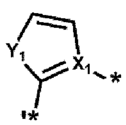
CY1-9
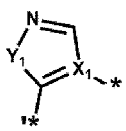
CY1-10
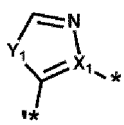
CY1-11
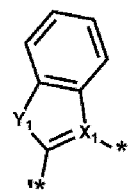
CY1-12
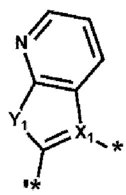
CY1-13
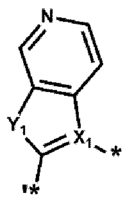
CY1-14

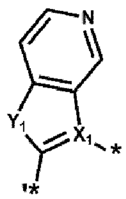
CY1-15
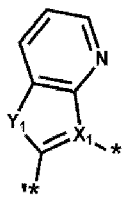
CY1-16
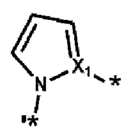
CY1-17
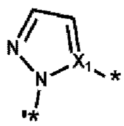
CY1-18
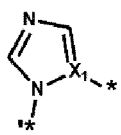
CY1-19
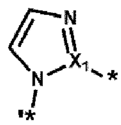
CY1-20
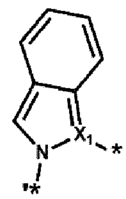
CY1-21

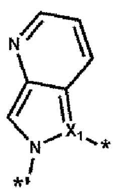
CY1-22
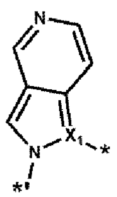
CY1-23
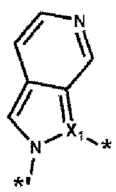
CY1-24
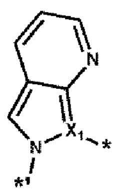
CY1-25
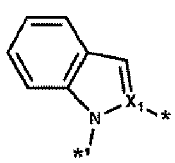
CY1-26
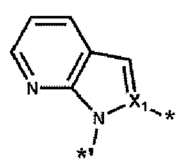
CY1-27
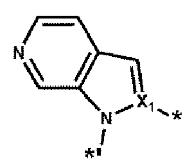
CY1-28

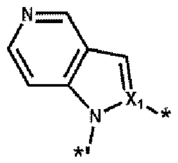
CY1-29

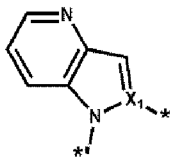
CY1-30

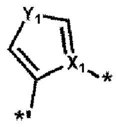
CY1-31

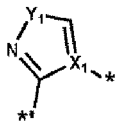
CY1-32

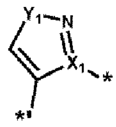
CY1-33

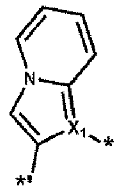
CY1-34

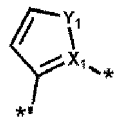
CY1-35

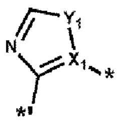
CY1-36

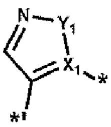
CY1-37

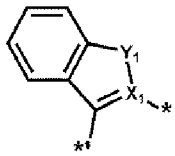
CY1-38

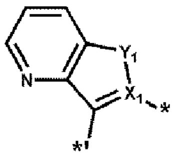
CY1-39

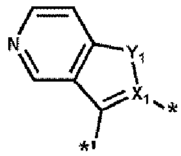
CY1-40

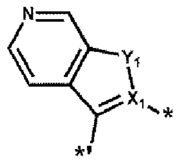
CY1-41

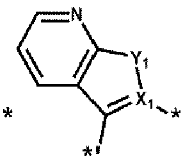
CY1-42

wherein, in Formulae CY1-1 to CY1-42,
$X_1$ is the same as described in the present specification,
$Y_1$ may include O, S, N, C, or Si,
* indicates a binding site to M in Formula 1, and
*' indicates a binding site to ring $CY_2$ in Formula 1.

In an embodiment, $X_1$ in Formulae CY1-1 to CY1-8 may be C, and $X_1$ in Formulae CY1-9 to CY1-42 may be N.

In an embodiment, a group represented by

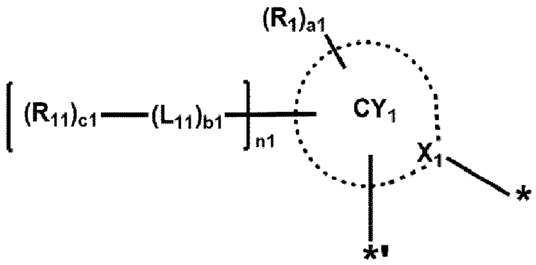

in Formula 1 may be a group represented by one selected from Formulae CY1 (1) to CY1 (8):

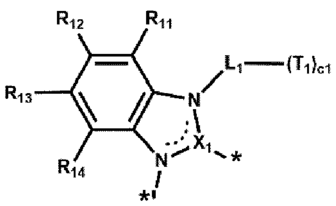
CY1(1)

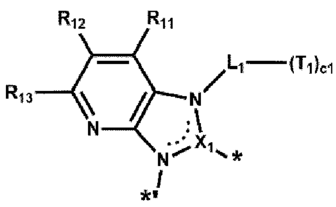
CY1(2)

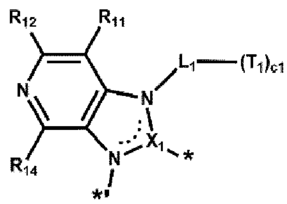
CY1(3)

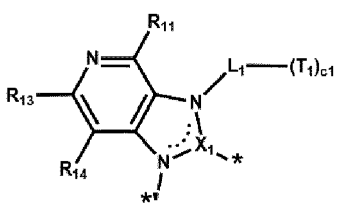
CY1(4)

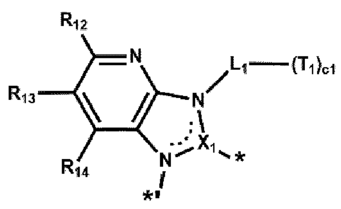
CY1(5)

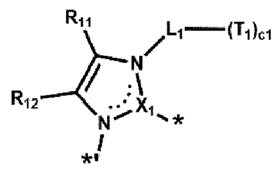
CY1(6)

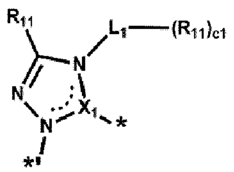
CY1(7)

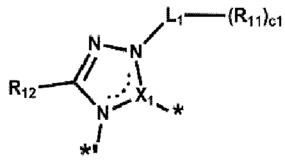
CY1(8)

wherein, in Formulae CY1(1) to CY1(8),
$X_1$ may be C,
$L_1$, $T_1$, and c1 are respectively the same as described in the present specification,
$R_{11}$ to $R_{14}$ are respectively the same as described in connection with $R_1$ in the present specification,
* indicates a binding site to M in Formula 1, and
*' indicates a binding site to ring $CY_2$ in Formula 1.

In an embodiment, a group represented by *-$(L_1)_{b1}$-$(T_1)_{c1}$ in Formula 1 may be a group represented by Formula CY1A:

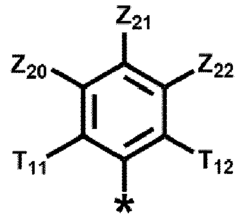
**CY1A**

wherein, in Formula CY1A,
$Z_{20}$ to $Z_{22}$ may each independently be hydrogen, or are respectively the same as described in connection with $R_{10a}$ in the present specification,
$T_{11}$ and $T_{12}$ are respectively the same as described in connection with $T_1$ in the present specification, and
* indicates a binding site to ring $CY_1$.

In an embodiment, $T_{11}$ and $T_{12}$ may each independently be a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof.

In an embodiment, a group represented by *-$(L_1)_{b1}$-$(T_1)_{c1}$ in Formula 1 may be a group represented by Formula CY1 (A):

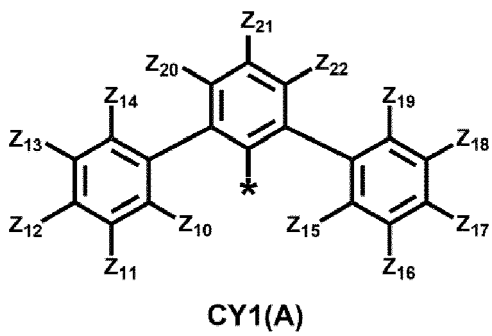
**CY1(A)**

wherein, in Formula CY1 (A),
$Z_{10}$ to $Z_{22}$ may each independently be hydrogen, or are respectively the same as described in connection with $R_{10a}$ in the present specification, and
* indicates a binding site to ring $CY_1$.

In an embodiment, $Z_{10}$ to $Z_{22}$ may each independently be hydrogen, deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, or a ($C_1$-$C_{20}$ alkyl)phenyl group.

In an embodiment, a group represented by

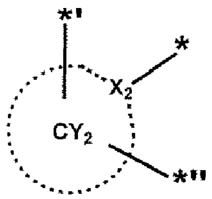

in Formula 1 may be a group represented by one selected from Formulae CY2-1 to CY2-11:

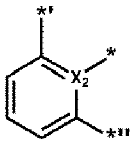
CY2-1

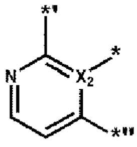
CY2-2

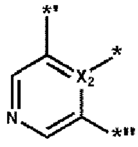
CY2-3

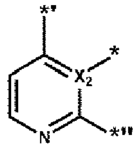
CY2-4

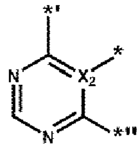
CY2-5

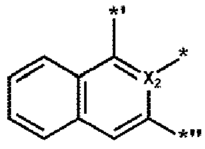
CY2-6

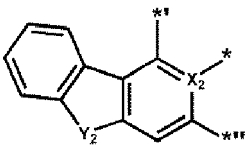
CY2-7

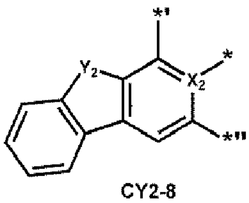
CY2-8

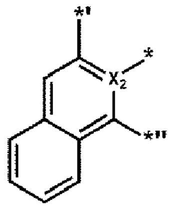
CY2-9

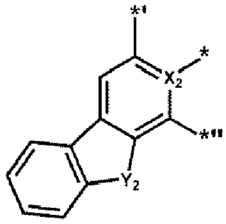
CY2-10

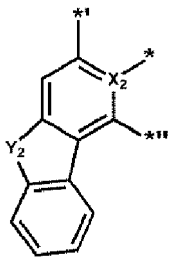
CY2-11

wherein, in Formulae CY2-1 to CY2-11,
$X_2$ is the same as described in the present specification,
$Y_2$ may include O, S, N, C, or Si,
* indicates a binding site to M in Formula 1,
*' indicates a binding site to ring $CY_1$ in Formula 1, and
*" indicates a binding site to $X_{51}$ in Formula 1.

In an embodiment, a group represented by

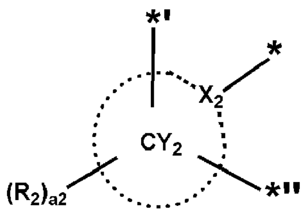

in Formula 1 and a group represented by

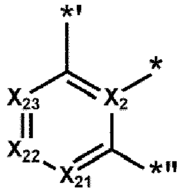

in Formulae 1-1 and 1-2 may each independently be a group represented by one selected from Formulae CY2(1) to CY2(26):

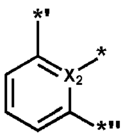
CY2(1)

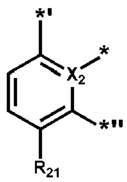
CY2(2)

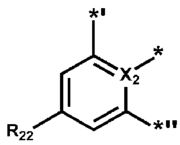
CY2(3)

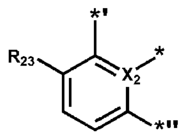
CY2(4)

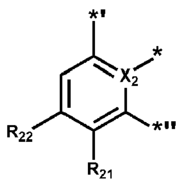
CY2(5)

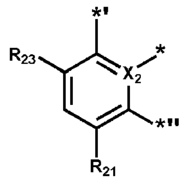
CY2(6)

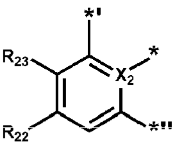
CY2(7)

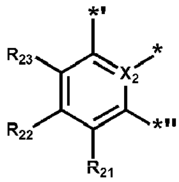
CY2(8)

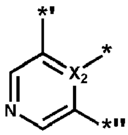
CY2(9)

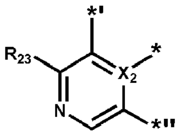
CY2(10)

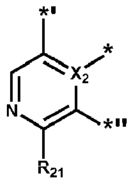
CY2(11)

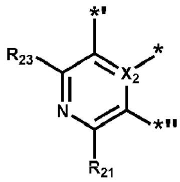
CY2(12)

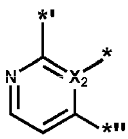
CY2(13)

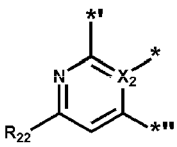
CY2(14)

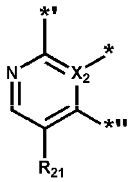
CY2(15)

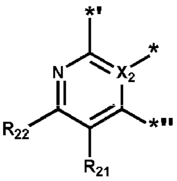
CY2(16)

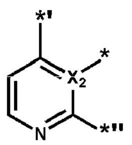
CY2(17)

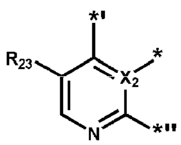
CY2(18)

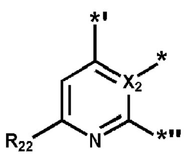
CY2(19)

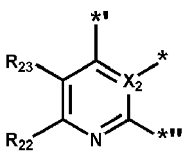
CY2(20)

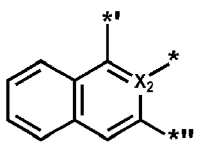
CY2(21)

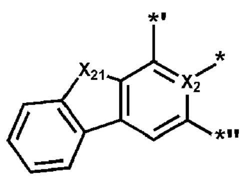
CY2(22)

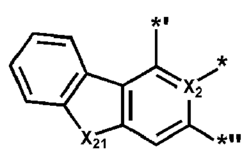
CY2(23)

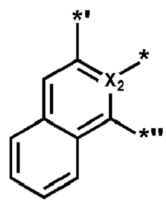

CY2(24)

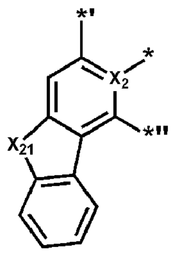

CY2(25)

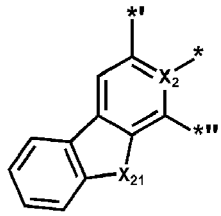

CY2(26)

wherein, in Formulae CY2(1) to CY2(26),
$X_2$ is the same as described in the present specification,
$X_{21}$ may be O, S, N($R_{20}$), C($R_{20a}$)($R_{20b}$), or Si($R_{20a}$)($R_{20b}$),
$R_{20}$, $R_{20a}$, $R_{20b}$, and $R_{21}$ to $R_{23}$ are respectively the same as described in connection with $R_2$ in the present specification, and $R_{21}$ to $R_{23}$ may each not be hydrogen,
* indicates a binding site to M in Formula 1,
*' indicates a binding site to ring $CY_1$ in Formula 1, and
*" indicates a binding site to $X_{51}$ in Formula 1.

In an embodiment, a group represented by

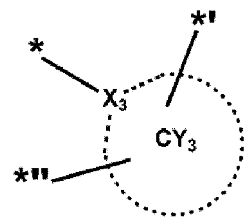

in Formula 1 may be a group represented by one selected from Formulae CY3-1 to CY3-23:

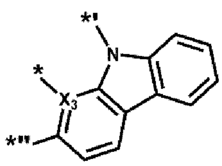

CY3-1

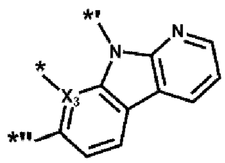

CY3-2

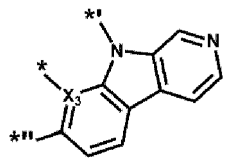

CY3-3

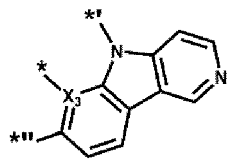

CY3-4

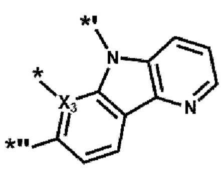

CY3-5

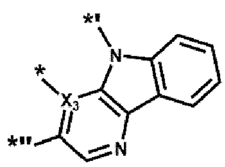

CY3-6

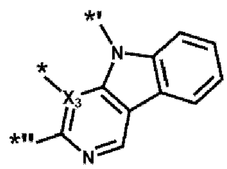

CY3-7

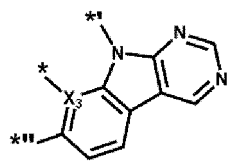

CY3-8

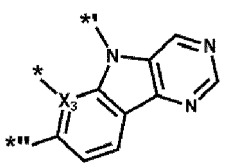

CY3-9

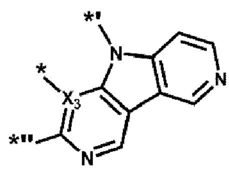

CY3-10

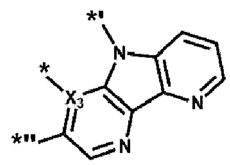

CY3-11

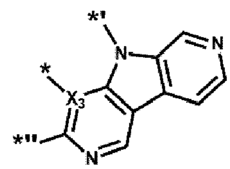

CY3-12

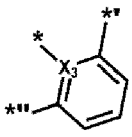
CY3-13

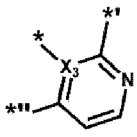
CY3-14

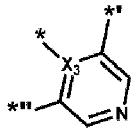
CY3-15

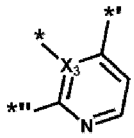
CY3-16

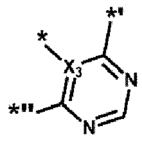
CY3-17

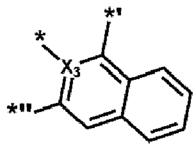
CY3-18

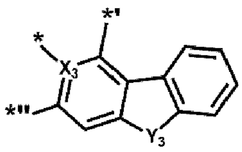
CY3-19

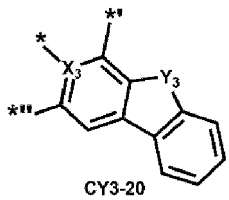
CY3-20

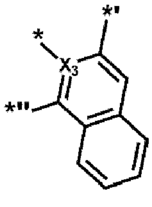
CY3-21

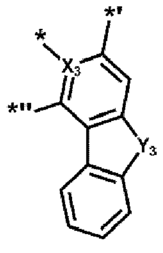
CY3-22

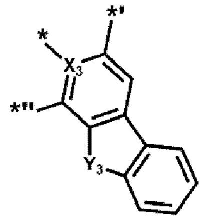
CY3-23

wherein, in Formulae CY3-1 to CY3-23,
$X_3$ is the same as described in the present specification,
$Y_3$ may include O, S, N, C, or Si,
* indicates a binding site to M in Formula 1,
*' indicates a binding site to $X_{52}$ in Formula 1, and
*" indicates a binding site to $X_{51}$ in Formula 1.

In an embodiment, a group represented by

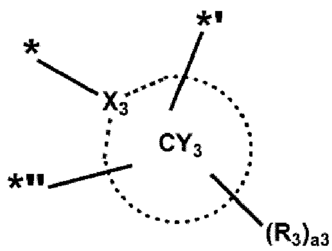

in Formula 1 may be a group represented by one selected from Formulae CY3(1) to CY3(20), and a group represented by

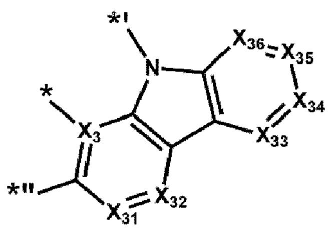

in Formulae 1-1 and 1-2 may be a group represented by one selected from Formulae CY3(1) to CY3(12):

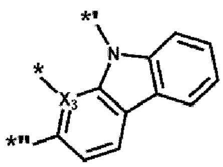
CY3(1)

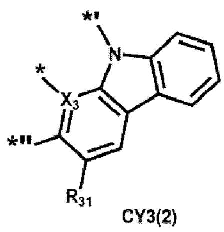
CY3(2)

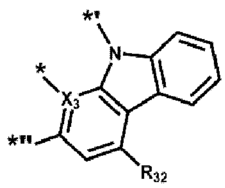
CY3(3)

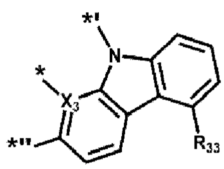
CY3(4)

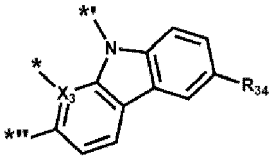
CY3(5)

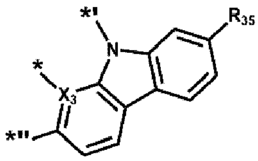
CY3(6)

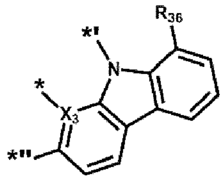
CY3(7)

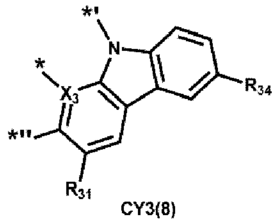
CY3(8)

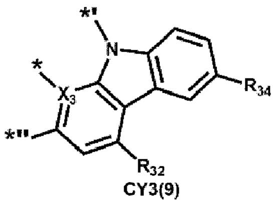
CY3(9)

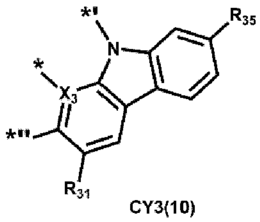
CY3(10)

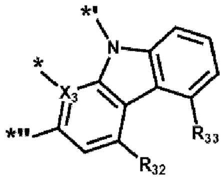
CY3(11)

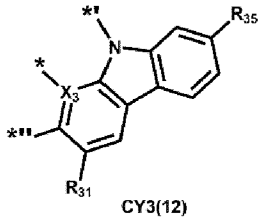
CY3(12)

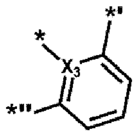
CY3(13)

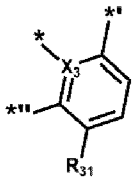
CY3(14)

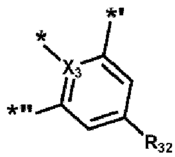
CY3(15)

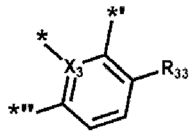
CY3(16)

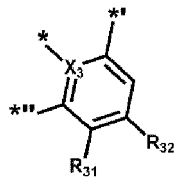
CY3(17)

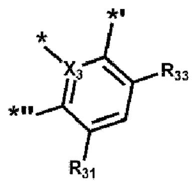
CY3(18)

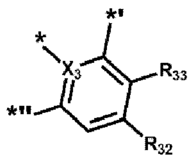
CY3(19)

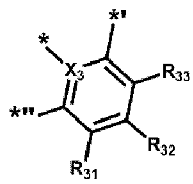
CY3(20)

wherein, in Formulae CY3(1) to CY3(20),
$X_3$ is the same as described in the present specification,
$R_{31}$ to $R_{36}$ are respectively the same as described in connection with $R_3$ in the present specification, wherein $R_{31}$ to $R_{36}$ may each not be hydrogen,
* indicates a binding site to M in Formula 1,
*' indicates a binding site to $X_{52}$ in Formula 1, and
*" indicates a binding site to $X_{51}$ in Formula 1.

In an embodiment, a group represented by

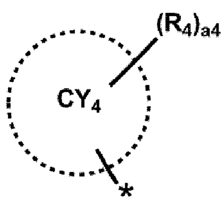

in Formula 1 and a group represented by

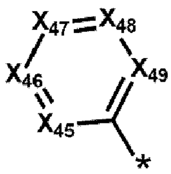

in Formulae 1-1 and 1-2 may each independently be a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof.

An absolute value (ΔCS) of a difference between a chemical shift value of $R_{44}$ and a chemical shift value of $R_{41}$ of the organometallic compound, as measured by proton nuclear magnetic resonance (NMR) spectroscopy, may be in a range of about 480 Hz to about 600 Hz (for example, about 500 Hz to about 600 Hz or about 510 Hz to about 600 Hz). Therefore, a maximum emission wavelength (or an emission peak wavelength) of the organometallic compound may be relatively decreased (e.g., a maximum emission wavelength may be blue-shifted). Examples of ΔCS are shown in Tables 8 and 9 in the present specification.

According to one or more embodiments, the organometallic compound includes:

platinum (Pt); and
a tetradentate ligand,
wherein the tetradentate ligand includes:
a pyridine group; and
a carbazole group or an azacarbazole group,
N in the pyridine group is bonded to the platinum,
N in the carbazole group or the azacarbazole group is bonded to a carbon in the 2-position of the pyridine group,
a carbon in the 3-position and a carbon in the 6-position of the pyridine group are each bonded to hydrogen or deuterium,
a substituent bonded to a carbon in the 4-position of the pyridine group is neither hydrogen nor deuterium,
a substituent bonded to a carbon in the 5-position of the pyridine group is a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof, and
an absolute value (ΔCS) of a difference between a chemical shift value of hydrogen or deuterium bonded to the carbon in the 6-position of the pyridine group and a chemical shift value of hydrogen or deuterium bonded to the carbon in the 3-position of the pyridine group of the organometallic compound, as measured by proton nuclear magnetic resonance (NMR) spectroscopy, is in a range of about 480 Hz to about 600 Hz (for example, about 500 Hz to about 600 Hz or about 510 Hz to about 600 Hz). Examples of ΔCS are shown in Table 8 in the present specification.

In an embodiment, the substituent bonded to the carbon in the 4-position of the pyridine group may be a $C_1$-$C_{20}$ alkyl group unsubstituted or substituted with deuterium, -F, a cyano group, or any combination thereof.

In an embodiment, the tetradentate ligand may further include a carbene-containing cyclic group (for example, an imidazole group, a triazole group, a benzimidazole group, or an imidazopyridine group) having 3 to 60 carbon atoms, and C of carbene in the carbene-containing cyclic group having 3 to 60 carbon atoms is bonded to the platinum.

The carbene-containing cyclic group having 3 to 60 carbon atoms may be substituted with a bulky cyclic group having 3 to 60 carbon atoms.

The bulky cyclic group having 3 to 60 carbon atoms may include three or more phenyl groups linked to each other via a single bond.

In an embodiment, the bulky cyclic group having 3 to 60 carbon atoms may be a group represented by Formula CY1(A) described in the present specification.

The organometallic compound represented by Formula 1 may include i) ring CY4, ii) R42 may not be hydrogen, and iii) $R_{41}$ and $R_{44}$ may each independently be hydrogen or deuterium (see Formula 1), thereby inducing an increase in electron density localization between $R_{41}$ and $R_{44}$ in Formula 1. In an embodiment, in the tetradentate ligand of the organometallic compound including the platinum and the tetradentate ligand, i) the substituent bonded to the carbon in the 5-position of the pyridine group may be a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl

group, a ($C_1$-$C_{20}$ alkyl)phenyl group, or any combination thereof, ii) the substituent bonded to the carbon in the 4-position of the pyridine group may neither be hydrogen nor deuterium, and iii) the carbon in the 3-position and the carbon in the 6-position of the pyridine group may each be bonded to hydrogen or deuterium, and thus the organometallic compound including the platinum and the tetradentate ligand may have increased electron density localization between hydrogen or deuterium bonded to the carbon in the 6-position of the pyridine group and hydrogen or deuterium bonded to the carbon in the 3-position of the pyridine group in the tetradentate ligand.

Therefore, the maximum emission wavelength, emission FWHM, and dipole moment of light emitted from the organometallic compound may be relatively decreased, color purity may be improved, and a radiative decay rate (Kr) may be increased. Also, the steric shielding effect (SSE) of the organometallic compound may be improved to substantially suppress or reduce excimer formation and/or exciplex formation with a host material in a light-emitting device including the organometallic compound, and thus, the internal quantum efficiency of the light-emitting device may be improved.

Furthermore, the organometallic compound may have a relatively large TSM(migration) energy (kcal/mol). In an embodiment, a TSM(migration) energy of the organometallic compound may be in a range of about 28 kcal/mol or more, about 28 kcal/mol to about 40 kcal/mol, about 28 kcal/mol to about 35 kcal/mol, or about 28 kcal/mol to about 32 kcal/mol. The $TS_{M(migration)}$ energy may be energy for ligand migration, which is an intermediate process of degradation between a metal and a ligand in the transition state of the organometallic compound, and may be an energy barrier for ligand migration. In an embodiment, the $TS_{M(migration)}$ energy may be calculated by using a density functional theory (DFT) method based on a lowest excitation triplet ($T_1$) energy of the organometallic compound (for example, see Evaluation Example 4 and Table 6). As described above, the organometallic compound has a relatively large $TS_{M(migration)}$ energy, and thus, material stability may be improved by minimizing or reducing intrinsic degradation during an energy transition process in the organometallic compound. Therefore, an electronic device, for example, a light-emitting device, including the organometallic compound may have excellent luminescence efficiency and/or lifespan.

b51 to b53 in Formula 2 indicate numbers of $L_{51}$ to $L_{53}$, respectively, and may each be an integer selected from 1 to 5. When b51 is 2 or more, two or more of $L_{51}$(s) may be identical to or different from each other, when b52 is 2 or more, two or more of $L_{52}$(s) may be identical to or different from each other, and when b53 is 2 or more, two or more of $L_{53}$(s) may be identical to or different from each other. In an embodiment, b51 to b53 may each independently be 1 or 2.

$L_{51}$ to $L_{53}$ in Formula 2 may each independently be:

a single bond; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxacilline group, a dibenzothiacilline group, a dibenzodihydroazacilline group, a dibenzodihydrodicilline group, a dibenzodihydrocilline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, $-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, or any combination thereof,

wherein $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 2, a bond between $L_{51}$ and $R_{51}$, a bond between $L_{52}$ and $R_{52}$, a bond between $L_{53}$ and $R_{53}$, a bond between two or more $L_{51}$(s), a bond between two or more $L_{52}$(s), a bond between two or more $L_{53}$(s), a bond between $L_{51}$ and carbon between $X_{54}$ and $X_{55}$ in Formula 2, a bond between $L_{52}$ and carbon between $X_{54}$ and $X_{56}$ in Formula 2, and a bond between $L_{53}$ and carbon between $X_{55}$ and $X_{56}$ in Formula 2 may each be a "carbon-carbon single bond".

In Formula 2, $X_{54}$ may be N or C($R_{54}$), $X_{55}$ may be N or C($R_{55}$), $X_{56}$ may be N or C(R56), and at least one selected from $X_{54}$ to $X_{56}$ may be N. $R_{54}$ to $R_{56}$ are respectively the same as described in the present specification. In an embodiment, two or three of $X_{54}$ to $X_{56}$ may be N.

$R_{51}$ to $R_{56}$, $R_{71}$ to $R_{74}$, $R_{81}$ to $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in the present specification may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$). $Q_1$ to $Q_3$ are respectively the same as described in the present specification.

In an embodiment, i) $R_1$ to $R_4$, $R_{42}$, $R_{51a}$, $R_{51b}$, $R_{52a}$, $R_{52b}$, and $T_1$ in Formula 1 , ii) $R_{51}$ to $R_{56}$, $R_{71}$ to $R_{74}$, $R_{81}$ to $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iii) $R_{10a}$ may each independently be:

hydrogen, deuterium, -F, -Cl, -Br, -I, a hydroxyl group, a cyano group, a nitro group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -$CD_3$, - $CD_2H$, -$CDH_2$, -$CF_3$, -$CF_2H$, -$CFH_2$, a hydroxyl group, a cyano group, a nitro group, a C1-C20 alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O($Q_{31}$), -S($Q_{31}$), -Si($Q_{31}$)($Q_{32}$)($Q_{33}$), -N($Q_{31}$)($Q_{32}$), -B($Q_{31}$)($Q_{32}$), -P($Q_{31}$)($Q_{32}$), - C(=O)($Q_{31}$), -S(=O)$_2$($Q_{31}$), or any combination thereof; or

-C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), - S(=O)$_2$($Q_1$), or -P(=O)($Q_1$)($Q_2$), and

$Q_1$ to $Q_3$ and $Q_{31}$ to $Q_{33}$ may each independently be:

-CH3, -$CD_3$, -$CD_2H$, -$CDH_2$, -$CH_2CH_3$, -$CH_2CD_3$, -$CH_2CD_2H$, -$CH_2CDH_2$, - $CHDCH_3$, -$CHDCD_2H$, -$CHDCDH_2$, -$CHDCD_3$, -$CD_2CD_3$, -$CD_2CD_2H$, or -$CD_2CDH_2$; or

an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof:

Formula 91

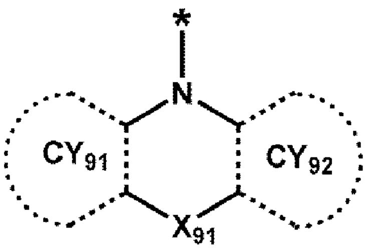

wherein, in Formula 91,

ring $CY_{91}$ and ring $CY_{92}$ may each independently be a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$X_{91}$ may be a single bond, O, S, $N(R_{91})$, $B(R_{91})$, $C(R_{91a})(R_{91b})$, or $Si(R_{91a})(R_{91b})$,

$R_{91}$, $R_{91a}$, and $R_{91b}$ may respectively be understood by referring to the descriptions of $R_{82}$, $R_{82a}$, and $R_{82b}$ provided herein,

$R_{10a}$ may be the same as described in the present specification, provided that $R_{10a}$ is not hydrogen, and

* indicates a binding site to an adjacent atom.

In an embodiment, in Formula 91,

ring $CY_{91}$ and ring $CY_{92}$ may each independently be a benzene group, a pyridine group, a pyrimidine group, a pyrazine group, a pyridazine group, or a triazine group, each unsubstituted or substituted with at least one $R_{10a}$, and $R_{91}$, $R_{91a}$, and $R_{91b}$ may each independently be:

hydrogen or a $C_1$-$C_{10}$ alkyl group; or

a phenyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof.

In an embodiment, i) $R_1$ to $R_4$, $R_{42}$, $R_{51a}$, $R_{51b}$, $R_{52a}$, $R_{52b}$, and $T_1$ in Formula 1 ii) $R_{51}$ to $R_{56}$, $R_{71}$ to $R_{74}$, $R_{81}$ to $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iii) $R_{10a}$ may each independently be hydrogen, deuterium, -F, a cyano group, a nitro group, $-CH_3$, $-CD_3$, $-CD_2H$, $-CDH_2$, $-CF_3$, $-CF_2H$, $-CFH_2$, a group represented by one selected from Formulae 9-1 to 9-19 below, a group represented by one selected from Formulae 10-1 to 10-246, $-C(Q_1)(Q_2)(Q_3)$, $-Si(Q_1)(Q_2)(Q_3)$, or - $P(=O)(Q_1)(Q_2)$ (wherein $Q_1$ to $Q_3$ are respectively the same as those described above):

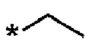
9-1

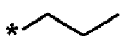
9-2

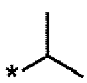
9-3

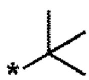
9-4

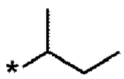
9-5

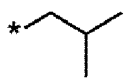
9-6

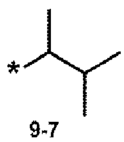
9-7

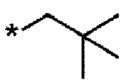
9-8

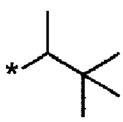
9-9

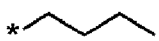
9-10

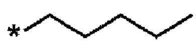
9-11

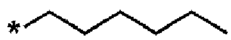
9-12

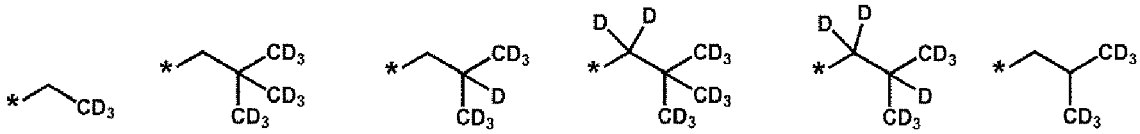
9-13 9-14 9-15 9-16 9-17 9-18

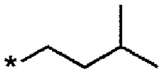
9-19

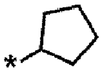
10-1

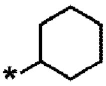
10-2

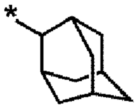
10-3

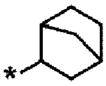
10-4

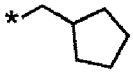
10-5

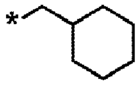
10-6

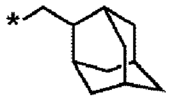
10-7

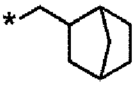
10-8

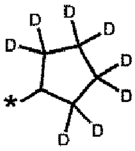
10-9

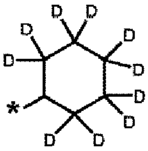
10-10

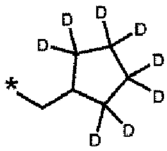
10-11

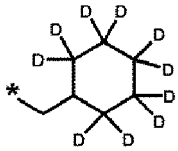
10-12

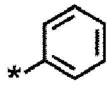
10-13

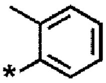
10-14

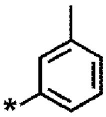
10-15

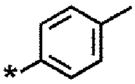
10-16

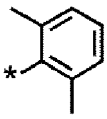
10-17

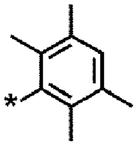
10-18

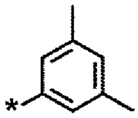
10-19

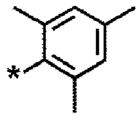
10-20

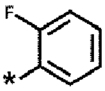
10-21

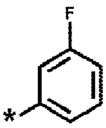
10-22

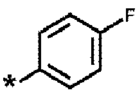
10-23

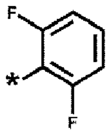
10-24

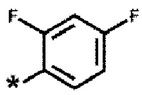
10-25

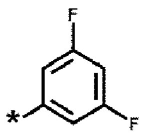
10-26

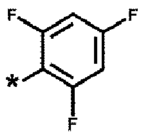
10-27

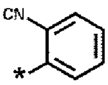
10-28

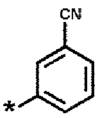
10-29

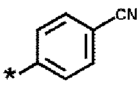
10-30

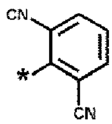
10-31

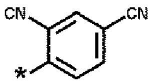
10-32

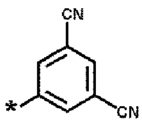
10-33

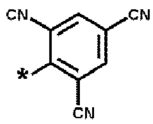
10-34

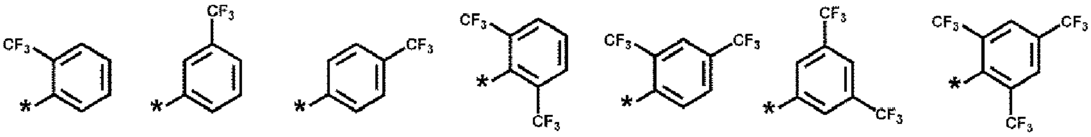
10-35 10-36 10-37 10-38 10-39 10-40 10-41

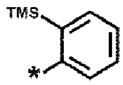
10-42
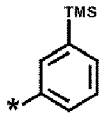
10-43
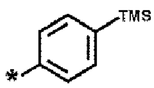
10-44
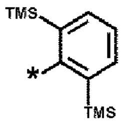
10-45
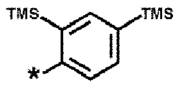
10-46
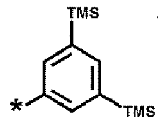
10-47
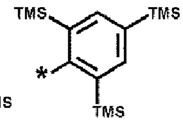
10-48

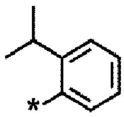
10-49
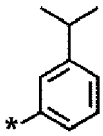
10-50
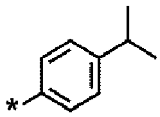
10-51
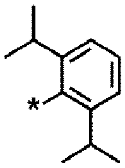
10-52
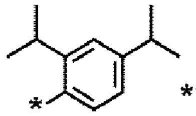
10-53
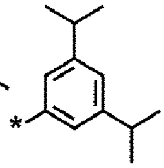
10-54
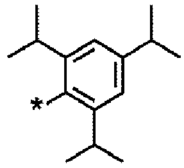
10-55

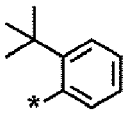
10-56
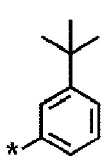
10-57
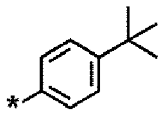
10-58
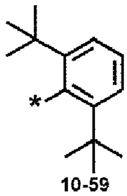
10-59
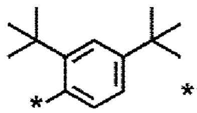
10-60
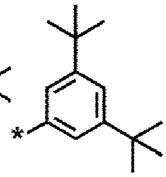
10-61
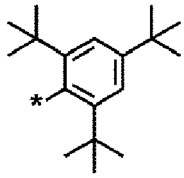
10-62

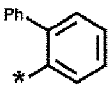
10-63
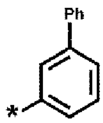
10-64
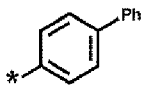
10-65
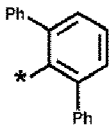
10-66
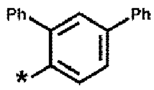
10-67
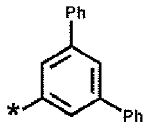
10-68
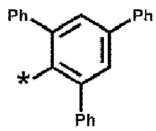
10-69

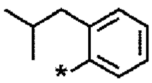
10-70
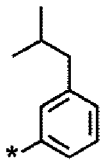
10-71
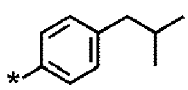
10-72
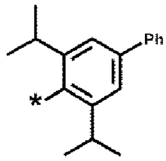
10-73
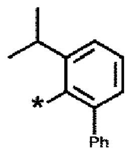
10-74
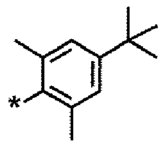
10-75

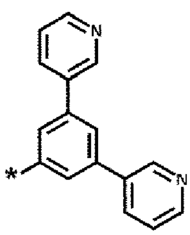
10-76
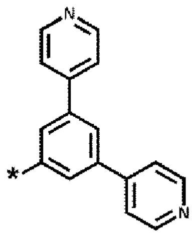
10-77
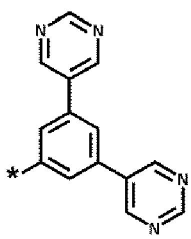
10-78
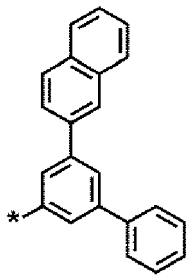
10-79
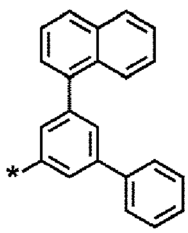
10-80

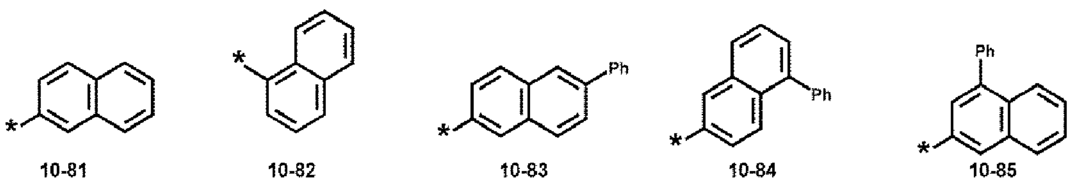
10-81
10-82
10-83
10-84
10-85

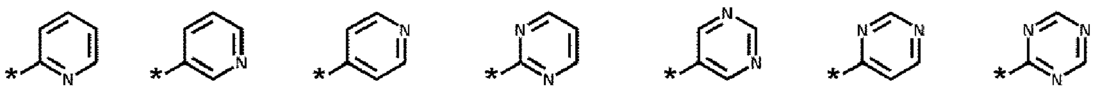

10-86 10-87 10-88 10-89 10-90 10-91 10-92

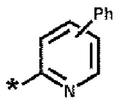 10-93
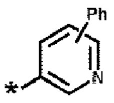 10-94
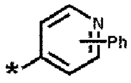 10-95
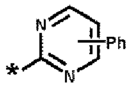 10-96
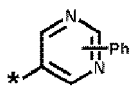 10-97
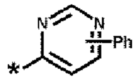 10-98
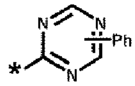 10-99

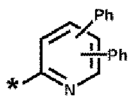 10-100
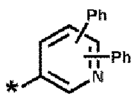 10-101
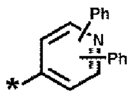 10-102
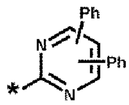 10-103
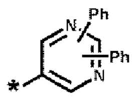 10-104
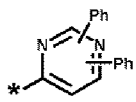 10-105
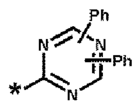 10-106

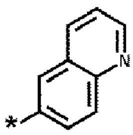 10-107
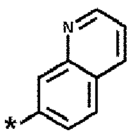 10-108
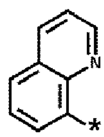 10-109
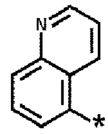 10-110
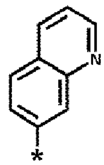 10-111
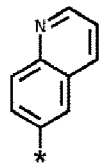 10-112

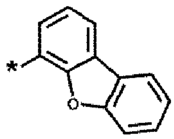 10-113
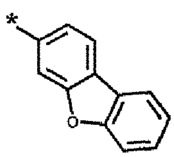 10-114
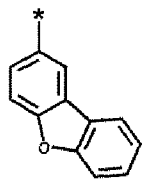 10-115
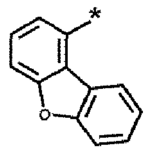 10-116
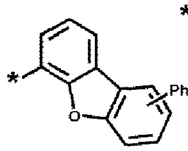 10-117
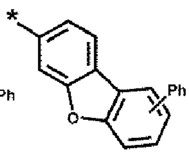 10-118

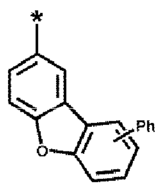 10-119
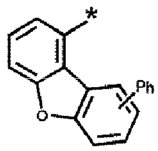 10-120
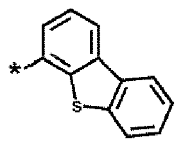 10-121
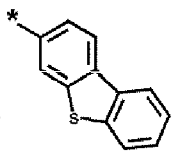 10-122
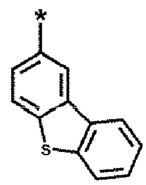 10-123
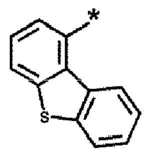 10-124

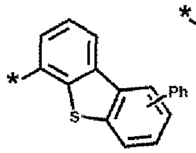 10-125
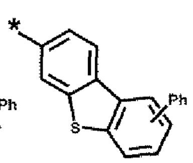 10-126
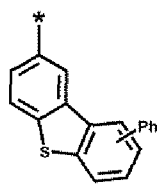 10-127
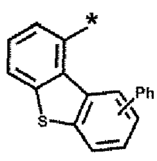 10-128
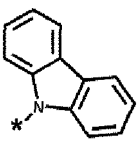 10-129
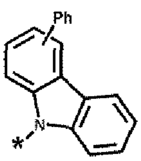 10-130

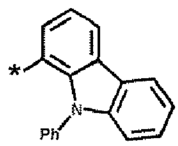
10-131

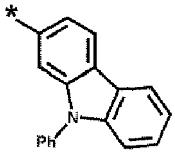
10-132

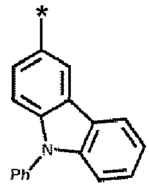
10-133

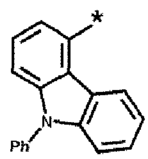
10-134

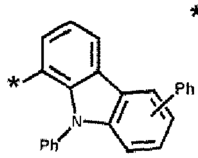
10-135

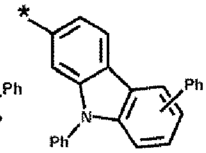
10-136

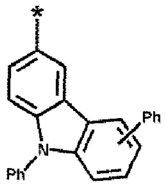
10-137

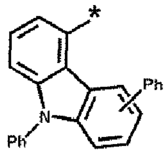
10-138

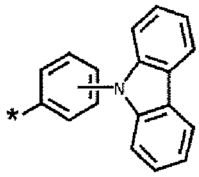
10-139

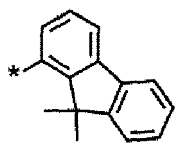
10-140

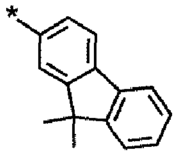
10-141

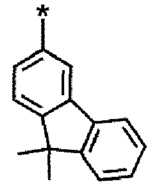
10-142

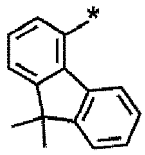
10-143

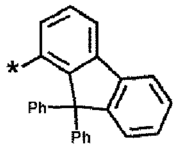
10-144

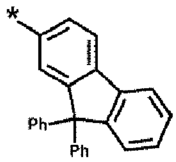
10-145

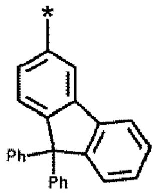
10-146

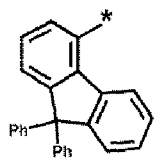
10-147

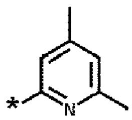
10-148

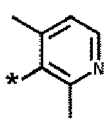
10-149

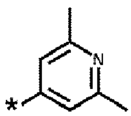
10-150

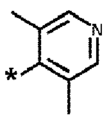
10-151

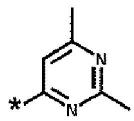
10-152

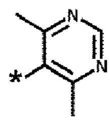
10-153

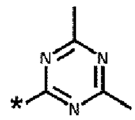
10-154

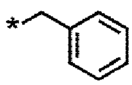
10-155

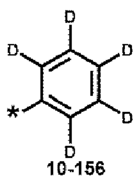
10-156

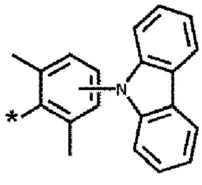
10-157

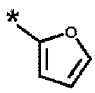
10-158

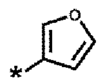
10-159

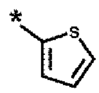
10-160

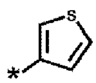
10-161

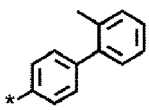
10-162

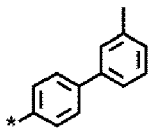
10-163

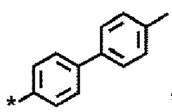
10-164

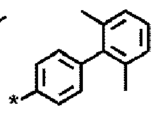
10-165

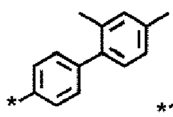
10-166

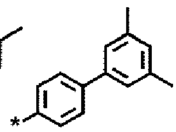
10-167

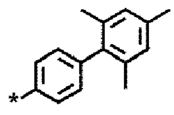
10-168

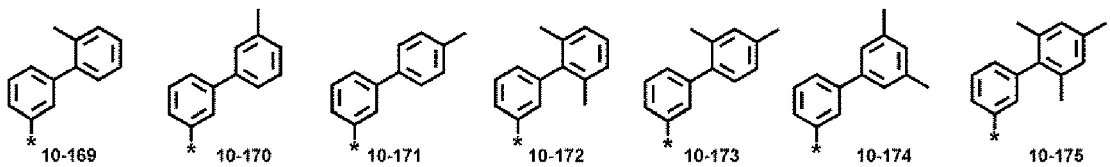
10-169 10-170 10-171 10-172 10-173 10-174 10-175

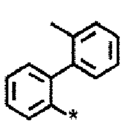
10-176
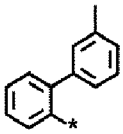
10-177
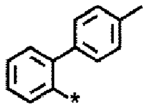
10-178
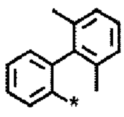
10-179
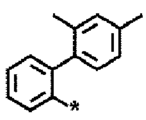
10-180
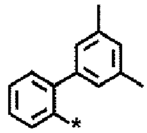
10-181
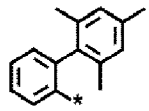
10-182

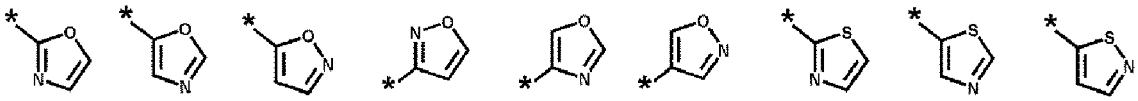
10-183 10-184 10-185 10-186 10-187 10-188 10-189 10-190 10-191

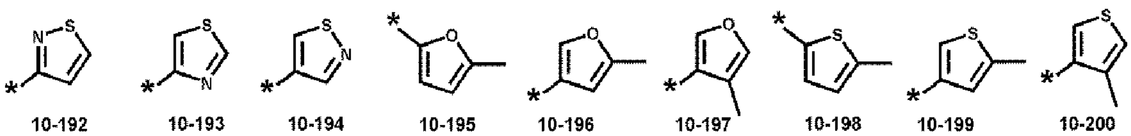
10-192 10-193 10-194 10-195 10-196 10-197 10-198 10-199 10-200

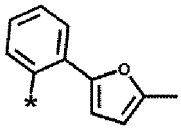
10-201
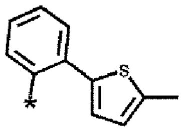
10-202
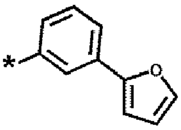
10-203
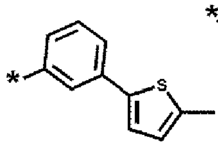
10-204
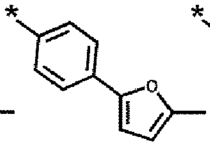
10-205
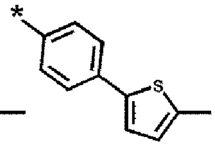
10-206

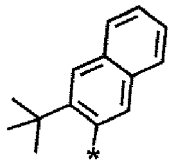
10-207
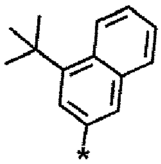
10-208
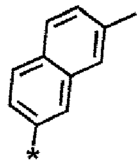
10-209
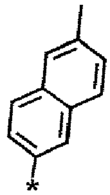
10-210
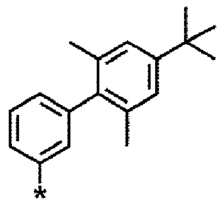
10-211
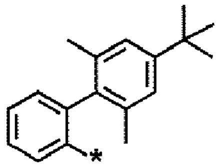
10-212

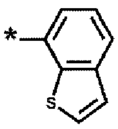
10-213
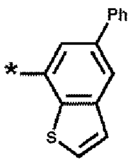
10-214
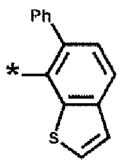
10-215
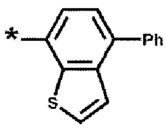
10-216
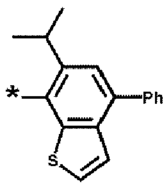
10-217
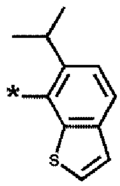
10-218
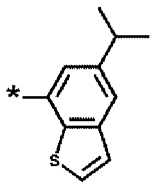
10-219

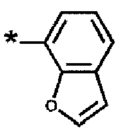
10-220
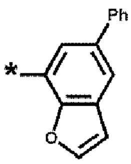
10-221
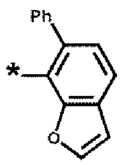
10-222
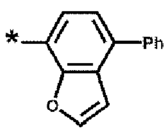
10-223
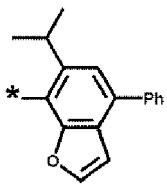
10-224
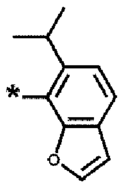
10-225
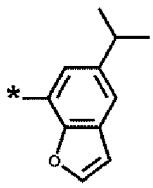
10-226

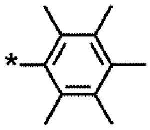
10-227

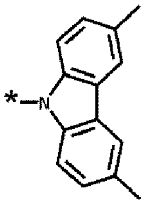
10-228

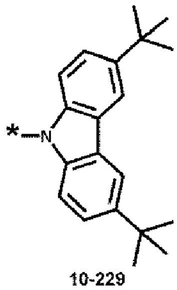
10-229

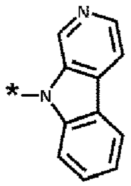
10-230

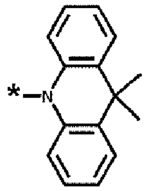
10-231

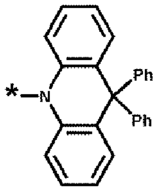
10-232

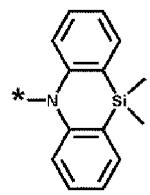
10-233

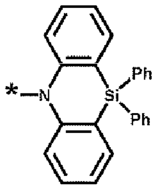
10-234

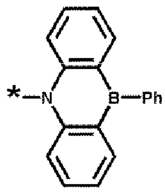
10-235

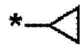
10-236

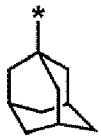
10-237

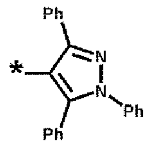
10-238

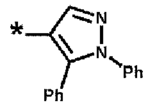
10-239

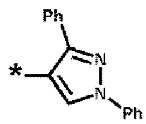
10-240

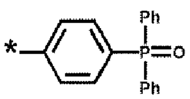
10-241

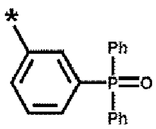
10-242

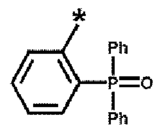
10-243

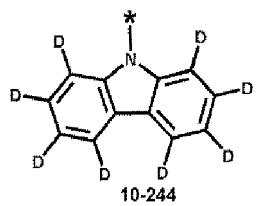
10-244

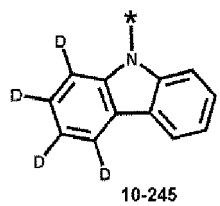
10-245

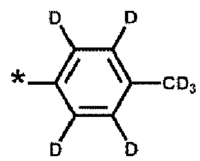
10-246

wherein, in Formulae 9-1 to 9-19 and 10-1 to 10-246, * indicates a binding site to an adjacent atom, "Ph" represents a phenyl group, and "TMS" represents a trimethylsilyl group.

In Formulae 3-1 to 3-5, 502, and 503, a71 to a74 and a501 to a504 may respectively indicate the number of $R_{71}$(s) to $R_{74}$(s) and $R_{501}$(s) to $R_{504}$(s), and a71 to a74 and a501 to a504 may each independently be an integer selected from 0 to 20. When a71 is 2 or greater, at least two $R_{71}$(s) may be identical to or different from each other, when a72 is 2 or greater, at least two $R_{72}$(s) may be identical to or different from each other, when a73 is 2 or greater, at least two $R_{73}$(s) may be identical to or different from each other, when a74 is 2 or greater, at least two $R_{74}$(s) may be identical to or different from each other, when a501 is 2 or greater, at least two $R_{501}$(s) may be identical to or different from each other, when a502 is 2 or greater, at least two $R_{502}$(s) may be identical to or different from each other, when a503 is 2 or greater, at least two $R_{503}$(s) may be identical to or different from each other, and when a504 is 2 or greater, at least two $R_{504}$(s) may be identical to or different from each other. a71 to a74 and a501 to a504 may each independently be an integer selected from 0 to 8.

In Formula 1, i) two or more of $R_1$(s) in the number of a1 may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, ii) two or more of $R_2$(s) in the number of a2 may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iii) two or more of $R_3$(s) in the number of a3 may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iv) two or more of $R_4$(s) in the number of a4 may optionally be bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and v) two or more of $R_1$ to $R_4$, $R_{51a}$, $R_{51b}$, $R_{52a}$, and $R_{52b}$ may optionally bonded together to form a $C_3$-$C_{60}$ carbocyclic group unsubstituted or substituted with at least one $R_{10a}$

or a $C_1$-$C_{60}$ heterocyclic group unsubstituted or substituted with at least one Rioa.

In an embodiment, a group represented by *-$(L_{51})_{b51}$-$R_{51}$ and a group represented by *-$(L_{52})_{b52}$-$R_{52}$ in Formula 2 may each not be a phenyl group.

In an embodiment, a group represented by *-$(L_{51})_{b51}$-$R_{51}$ and a group represented by *-$(L_{52})_{b52}$-$R_{52}$ in Formula 2 may be identical to each other.

In an embodiment, a group represented by *-$(L_{51})_{b51}$-$R_{51}$ and a group represented by *-$(L_{52})_{b52}$-$R_{52}$ in Formula 2 may be different from each other.

In an embodiment, b51 and b52 in Formula 2 may each be 1, 2, or 3, and $L_{51}$ and $L_{52}$ may each independently be a benzene group, a pyridine group, a pyrimidine group, a pyridazine group, a pyrazine group, or a triazine group, each unsubstituted or substituted with at least one Rioa.

In an embodiment, $R_{51}$ and $R_{52}$ in Formula 2 may each independently be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), or -Si($Q_1$)($Q_2$)($Q_3$), and

wherein $Q_1$ to $Q_3$ may each independently be a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

In an embodiment,

a group represented by *-$(L_{51})_{b51}$-$R_{51}$ in Formula 2 may be a group represented by one selected from Formulae CY51-1 to CY51-26, and/or

a group represented by *-$(L_{52})_{b52}$-$R_{52}$ in Formula 2 may be a group represented by one selected from Formulae CY52-1 to CY52-26, and/or

a group represented by *-$(L_{53})_{b53}$-$R_{53}$ in Formula 2 may be a group represented by one selected from Formulae CY53-1 to CY53-27, -C($Q_1$)($Q_2$)($Q_3$), or - Si($Q_1$)($Q_2$)($Q_3$):

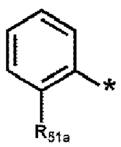
CY51-1

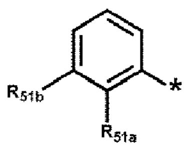
CY51-2

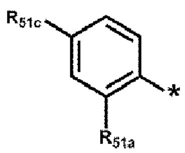
CY51-3

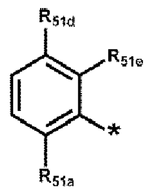
CY51-4

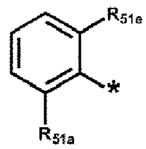
CY51-5

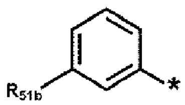
CY51-6

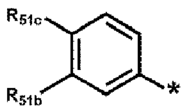
CY51-7

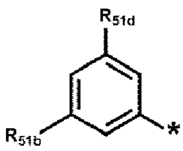
CY51-8

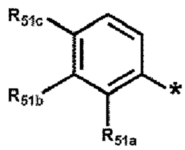
CY51-9

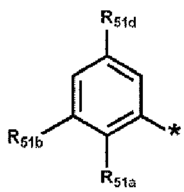
CY51-10

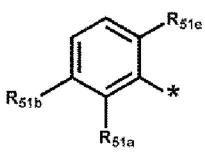
CY51-11

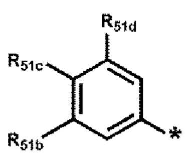
CY51-12

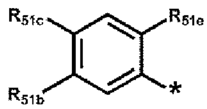
CY51-13

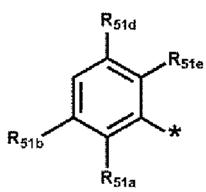
CY51-14

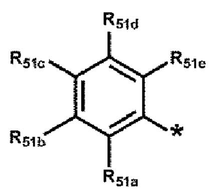
CY51-15

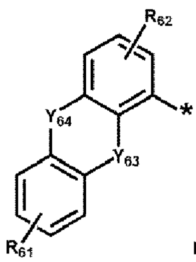
CY51-16
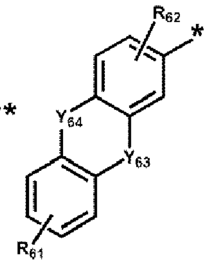
CY51-17
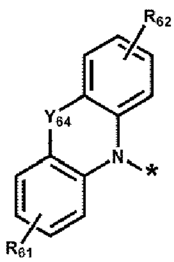
CY51-18
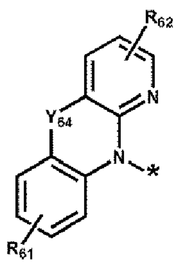
CY51-19
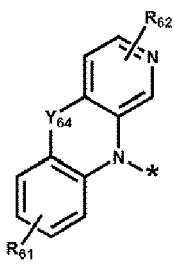
CY51-20
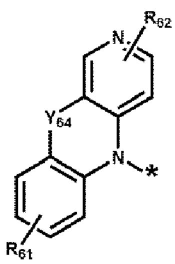
CY51-21

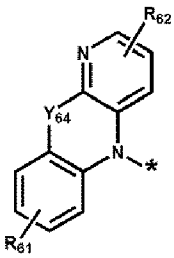
CY51-22
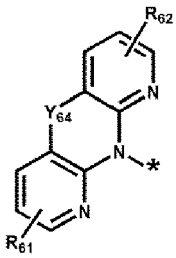
CY51-23
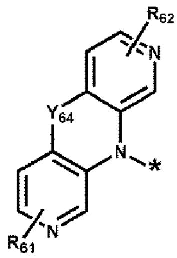
CY51-24
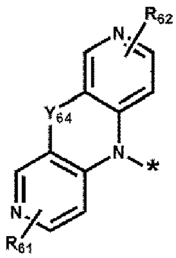
CY51-25
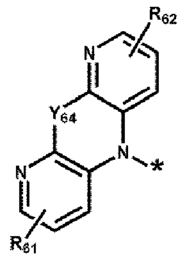
CY51-26

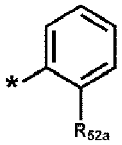
CY52-1
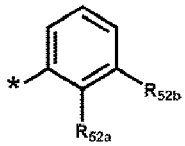
CY52-2
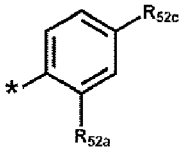
CY52-3
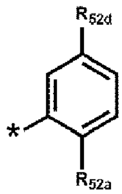
CY52-4
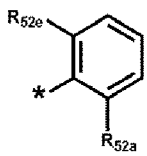
CY52-5

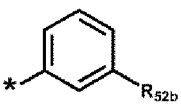
CY52-6
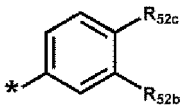
CY52-7
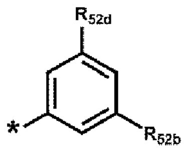
CY52-8
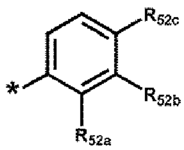
CY52-9
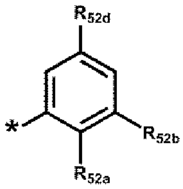
CY52-10

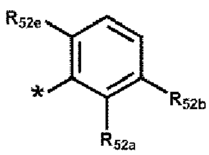
CY52-11
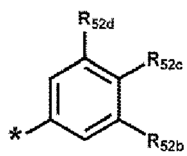
CY52-12
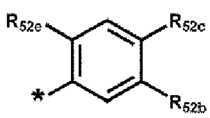
CY52-13
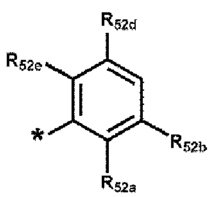
CY52-14
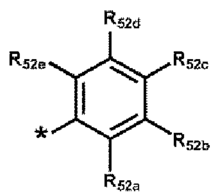
CY52-15

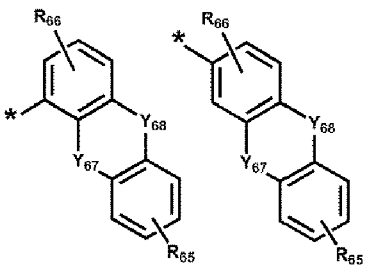
CY52-16 CY52-17
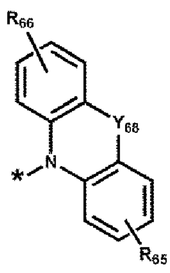
CY52-18
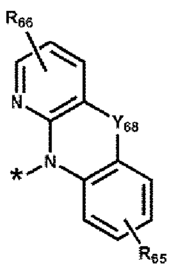
CY52-19
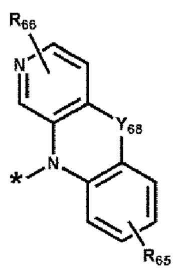
CY52-20
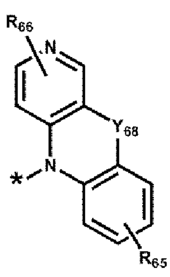
CY52-21

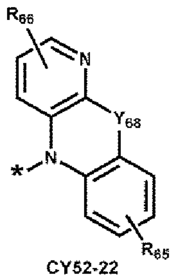
CY52-22

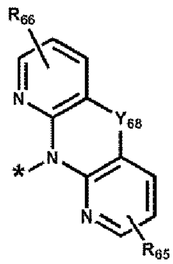
CY52-23

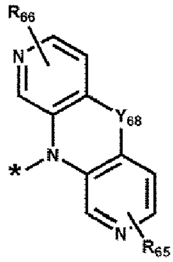
CY52-24

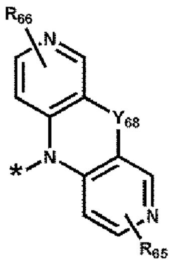
CY52-25

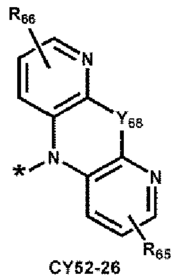
CY52-26

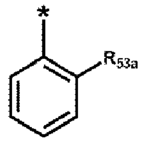
CY53-1

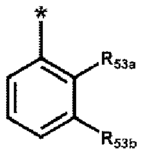
CY53-2

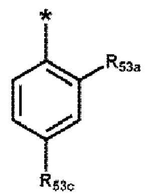
CY53-3

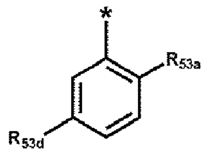
CY53-4

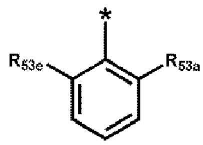
CY53-5

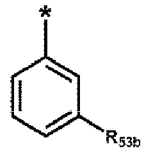
CY53-6

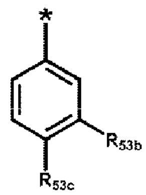
CY53-7

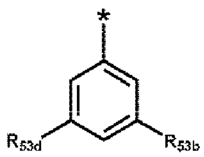
CY53-8

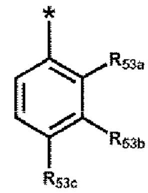
CY53-9

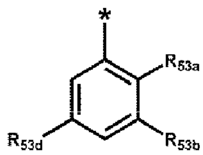
CY53-10

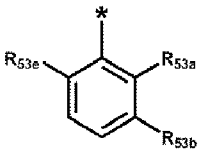
CY53-11

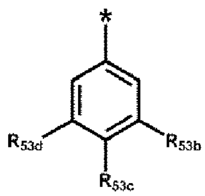
CY53-12

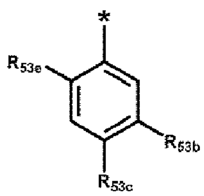
CY53-13

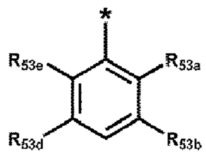
CY53-14

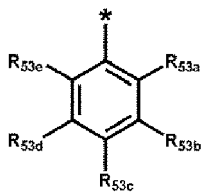
CY53-15

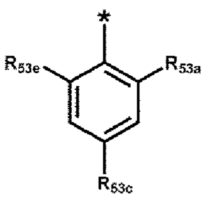
CY53-16

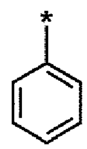
CY53-17

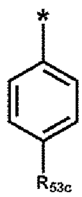
CY53-18

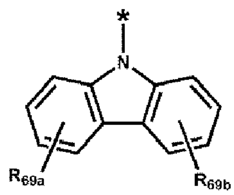
CY53-19

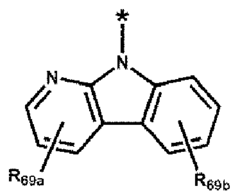
CY53-20

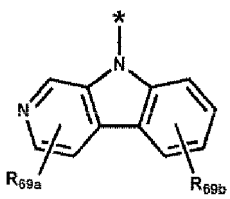
CY53-21

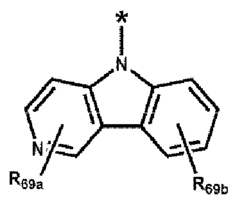
CY53-22

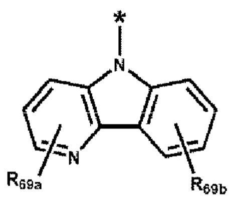
CY53-23

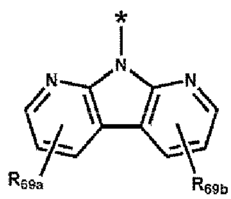
CY53-24

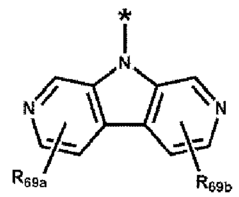

CY53-25

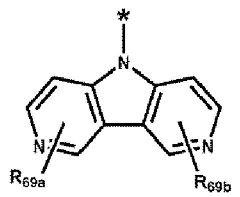

CY53-26

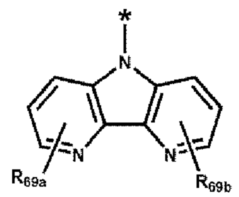

CY53-27

wherein, in Formulae CY51-1 to CY51-26, CY52-1 to CY52-26, and CY53-1 to CY53-27,
$Y_{63}$ may be a single bond, O, S, N($R_{63}$), B($R_{63}$), C($R_{63a}$)($R_{63b}$), or Si($R_{63a}$)($R_{63b}$),
$Y_{64}$ may be a single bond, O, S, N($R_{64}$), B($R_{64}$), C($R_{64a}$)($R_{64b}$), or Si($R_{64a}$)($R_{64b}$),
$Y_{67}$ may be a single bond, O, S, N($R_{67}$), B($R_{67}$), C($R_{67a}$)($R_{67b}$), or Si($R_{67a}$)($R_{67b}$),
$Y_{68}$ may be a single bond, O, S, N($R_{68}$), B($R_{68}$), C($R_{68a}$)($R_{68b}$), or Si($R_{68a}$)($R_{68b}$),
$Y_{63}$ and $Y_{64}$ in Formulae CY51-16 and CY51-17 may each not be a single bond,
$Y_{67}$ and $Y_{68}$ in Formulae CY52-16 and CY52-17 may each not be a single bond,
$R_{51a}$ to $R_{51e}$, $R_{61}$ to $R_{64}$, $R_{63a}$, $R_{63b}$, $R_{64a}$, and R64b are respectively the same as described in connection with $R_{51}$ in the present specification, and $R_{51a}$ to $R_{51e}$ may each not be hydrogen,
$R_{52a}$ to $R_{52e}$, $R_{65}$ to $R_{68}$, $R_{67a}$, R67b, $R_{68a}$, and R68b are respectively the same as described in connection with $R_{52}$ in the present specification, and $R_{52a}$ to $R_{52e}$ may each not be hydrogen,
$R_{53a}$ to $R_{53e}$, $R_{69a}$, and $R_{69b}$ are respectively the same as described in connection with $R_{53}$ in the present specification, and $R_{53a}$ to $R_{53e}$ may each not be hydrogen, and
* indicates a binding site to a neighboring atom.

In an embodiment,
$R_{51a}$ to $R_{51e}$ and $R_{52a}$ to $R_{52e}$ in Formulae CY51-1 to CY51-26 and Formulae CY52-1 to CY52-26 may each independently be:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, a C1-C20 alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C($Q_1$)($Q_2$)($Q_3$) or -Si($Q_1$)($Q_2$)($Q_3$),
$Q_1$ to $Q_3$ may each independently be a phenyl group, a naphthyl group, a pyridinyl group, a pyrimidinyl group, a pyridazinyl group, a pyrazinyl group, or a triazinyl group, each unsubstituted or substituted with deuterium, a $C_1$-$C_{10}$

alkyl group, a phenyl group, a biphenyl group, a pyridinyl group, a pyrimidinyl group, a pyridazinyl group, a pyrazinyl group, a triazinyl group, or any combination thereof,

in Formulae CY51-16 and CY51-17, i) $Y_{63}$ may be O or S and $Y_{64}$ may be $Si(R_{64a})(R_{64b})$, or ii) $Y_{63}$ may be $Si(R_{63a})(R_{63b})$ and $Y_{64}$ may be O or S, and

in Formulae CY52-16 and CY52-17, i) $Y_{67}$ may be O or S, and $Y_{68}$ may be $Si(R_{68a})(R_{68b})$, or ii) $Y_{67}$ may be $Si(R_{67a})(R_{67b})$, and $Y_{68}$ may be O or S.

In an embodiment, $L_{81}$ to $L_{85}$ in Formulae 3-1 to 3-5 may each independently be:

a single bond; or

*-C($Q_4$)($Q_5$)-*' or *-Si($Q_4$)($Q_5$)-*'; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O($Q_{31}$), -S($Q_{31}$), - Si($Q_{31}$)($Q_{32}$)($Q_{33}$), -N($Q_{31}$)($Q_{32}$), -B($Q_{31}$)($Q_{32}$), -P(Q31)(Q32), -C(=O)($Q_{31}$), -S(=O)$_2$($Q_{31}$), - P(=O)($Q_{31}$)($Q_{32}$), or any combination thereof,

wherein $Q_4$, $Q_5$, and $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In an embodiment, a group represented by

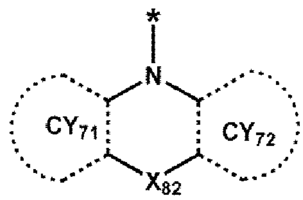

in Formulae 3-1 and 3-2 may be a group represented by one selected from Formulae CY71-1(1) to CY71-1(8),

a group represented by

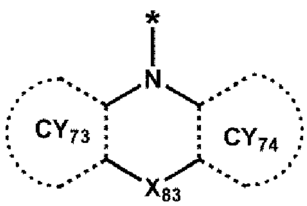

in Formulae 3-1 and 3-3 may be a group represented by one selected from Formulae CY71-2(1) to CY71-2(8),

a group represented by

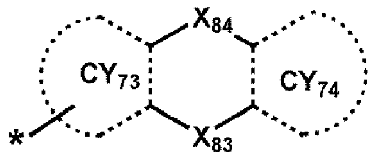

in Formulae 3-2 and 3-4 may be a group represented by one selected from Formulae CY71-3(1) to CY71-3(32), a group represented by

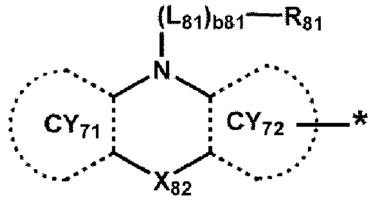

in Formulae 3-3 to 3-5 may be a group represented by one selected from Formulae CY71-4(1) to CY71-4(32), and/or a group represented by

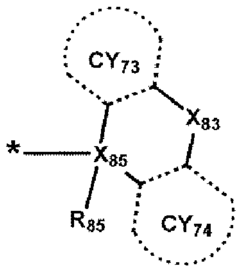

in Formula 3-5 may be a group represented by one selected from Formulae CY71-5(1) to CY71-5(8):

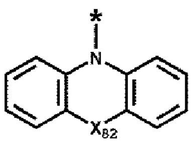

CY71-1(1)

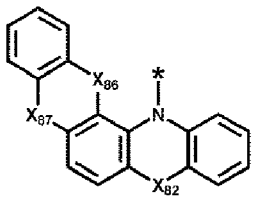

CY71-1(2)

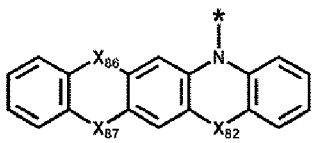

CY71-1(3)

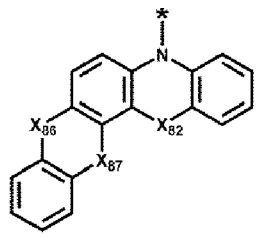

CY71-1(4)

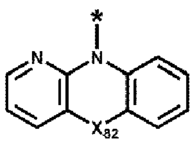

CY71-1(5)

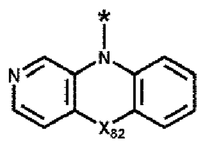

CY71-1(6)

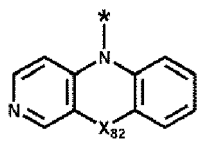

CY71-1(7)

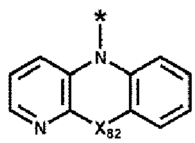

CY71-1(8)

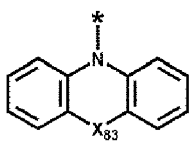

CY71-2(1)

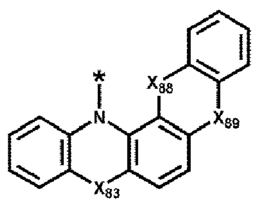

CY71-2(2)

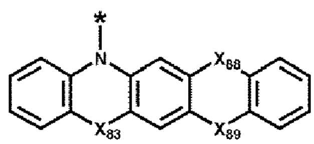

CY71-2(3)

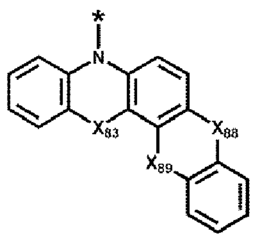

CY71-2(4)

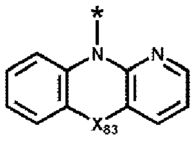
CY71-2(5)

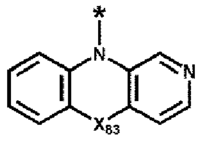
CY71-2(6)

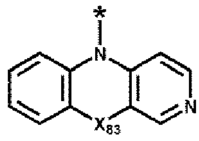
CY71-2(7)

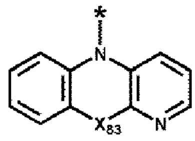
CY71-2(8)

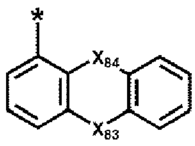
CY71-3(1)

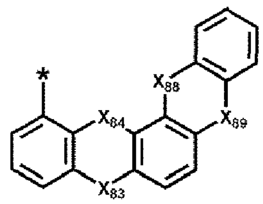
CY71-3(2)

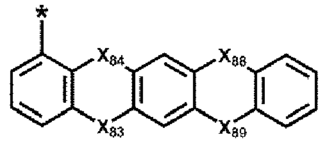
CY71-3(3)

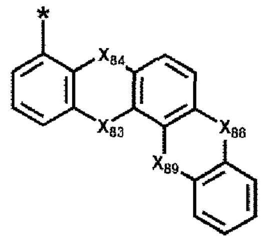
CY71-3(4)

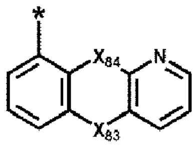
CY71-3(5)

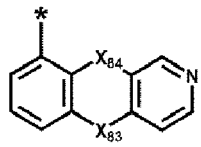
CY71-3(6)

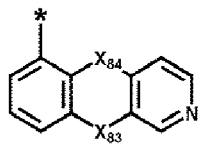
CY71-3(7)

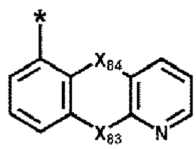
CY71-3(8)

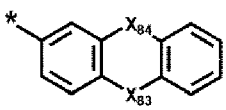
CY71-3(9)

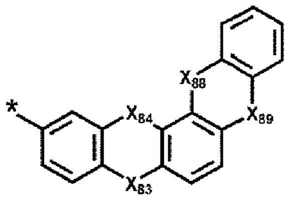
CY71-3(10)

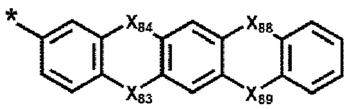
CY71-3(11)

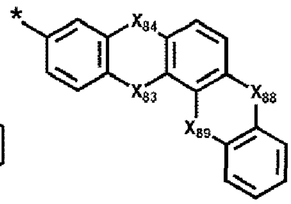
CY71-3(12)

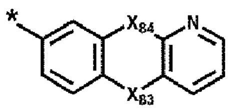
CY71-3(13)

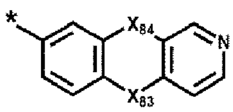
CY71-3(14)

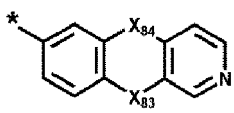
CY71-3(15)

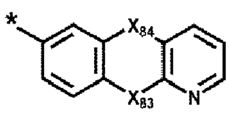
CY71-3(16)

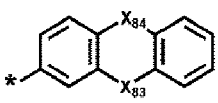
CY71-3(17)

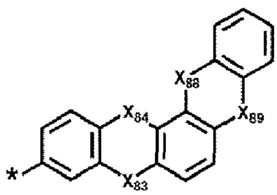
CY71-3(18)

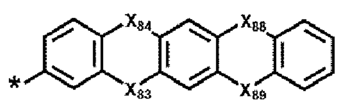
CY71-3(19)

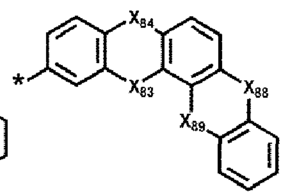
CY71-3(20)

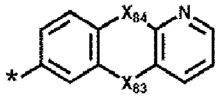
CY71-3(21)

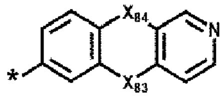
CY71-3(22)

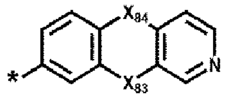
CY71-3(23)

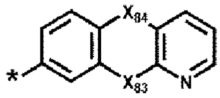
CY71-3(24)

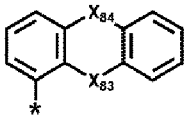
CY71-3(25)

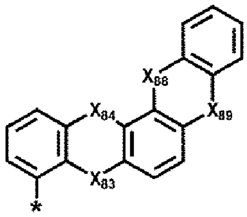
CY71-3(26)

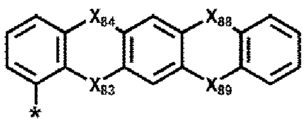
CY71-3(27)

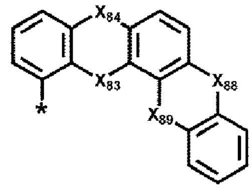
CY71-3(28)

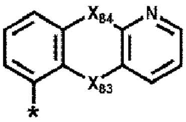
CY71-3(29)

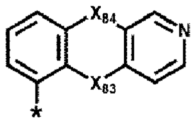
CY71-3(30)

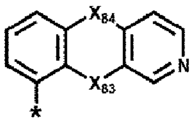
CY71-3(31)

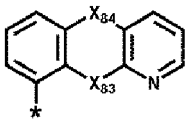
CY71-3(32)

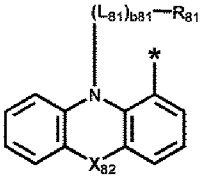
CY71-4(1)

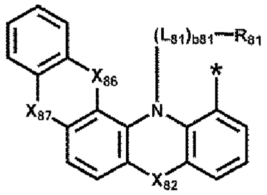
CY71-4(2)

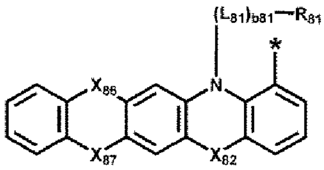
CY71-4(3)

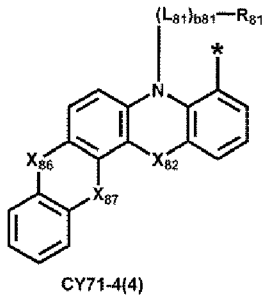
CY71-4(4)

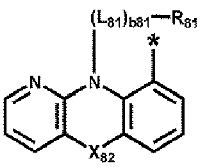
CY71-4(5)

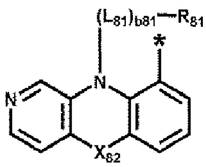
CY71-4(6)

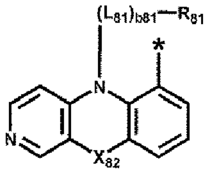
CY71-4(7)

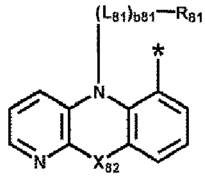
CY71-4(8)

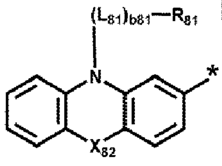
CY71-4(9)

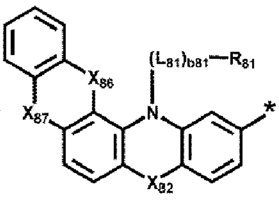
CY71-4(10)

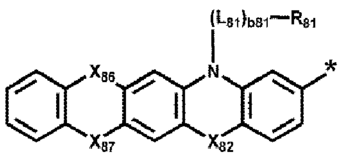
CY71-4(11)

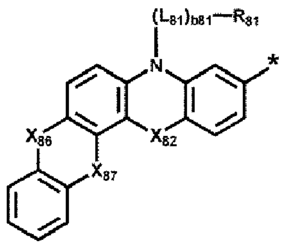
CY71-4(12)

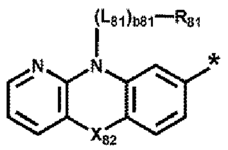
CY71-4(13)

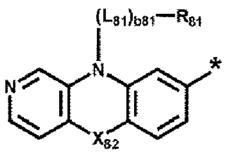
CY71-4(14)

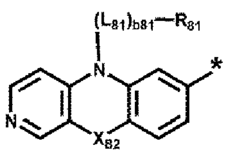
CY71-4(15)

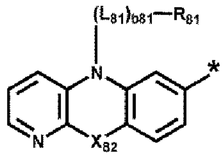
CY71-4(16)

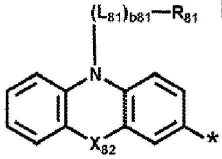
CY71-4(17)

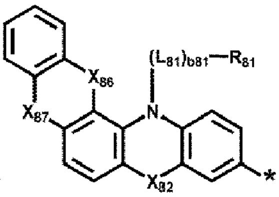
CY71-4(18)

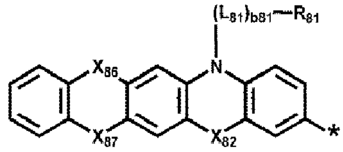
CY71-4(19)

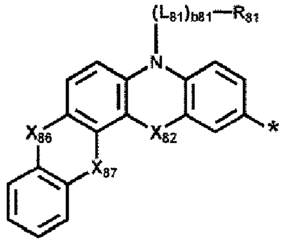
CY71-4(20)

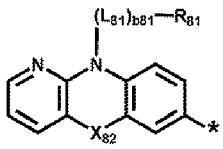
CY71-4(21)

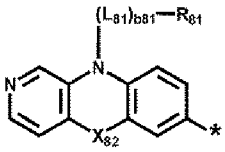
CY71-4(22)

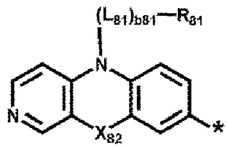
CY71-4(23)

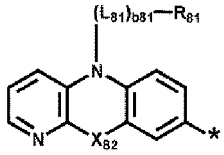
CY71-4(24)

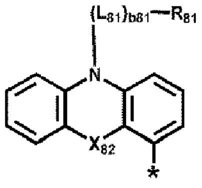
CY71-4(25)

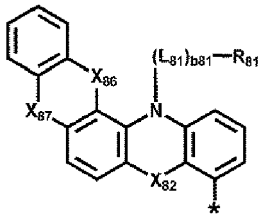
CY71-4(26)

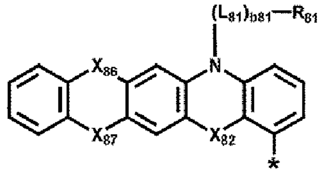
CY71-4(27)

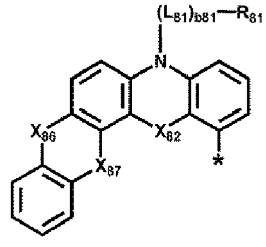
CY71-4(28)

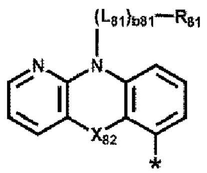
CY71-4(29)

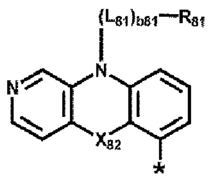
CY71-4(30)

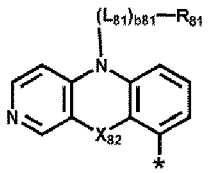
CY71-4(31)

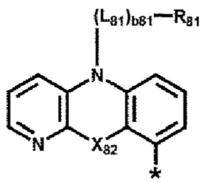
CY71-4(32)

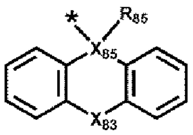
CY71-5(1)

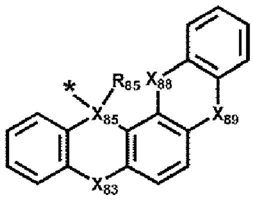
CY71-5(2)

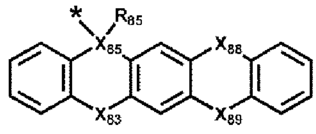
CY71-5(3)

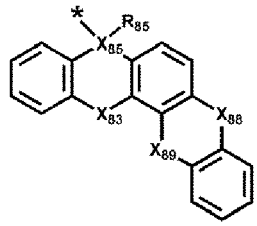
CY71-5(4)

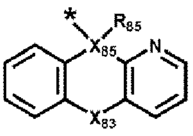
CY71-5(5)

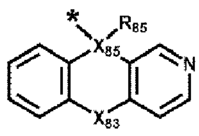
CY71-5(6)

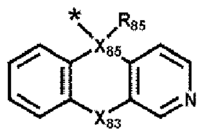
CY71-5(7)

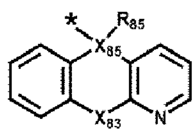
CY71-5(8)

wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),

$X_{82}$ to $X_{85}$, $L_{81}$, b81, $R_{81}$, and $R_{85}$ may respectively be the same as described in the present specification,

$X_{86}$ may be a single bond, O, S, $N(R_{86})$, $B(R_{86})$, $C(R_{86a})(R_{86b})$, or $Si(R_{86a})(R_{86b})$,

$X_{87}$ may be a single bond, O, S, $N(R_{87})$, $B(R_{87})$, $C(R_{87a})(R_{87b})$, or $Si(R_{87a})(R_{87b})$,

in Formulae CY71-1(1) to CY71-1(8) and CY71-4(1) to CY71-4(32), $X_{86}$ and $X_{87}$ may not be a single bond, simultaneously,

$X_{88}$ may be a single bond, O, S, $N(R_{88})$, $B(R_{88})$, $C(R_{88a})(R_{88b})$, or $Si(R_{88a})(R_{88b})$,

$X_{89}$ may be a single bond, O, S, $N(R_{89})$, $B(R_{89})$, $C(R_{89a})(R_{89b})$, or $Si(R_{89a})(R_{89b})$,

in Formulae CY71-2(1) to CY71-2(8), CY71-3(1) to CY71-3(32), and CY71-5(1) to CY71-5(8), $X_{88}$ and $X_{89}$ may not be a single bond, simultaneously, and

$R_{86}$ to $R_{89}$, $R_{86a}$, R86b, $R_{87a}$, R87b, $R_{88a}$, $R_{88b}$, $R_{89a}$, and R89b may respectively the same as described in connection with $R_{81}$ in the present specification.

## Examples of compounds

In an embodiment, the organometallic compound represented by Formula 1 may be one selected from Compounds B0D1 to BD334 below:

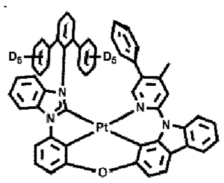
BD01

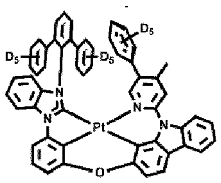
BD02

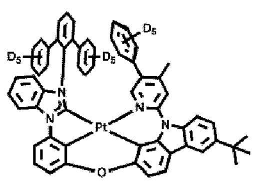
BD03

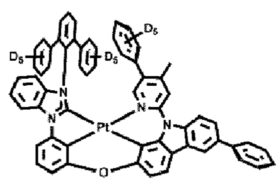
BD04

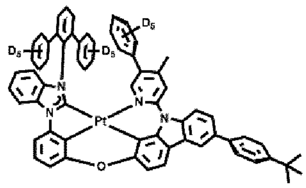
BD05

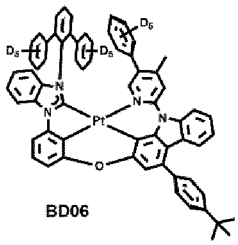
BD06

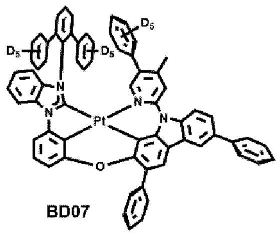
BD07

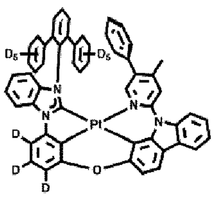
BD08

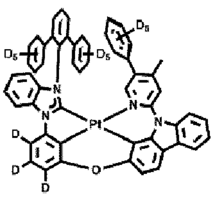
BD09

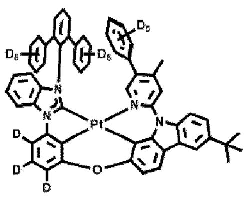
BD10

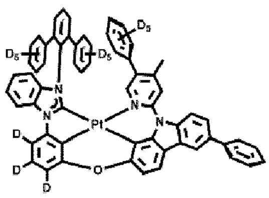
BD11

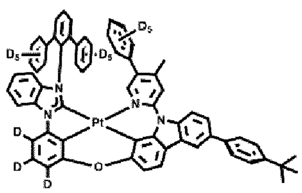
BD12

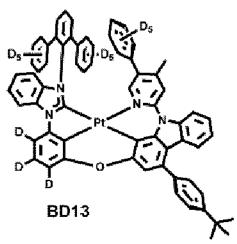
BD13

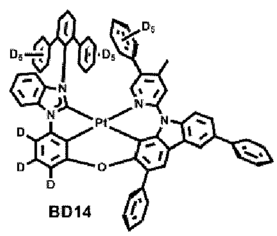
BD14

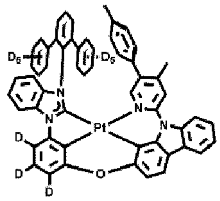
BD15

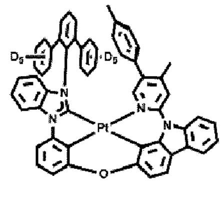
BD16

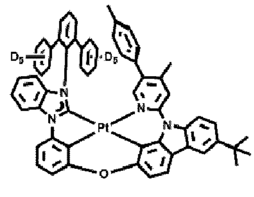
BD17

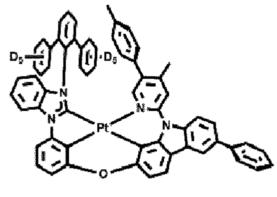
BD18

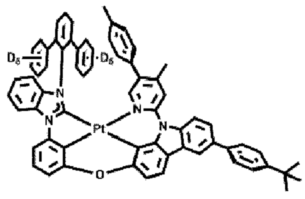
BD19

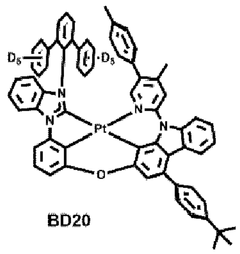
BD20

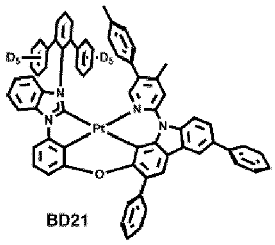
BD21

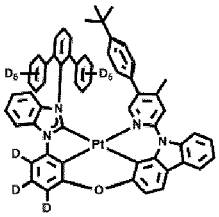
BD22

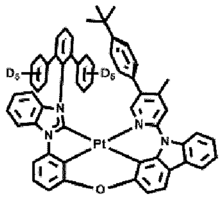
BD23

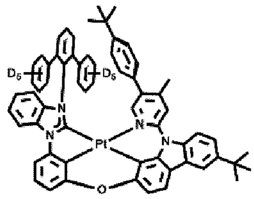
BD24

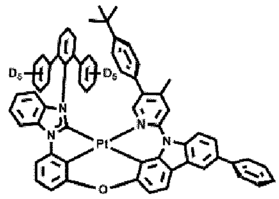
BD25

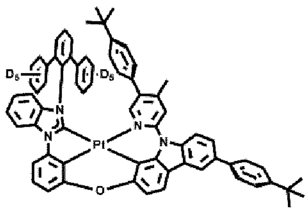
BD26

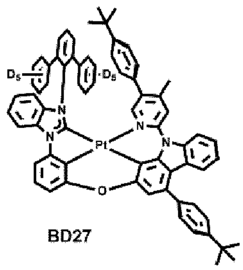
BD27

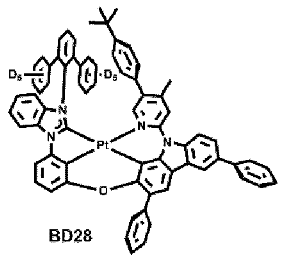
BD28

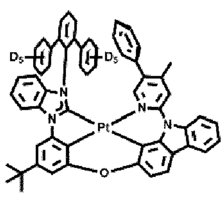
BD29

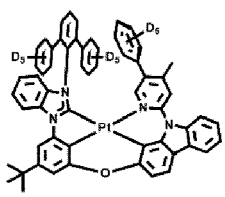
BD30

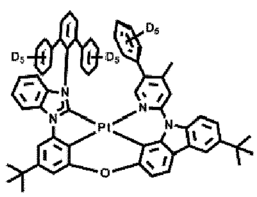
BD31

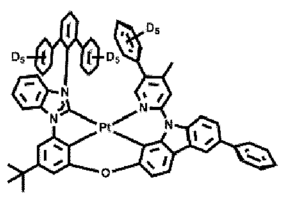
BD32

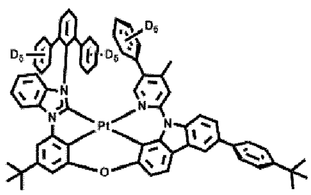
BD33

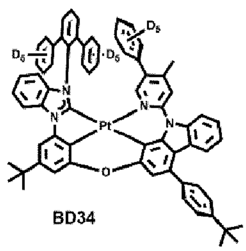
BD34

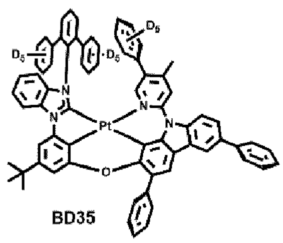
BD35

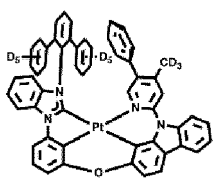
BD36

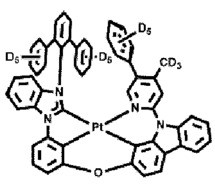
BD37

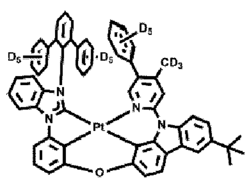
BD38

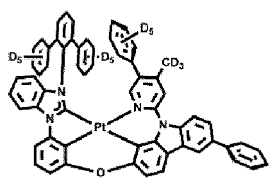
BD39

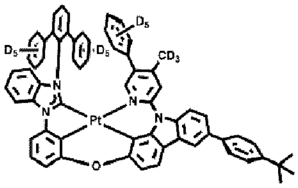
BD40

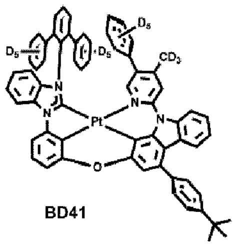
BD41

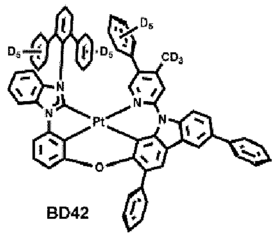
BD42

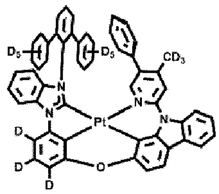
BD43

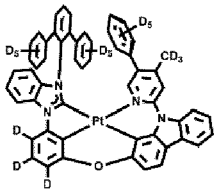
BD44

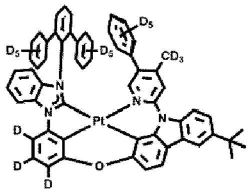
BD45

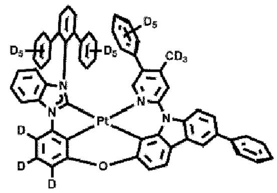
BD46

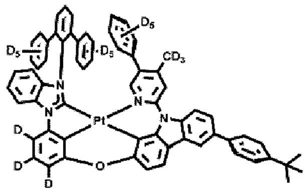
BD47

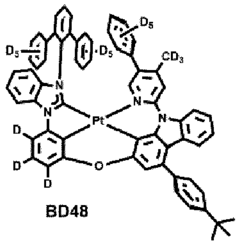
BD48

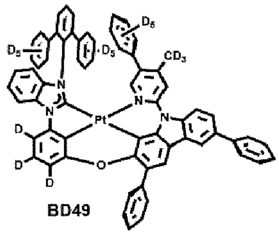
BD49

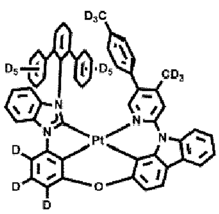
BD50

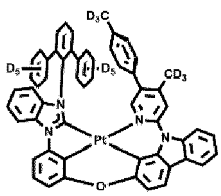
BD51

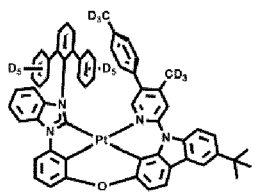
BD52

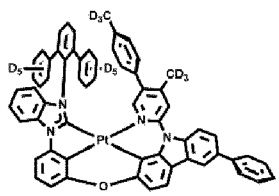
BD53

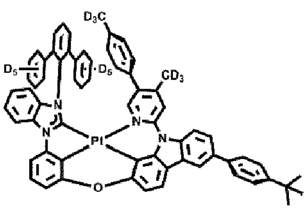
BD54

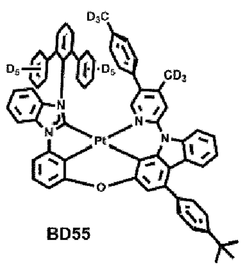
BD55

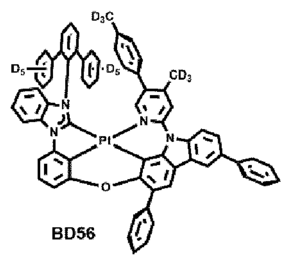
BD56

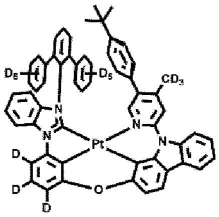
BD57

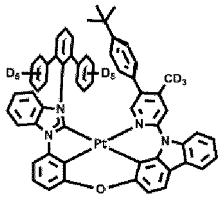
BD58

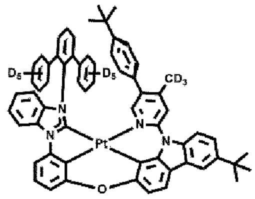
BD59

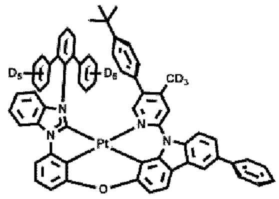
BD60

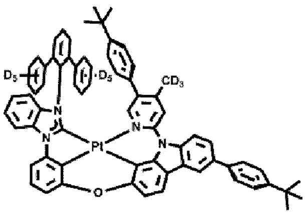
BD61

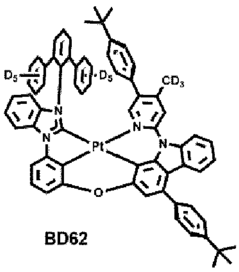
BD62

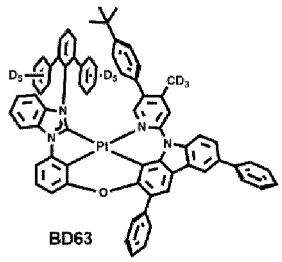
BD63

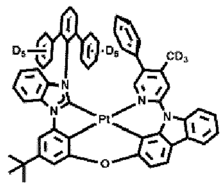
BD64

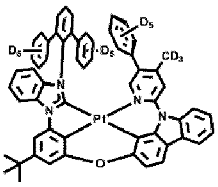
BD65

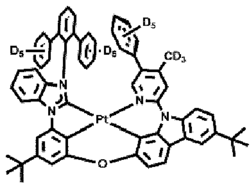
BD66

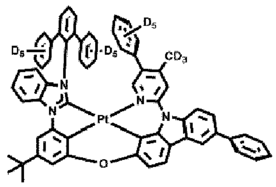
BD67

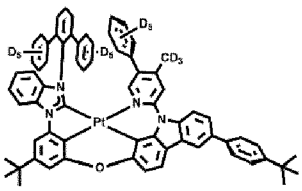
BD68

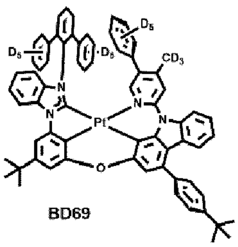
BD69

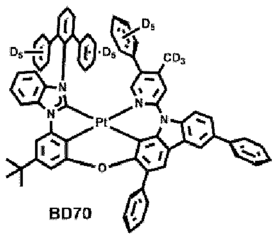
BD70

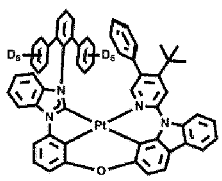
BD71

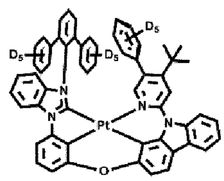
BD72

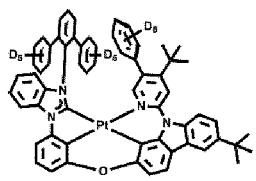
BD73

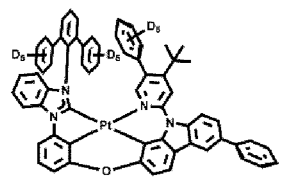
BD74

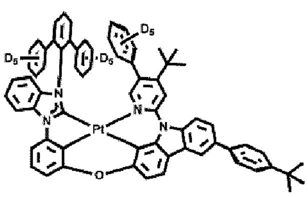
BD75

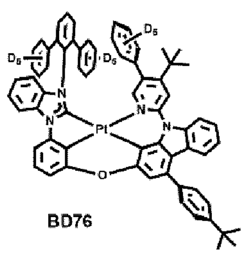
BD76

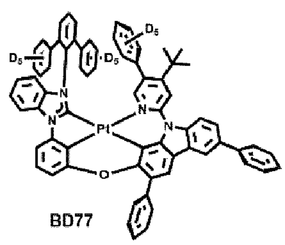
BD77

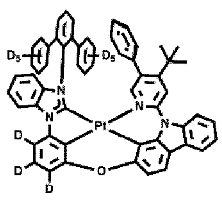
BD78

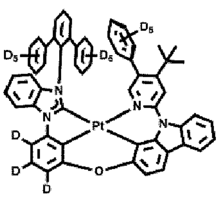
BD79

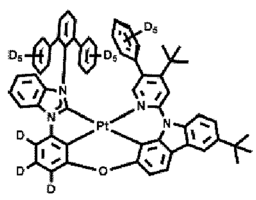
BD80

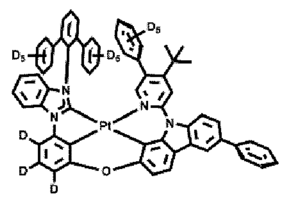
BD81

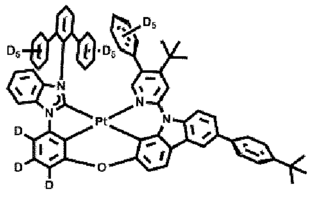
BD82

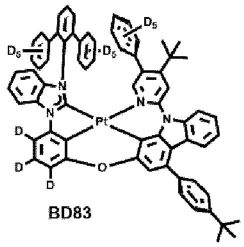
BD83

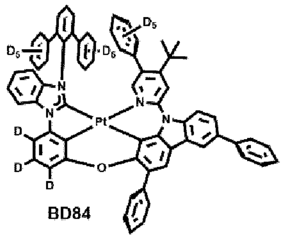
BD84

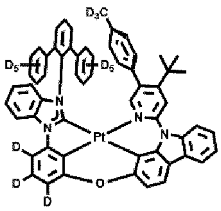
BD85

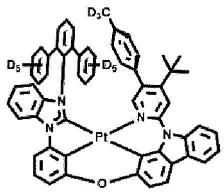
BD86

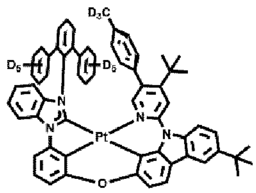
BD87

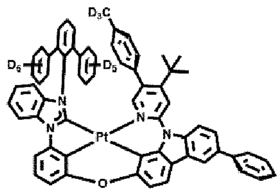
BD88

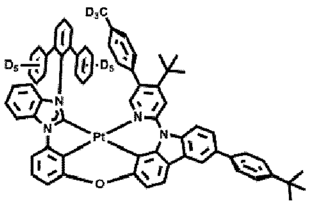
BD89

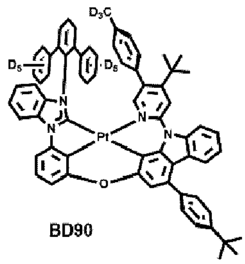
BD90

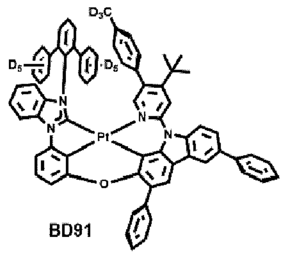
BD91

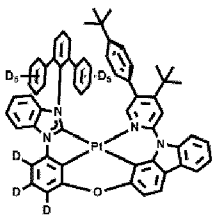
BD92

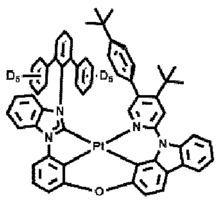
BD93

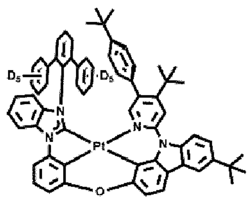
BD94

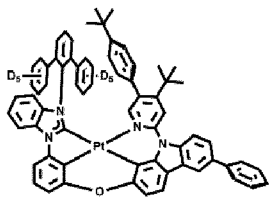
BD95

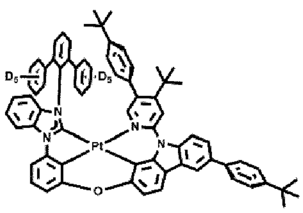
BD96

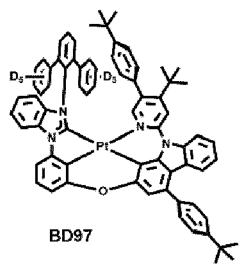
BD97

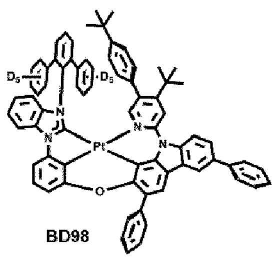
BD98

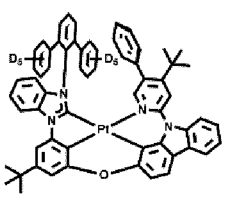
BD99

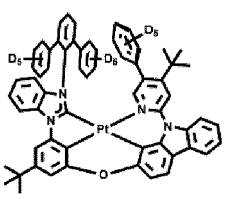
BD100

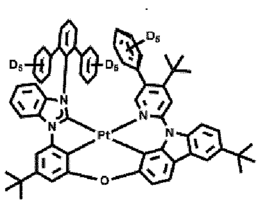
BD101

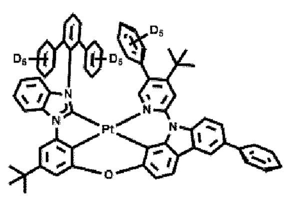
BD102

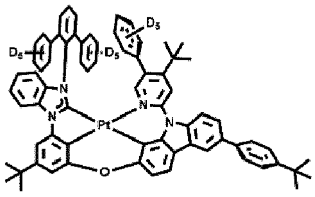

BD103

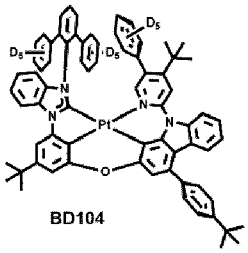

BD104

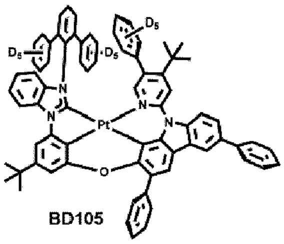

BD105

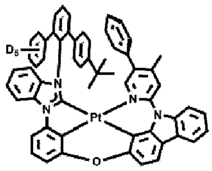

BD106

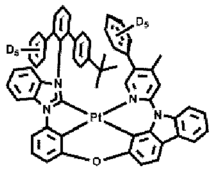

BD107

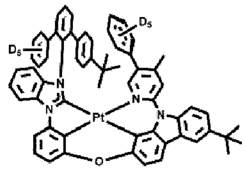

BD108

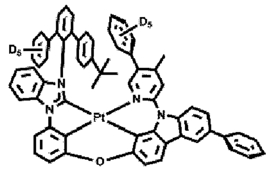

BD109

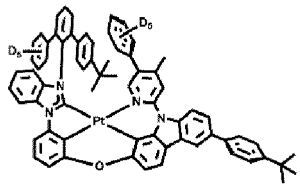

BD110

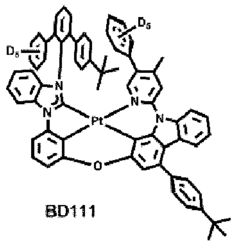

BD111

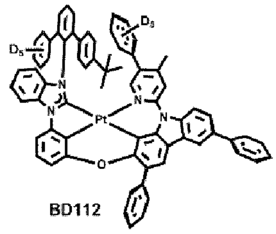

BD112

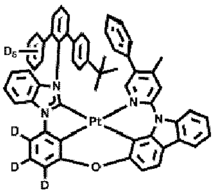

BD113

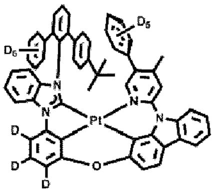

BD114

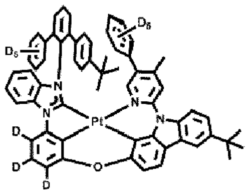

BD115

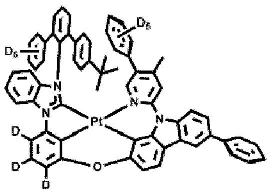

BD116

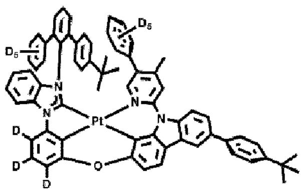

BD117

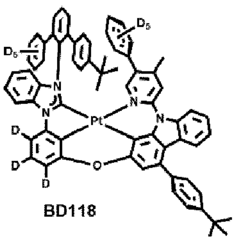

BD118

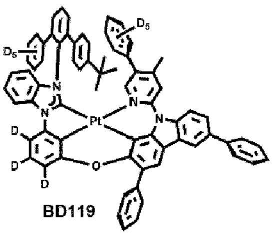

BD119

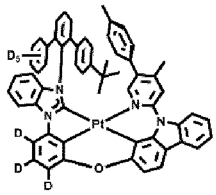

BD120

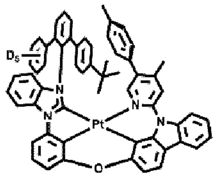

BD121

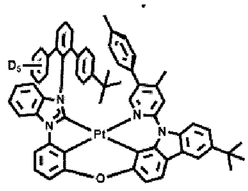

BD122

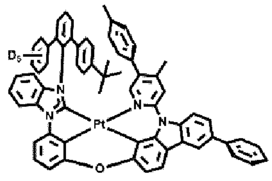

BD123

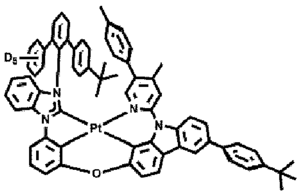
BD124

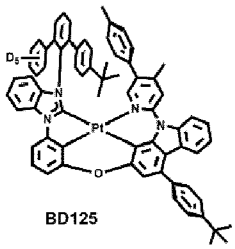
BD125

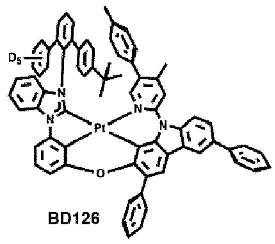
BD126

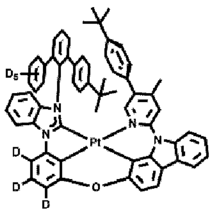
BD127

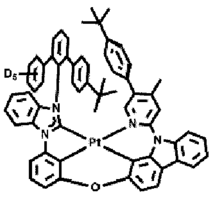
BD128

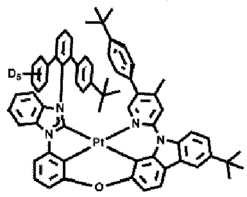
BD129

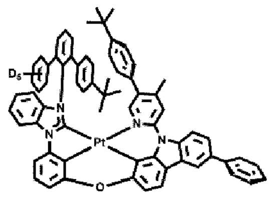
BD130

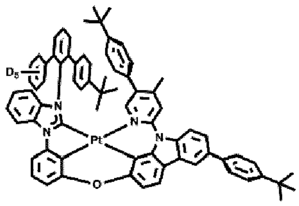
BD131

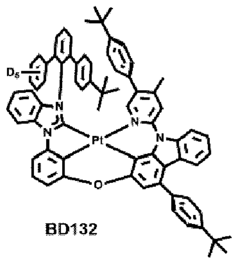
BD132

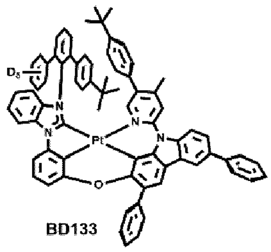
BD133

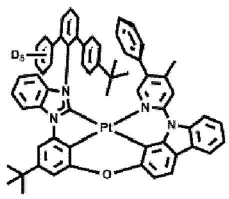
BD134

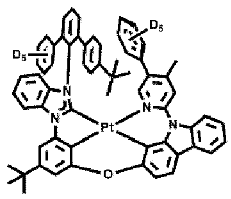
BD135

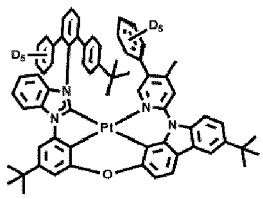
BD136

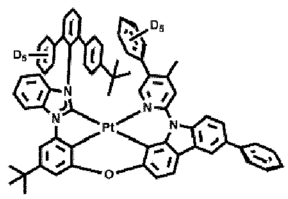
BD137

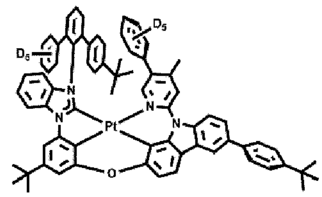
BD138

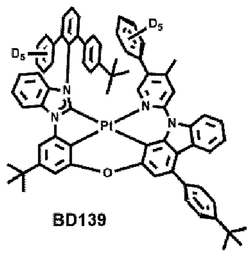
BD139

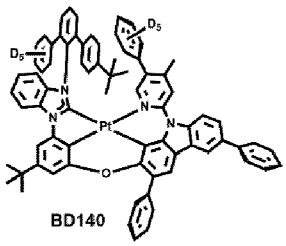
BD140

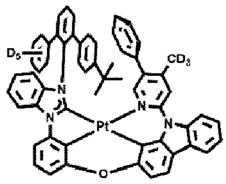
BD141

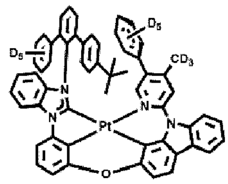
BD142

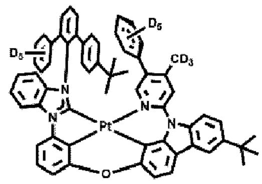
BD143

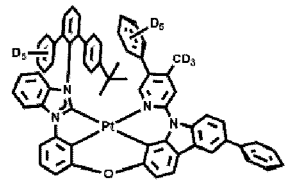
BD144

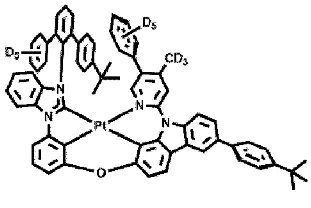
BD145

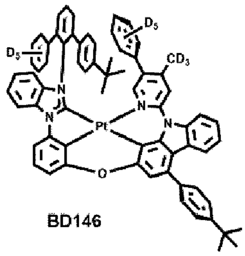
BD146

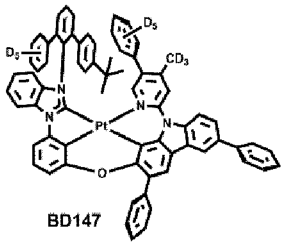
BD147

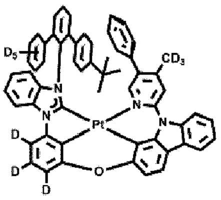
BD148

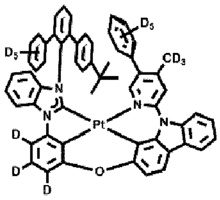
BD149

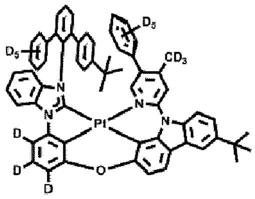
BD150

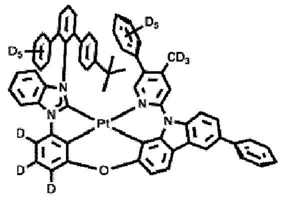
BD151

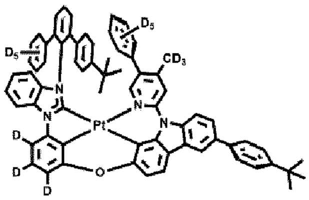
BD152

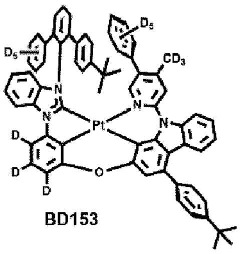
BD153

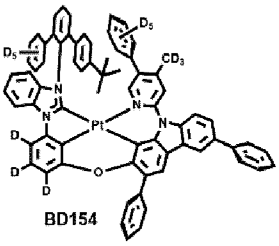
BD154

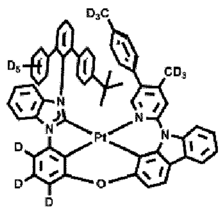
BD155

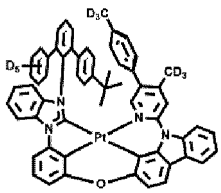
BD156

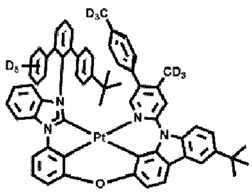
BD157

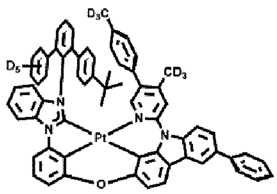
BD158

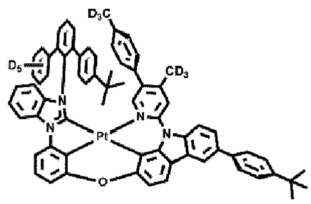
BD159

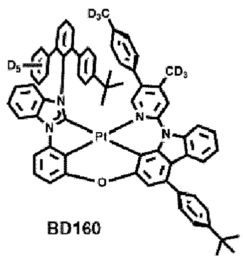
BD160

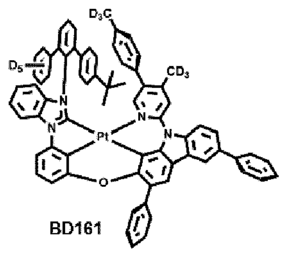
BD161

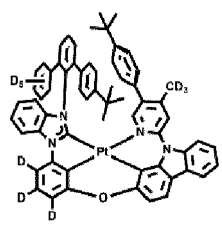
BD162

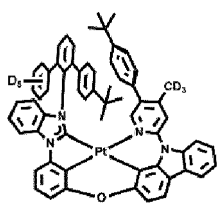
BD163

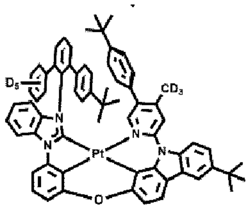
BD164

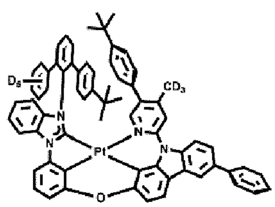
BD165

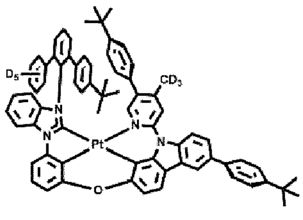
BD166

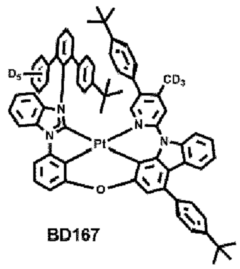
BD167

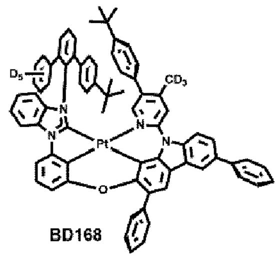
BD168

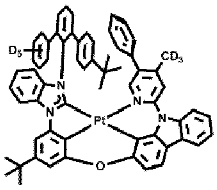
BD169

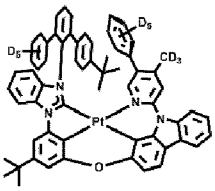
BD170

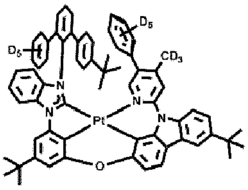
BD171

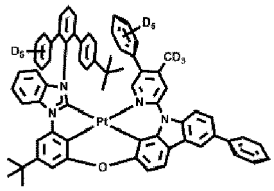
BD172

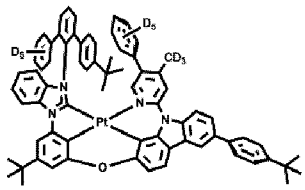
BD173

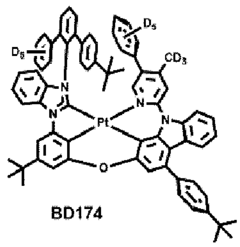
BD174

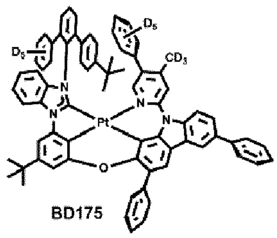
BD175

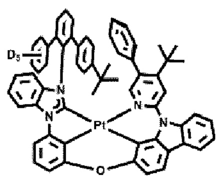
BD176

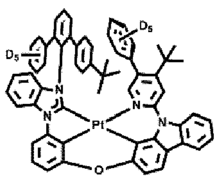
BD177

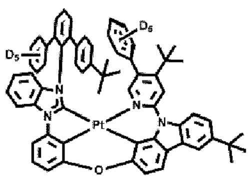
BD178

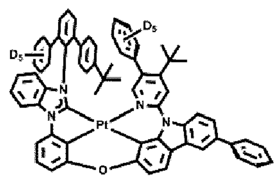
BD179

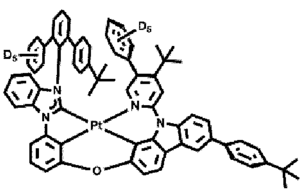
BD180

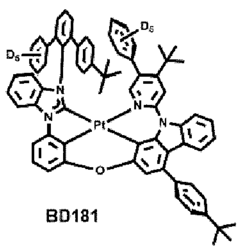
BD181

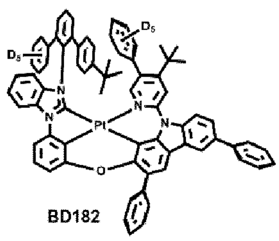
BD182

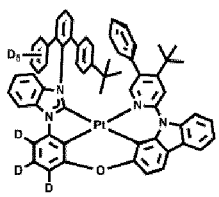
BD183

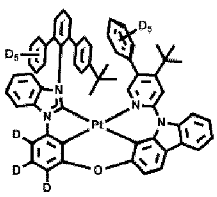
BD184

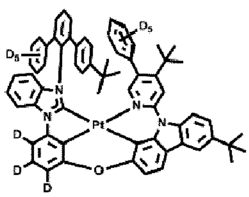
BD185

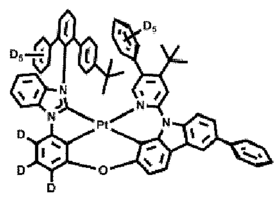
BD186

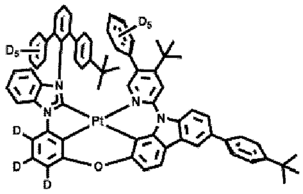
BD187

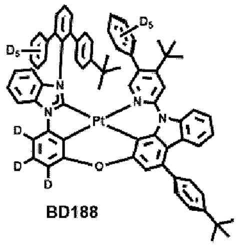
BD188

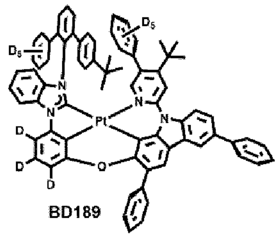
BD189

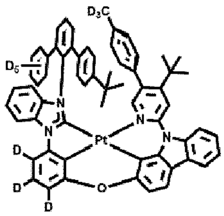
BD190

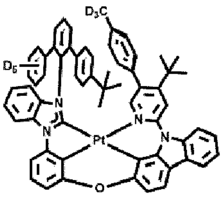
BD191

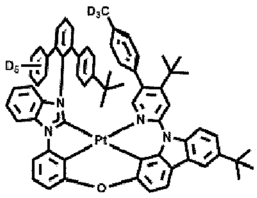
BD192

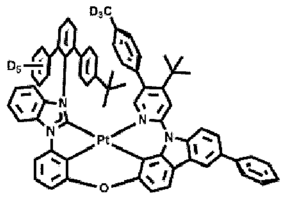
BD193

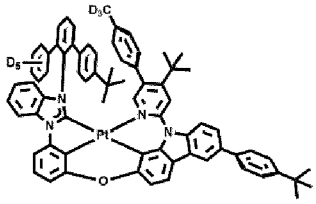
BD194

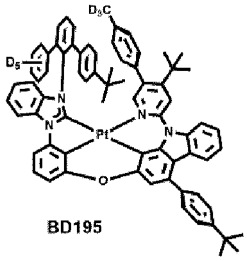
BD195

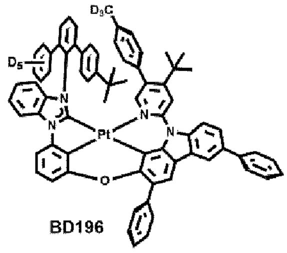
BD196

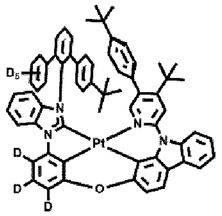
BD197

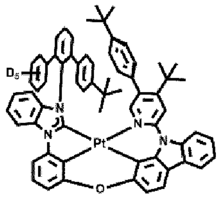
BD198

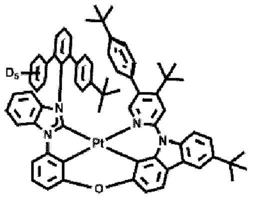
BD199

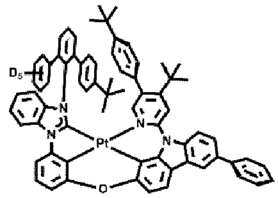
BD200

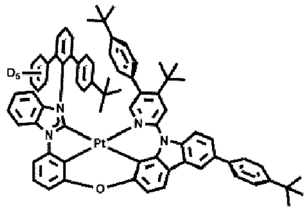
BD201

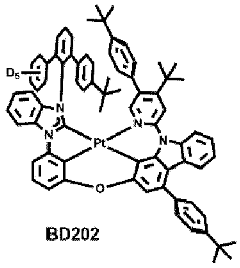
BD202

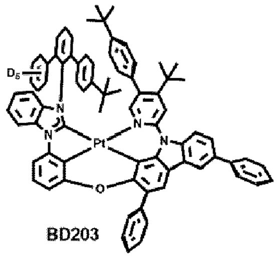
BD203

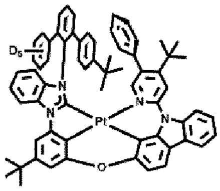
BD204

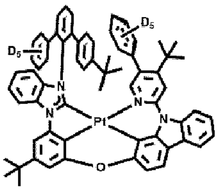
BD205

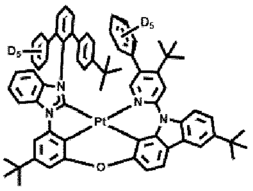
BD206

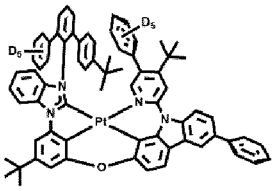
BD207

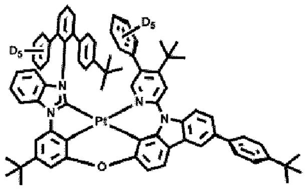
BD208

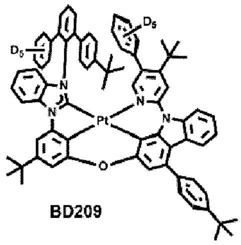
BD209

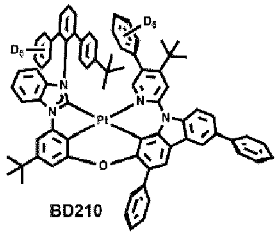
BD210

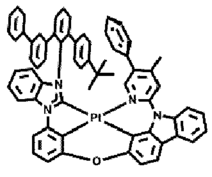
BD211

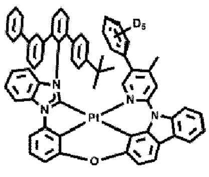
BD212

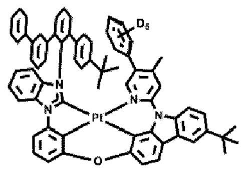
BD213

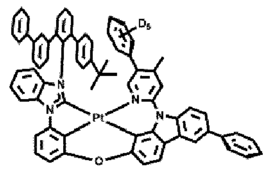
BD214

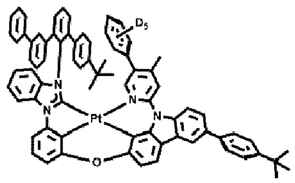
BD215

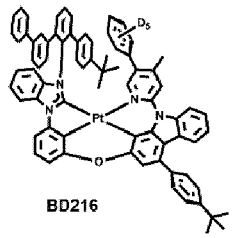
BD216

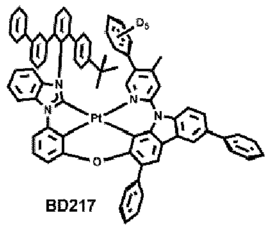
BD217

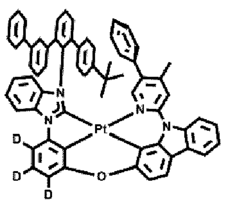
BD218

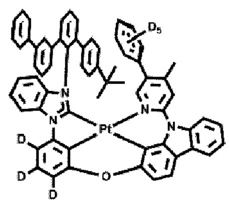
BD219

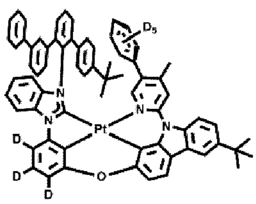
BD220

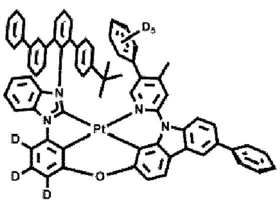
BD221

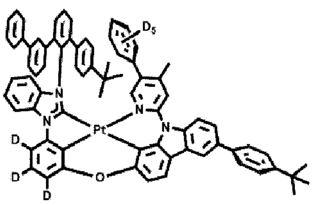
BD222

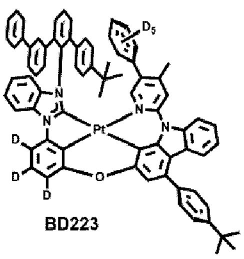
BD223

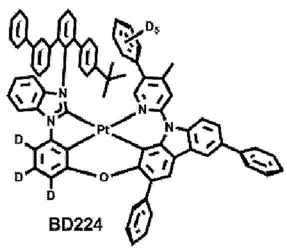
BD224

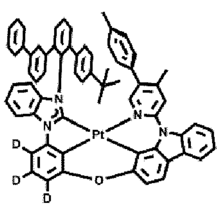
BD225

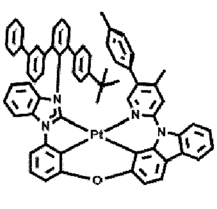
BD226

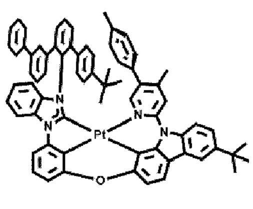
BD227

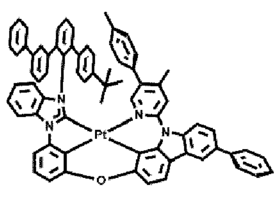
BD228

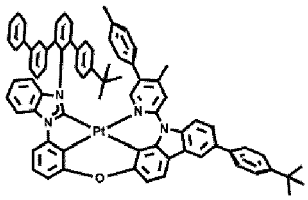

BD229

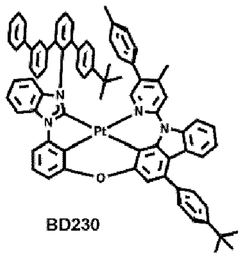

BD230

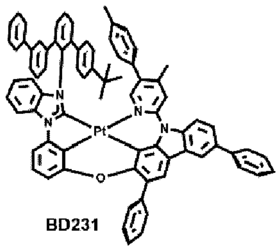

BD231

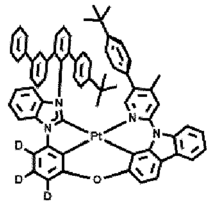

BD232

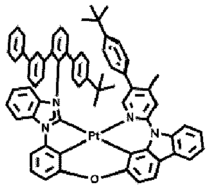

BD233

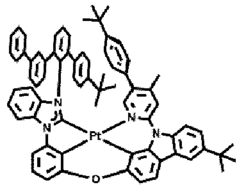

BD234

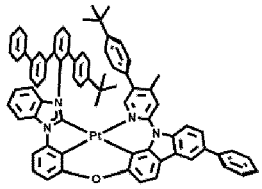

BD235

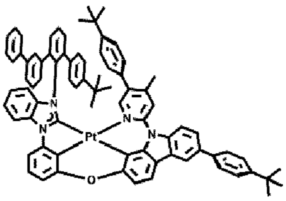

BD236

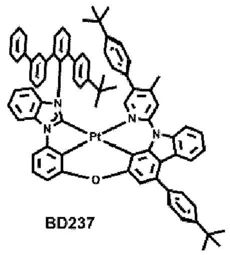

BD237

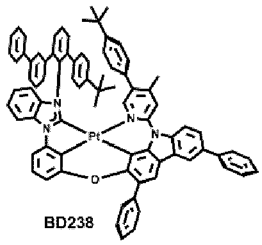

BD238

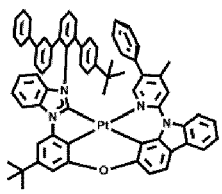

BD239

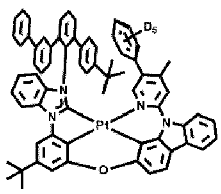

BD240

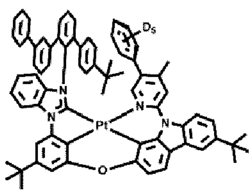

BD241

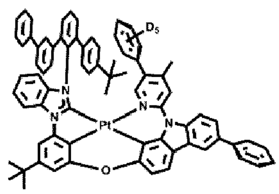

BD242

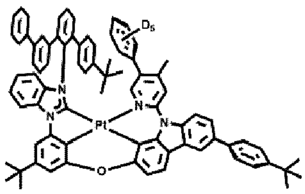

BD243

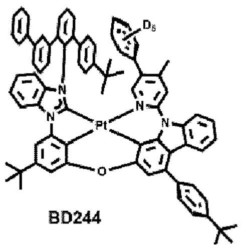

BD244

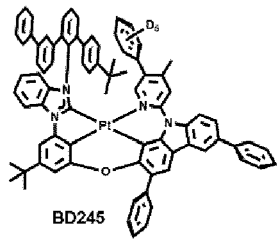

BD245

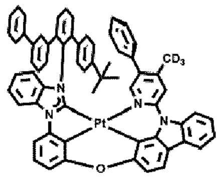

BD246

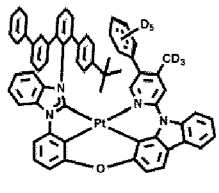

BD247

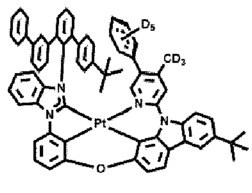

BD248

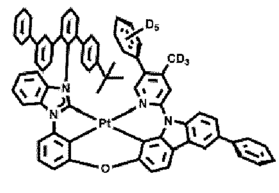

BD249

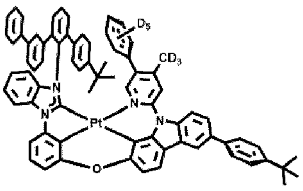
BD250

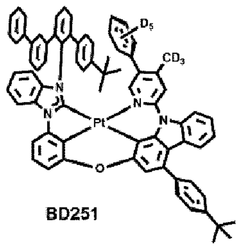
BD251

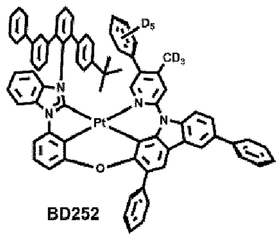
BD252

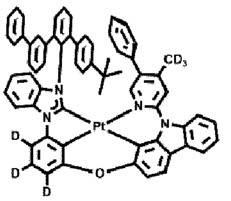
BD253

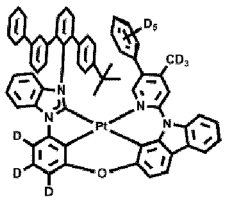
BD254

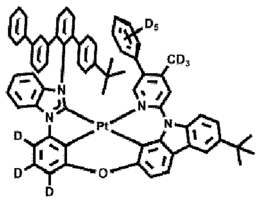
BD255

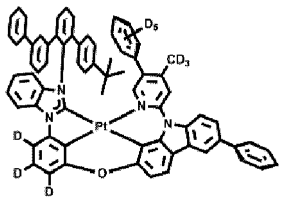
BD256

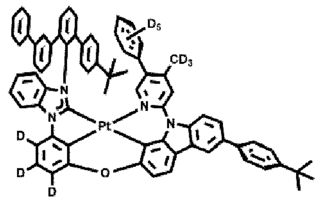
BD257

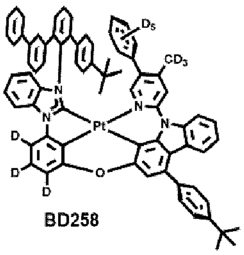
BD258

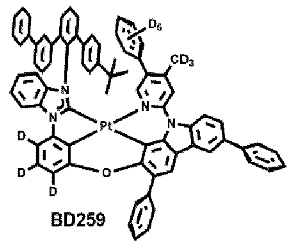
BD259

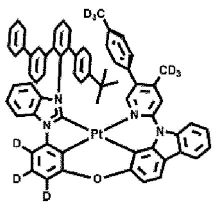
BD260

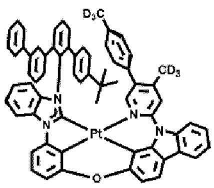
BD261

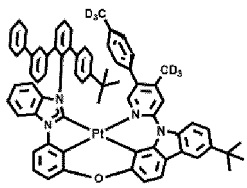
BD262

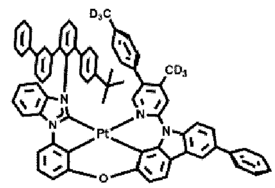
BD263

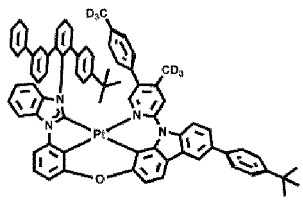
BD264

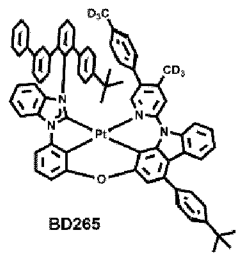
BD265

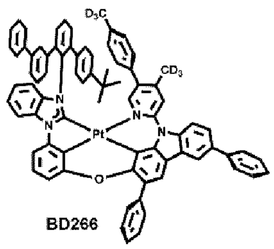
BD266

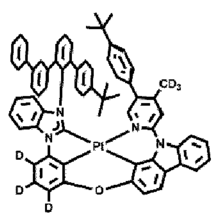
BD267

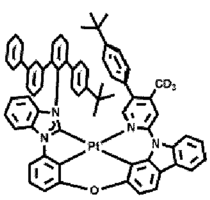
BD268

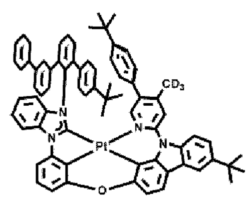
BD269

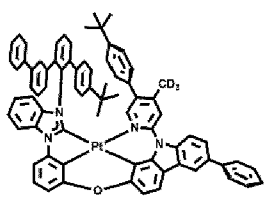
BD270

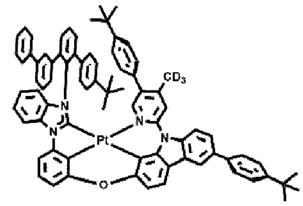
BD271

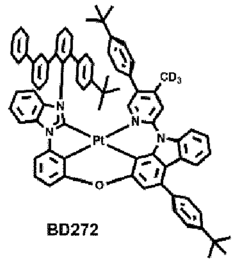
BD272

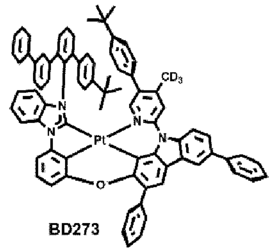
BD273

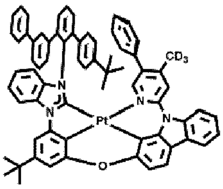
BD274

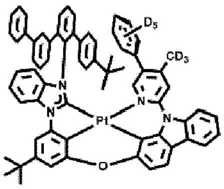
BD275

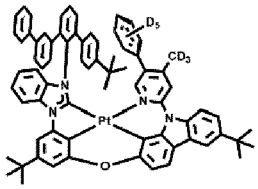
BD276

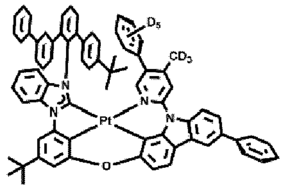
BD277

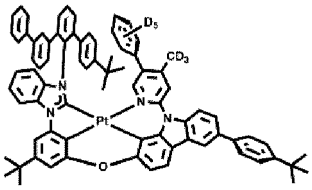
BD278

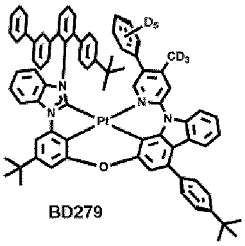
BD279

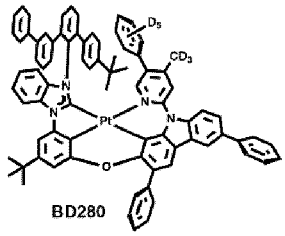
BD280

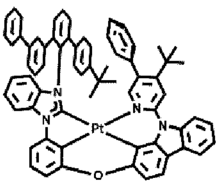
BD281

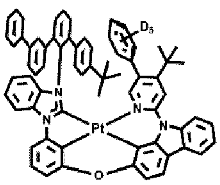
BD282

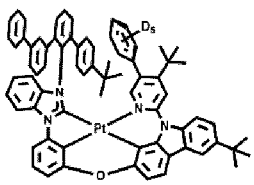
BD283

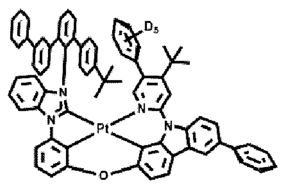
BD284

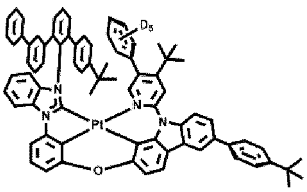
BD285

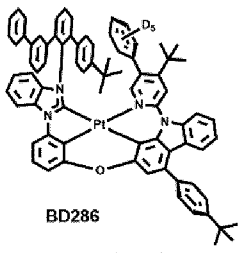
BD286

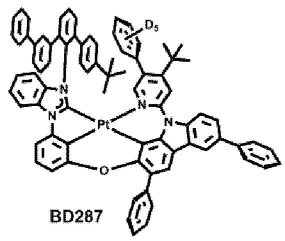
BD287

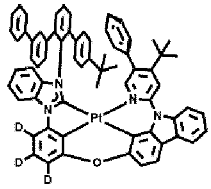
BD288

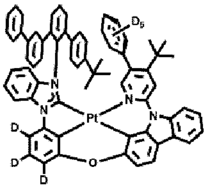
BD289

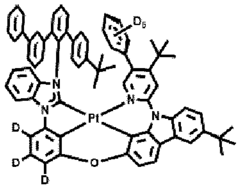
BD290

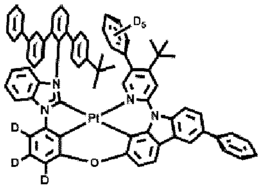
BD291

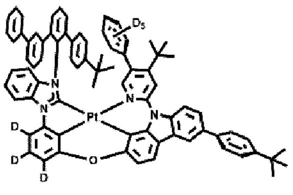
BD292

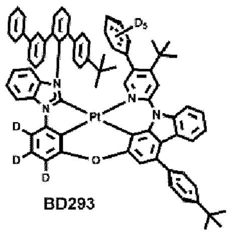
BD293

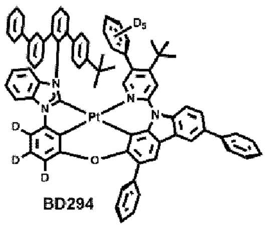
BD294

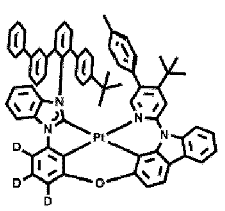
BD295

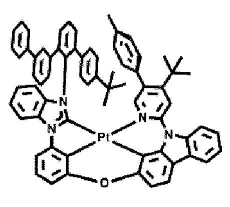
BD296

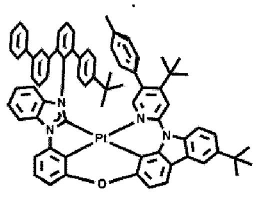
BD297

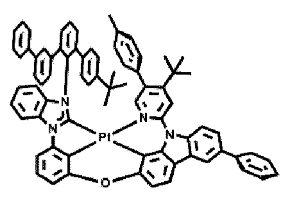
BD298

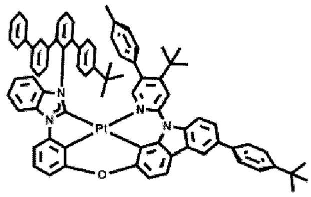
BD299

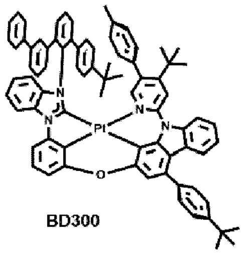
BD300

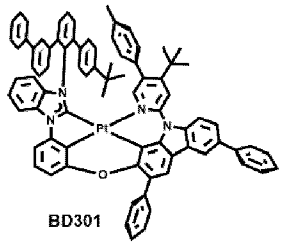
BD301

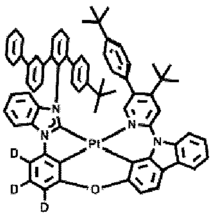
BD302

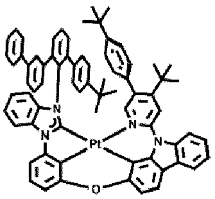
BD303

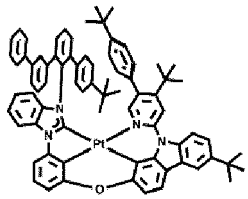
BD304

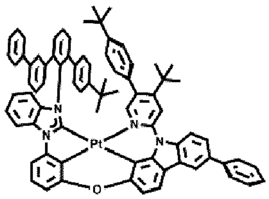
BD305

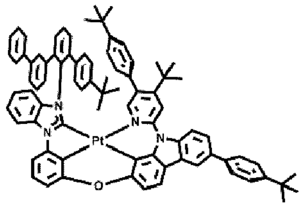
BD306

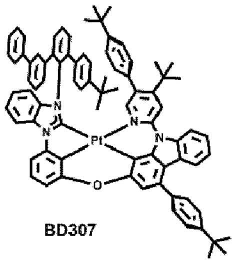
BD307

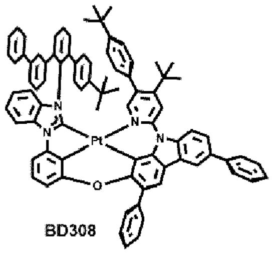
BD308

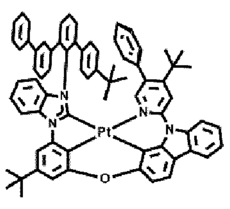
BD309

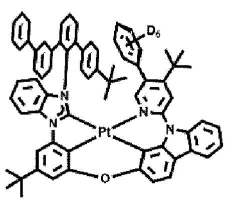
BD310

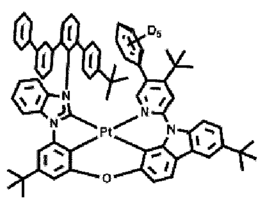
BD311

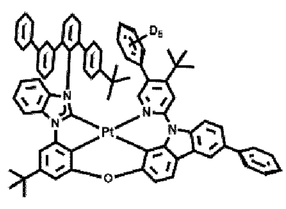
BD312

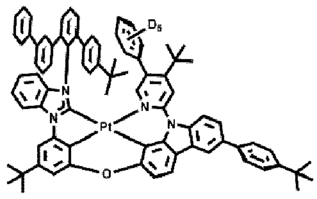
BD313

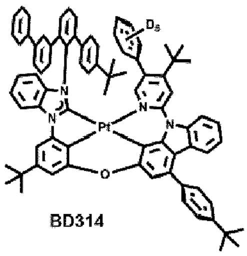
BD314

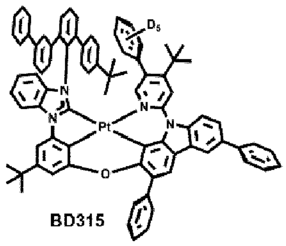
BD315

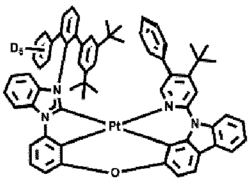
BD316

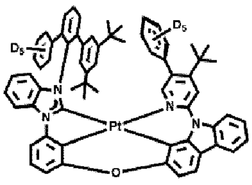
BD317

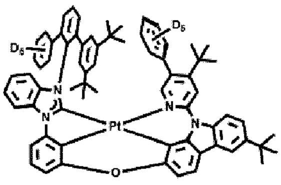
BD318

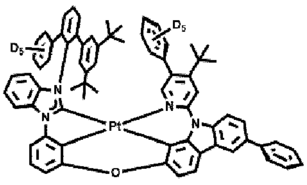
BD319

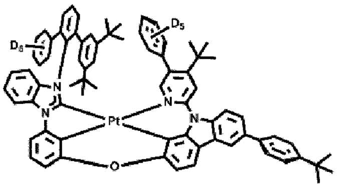
BD320

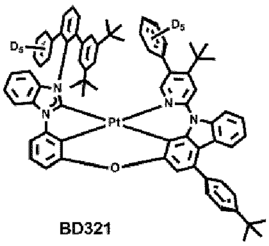
BD321

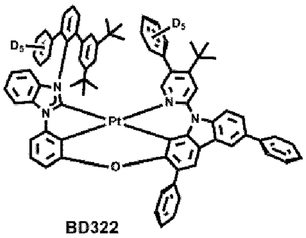
BD322

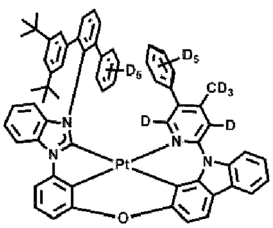
BD323

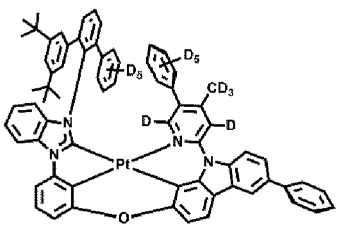
BD324

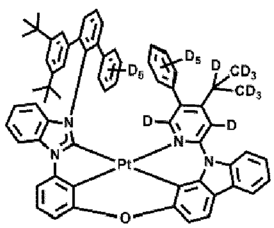
BD325

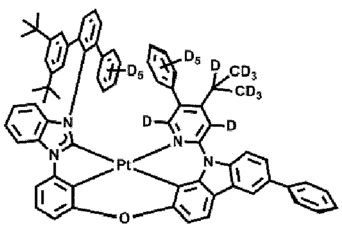
BD326

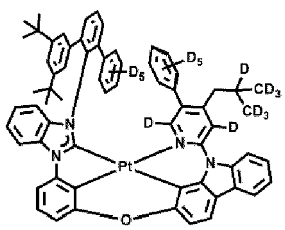
BD327

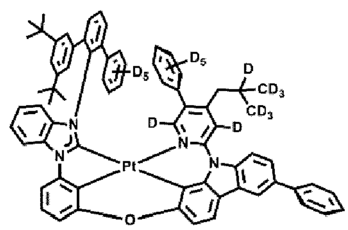
BD328

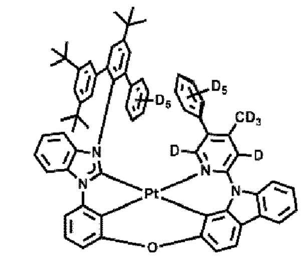

BD329

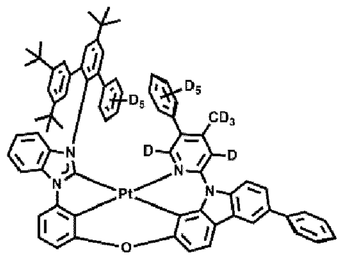

BD330

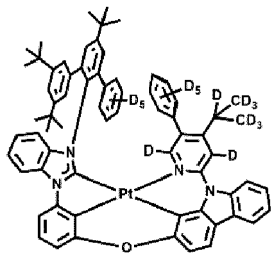

BD331

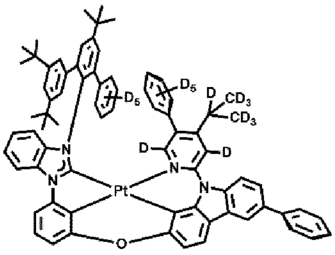

BD332

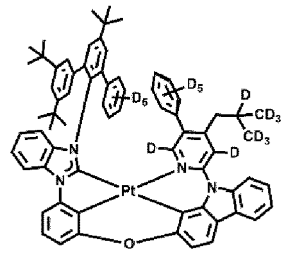

BD333

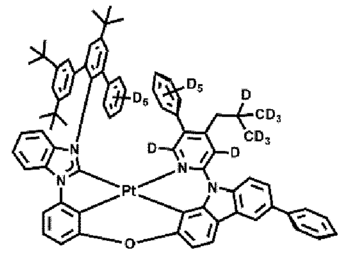

BD334

.

In an embodiment, the second compound may be one selected from Compounds ETH1 to ETH96 below:

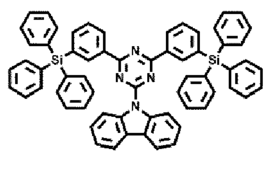

ETH1

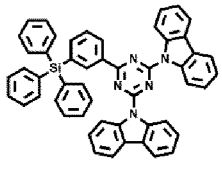

ETH2

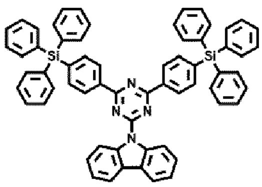

ETH3

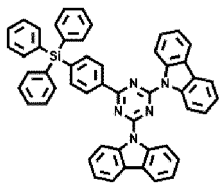

ETH4

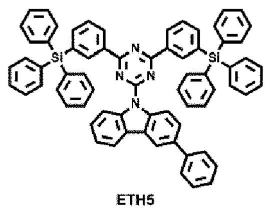

ETH5

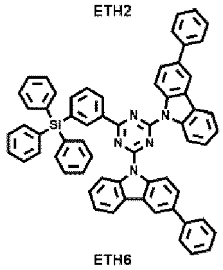

ETH6

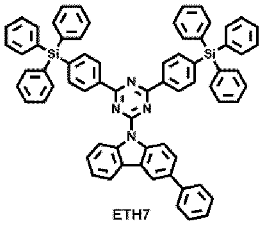

ETH7

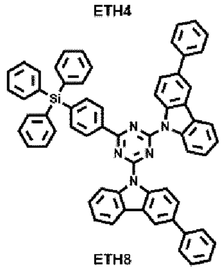

ETH8

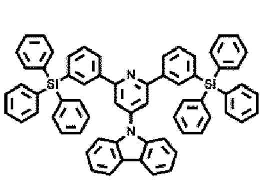

ETH9

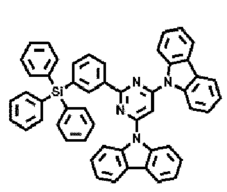

ETH10

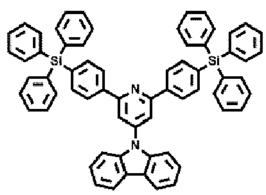

ETH11

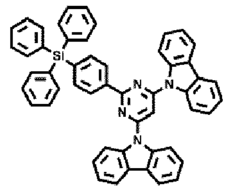

ETH12

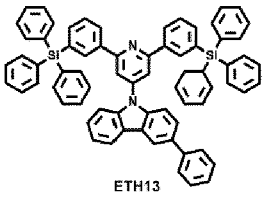
ETH13

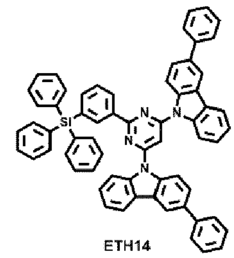
ETH14

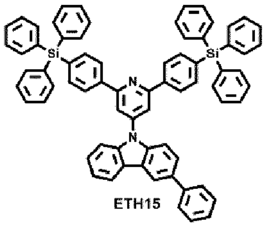
ETH15

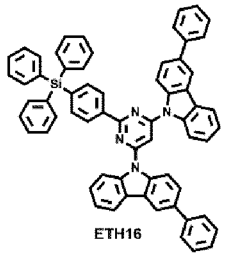
ETH16

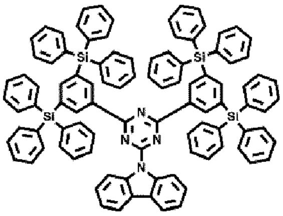
ETH17

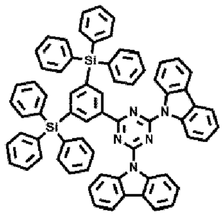
ETH18

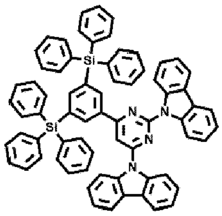
ETH19

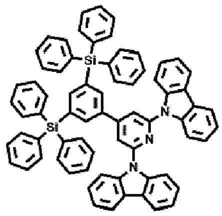
ETH20

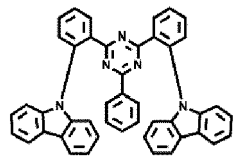
ETH21

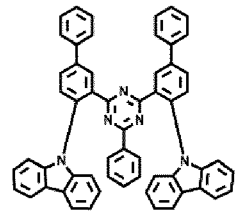
ETH22

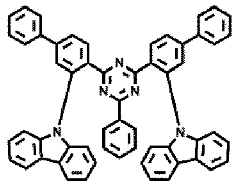
ETH23

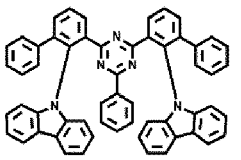
ETH24

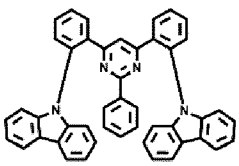
ETH25

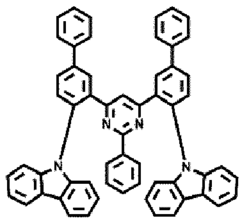
ETH26

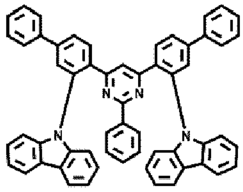
ETH27

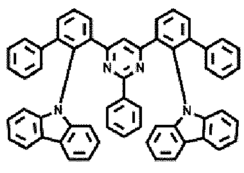
ETH28

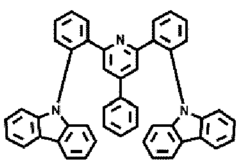
ETH29

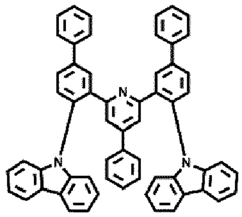
ETH30

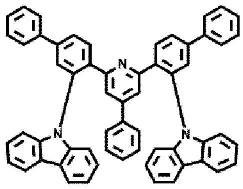
ETH31

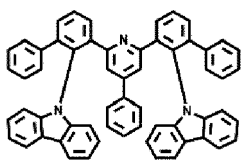
ETH32

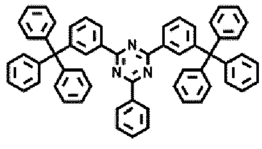
ETH33

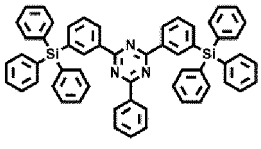
ETH34

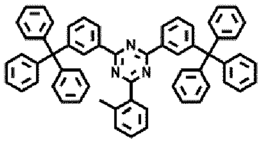
ETH35

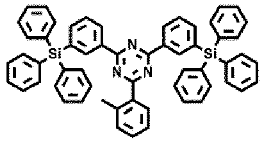
ETH36

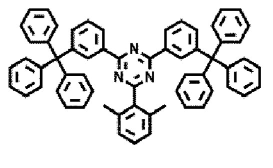
ETH37

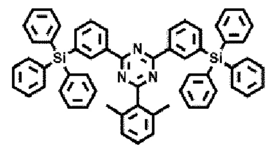
ETH38

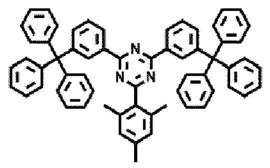
ETH39

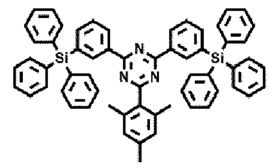
ETH40

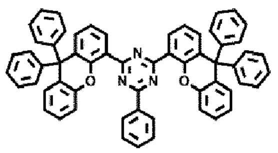
ETH41

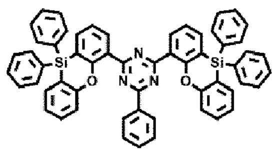
ETH42

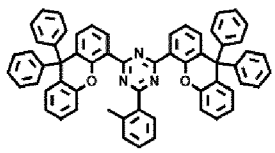
ETH43

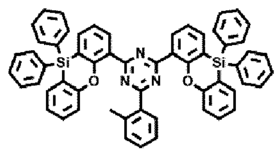
ETH44

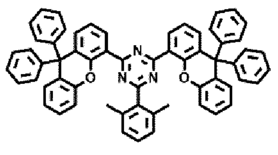
ETH45

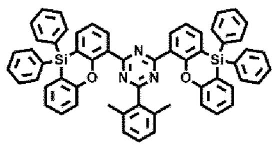
ETH46

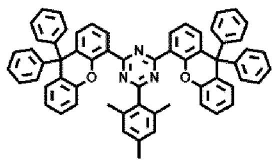
ETH47

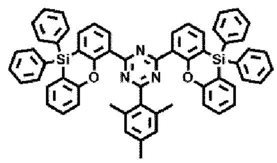
ETH48

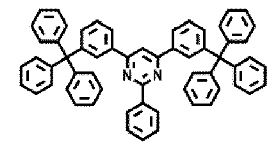
ETH49

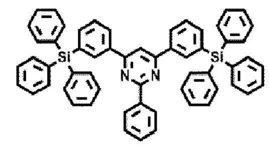
ETH50

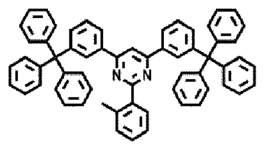
ETH51

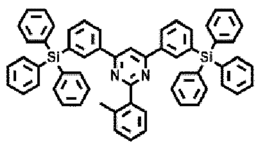
ETH52

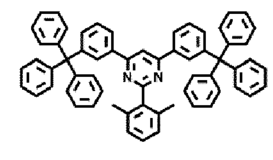
ETH53

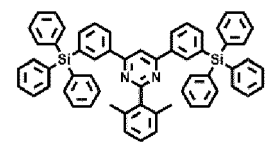
ETH54

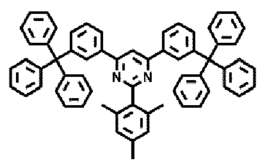
ETH55

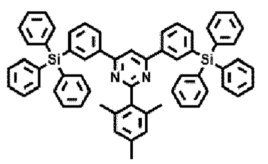
ETH56

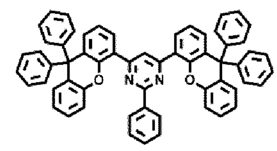
ETH57

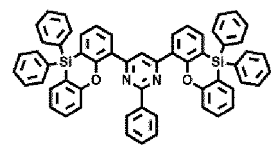
ETH58

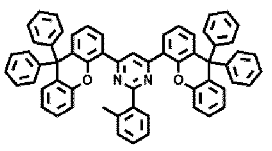
ETH59

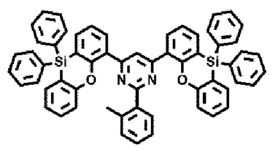
ETH60

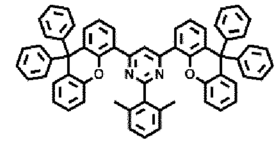
ETH61

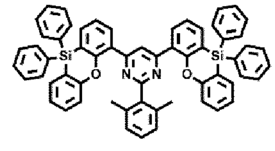
ETH62

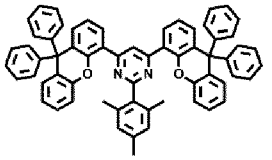
ETH63

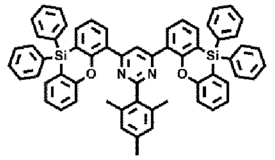
ETH64

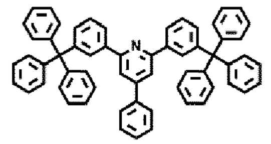
ETH65

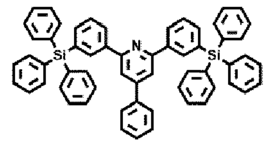
ETH66

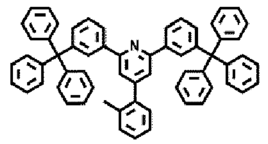
ETH67

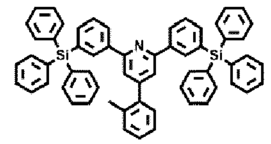
ETH68

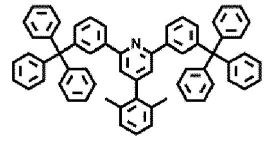
ETH69

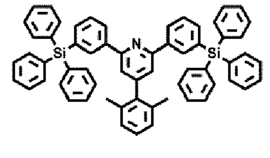
ETH70

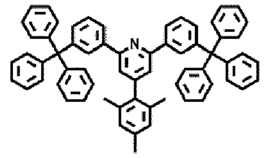
ETH71

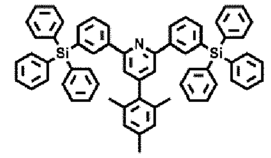
ETH72

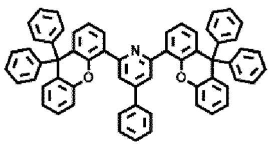
ETH73

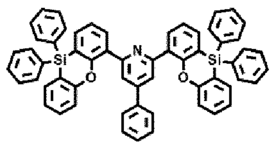
ETH74

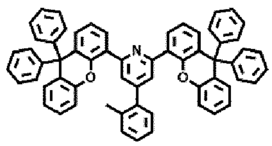
ETH75

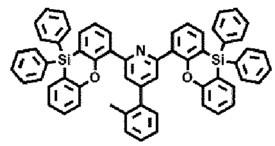
ETH76

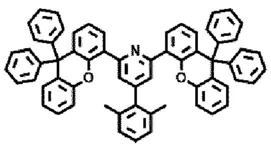
ETH77

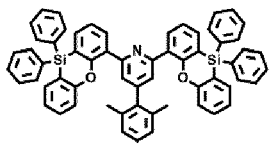
ETH78

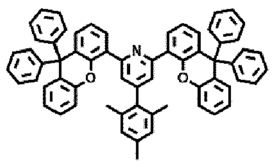
ETH79

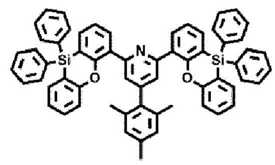
ETH80

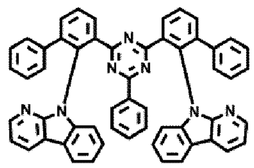
ETH81

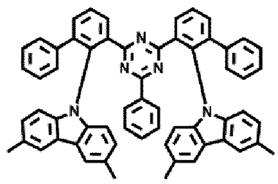
ETH82

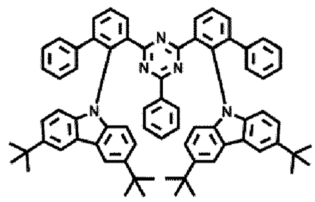
ETH83

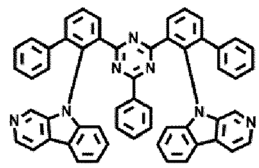
ETH84

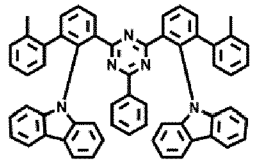
ETH85

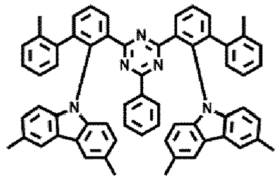
ETH86

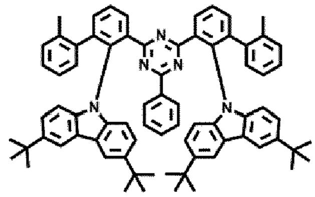
ETH87

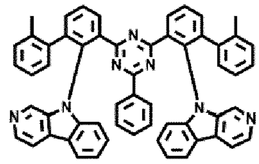
ETH88

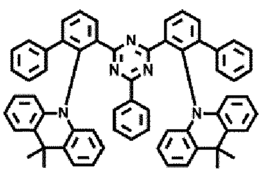
ETH89

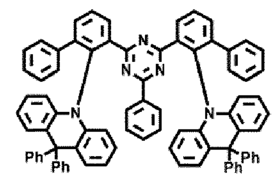
ETH90

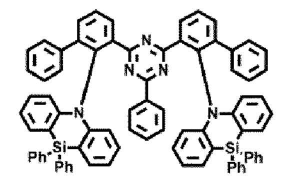
ETH91

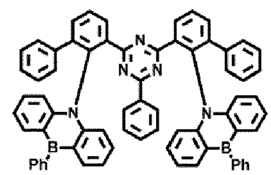
ETH92

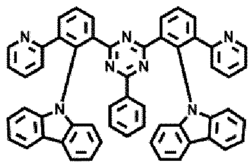

ETH93

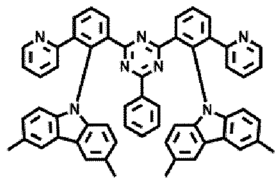

ETH94

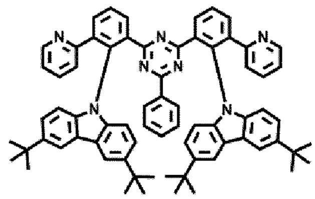

ETH95

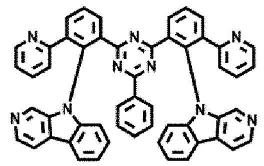

ETH96

In an embodiment, the third compound may be one selected from Compounds HTH1 to HTH40 below:

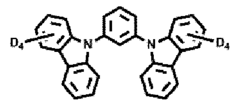

HTH1

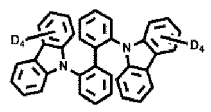

HTH2

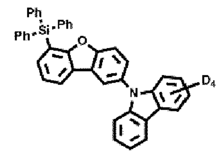

HTH3

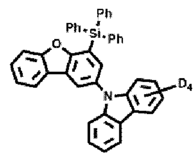

HTH4

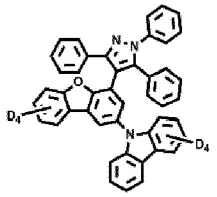

HTH5

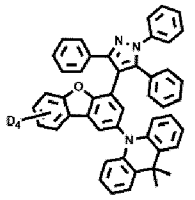

HTH6

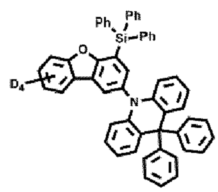

HTH7

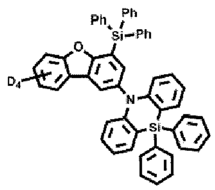

HTH8

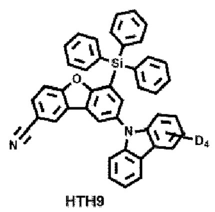

HTH9

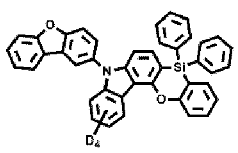

HTH10

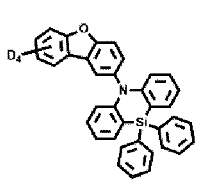

HTH11

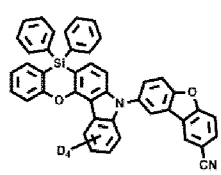

HTH12

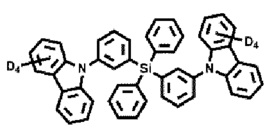

HTH13

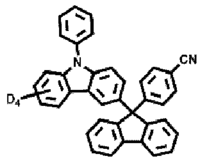

HTH14

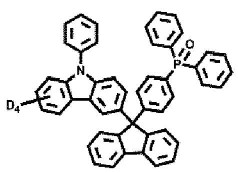

HTH15

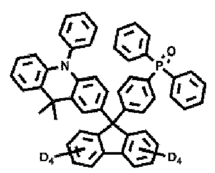

HTH16

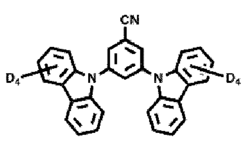

HTH17

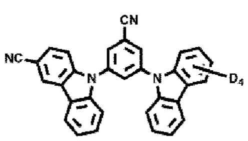

HTH18

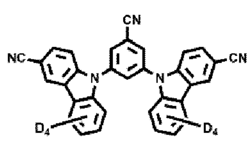

HTH19

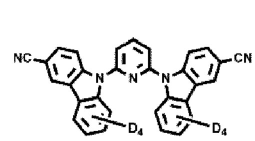

HTH20

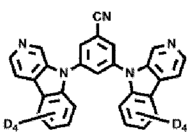

HTH21

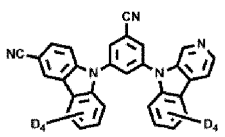

HTH22

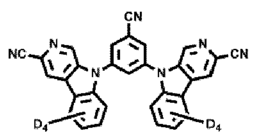

HTH23

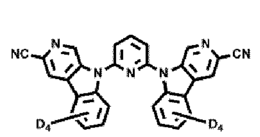

HTH24

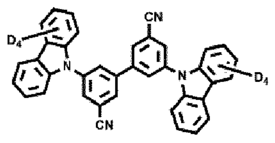
HTH25

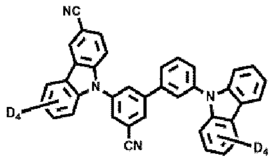
HTH26

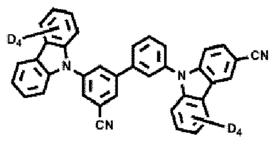
HTH27

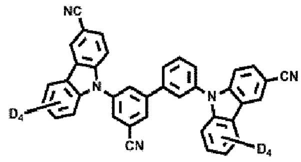
HTH28

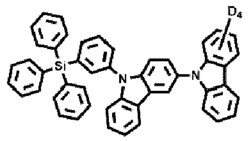
HTH29

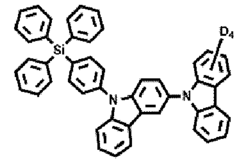
HTH30

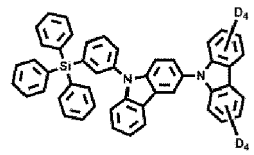
HTH31

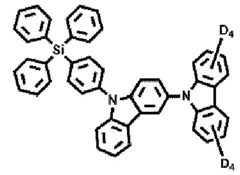
HTH32

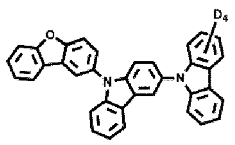
HTH33

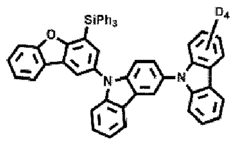
HTH34

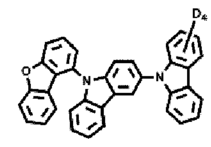
HTH35

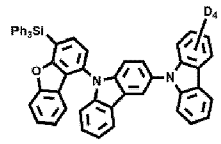
HTH36

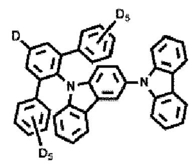
HTH37

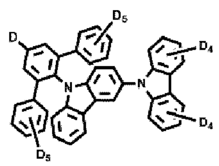
HTH38

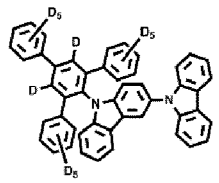
HTH39

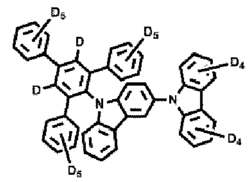
HTH40

.

In an embodiment, the fourth compound may be one selected from Compounds DFD1 to DFD29 below:

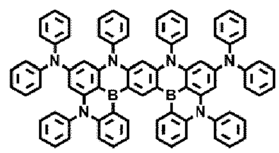
DFD1

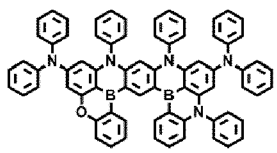
DFD2

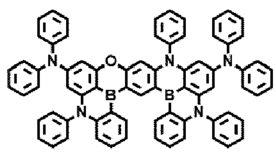
DFD3

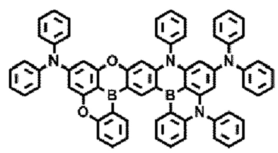
DFD4

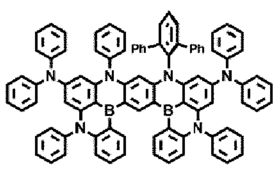
DFD5

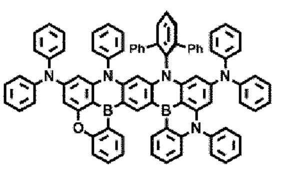
DFD6

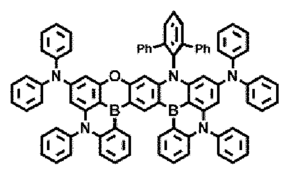
DFD7

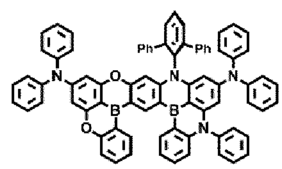
DFD8

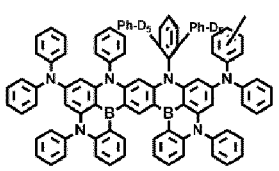
DFD9

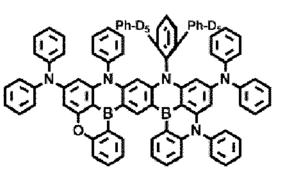
DFD10

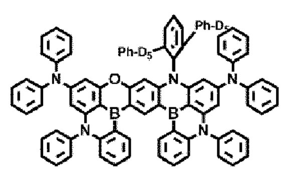
DFD11

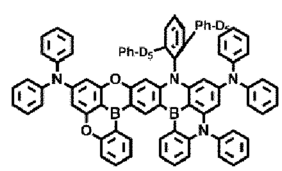
DFD12

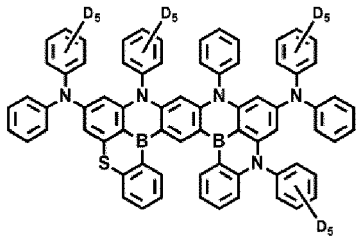 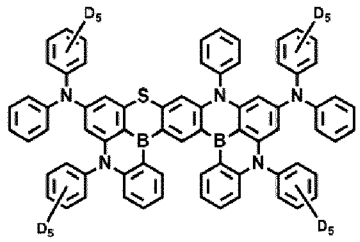 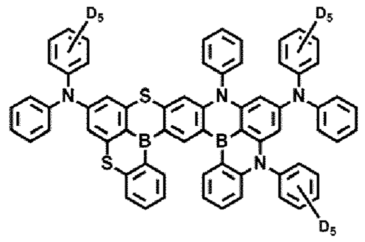

DFD13 DFD14 DFD15

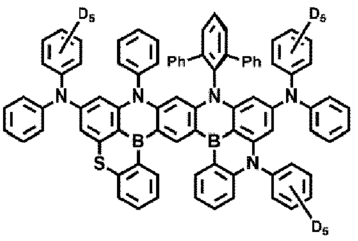 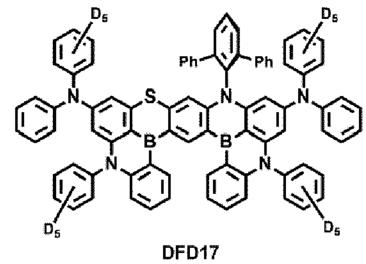 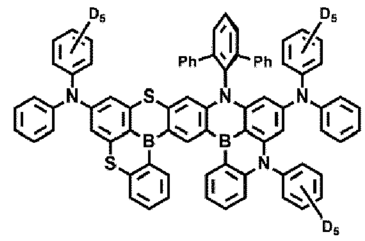

DFD16 DFD17 DFD18

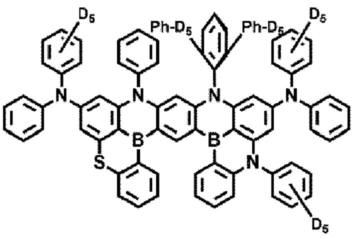 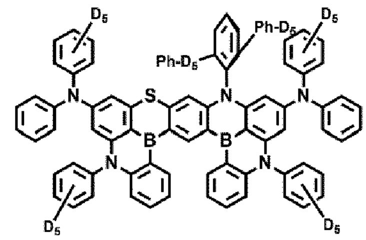 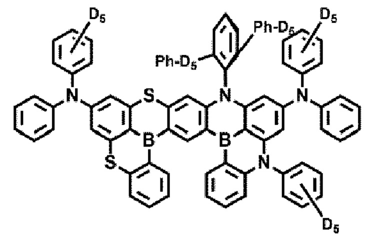

DFD19 DFD20 DFD21

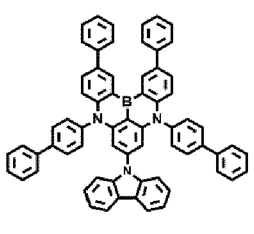 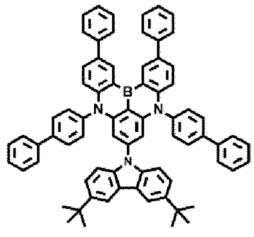 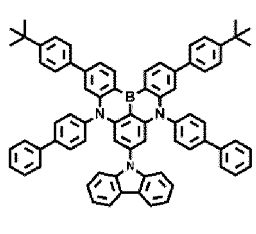 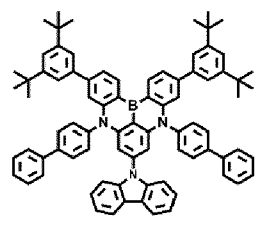

DFD22 DFD23 DFD24 DFD25

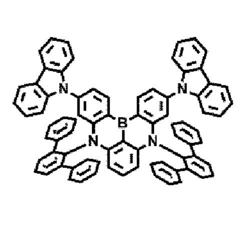 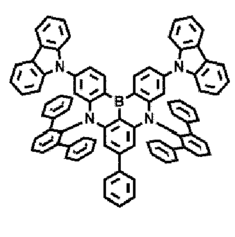 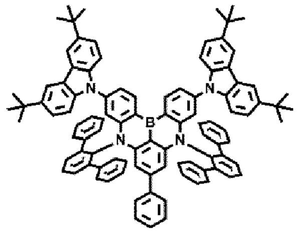 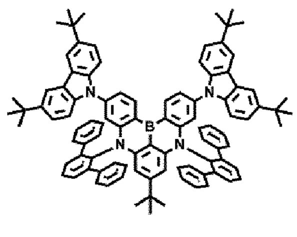

DFD26 DFD27 DFD28 DFD29 .

In the compounds described above, Ph represents a phenyl group, $D_5$ represents substitution with five deuterium, and $D_4$ represents substitution with four deuterium. In an embodiment, a group represented by

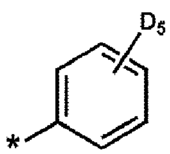

may be identical to a group represented by

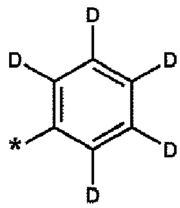

.

**Description of FIG. 1**

FIG. 1 is a schematic cross-sectional view of a light-emitting device 10 according to an embodiment of the disclosure. The light-emitting device 10 includes a first electrode 110, an interlayer 130, and a second electrode 150.

Hereinafter, a structure of the light-emitting device 10 according to an embodiment and a method of manufacturing the light-emitting device 10 will be described in connection with FIG. 1.

**First electrode 110**

In FIG. 1, a substrate may be additionally under the first electrode 110 and/or above the second electrode 150. As the substrate, a glass substrate and/or a plastic substrate may be used. In an embodiment, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, a material for forming the first electrode 110 may be a high work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or any combinations thereof. In one or more embodiments, when the first electrode 110 is a semi-transmissive electrode or a reflective electrode, magnesium (Mg), silver (Ag), aluminum (Al), aluminum-lithium (Al-Li), calcium (Ca), magnesium-indium (Mg-In), magnesium-silver (Mg-Ag), or any combinations thereof may be used as a material for forming the first electrode 110.

The first electrode 110 may have a single-layered structure consisting of a single layer or a multilayer structure including a plurality of layers. In an embodiment, the first electrode 110 may have a three-layered structure of ITO/Ag/ITO.

**Interlayer 130**

The interlayer 130 may be on the first electrode 110. The interlayer 130 may include an emission layer.

The interlayer 130 may further include a hole transport region between the first electrode 110 and the emission layer and an electron transport region between the emission layer and the second electrode 150.

The interlayer 130 may further include metal-containing compounds such as organometallic compounds, inorganic materials such as quantum dots, and/or the like, in addition to various suitable organic materials.

In an embodiment, the interlayer 130 may include i) two or more emitting units sequentially stacked between the first electrode 110 and the second electrode 150, and ii) a charge generation layer between two neighboring emitting units. When the interlayer 130 includes emitting units and a charge generation layer as described above, the light-emitting device 10 may be a tandem light-emitting device.

**Hole transport region in interlayer 130**

The hole transport region may have: i) a single-layered structure consisting of a single layer consisting of a single material, ii) a single-layered structure consisting of a single layer consisting of a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110.

The hole transport region may include a compound represented by Formula 201, a compound represented by Formula 202, or any combination thereof:

Formula 201

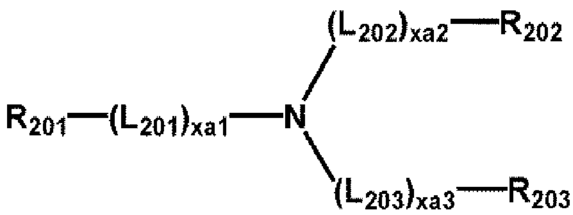

Formula 202

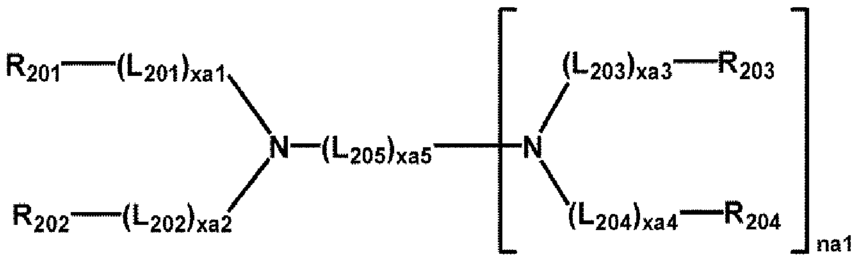

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

xa1 to xa4 may each independently be an integer selected from 0 to 5,

xa5 may be an integer selected from 1 to 10,

$R_{201}$ to $R_{204}$ and $Q_{201}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

$R_{201}$ and $R_{202}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$ to form a $C_8$-$C_{60}$ polycyclic group (for example, a carbazole group and/or the like) unsubstituted or substituted with at least one $R_{10a}$ (for example, see Compound HT16),

$R_{203}$ and $R_{204}$ may optionally be linked to each other, via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and

na1 may be an integer selected from 1 to 4.

In an embodiment, each of Formulae 201 and 202 may include at least one selected from groups represented by Formulae CY201 to CY217.

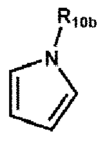
CY201

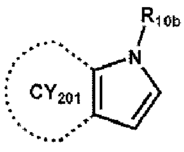
CY202

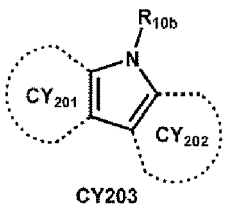
CY203

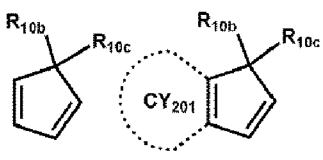
CY204

CY205

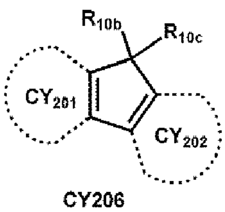
CY206

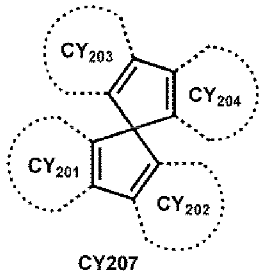
CY207

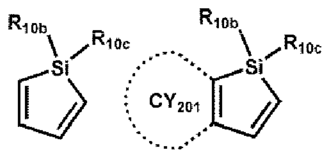
CY208 CY209

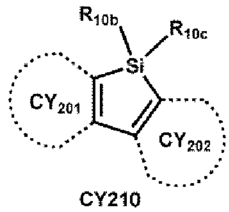
CY210

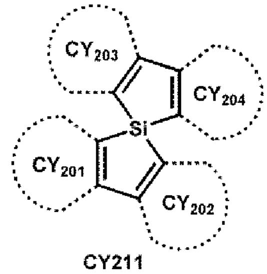
CY211

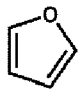
CY212

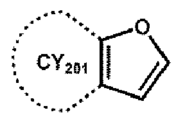
CY213

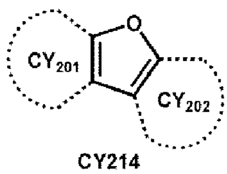
CY214

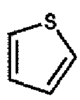
CY215

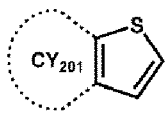
CY216

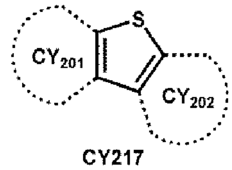
CY217

$R_{10b}$ and $R_{10c}$ in Formulae CY201 to CY217 are respectively the same as described in connection with $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$ as described above.

In an embodiment, ring $CY_{201}$ to ring $CY_{204}$ in Formulae CY201 to CY217 may each independently be a benzene group, a naphthalene group, a phenanthrene group, or an anthracene group.

In an embodiment, each of Formulae 201 and 202 may include at least one selected from groups represented by Formulae CY201 to CY203.

In an embodiment, Formula 201 may include at least one selected from groups represented by Formulae CY201 to CY203 and at least one selected from groups represented by Formulae CY204 to CY217.

In an embodiment, xa1 in Formula 201 may be 1, $R_{201}$ may be a group represented by one selected from Formulae CY201 to CY203, xa2 may be 0, and $R_{202}$ may be a group represented by one selected from Formulae CY204 to CY207.

In an embodiment, each of Formulae 201 and 202 may not include groups represented by Formulae CY201 to CY203.

In an embodiment, each of Formulae 201 and 202 may not include groups represented by Formulae CY201 to CY203, and may include at least one selected from groups represented by Formulae CY204 to CY217.

In an embodiment, each of Formulae 201 and 202 may not include groups represented by Formulae CY201 to CY217.

In an embodiment, the hole transport region may include one selected from Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

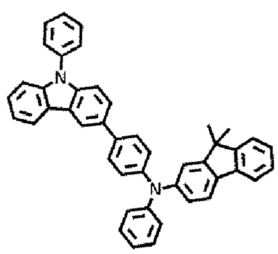
HT1

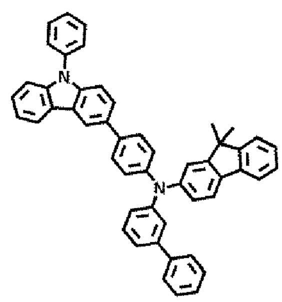
HT2

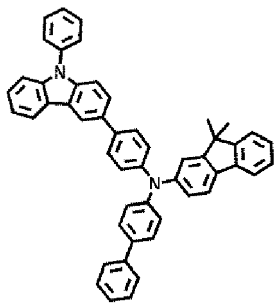
HT3

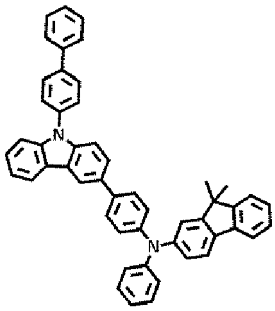
HT4

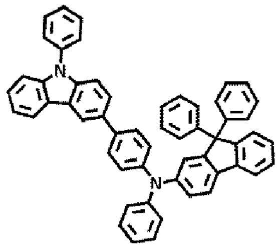
HT5

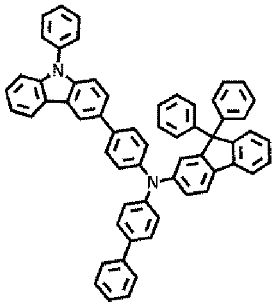
HT6

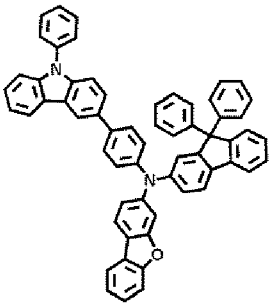
HT7

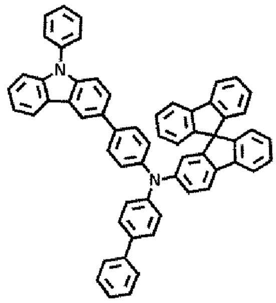
HT8

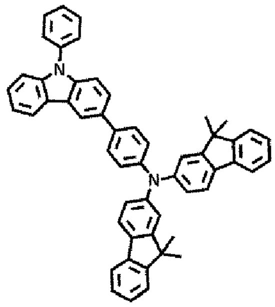
HT9

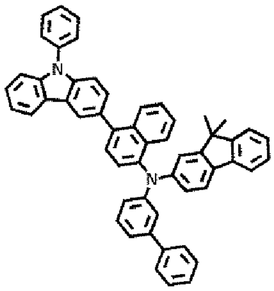
HT10

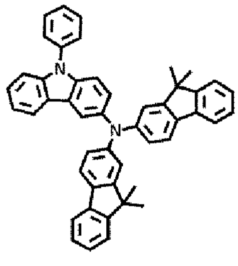
HT11

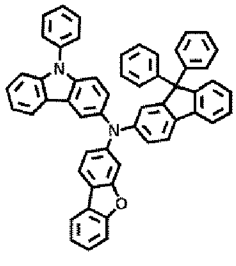
HT12

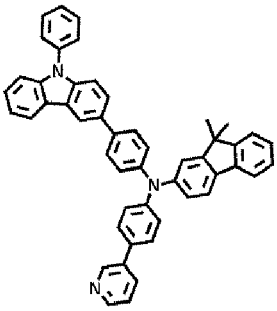
HT13

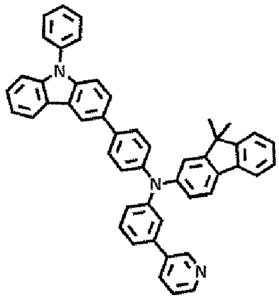
HT14

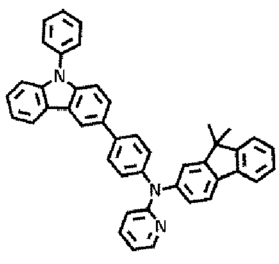
HT15

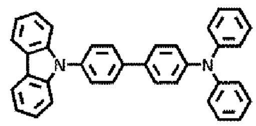

HT16

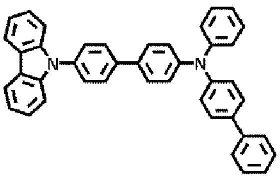

HT17

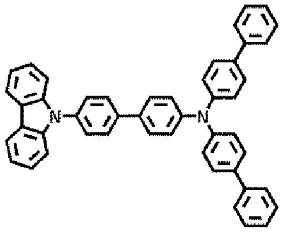

HT18

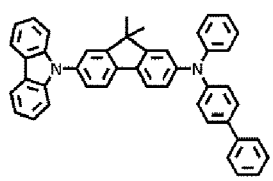

HT19

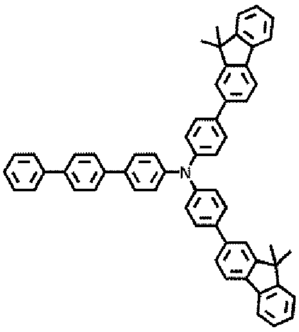

HT20

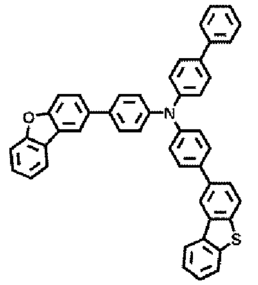

HT21

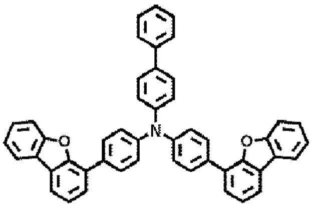

HT22

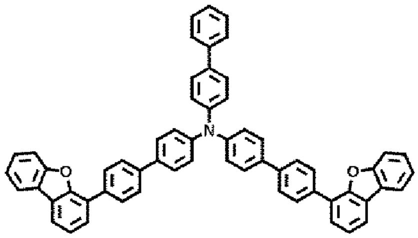

HT23

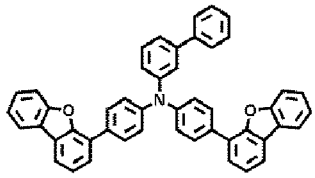

HT24

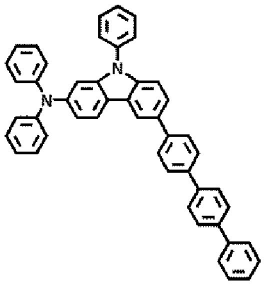

HT25

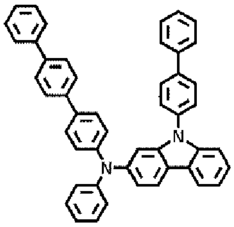

HT26

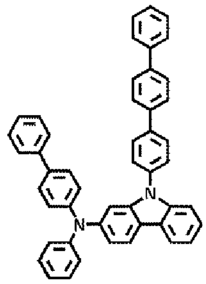

HT27

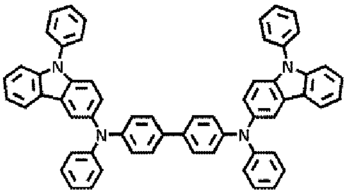

HT28

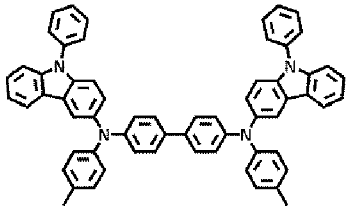

HT29

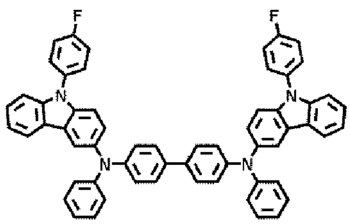

HT30

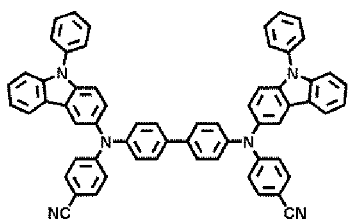

HT31

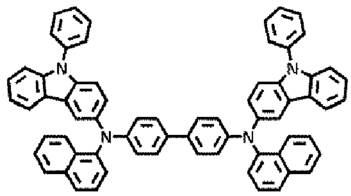

HT32

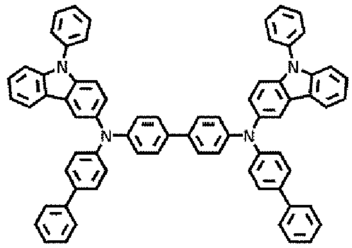

HT33

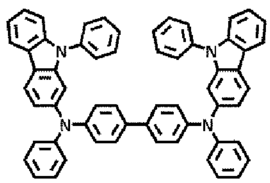

HT34

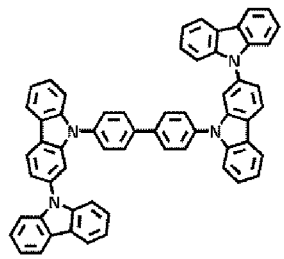

HT35

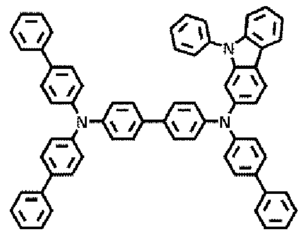

HT36

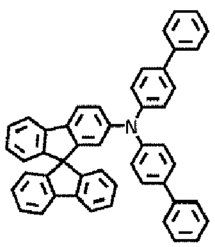

HT37

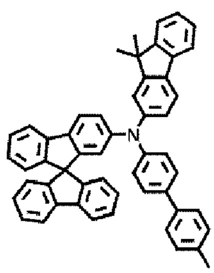

HT38

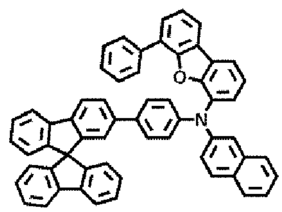

HT39

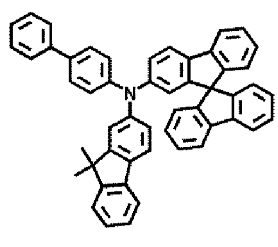

HT40

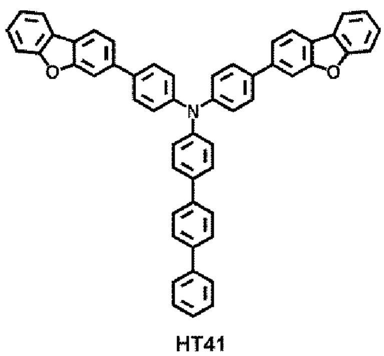

HT41

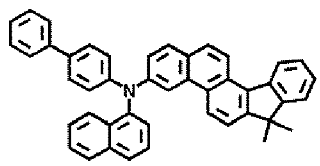

HT42

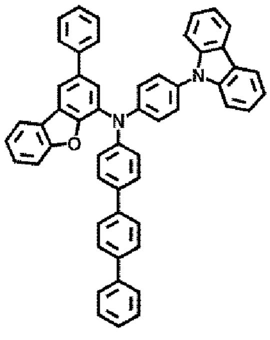

HT43

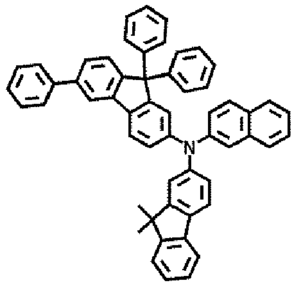

HT44

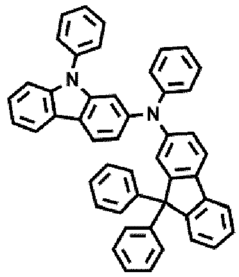

HT45

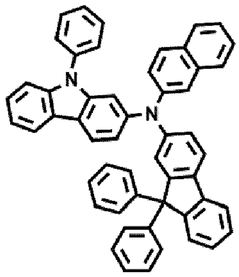

HT46

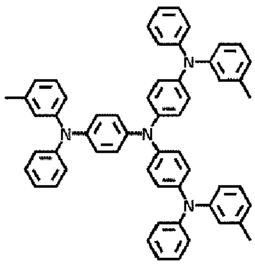

m-MTDATA

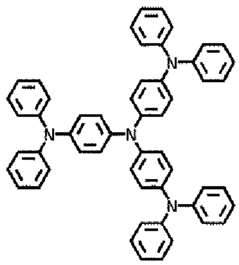

TDATA

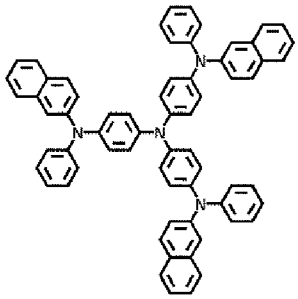

2-TNATA

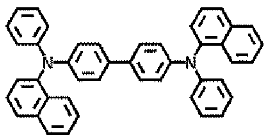

NPB

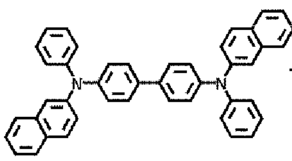

β-NPB

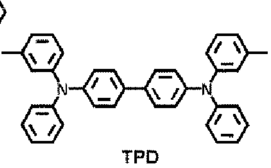

TPD

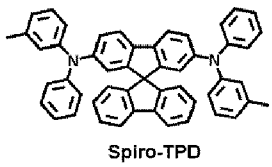

Spiro-TPD

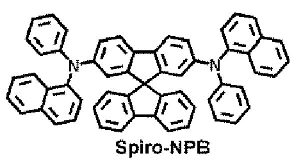

Spiro-NPB

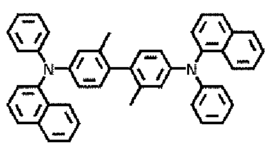

methylated-NPB

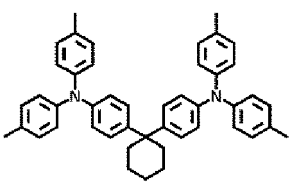

TAPC

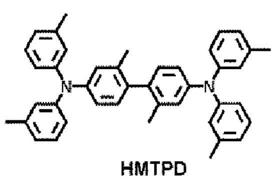

HMTPD

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole

injection layer and the hole transport layer are within these ranges, suitable or satisfactory hole-transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the leakage of electrons from an emission layer to a hole transport region. Materials that may be included in the hole transport region may be included in the emission auxiliary layer and the electron blocking layer.

**p-dopant**

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer consisting of a charge-generation material).

The charge-generation material may be, for example, a p-dopant.

In an embodiment, a LUMO energy level of the p-dopant may be about -3.5 eV or less.

In an embodiment, the p-dopant may include a quinone derivative, a cyano group-containing compound, a compound containing element EL1 and element EL2, or any combination thereof.

Examples of the quinone derivative may include TCNQ, F4-TCNQ, and the like.

Examples of the cyano group-containing compound may include HAT-CN, a compound represented by Formula 221 below, and the like.

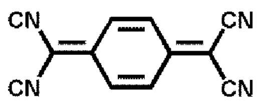

TCNQ

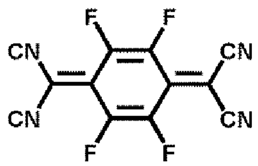

F4-TCNQ

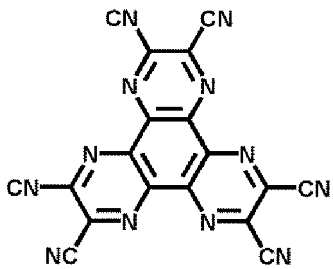

HAT-CN

Formula 221

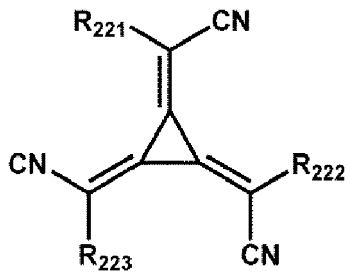

In Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and
at least one selected from $R_{221}$ to $R_{223}$ may each independently be a $C_3$-$C_{60}$ carbocyclic group or a $C_1$-$C_{60}$ heterocyclic group, each substituted with: a cyano group; -F; -Cl; -Br; -I; a $C_1$-$C_{20}$ alkyl group substituted with a cyano group, -F, -Cl, -Br, -I, or any combination thereof; or any combination thereof.

In the compound containing element EL1 and element EL2, element EL1 may be metal, metalloid, or a combination thereof, and element EL2 may be non-metal, metalloid, or a combination thereof.

Examples of the metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc),

rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid may include silicon (Si), antimony (Sb), and tellurium (Te).

Examples of the non-metal may include oxygen (O) and halogen (for example, F, Cl, Br, I, etc.).

In an embodiment, examples of the compound containing element EL1 and element EL2 may include metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or any combination thereof.

Examples of the metal oxide may include tungsten oxide (for example, WO, $W_2O_3$, $WO_2$, $WO_3$, $W_2O_5$, etc.), vanadium oxide (for example, VO, $V_2O_3$, $VO_2$, $V_2O_5$, etc.), molybdenum oxide (MoO, $Mo_2O_3$, $MoO_2$, $M0O_3$, $Mo_2O_5$, etc.), and rhenium oxide (for example, $ReO_3$, etc.).

Examples of the metal halide may include alkali metal halide, alkaline earth metal halide, transition metal halide, post-transition metal halide, and lanthanide metal halide.

Examples of the alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of the alkaline earth metal halide may include $BeF_2$, $MgF_2$, $CaF_2$, SrF2, BaF2, $BeCl_2$, $MgCl_2$, $CaCl_2$, $SrCl_2$, $BaCl_2$, BeBr2, MgBr2, CaBr2, SrBr2, BaBr2, $BeI_2$, MgI2, $CaI_2$, $SrI_2$, and $BaI_2$.

Examples of the transition metal halide may include titanium halide (for example, $TiF_4$, $TiCl_4$, $TiBr_4$, $TiI_4$, etc.), zirconium halide (for example, $ZrF_4$, $ZrCl_4$, $ZrBr_4$, $ZrI_4$, etc.), hafnium halide (for example, $HfF_4$, $HfCl_4$, $HfBr_4$, $HfI_4$, etc.), vanadium halide (for example, $VF_3$, $VCl_3$, $VBr_3$, $VI_3$, etc.), niobium halide (for example, $NbF_3$, $NbCl_3$, $NbBr_3$, $NbI_3$, etc.), tantalum halide (for example, $TaF_3$, $TaCl_3$, $TaBr_3$, $TaI_3$, etc.), chromium halide (for example, $CrF_3$, $CrCl_3$, $CrBr_3$, $CrI_3$, etc.), molybdenum halide (for example, $MoF_3$, $MoCl_3$, $MoBr_3$, $MoI_3$, etc.), tungsten halide (for example, $WF_3$, $WCl_3$, $WBr_3$, $WI_3$, etc.), manganese halide (for example, $MnF_2$, $MnCl_2$, $MnBr_2$, $MnI_2$, etc.), technetium halide (for example, $TcF_2$, $TcCl_2$, $TcBr_2$, $TcI_2$, etc.), rhenium halide (for example, $ReF_2$, $ReCl_2$, $ReBr_2$, $ReI_2$, etc.), iron halide (for example, $FeF_2$, $FeCl_2$, $FeBr_2$, $FeI_2$, etc.), ruthenium halide (for example, $RuF_2$, $RuCl_2$, $RuBr_2$, $RuI_2$, etc.), osmium halide (for example, $OsF_2$, $OsCl_2$, $OsBr_2$, $OsI_2$, etc.), cobalt halide (for example, $CoF_2$, $CoCl_2$, $CoBr_2$, $CoI_2$, etc.), rhodium halide (for example, $RhF_2$, $RhCl_2$, $RhBr_2$, $RhI_2$, etc.), iridium halide (for example, $IrF_2$, $IrCl_2$, $IrBr_2$, $IrI_2$, etc.), nickel halide (for example, $NiF_2$, $NiCl_2$, $NiBr_2$, $NiI_2$, etc.), palladium halide (for example, $PdF_2$, $PdCl_2$, $PdBr_2$, $PdI_2$, etc.), platinum halide (for example, $PtF_2$, $PtCl_2$, $PtBr_2$, $PtI_2$, etc.), copper halide (for example, CuF, CuCl, CuBr, CuI, etc.), silver halide (for example, AgF, AgCl, AgBr, AgI, etc.), and gold halide (for example, AuF, AuCl, AuBr, AuI, etc.).

Examples of the post-transition metal halide may include zinc halide (for example, $ZnF_2$, $ZnCl_2$, $ZnBr_2$, $ZnI_2$, etc.), indium halide (for example, $InI_3$, etc.), and tin halide (for example, $SnI_2$, etc.).

Examples of the lanthanide metal halide may include YbF, $YbF_2$, $YbF_3$, $SmF_3$, YbCl, $YbCl_2$, $YbCl_3$, $SmCl_3$, YbBr, $YbBr_2$, $YbBr_3$, $SmBr_3$, YbI, $YbI_2$, $YbI_3$, $SmI_3$, and the like.

Examples of the metalloid halide may include antimony halide (for example, $SbCl_5$, etc.).

Examples of the metal telluride may include alkali metal telluride (for example, $Li_2Te$, $Na_2Te$, $K_2Te$, $Rb_2Te$, $Cs_2Te$, etc.), alkaline earth metal telluride (for example, BeTe, MgTe, CaTe, SrTe, BaTe, etc.), transition metal telluride (for example, TiTe2, ZrTe2, HfTe2, V2Te3, Nb2Te3, Ta2Te3, Cr2Te3, $Mo_2Te_3$, W2Te3, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

**[Emission layer in interlayer 130**

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact (e.g., physically contact) each other or are spaced apart from each other. In one or more embodiments, the emission layer may include two or more materials of a red light-emitting material, a green light-emitting material, and a blue light-emitting material, in which the two or more materials are mixed together with each other in a single layer to emit white light.

In an embodiment, the emission layer may include a host and a dopant (or emitter). In an embodiment, the emission layer may further include an auxiliary dopant that promotes energy transfer to a dopant (or emitter), in addition to the host and the dopant (or emitter). When the emission layer includes the dopant (or emitter) and the auxiliary dopant, the dopant (or emitter) and the auxiliary dopant are different from each other.

The organometallic compound represented by Formula 1 in the present specification may serve as the dopant (or emitter), or may serve as the auxiliary dopant.
An amount of the dopant (or emitter) in the emission layer may be in a range of about 0.01 parts by weight to about 15 parts by weight based on 100 parts by weight of the host.
A thickness of the emission layer may be in a range of about 100 Å to about 1,000 Å, for example, about 200 Å to about 600 Å. When the thickness of the emission layer is within the range, excellent light-emission characteristics may be obtained without a substantial increase in driving voltage.

**Host**

The host in the emission layer may include the second compound or the third compound described in the present specification, or any combination thereof.
In an embodiment, the host may include a compound represented by Formula 301 below:

Formula 301 $[Ar_{301}]_{xb11}$-$[(L_{301})_{xb1}$-$R_{301}]_{xb21}$

wherein, in Formula 301,
$Ar_{301}$ and $L_{301}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb11 may be 1, 2, or 3,
xb1 may be an integer selected from 0 to 5,
$R_{301}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$,-Si($Q_{301}$)($Q_{302}$)($Q_{303}$), -N($Q_{301}$)($Q_{302}$), -B($Q_{301}$)($Q_{302}$), -C(=O)($Q_{301}$), -S(=O)$_2$($Q_{301}$), or -P(=O)($Q_{301}$)($Q_{302}$),
xb21 may be an integer from 1 to 5, and
$Q_{301}$ to $Q_{303}$ are respectively the same as described in connection with $Q_1$ in the present specification.

In an embodiment, when xb11 in Formula 301 is 2 or more, two or more of $Ar_{301}$(s) may be linked to each other via a single bond.
In an embodiment, the host may include a compound represented by Formula 301-1, a compound represented by Formula 301-2, or any combination thereof:

Formula 301-1

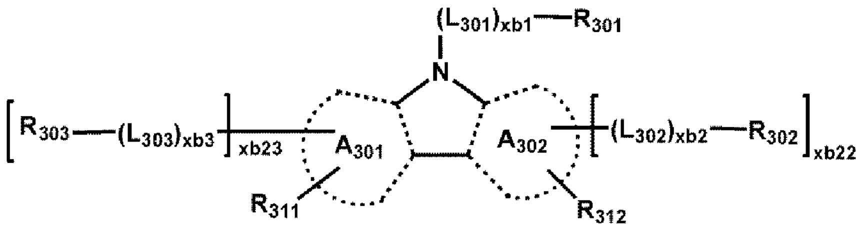

Formula 301-2

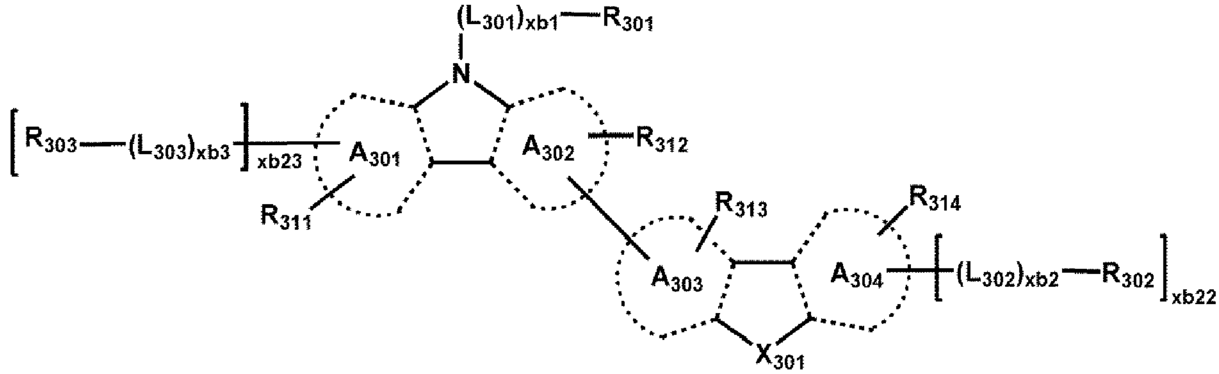

wherein, in Formulae 301-1 and 301-2,
ring A301 to ring A304 may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C(R304)(R305), or Si(R304)(R305),
xb22 and xb23 may each independently be 0, 1, or 2,
$L_{301}$, xb1, and $R_{301}$ are respectively the same as described in the present specification,
$L_{302}$ to $L_{304}$ are each independently the same as described in connection with $L_{301}$,
xb2 to xb4 are each independently the same as described in connection with xb1, and
$R_{302}$ to $R_{305}$ and $R_{311}$ to $R_{314}$ are respectively the same as described in connection with $R_{301}$ in the present specification.

In an embodiment, the host may include an alkali earth metal complex, a post-transition metal complex, or a combination thereof. In an embodiment, the host may include a Be complex (for example, Compound H55), an Mg complex, a Zn complex, or a combination thereof.

In an embodiment, the host may include one selected from Compounds H1 to H124, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-(9-carbazolyl)benzene (mCP), 1,3,5-tri(carbazol-9-yl)benzene (TCP), or any combination thereof:

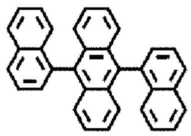
H1

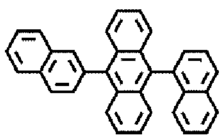
H2

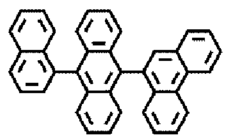
H3

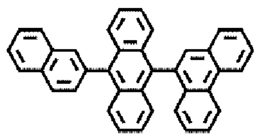
H4

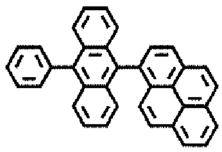
H5

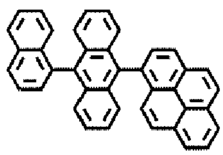
H6

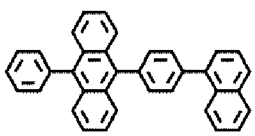
H7

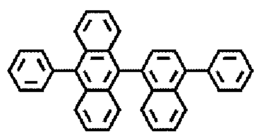
H8

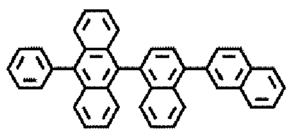
H9

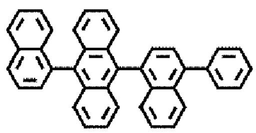
H10

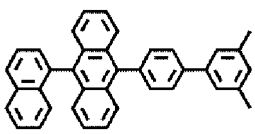
H11

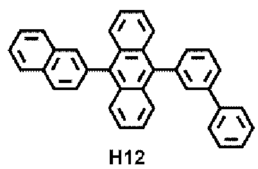
H12

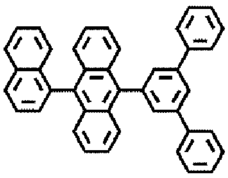
H13

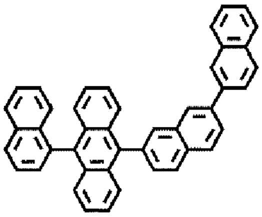
H14

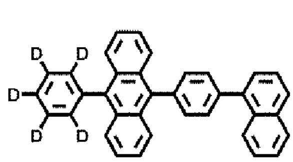
H15

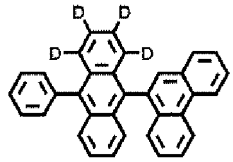
H16

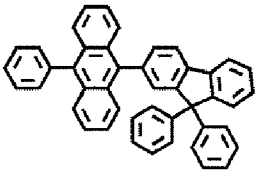
H17

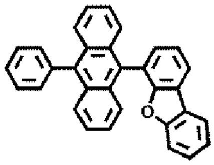
H18

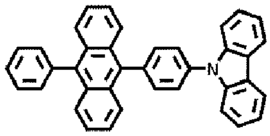
H19

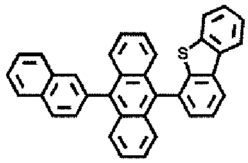
H20

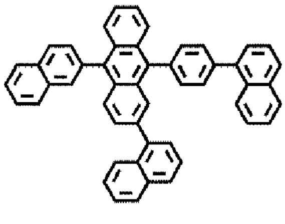
H21

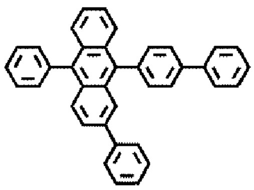
H22

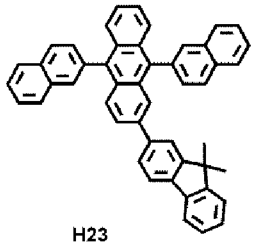
H23

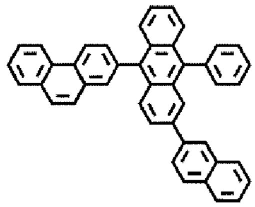
H24

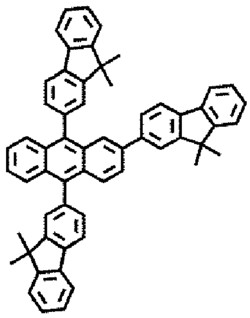
H25

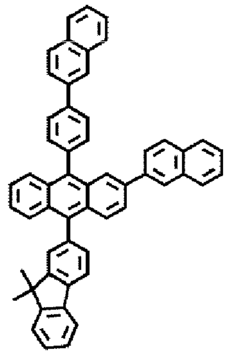
H26

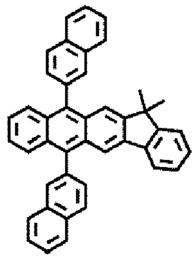
H27

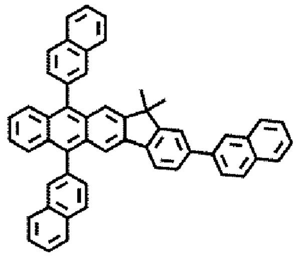
H28

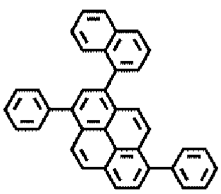
H29

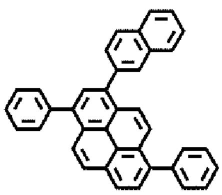
H30

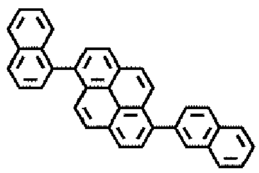
H31

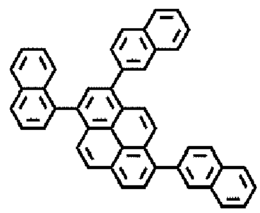
H32

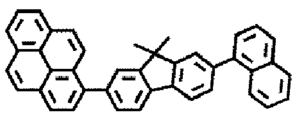
H33

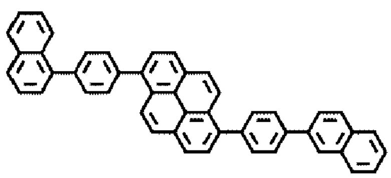
H34

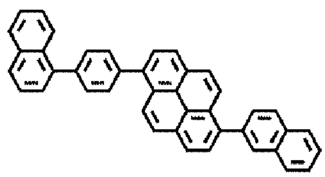
H35

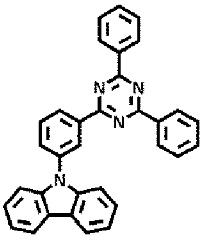
H36

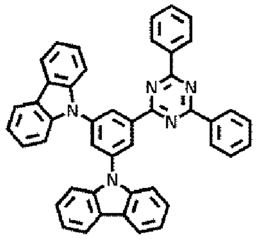
H37

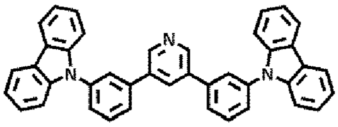
H38

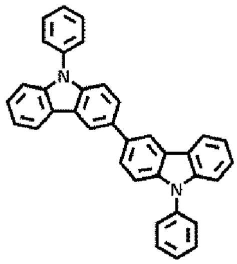
H39

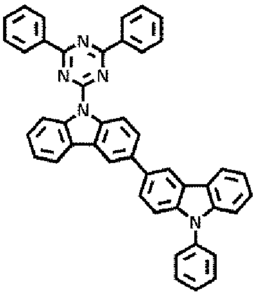
H40

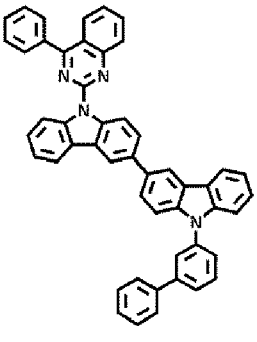
H41

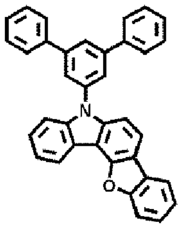
H42

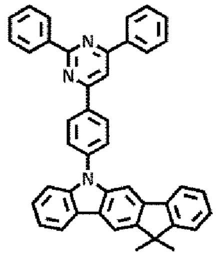
H43

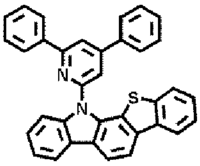
H44

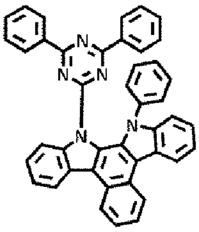
H45

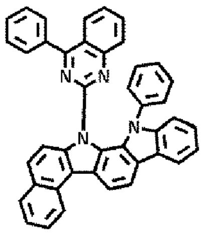
H46

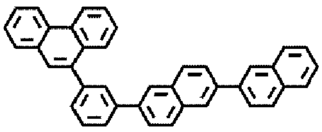
H47

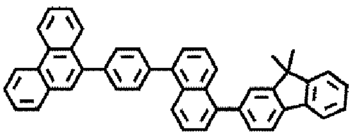
H48

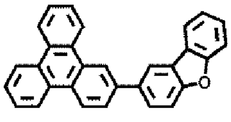
H49

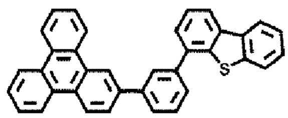
H50

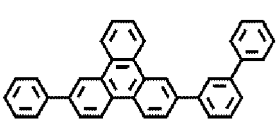
H51

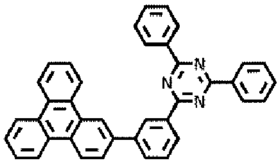
H52

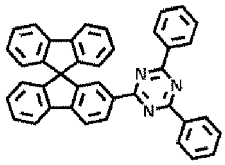
H53

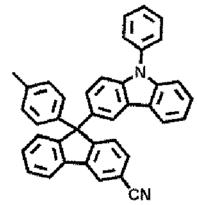
H54

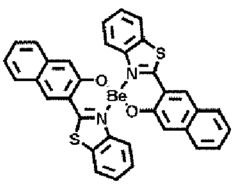
H55

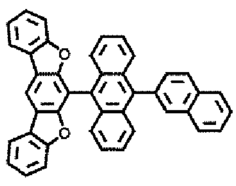
H56

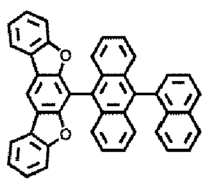
H57

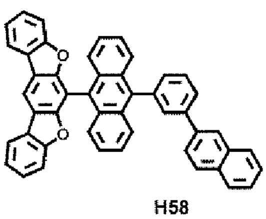
H58

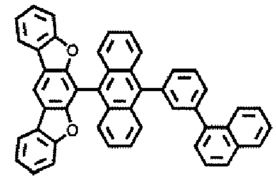
H59

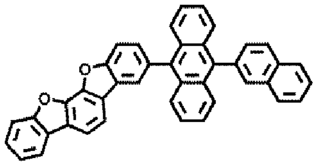
H60

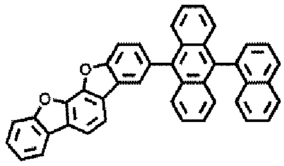
H61

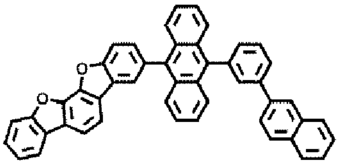
H62

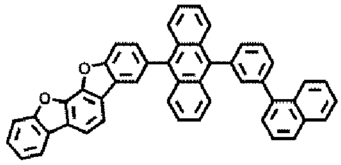
H63

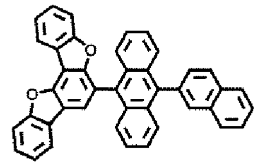
H64

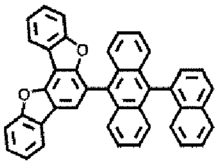
H65

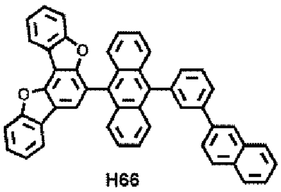
H66

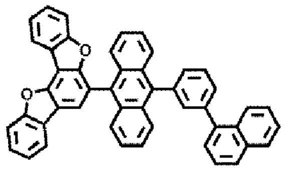
H67

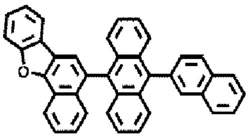
H68

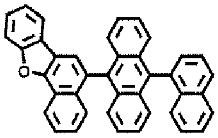
H69

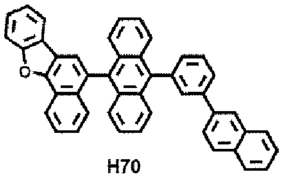
H70

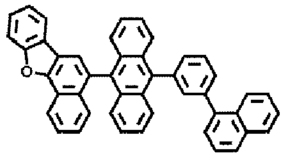
H71

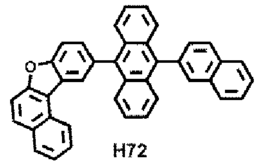
H72

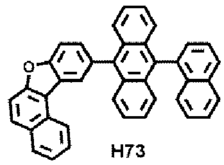
H73

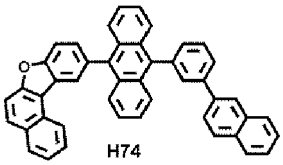
H74

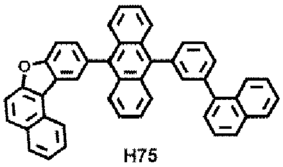
H75

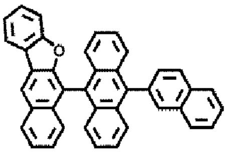
H76

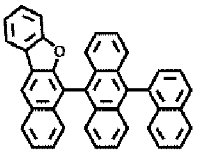
H77

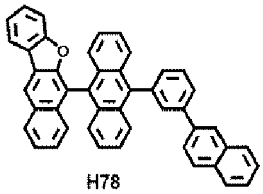
H78

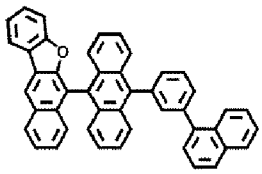
H79

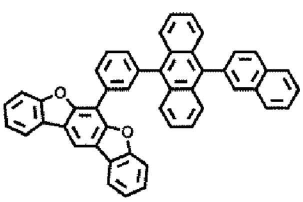
H80

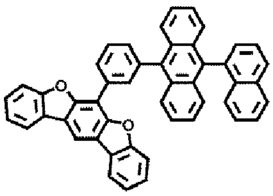
H81

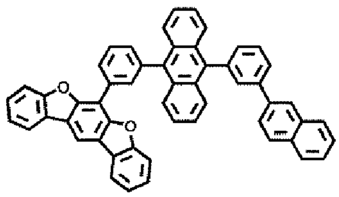
H82

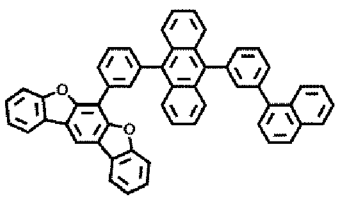
H83

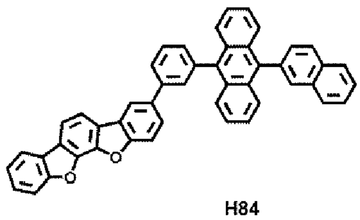
H84

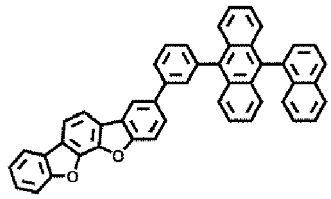
H85

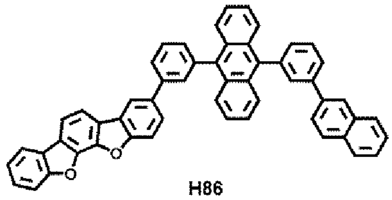
H86

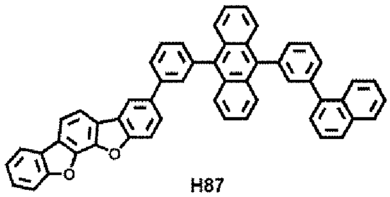
H87

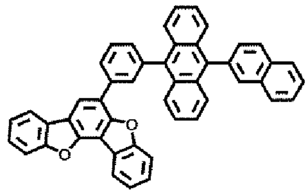
H88

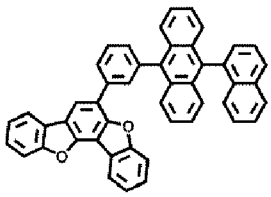
H89

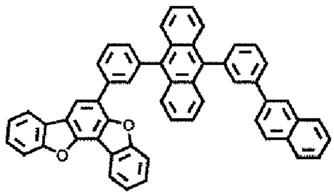
H90

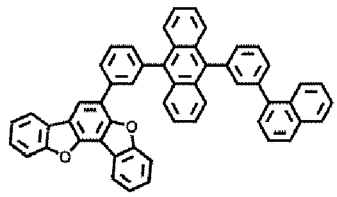
H91

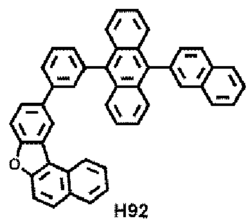
H92

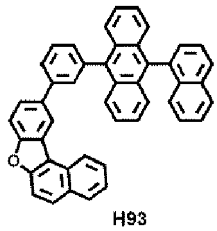
H93

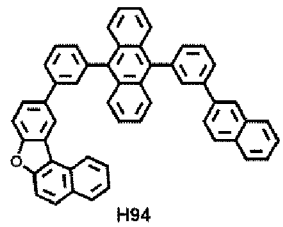
H94

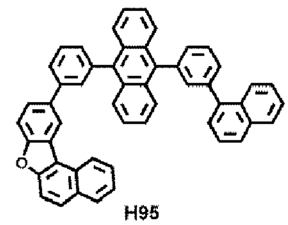
H95

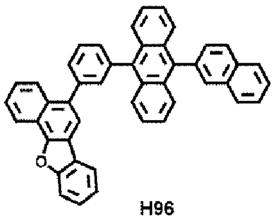
H96

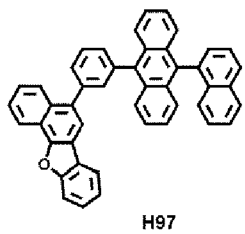
H97

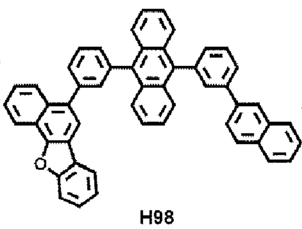
H98

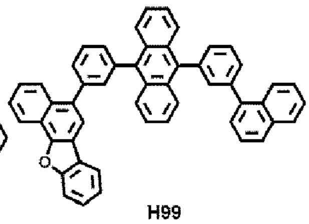
H99

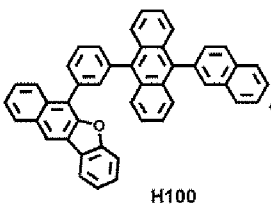
H100

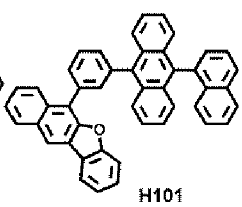
H101

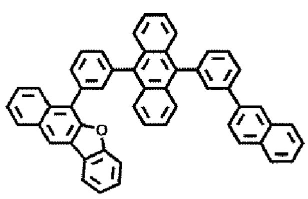
H102

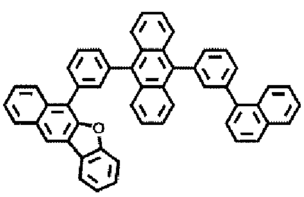
H103

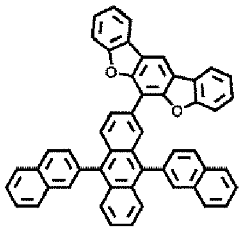
H104

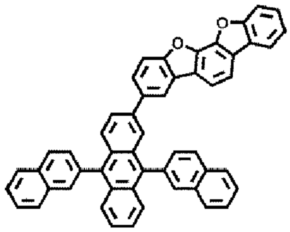
H105

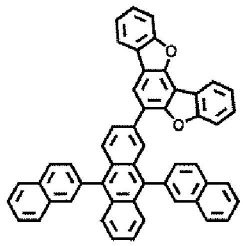
H106

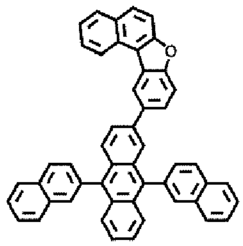
H107

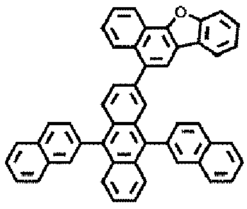
H108

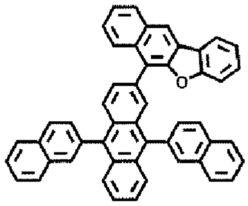
H109

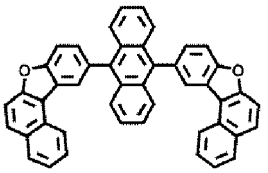
H110

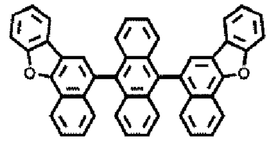
H111

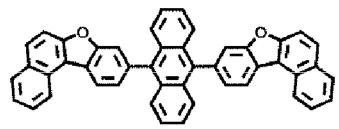
H112

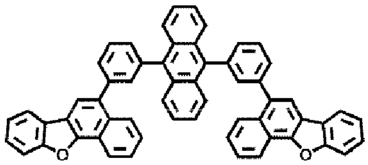
H113

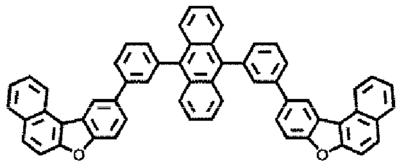
H114

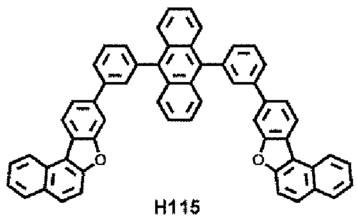
H115

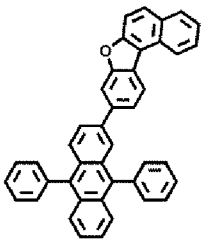
H116

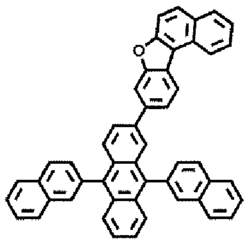
H117

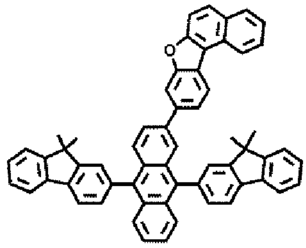
H118

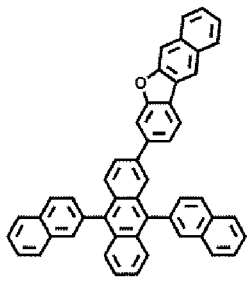
H119

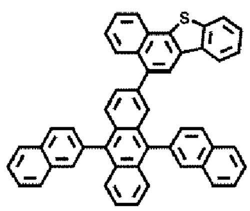
H120

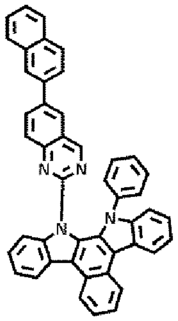
H121

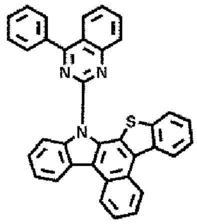
H122

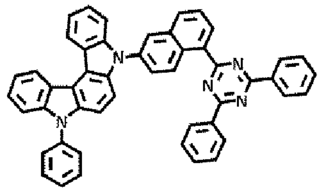
H123

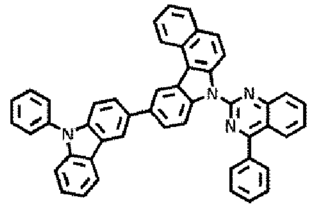
H124

.

In an embodiment, the host may include a silicon-containing compound, a phosphine oxide-containing compound, or any combination thereof.

The host may have various suitable modifications. In an embodiment, the host may include only one kind of compound, or may include two or more kinds of different compounds.

**Phosphorescent dopant**

The emission layer may include, as a phosphorescent dopant, an organometallic compound represented by Formula 1 as described in the present specification or an organometallic compound including platinum and a tetradentate ligand.

In an embodiment, the emission layer may include an organometallic compound represented by Formula 1 as described in the present specification or an organometallic compound including platinum and a tetradentate ligand, and when the organometallic compound represented by Formula 1 as described in the present specification or the organometallic compound including the platinum and the tetradentate ligand serves an auxiliary dopant, the emission layer may include a phosphorescent dopant.

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In an embodiment, the phosphorescent dopant may include an organometallic compound represented by Formula 401:

Formula 401 $M(L_{401})_{xc1}(L_{402})_{xc2}$

Formula 402

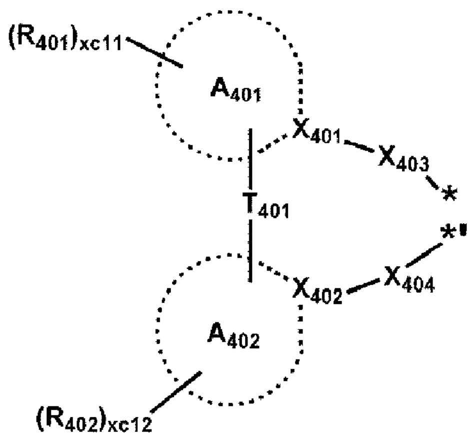

wherein, in Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),

$L_{401}$ may be a ligand represented by Formula 402, and xc1 may be 1, 2, or 3, wherein, when xc1 is two or more, two or more of $L_{401}$(s) may be identical to or different from each other,

$L_{402}$ may be an organic ligand, and xc2 may be 0, 1, 2, 3, or 4, wherein, when xc2 is 2 or more, two or more of $L_{402}$(s) may be identical to or different from each other,

$X_{401}$ and $X_{402}$ may each independently be nitrogen or carbon,

ring A401 and ring A402 may each independently be a $C_3$-$C_{60}$ carbocyclic group or a $C_1$-$C_{60}$ heterocyclic group,

$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C=*',

$X_{403}$ and $X_{404}$ may each independently be a chemical bond (for example, a covalent bond or a coordinate bond), O, S, N(Q413), B(Q413), P(Q413), C($Q_{413}$)($Q_{414}$), or Si(Q413)(Q414),

$Q_{411}$ to $Q_{414}$ are respectively the same as described in connection with $Q_1$ in the present specification,

$R_{401}$ and $R_{402}$ may each independently be hydrogen, deuterium, -F, -Cl, -Br, - I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), - S(=O)$_2$($Q_{401}$), or -P(=O)($Q_{401}$)($Q_{402}$),

$Q_{401}$ to $Q_{403}$ are respectively the same as described in connection with $Q_1$ in the present specification,

xc11 and xc12 may each independently be an integer selected from 0 to 10, and

* and *' in Formula 402 each indicate a binding site to M in Formula 401.

In an embodiment, in Formula 402, i) $X_{401}$ may be nitrogen, and $X_{402}$ may be carbon, or ii) each of $X_{401}$ and $X_{402}$ may be nitrogen.

In an embodiment, when xc1 in Formula 401 is 2 or more, two ring $A_{401}$ in two or more of $L_{401}$(s) may be optionally linked to each other via T402, which is a linking group, and two ring A402 may optionally be linked to each other via T403, which is a linking group (see Compounds PD1 to PD4 and PD7). $T_{402}$ and $T_{403}$ are respectively the same as described in connection with $T_{401}$ in the present specification.

$L_{402}$ in Formula 401 may be an organic ligand. In an embodiment, $L_{402}$ may include a halogen group, a diketone group (for example, an acetylacetonate group), a carboxylic acid group (for example, a picolinate group), -C(=O), an isonitrile group, -CN group, a phosphorus-containing group (for example, a phosphine group, a phosphite group, etc.), or any combination thereof.

The phosphorescent dopant may include, for example, one selected from compounds PD1 to PD25 or any combination thereof:

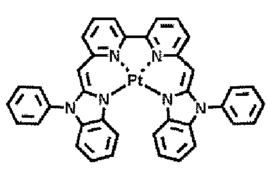
PD1

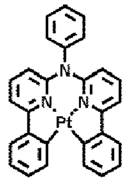
PD2

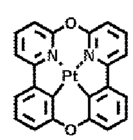
PD3

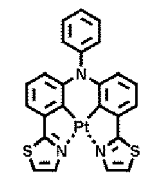
PD4

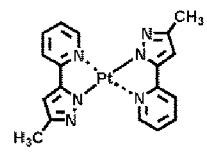
PD5

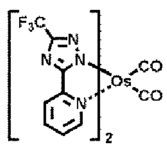
PD6

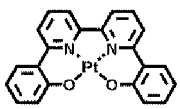
PD7

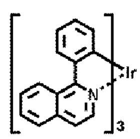
PD8

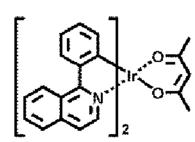
PD9

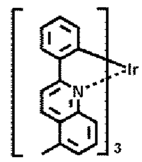
PD10

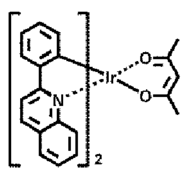
PD11

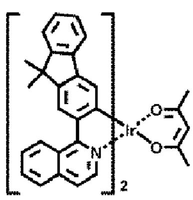
PD12

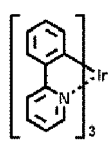
PD13

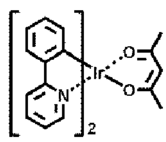
PD14

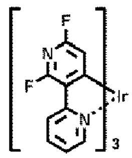
PD15

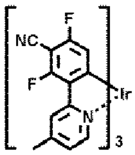
PD16

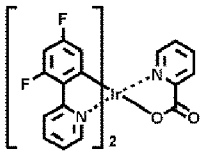
PD17

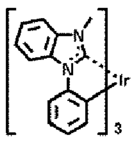
PD18

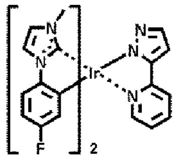
PD19

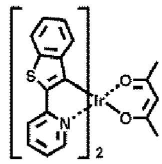
PD20

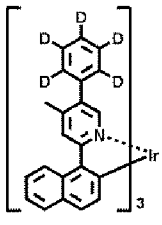
PD21

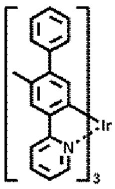
PD22

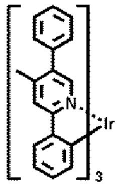
PD23

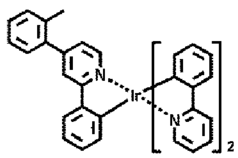
PD24

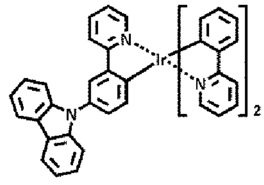
PD25

.

**Fluorescent dopant**

The emission layer may include an organometallic compound represented by Formula 1 as described in the present specification or an organometallic compound including platinum and a tetradentate ligand, and when the organometallic compound represented by Formula 1 as described in the present specification or the organometallic compound including the platinum and the tetradentate ligand serves an auxiliary dopant, the emission layer may further include a fluorescent dopant.

In an embodiment, the emission layer may include an organometallic compound represented by Formula 1 as described in the present specification or an organometallic compound including platinum and a tetradentate ligand, and when the organometallic compound represented by Formula 1 as described in the present specification or the organometallic compound including the platinum and the tetradentate ligand serves a phosphorescent dopant, the emission layer may further include an auxiliary dopant.

The fluorescent dopant and the auxiliary dopant may each independently include an arylamine compound, a styrylamine compound, a boron-containing compound, or any combination thereof.

In an embodiment, the fluorescent dopant and the auxiliary dopant may each independently include a compound represented by Formula 501 below:

Formula 501

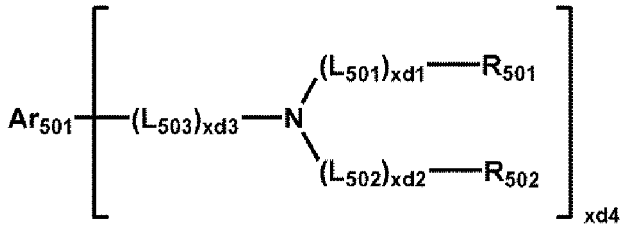

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

xd1 to xd3 may each independently be 0, 1, 2, or 3, and

xd4 may be 1, 2, 3, 4, 5, or 6.

In an embodiment, $Ar_{501}$ in Formula 501 may be a condensed cyclic group (for example, an anthracene group, a chrysene group, or a pyrene group) in which three or more monocyclic groups are condensed together.

In an embodiment, xd4 in Formula 501 may be 2.

In an embodiment, the fluorescent dopant and the auxiliary dopant may each include one selected from Compounds FD1 to FD36, DPVBi, DPAVBi, or any combination thereof:

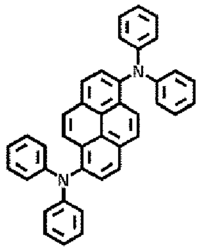

FD1

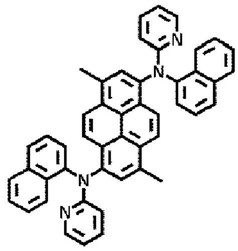

FD2

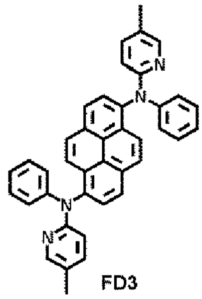

FD3

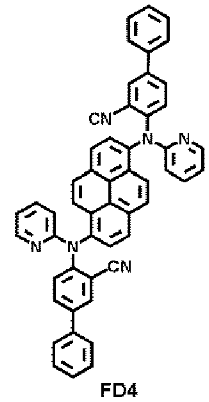

FD4

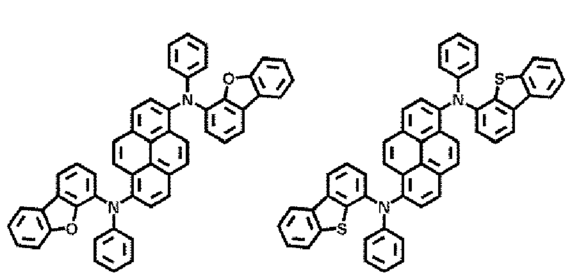

FD5

FD6

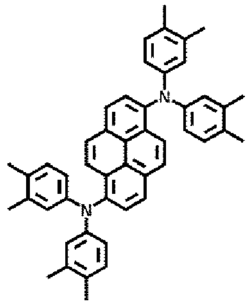

FD7

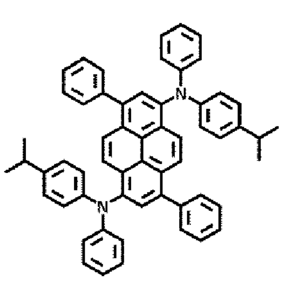

FD8

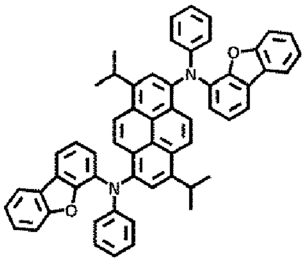

FD9

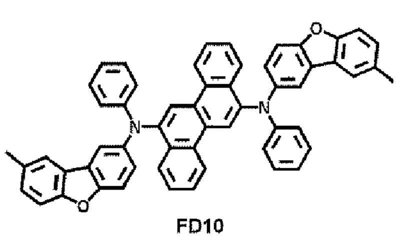

FD10

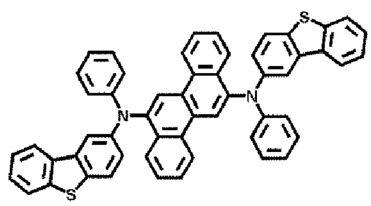

FD11

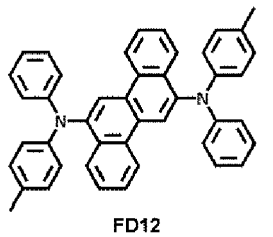

FD12

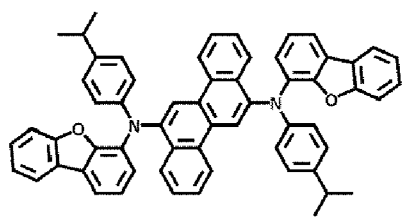

FD13

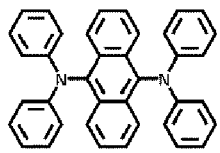

FD14

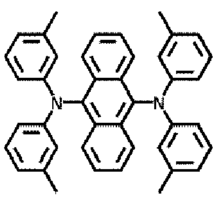

FD15

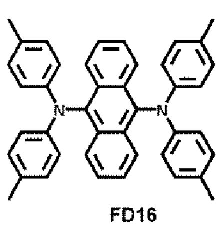

FD16

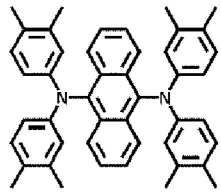

FD17

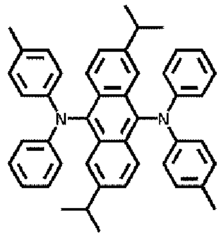

FD18

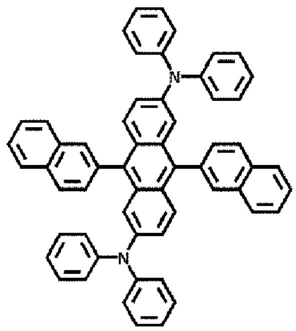
FD19

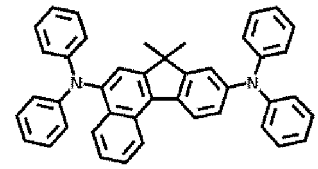
FD20

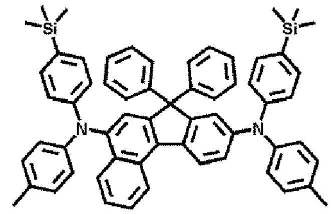
FD21

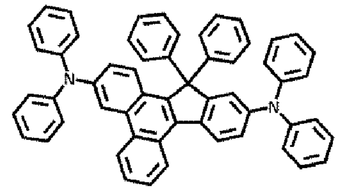
FD22

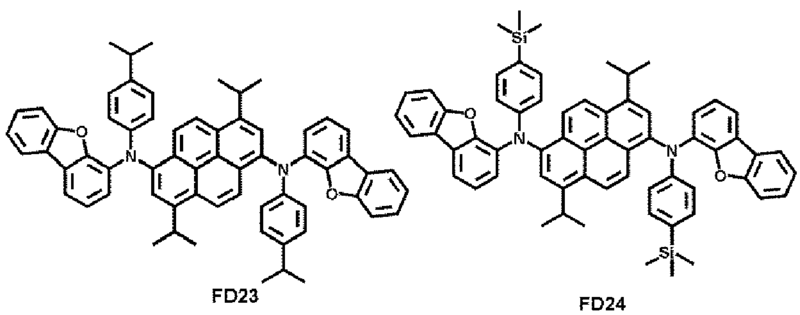
FD23

FD24

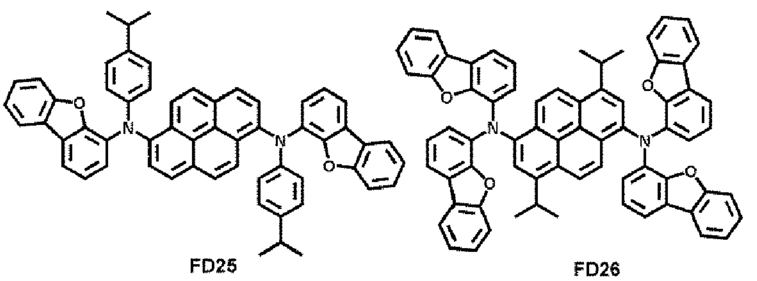
FD25

FD26

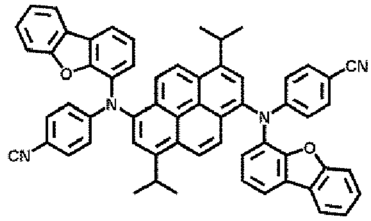
FD27

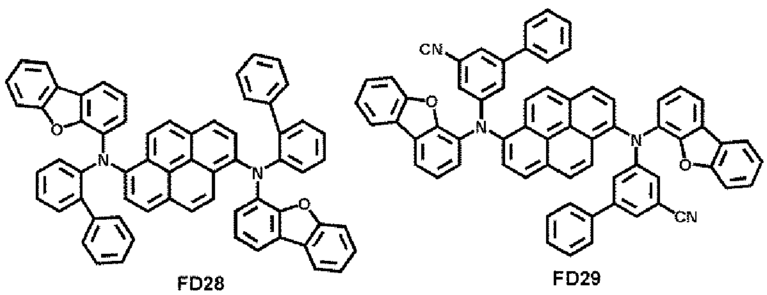
FD28

FD29

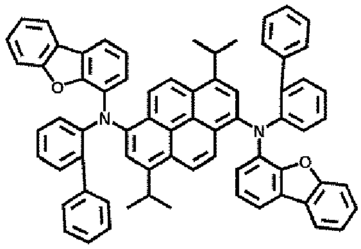
FD30

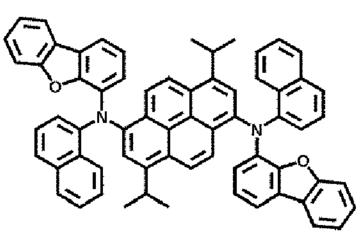
FD31

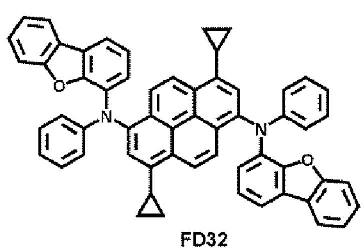
FD32

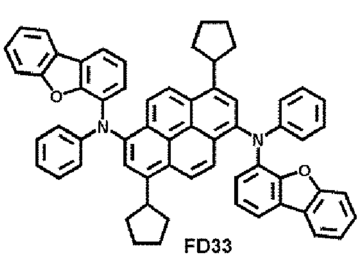
FD33

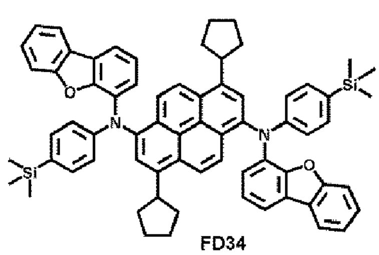

FD34

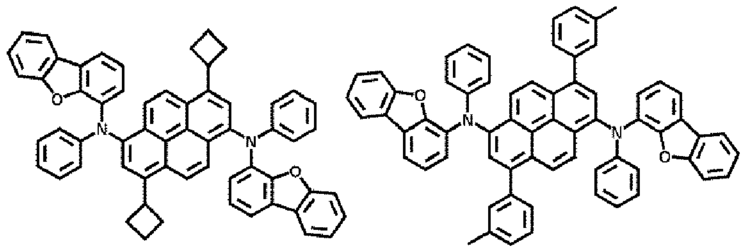

FD35

FD36

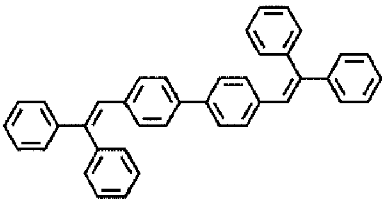

DPVBi

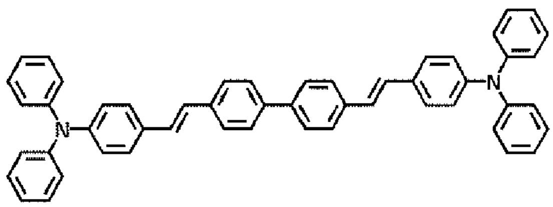

DPAVBi .

In an embodiment, the fluorescent dopant and the auxiliary dopant may each independently include the fourth compound represented by Formula 502 or 503 as described in the present specification.

## Electron transport region in interlayer 130

The electron transport region may have: i) a single-layered structure consisting of a single layer consisting of a single material, ii) a single-layered structure consisting of a single layer consisting of a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In an embodiment, the electron transport region (for example, the buffer layer, the hole-blocking layer, the electron control layer, or the electron transport layer in the electron transport region) may include a metal-free compound including at least one $\pi$ electron-deficient nitrogen-containing $C_1$-$C_{60}$ cyclic group.

In an embodiment, the electron transport region may include a compound represented by Formula 601 below:

Formula 601 $$[Ar_{601}]_{xe11}\text{-}[(L_{601})_{xe1}\text{-}R_{601}]_{xe21}$$

wherein, in Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

xe11 may be 1, 2, or 3,

xe1 may be 0, 1, 2, 3, 4, or 5,

$R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{601})(Q_{602})(Q_{603})$, $-C(=O)(Q_{601})$, $-S(=O)_2(Q_{601})$, or $-P(=O)(Q_{001})(Q_{002})$,

$Q_{601}$ to $Q_{603}$ are respectively the same as described in connection with $Q_1$,

xe21 may be 1, 2, 3, 4, or 5, and

at least one selected from $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

In an embodiment, when xe11 in Formula 601 is 2 or more, two or more of $Ar_{601}$(s) may be linked via a single bond.

In an embodiment, $Ar_{601}$ in Formula 601 may be a substituted or unsubstituted anthracene group.

In an embodiment, the electron transport region may include a compound represented by Formula 601-1:

Formula 601-1

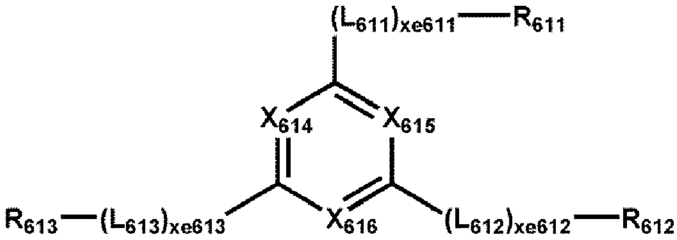

wherein, in Formula 601-1,

$X_{614}$ may be N or $C(R_{614})$, $X_{615}$ may be N or $C(R_{615})$, $X_{616}$ may be N or $C(R_{616})$, at least one selected from $X_{614}$ to $X_{616}$ may be N,

$L_{611}$ to $L_{613}$ are respectively the same as described in connection with $L_{601}$,

xe611 to xe613 are respectively the same as described in connection with xe1,

$R_{611}$ to $R_{613}$ are respectively the same as described in connection with $R_{601}$, and

$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

In an embodiment, xe1 and xe611 to xe613 in Formulae 601 and 601-1 may each independently be 0, 1, or 2.

The electron transport region may include one selected from Compounds ET1 to ET46, 2,9-dimethyl-4,7-diphenyl-1,10-phenanthroline (BCP), 4,7-diphenyl-1,10-phenanthroline (Bphen), $Alq_3$, BAlq, TAZ, NTAZ, or any combination thereof:

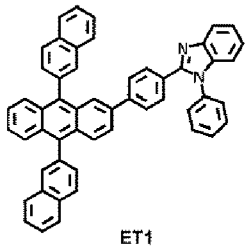
ET1

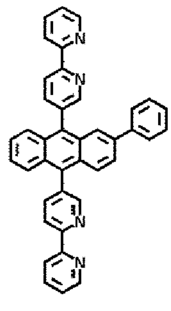
ET2

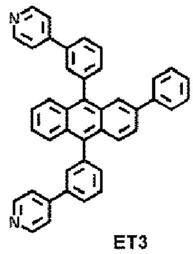
ET3

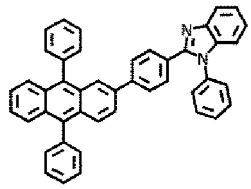
ET4

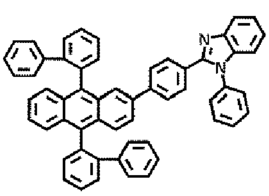
ET5

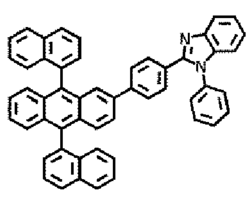
ET6

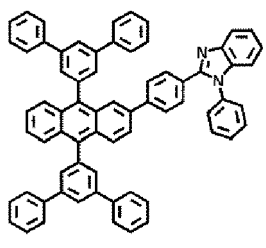
ET7

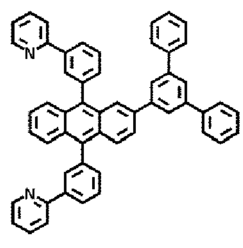
ET8

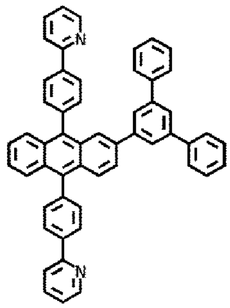
ET9

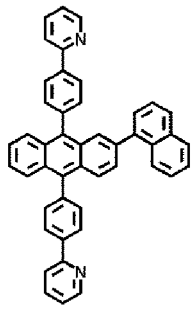
ET10

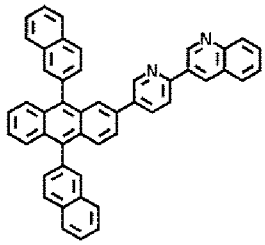
ET11

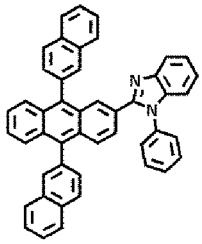
ET12

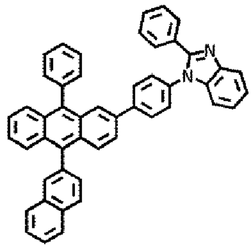
ET13

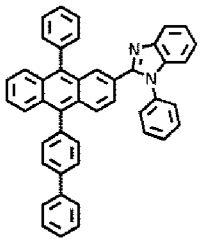
ET14

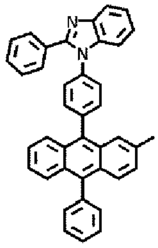
ET15

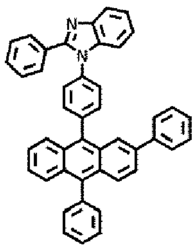
ET16

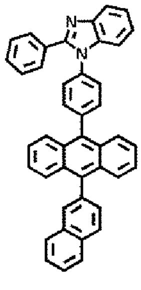
ET17

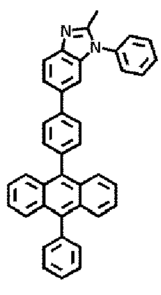
ET18

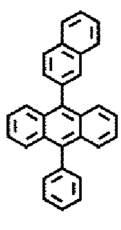
ET19

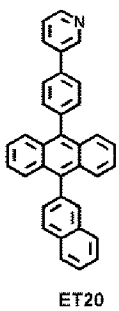
ET20

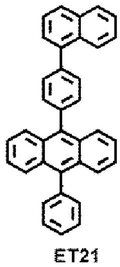
ET21

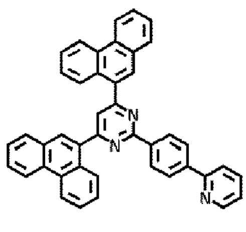
ET22

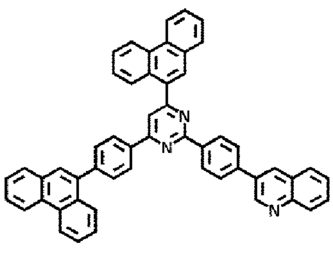
ET23

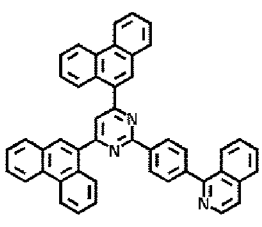
ET24

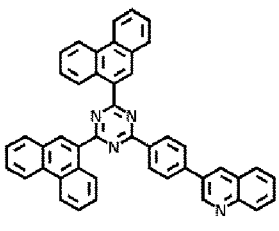
ET25

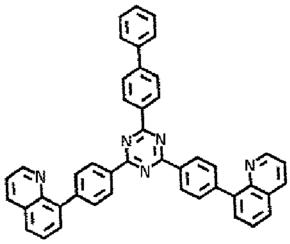
ET26

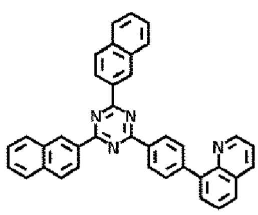
ET27

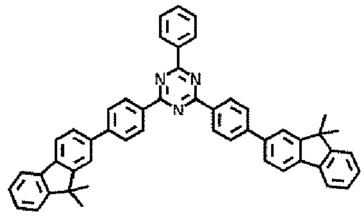
ET28

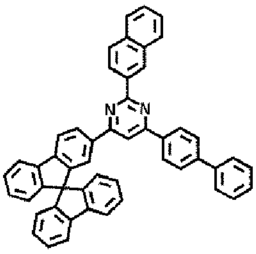
ET29

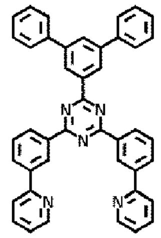
ET30

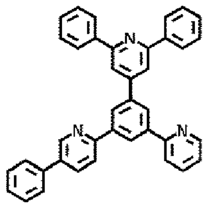
ET31

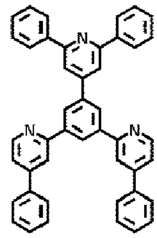
ET32

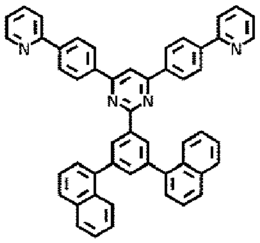
ET33

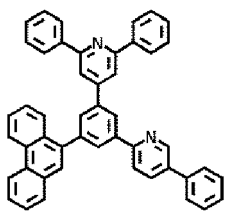
ET34

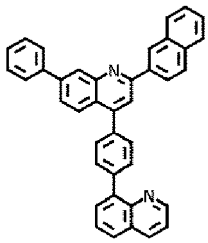
ET35

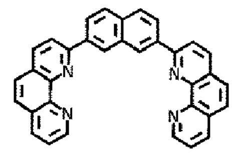
ET36

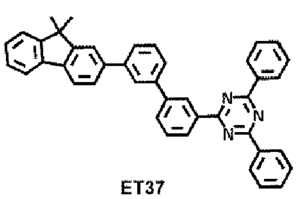
ET37

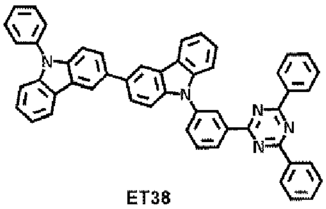
ET38

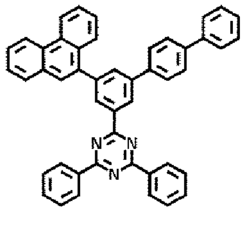
ET39

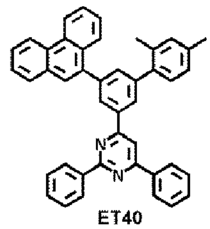
ET40

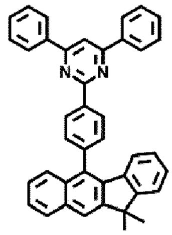
ET41

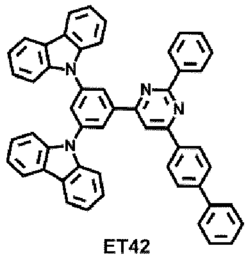
ET42

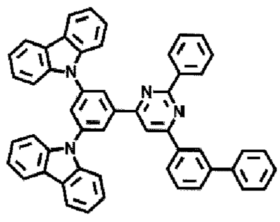
ET43

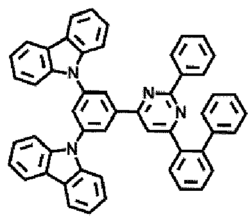
ET44

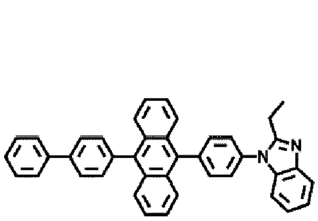
ET45

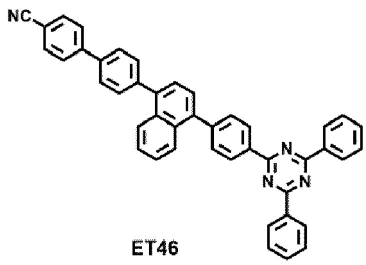
ET46

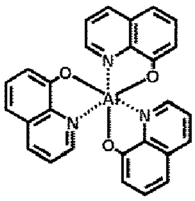
Alq3

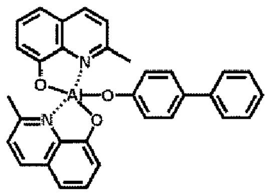
BAlq

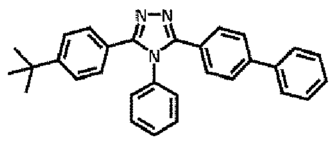
TAZ

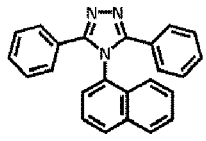
NTAZ .

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or any combination thereof, the thickness of the buffer layer, the hole blocking layer, or the electron control layer may each independently be from about 20 Å to about 1000 Å, for example, about 30 Å to about 300 Å, and the thickness of the electron transport layer may be from about 100 Å to about 1,000 Å, for example, about 150 Å to about 500 Å. When the thickness of the buffer layer, the hole-blocking layer, the electron control layer, the electron transport layer, and/or the electron transport region are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (Liq) or ET-D2:

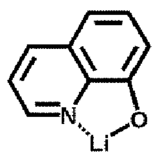
ET-D1

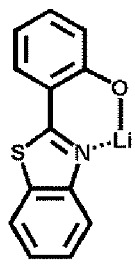
ET-D2 .

The electron transport region may include an electron injection layer that facilitates the injection of electrons from the second electrode 150. The electron injection layer may be in direct contact (e.g., physical contact) with the second electrode 150.

The electron injection layer may have: i) a single-layered structure consisting of a single layer consisting of a single material, ii) a single-layered structure consisting of a single layer consisting of a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, or iodides), or tellurides of the alkali metal, the alkaline earth metal, and the rare earth metal, or any combination thereof.

The alkali metal-containing compound may include alkali metal oxides, such as $Li_2O$, $Cs_2O$, or $K_2O$, alkali metal

halides, such as LiF, NaF, CsF, KF, LiI, NaI, CsI, or KI, or any combination thereof. The alkaline earth metal-containing compound may include an alkaline earth metal oxidecompound, such as BaO, SrO, CaO, $Ba_xSr_{1-x}O$ (x is a real number satisfying the condition of 0<x<1), $Ba_xCa_{1-x}O$ (x is a real number satisfying the condition of 0<x<1), and/or the like. The rare earth metal-containing compound may include $YbF_3$, $ScF_3$, $Sc_2O_3$, $Y_2O_3$, $Ce_2O_3$, $GdF_3$, $TbF_3$, YbI3, $ScI_3$, $TbI_3$, or any combination thereof. In an embodiment, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, Sm2Te3, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and $Lu_2Te_3$.

The alkali metal complex, the alkaline earth metal complex, and the rare earth metal complex may include i) one selected from metal ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In an embodiment, the electron injection layer may further include an organic material (for example, a compound represented by Formula 601).

In an embodiment, the electron injection layer may consist of i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. For example, the electron injection layer may be a KI:Yb co-deposited layer, a RbI:Yb co-deposited layer, a LiF:Yb co-deposited, and/or the like.

When the electron injection layer further includes an organic material, alkali metal, alkaline earth metal, rare earth metal, an alkali metal-containing compound, an alkaline earth metal-containing compound, a rare earth metal-containing compound, alkali metal complex, alkaline earth-metal complex, rare earth metal complex, or any combination thereof may be homogeneously or non-homogeneously dispersed in a matrix including the organic material.

A thickness of the electron injection layer may be in a range of about 1 Å to about 100 Å, for example, about 3 Å to about 90 Å. When the thickness of the electron injection layer is within the range described above, suitable or satisfactory electron injection characteristics may be obtained without a substantial increase in driving voltage.

**Second electrode 150**

The second electrode 150 may be on the interlayer 130 having such a structure. The second electrode 150 may be a cathode, which is an electron injection electrode, and as the material for the second electrode 150, a metal, an alloy, an electrically conductive compound, or any combination thereof, each having a low work function, may be used.

In an embodiment, the second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including two or more layers.

**Capping layer**

A first capping layer may be outside the first electrode 110, and/or a second capping layer may be outside the second electrode 150. In more detail, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer or light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is

increased, so that the emission efficiency of the light-emitting device 10 may be improved.

Each of the first capping layer and second capping layer may include a material having a refractive index (at a wavelength of 589 nm) of 1.6 or more.

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include carbocyclic compounds, heterocyclic compounds, amine group-containing compounds, porphyrin derivatives, phthalocyanine derivatives, naphthalocyanine derivatives, alkali metal complexes, alkaline earth metal complexes, or any combination thereof. The carbocyclic compound, the heterocyclic compound, and the amine group-containing compound may be optionally substituted with a substituent containing O, N, S, Se, Si, F, Cl, Br, I, or any combination thereof. In an embodiment, at least one selected from the first capping layer and the second capping layer may each independently include an amine group-containing compound.

In an embodiment, at least one selected from the first capping layer and the second capping layer may each independently include a compound represented by Formula 201, a compound represented by Formula 202, or any combination thereof.

In an embodiment, at least one selected from the first capping layer and the second capping layer may each independently include one selected from Compounds HT28 to HT33, one selected from Compounds CP1 to CP6, β-NPB, or any combination thereof:

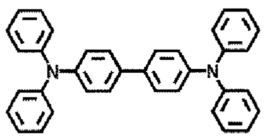

CP1

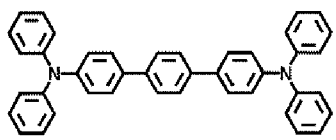

CP2

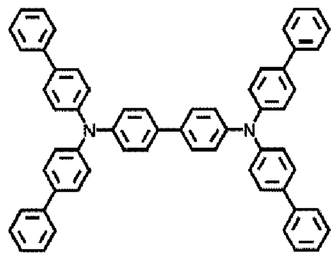

CP3

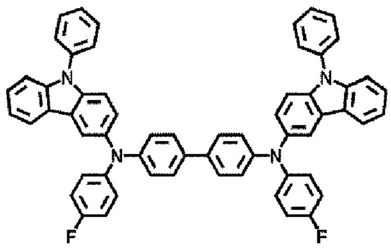

CP4

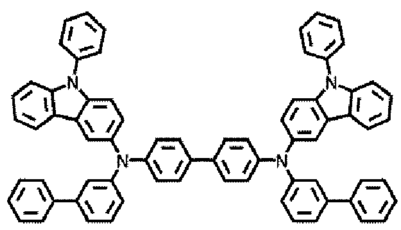

CP5

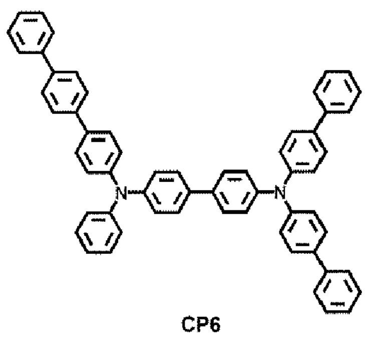

CP6

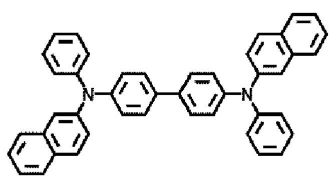

β-NPB

.

## Electronic apparatus

The light-emitting device may be included in various suitable electronic apparatuses. In an embodiment, the electronic apparatus including the light-emitting device may be a light-emitting apparatus, an authentication apparatus, and/or the like.

The electronic apparatus (for example, light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, the light emitted from the light-emitting device may be blue light or white light. The light-emitting device may be the same as described above. In an embodiment, the color conversion layer may include quantum dots.

The electronic apparatus may include a first substrate. The first substrate may include a plurality of subpixel areas, the color filter may include a plurality of color filter areas respectively corresponding to the plurality of subpixel areas, and the color conversion layer may include a plurality of color conversion areas respectively corresponding to the plurality of subpixel areas.

A pixel-defining layer may be located among the plurality of subpixel areas to define each of the plurality of subpixel areas.

The color filter may further include a plurality of color filter areas and light-shielding patterns located among the plurality of color filter areas, and the color conversion layer may include a plurality of color conversion areas and light-shielding patterns located among the plurality of color conversion areas.

The color filter areas (or the color conversion areas) may include a first area that emits a first color light, a second area that emits a second color light, and/or a third area that emits a third color light, and the first color light, the second color light, and/or the third color light may have different maximum emission wavelengths from one another. In an embodiment, the first color light may be red light, the second color light may be green light, and the third color light may be blue light. In an embodiment, the color filter areas (or the color conversion areas) may include quantum dots. In more detail, the first area may include a red quantum dot, the second area may include a green quantum dot, and the third area may not include a quantum dot. The quantum dot is the same as described in the present specification. The first area, the second area, and/or the third area may each further include a scatterer (e.g., a light scatterer).

In an embodiment, the light-emitting device may emit first light, the first area may absorb the first light to emit a first first-color light, the second area may absorb the first light to emit a second first-color light, and the third area may absorb the first light to emit a third first-color light. In this regard, the first first-color light, the second first-color light, and the third first-color light may have different maximum emission wavelengths. In more detail, the first light may be blue light, the first first-color light may be red light, the second first-color light may be green light, and the third first-color light may be blue light.

The electronic apparatus may further include a thin-film transistor in addition to the light-emitting device as described above. The thin-film transistor may include a source electrode, a drain electrode, and an active layer, wherein any one selected from the source electrode and the drain electrode may be electrically connected to any one selected from the first electrode and the second electrode of the light-emitting device.

The thin-film transistor may further include a gate electrode, a gate insulating film, etc.

The active layer may include crystalline silicon, amorphous silicon, organic semiconductor, oxide semiconductor, or the like.

The electronic apparatus may further include a sealing portion for sealing the light-emitting device. The sealing portion may be between the color filter and/or the color conversion layer and the light-emitting device. The sealing portion allows light from the light-emitting device to be extracted to the outside, while concurrently (e.g., simultaneously) preventing or reducing penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally on the sealing portion, in addition to the color filter and/or the color conversion layer, according to the use of the electronic apparatus. The functional layers may include a touch screen layer, a polarizing layer, and/or the like. The touch screen layer may be a pressure-sensitive touch screen layer, a capacitive touch screen layer, and/or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device, a biometric information collector.

The electronic apparatus may be applied to various suitable displays, light sources, lighting, personal computers (for example, a mobile personal computer), mobile phones, digital cameras, electronic diaries, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various measuring instruments, meters (for example, meters for a vehicle, an aircraft, and/or a vessel), projectors, and/or the like.

**Description of FIGS. 2 and 3**

FIG. 2 is a schematic cross-sectional view of a structure of an electronic apparatus according to an embodiment of the disclosure.

The electronic apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may include an active layer 220, a gate electrode 240, a source electrode 260, and a drain electrode 270.

The active layer 220 may include an inorganic semiconductor such as silicon or polysilicon, an organic semiconductor, or an oxide semiconductor, and may include a source region, a drain region and a channel region.

A gate insulating film 230 for insulating the active layer 220 from the gate electrode 240 may be on the active layer 220, and the gate electrode 240 may be on the gate insulating film 230.

An interlayer insulating film 250 is on the gate electrode 240. The interlayer insulating film 250 may be placed between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be on the interlayer insulating film 250. The interlayer insulating film 250 and the gate insulating film 230 may expose the source region and the drain region of the active layer 220, and the source electrode 260 and the drain electrode 270 may be in contact (e.g., physical contact) with the exposed portions of the source region and the drain region of the active layer 220.

The TFT is electrically connected to a light-emitting device to drive the light-emitting device, and is covered by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be on the passivation layer 280. The passivation layer 280 does not completely cover the drain electrode 270 and exposes a portion of the drain electrode 270, and the first electrode 110 is connected to the exposed portion of the drain electrode 270.

A pixel-defining layer 290 containing an insulating material may be on the first electrode 110. The pixel-defining layer 290 exposes a region of the first electrode 110, and an interlayer 130 may be in the exposed region of the first electrode 110. The pixel-defining layer 290 may be a polyimide and/or polyacrylic organic film. In some embodiments, at least some layers of the interlayer 130 may extend beyond the upper portion of the pixel-defining layer 290 in the form of a common layer.

The second electrode 150 may be on the interlayer 130, and a capping layer 170 may be additionally on the second electrode 150. The capping layer 170 may cover the second electrode 150.

The encapsulation portion 300 may be on the capping layer 170. The encapsulation portion 300 may be on a light-emitting device to protect the light-emitting device from moisture and/or oxygen. The encapsulation portion 300 may include: an inorganic film including silicon nitride ($SiN_x$), silicon oxide ($SiO_x$), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, and/or the like), an epoxy-based resin (for example, aliphatic glycidyl ether (AGE), and/or the like), or a combination thereof; or a combination of the inorganic film and the organic film.

FIG. 3 is a schematic cross-sectional view of a structure of an electronic apparatus according to an embodiment of the disclosure.

The electronic apparatus of FIG. 3 is substantially the same as the electronic apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In an embodiment, the light-emitting device included in the electronic apparatus of FIG. 3 may be a tandem light-emitting device.

**Manufacture method**

Respective layers included in the hole transport region, the emission layer, and respective layers included in the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When layers constituting the hole transport region, an emission layer, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec, depending on a material to be included in a layer to be formed and the structure of a layer to be formed.

**Definition of Terms**

The term "$C_3$-$C_{60}$ carbocyclic group," as used herein, refers to a cyclic group consisting of carbon only as a ring-forming atom and having three to sixty carbon atoms, and the term "$C_1$-$C_{60}$ heterocyclic group," as used herein, refers to a cyclic group that has one to sixty carbon atoms and further has, in addition to carbon, a heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings are condensed together with each other. In an embodiment, the $C_1$-$C_{60}$ heterocyclic group has 3 to 61 ring-forming atoms.
The term "cyclic group," as used herein, may include the $C_3$-$C_{60}$ carbocyclic group and the $C_1$-$C_{60}$ heterocyclic group.
The term "π electron-rich $C_3$-$C_{60}$ cyclic group," as used herein, refers to a cyclic group that has three to sixty carbon atoms and does not include *-N=*' as a ring-forming moiety, and the term "π electron-deficient nitrogen-containing $C_1$-$C_{60}$ cyclic group" as used herein refers to a heterocyclic group that has one to sixty carbon atoms and includes *-N=*' as a ring-forming moiety.
In an embodiment,

the $C_3$-$C_{60}$ carbocyclic group may be i) group T1 or ii) a condensed cyclic group in which two or more groups T1 are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the $C_1$-$C_{60}$ heterocyclic group may be i) group T2, ii) a condensed cyclic group in which two or more groups T2 are condensed together with each other, or iii) a condensed cyclic group in which at least one group T2 and at least one group T1 are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich $C_3$-$C_{60}$ cyclic group may be i) group T1, ii) a condensed cyclic group in which two or more groups T1 are condensed together with each other, iii) group T3, iv) a condensed cyclic group in which two or more groups T3 are condensed together with each other, or v) a condensed cyclic group in which at least one group T3 and at least one group T1 are condensed together with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole

group, a benzofurodibenzofuran group, a benzofurodibenzothiophene group, a benzothienodibenzothiophene group, etc.),

the π electron-deficient nitrogen-containing $C_1$-$C_{60}$ cyclic group may be i) group T4, ii) a condensed cyclic group in which two or more group T4 are condensed together with each other, iii) a condensed cyclic group in which at least one group T4 and at least one group T1 are condensed together with each other, iv) a condensed cyclic group in which at least one group T4 and at least one group T3 are condensed together with each other, or v) a condensed cyclic group in which at least one group T4, at least one group T1, and at least one group T3 are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1,1]hexane group, a bicyclo[2.2.2]octane group, or a benzene group,

group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

group T3 may be a furan group, a thiophene group, a 1H-pyrrole group, a silole group, or a borole group, and

group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "$C_3$-$C_{60}$ carbocyclic group", "$C_1$-$C_{60}$ heterocyclic group", "π electron-rich $C_3$-$C_{60}$ cyclic group", or "π electron-deficient nitrogen-containing $C_1$-$C_{60}$ cyclic group," as used herein, refers to a monovalent or polyvalent group (for example, a divalent group, a trivalent group, a tetravalent group, or the like) that is condensed with (e.g., combined together with) a cyclic group, depending on the structure of a formula in connection with which the terms are used. In an embodiment, "a benzene group" may be a benzo group, a phenyl group, a phenylene group, or the like, which may be easily understood by one of ordinary skill in the art according to the structure of a formula including the "benzene group."

Examples of the monovalent $C_3$-$C_{60}$ carbocyclic group and the monovalent $C_1$-$C_{60}$ heterocyclic group may include a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and examples of the divalent $C_3$-$C_{60}$ carbocyclic group and the monovalent $C_1$-$C_{60}$ heterocyclic group may include a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group," as used herein, refers to a linear or branched aliphatic hydrocarbon monovalent group that has one to sixty carbon atoms, for example, a $C_1$-$C_{20}$ alkyl group, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group," as used herein, refers

to a divalent group having substantially the same structure as the $C_1$-$C_{60}$ alkyl group.

The term "$C_2$-$C_{60}$ alkenyl group," as used herein refers to a monovalent hydrocarbon group having at least one carbon-carbon double bond at a main chain (e.g., in the middle) or at a terminal end (e.g., the terminus) of the $C_2$-$C_{60}$ alkyl group, and examples thereof include an ethenyl group, a propenyl group, and a butenyl group. The term "$C_2$-$C_{60}$ alkenylene group," as used herein, refers to a divalent group having substantially the same structure as the $C_2$-$C_{60}$ alkenyl group.

The term "$C_2$-$C_{60}$ alkynyl group," as used herein, refers to a monovalent hydrocarbon group having at least one carbon-carbon triple bond at a main chain (e.g., in the middle) or at a terminal end (e.g., the terminus) of the $C_2$-$C_{60}$ alkyl group, and examples thereof include an ethynyl group and a propynyl group. The term "$C_2$-$C_{60}$ alkynylene group," as used herein, refers to a divalent group having substantially the same structure as the $C_2$-$C_{60}$ alkynyl group.

The term "$C_1$-$C_{60}$ alkoxy group," as used herein, refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_3$-$C_{10}$ cycloalkyl group," as used herein, refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1,1]hexyl group, and a bicyclo[2.2.2]octyl group. The term "$C_3$-$C_{10}$ cycloalkylene group," as used herein, refers to a divalent group having substantially the same structure as the $C_3$-$C_{10}$ cycloalkyl group.

The term "$C_1$-$C_{10}$ heterocycloalkyl group," as used herein, refers to a monovalent cyclic group that further includes, in addition to a carbon atom, at least one heteroatom as a ring-forming atom and has 1 to 10 carbon atoms, and examples thereof include a 1,2,3,4-oxatriazolidinyl group, a tetrahydrofuranyl group, and a tetrahydrothiophenyl group. The term "$C_1$-$C_{10}$ heterocycloalkylene group," as used herein, refers to a divalent group having substantially the same structure as the $C_1$-$C_{10}$ heterocycloalkyl group.

The term "$C_3$-$C_{10}$ cycloalkenyl group," as used herein, refers to a monovalent cyclic group that has three to ten carbon atoms and at least one double bond in the ring thereof and no aromaticity (e.g., is not aromatic), and examples thereof include a cyclopentenyl group, a cyclohexenyl group, and a cycloheptenyl group. The term "$C_3$-$C_{10}$ cycloalkenylene group," as used herein, refers to a divalent group having substantially the same structure as the $C_3$-$C_{10}$ cycloalkenyl group.

The term "$C_1$-$C_{10}$ heterocycloalkenyl group," as used herein, refers to a monovalent cyclic group that has, in addition to a carbon atom, at least one heteroatom as a ring-forming atom, 1 to 10 carbon atoms, and at least one carbon-carbon double bond in the cyclic structure thereof. Examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group," as used herein, refers to a divalent group having substantially the same structure as the $C_1$-$C_{10}$ heterocycloalkenyl group.

The term "$C_6$-$C_{60}$ aryl group," as used herein, refers to a monovalent group having a carbocyclic aromatic system having six to sixty carbon atoms, and the term "$C_6$-$C_{60}$ arylene group," as used herein, refers to a divalent group having a carbocyclic aromatic system having six to sixty carbon atoms. Examples of the $C_6$-$C_{60}$ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each include two or more rings, the rings may be condensed together with each other.

The term "$C_1$-$C_{60}$ heteroaryl group," as used herein, refers to a monovalent group having a heterocyclic aromatic system that has, in addition to a carbon atom, at least one heteroatom as a ring-forming atom, and 1 to 60 carbon atoms. The term "$C_1$-$C_{60}$ heteroarylene group," as used herein, refers to a divalent group having a heterocyclic aromatic system that has, in addition to a carbon atom, at least one heteroatom as a ring-forming atom, and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the rings may be condensed together with each other.

The term "monovalent non-aromatic condensed polycyclic group," as used herein, refers to a monovalent group having two or more rings condensed to each other, only carbon atoms (for example, having 8 to 60 carbon atoms) as ring-forming atoms, and non-aromaticity in its molecular structure when considered as a whole (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, and an indeno

anthracenyl group. The term "divalent non-aromatic condensed polycyclic group," as used herein, refers to a divalent group having substantially the same structure as a monovalent non-aromatic condensed polycyclic group.

The term "monovalent non-aromatic condensed heteropolycyclic group," as used herein, refers to a monovalent group having two or more rings condensed to each other, at least one heteroatom other than carbon atoms (for example, having 1 to 60 carbon atoms), as a ring-forming atom, and non-aromaticity in its molecular structure when considered as a whole (e.g., is not aromatic when considered as a whole). Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group," as used herein, refers to a divalent group having substantially the same structure as a monovalent non-aromatic condensed heteropolycyclic group.

The term "$C_6$-$C_{60}$ aryloxy group," as used herein, indicates -$OA_{102}$ (wherein A102 is the $C_6$-$C_{60}$ aryl group), and the term "$C_6$-$C_{60}$ arylthio group," as used herein, indicates -SA103 (wherein A103 is the $C_6$-$C_{60}$ aryl group).

The term "$C_7$-$C_{60}$ aryl alkyl group," as used herein, refers to -$A_{104}A_{105}$ (where A104 may be a $C_1$-$C_{54}$ alkylene group, and A105 may be a $C_6$-$C_{59}$ aryl group), and the term "$C_2$-$C_{60}$ heteroaryl alkyl group," as used herein, refers to -$A_{106}A_{107}$ (where $A_{106}$ may be a $C_1$-$C_{59}$ alkylene group, and A107 may be a $C_1$-$C_{59}$ heteroaryl group).

$R_{10a}$ may be:

deuterium (-D), -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{21}$)($Q_{22}$)($Q_{23}$), -N($Q_{21}$)($Q_{22}$), -B($Q_{21}$)($Q_{22}$), - C(=O)($Q_{21}$), -S(=O)$_2$($Q_{21}$), -P(=O)($Q_{21}$)($Q_{22}$), or any combination thereof; or

-O($Q_{31}$), -S($Q_{31}$), -Si($Q_{31}$)($Q_{32}$)($Q_{33}$), -N($Q_{31}$)($Q_{32}$), -B($Q_{31}$)($Q_{32}$), -P($Q_{31}$)($Q_{32}$), -C(=O)($Q_{31}$), -S(=O)$_2$($Q_{31}$), or -P(=O)($Q_{31}$)($Q_{32}$).

$Q_1$ to $Q_3$, $Q_{11}$ to $Q_{13}$, $Q_{21}$ to $Q_{23}$, and $Q_{31}$ to $Q_{33}$ in the present specification may each independently be: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, a pyridinyl group, a pyrimidinyl group, a pyridazinyl group, a pyrazinyl group, a triazinyl group, or any combination thereof.

The term "hetero atom," as used herein, refers to any atom other than a carbon atom. Examples of the heteroatom include O, S, N, P, Si, B, Ge, Se, or any combination thereof.

The term "the third-row transition metal," as used herein, includes hafnium (Hf), tantalum (Ta), tungsten (W), rhenium (Re), osmium (Os), iridium (Ir), platinum (Pt), gold (Au), and the like.

The term "Ph," as used herein, refers to a phenyl group, the term "Me," as used herein, refers to a methyl group, the term "Et," as used herein, refers to an ethyl group, the term "tert-Bu" or "$Bu^t$," as used herein, refers to a tert-butyl group, and the term "OMe," as used herein, refers to a methoxy group.

The term "biphenyl group," as used herein, refers to "a phenyl group substituted with a phenyl group." In other words, the "biphenyl group" is a substituted phenyl group having a $C_6$-$C_{60}$ aryl group as a substituent.

The term "terphenyl group," as used herein, refers to "a phenyl group substituted with a biphenyl group". The

"terphenyl group" is a substituted phenyl group having, as a substituent, a $C_6$-$C_{60}$ aryl group substituted with a $C_6$-$C_{60}$ aryl group.

*, *', and *", as used herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was used instead of A" used in describing Synthesis Examples means that an identical molar equivalent of B was used in place of A.

**Examples**

**Synthesis Example 1 (Synthesis of Compound BD02)**

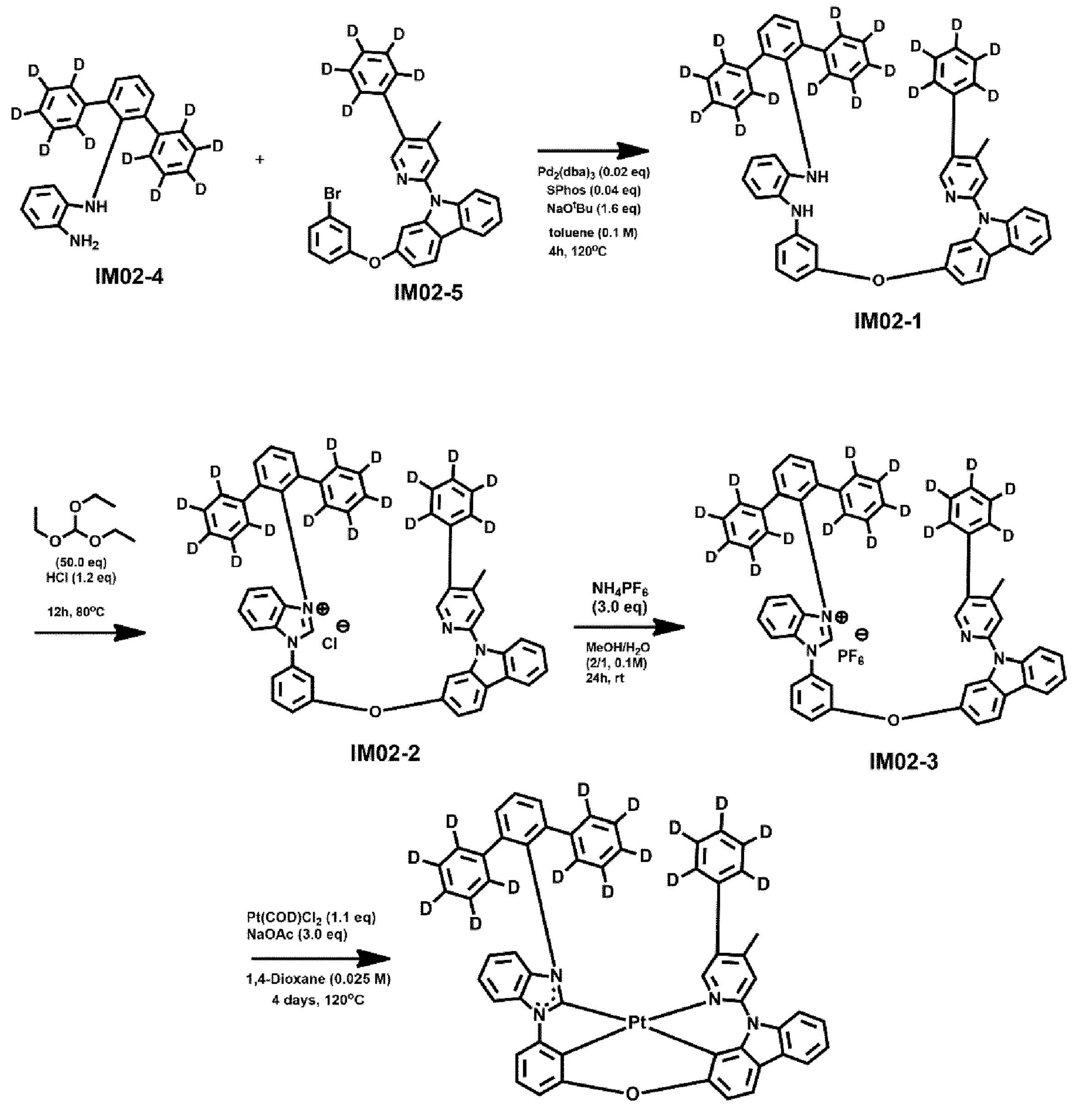


BD02

**Synthesis of Intermediate IM02-1**

$N^1$-([1,1':3',1"-terphenyl]-2'-yl-2,2",3,3",4,4",5,5",6,6"-$d_{10}$)benzene-1,2-diamine (Intermediate IM02-4) (3.9 g, 11.4 mmol), 2-(3-bromophenoxy)-9-(4-methyl-5-(phenyl-$d_5$)pyridin-2-yl)-9*H*-carbazole (Intermediate IM02-5) (5.8 g, 11.4 mmol), $Pd_2(dba)_3$ (0.2 g, 0.2 mmol), SPhos (1.9 g, 4.6 mmol), and $NaO^tBu$ (1.7 g, 18.2 mmol) were placed in a reaction vessel and suspended in 114 ml of toluene, and then heated and stirred for 4 hours at 120 °C. After the reaction was terminated, the resultant mixture was cooled to room temperature, 300 ml of distilled water was added thereto, and an organic layer was extracted therefrom using ethylacetate, and the extracted organic layer was washed with a saturated sodium chloride aqueous solution and dried using sodium sulfate. The obtained result was subjected to column chromatography to obtain Intermediate IM02-1 (6.7 g, 8.6 mmol) in the yield of 75%.

**Synthesis of Intermediate IM02-2**

Intermediate IM02-1 (6.7 g, 8.6 mmol), 86 ml (516 mmol) of triethyl orthoformate, and 1.0 ml (10.3 mmol) of HCl (37%) were placed in a reaction vessel, and then heated and stirred for 12 hours at 80 °C. After the reaction was terminated, the resultant mixture was cooled to room temperature, a solid thus generated therefrom was subjected to filtration and washed using ether, and then the washed solid was dried to obtain Intermediate IM02-2 (6.3 g, 7.7 mmol) in the yield of 90%.

**Synthesis of Intermediate IM02-3**

Intermediate IM02-2 (6.3 g, 7.7 mmol) and $NH_4PF_6$ (3.8 g, 23.1 mmol) were placed in a reaction vessel and suspended in a mixed solution including 100 ml of methyl alcohol and 50 ml of water, and then stirred for 24 hours at room temperature. After the reaction was terminated, a solid thus generated therefrom was subjected to filtration and washed using ether, and then the washed solid was dried to obtain Intermediate IM02-3 (6.4 g, 6.9 mmol) in the yield of 90%.

**Synthesis of Compound BD02**

Intermediate IM02-3 (6.4 g, 6.9 mmol), dichloro(1,5-cyclooctadiene)platinum ($Pt(COD)Cl_2$, 2.8 g, 7.6 mmol), and NaOAc (1.7 g, 20.7 mmol) were suspended in 150 ml of 1,4-dioxane, and then heated and stirred for 4 days at 120 °C. After the reaction was terminated, the resultant mixture was cooled to room temperature, 150 mL of distilled water was added thereto, an organic layer was extracted therefrom using ethylacetate, and then, the extracted organic layer was washed with a NaCl aqueous solution and dried using $MgSO_4$. The obtained result was subjected to column chromatography to obtain Compound BD02 (2.3 g, 2.4 mmol) in the yield of 35%.

**Synthesis Example 2 (Synthesis of Compound BD04)**

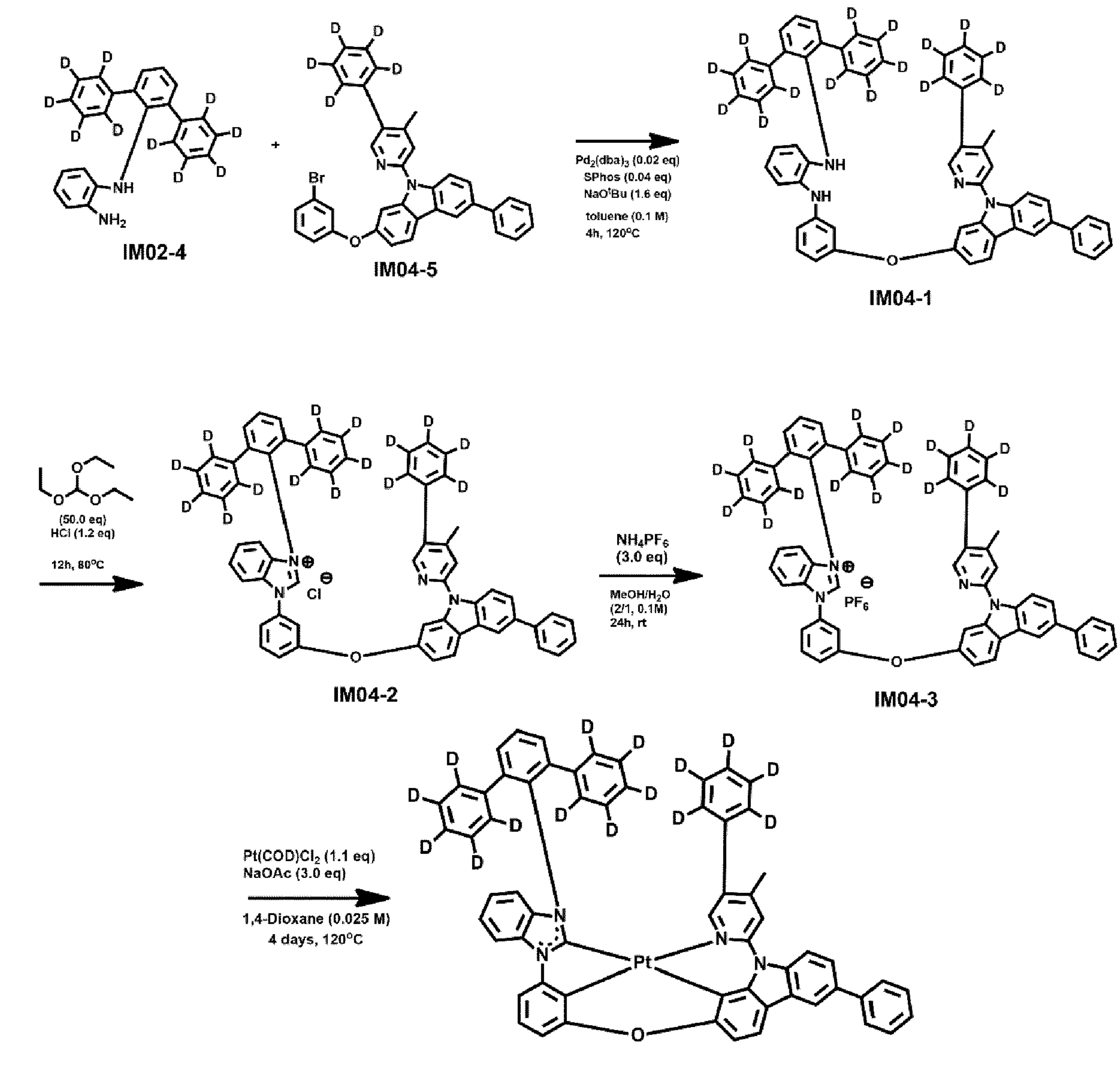


IM02-4 IM04-5 IM04-1

IM04-2 IM04-3

BD04

Compound BD04 (2.3 g, 2.2 mmol) was obtained in the yield of 32% in substantially the same manner as in Synthesis Example 1, except that 2-(3-bromophenoxy)-9-(4-methyl-5-(phenyl-$d_5$)pyridin-2-yl)-6-phenyl-9*H*-carbazole (Intermediate IM04-5) (6.7 g, 11.4 mmol), Intermediate IM04-1, Intermediate IM04-2, and Intermediate IM04-3 were sequentially used instead of Intermediate IM02-5, Intermediate IM02-1, Intermediate IM02-2, and Intermediate IM02-3, respectively.

**Synthesis Example 3 (Synthesis of Compound BD23)**

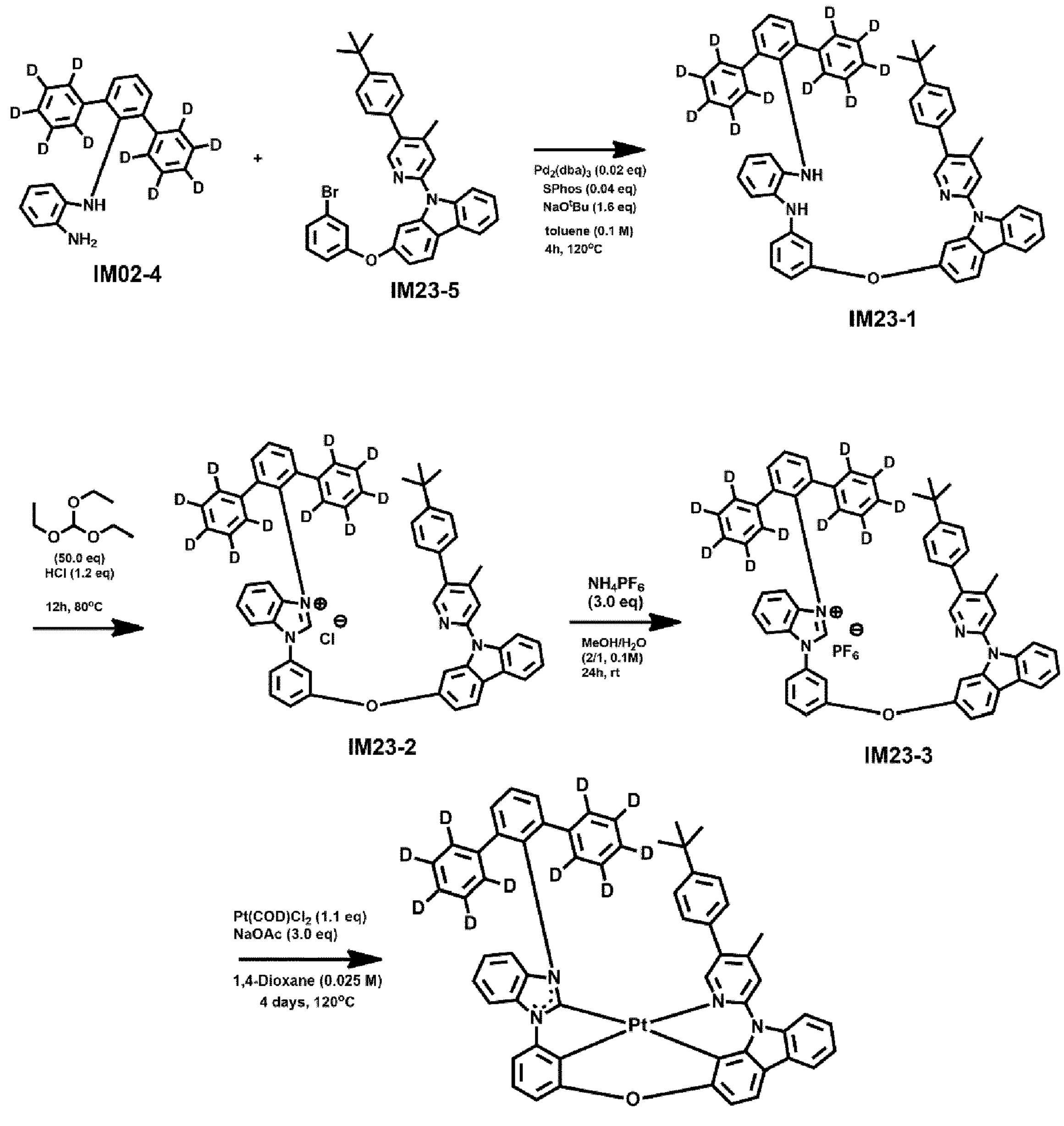


**BD23**

Compound BD23 (2.5 g, 2.4 mmol) was obtained in the yield of 35% in substantially the same manner as in Synthesis Example 1, except that 2-(3-bromophenoxy)-9-(5-(4-(*tert*-butyl)phenyl)-4-methylpyridin-2-yl)-9*H*-carbazole (Intermediate IM23-5) (6.4 g, 11.4 mmol), Intermediate IM23-1, Intermediate IM23-2, and Intermediate IM23-3 were sequentially used instead of Intermediate IM02-5, Intermediate IM02-1, Intermediate IM02-2, and Intermediate IM02-3, respectively.

**Synthesis Example 4 (Synthesis of Compound BD58)**

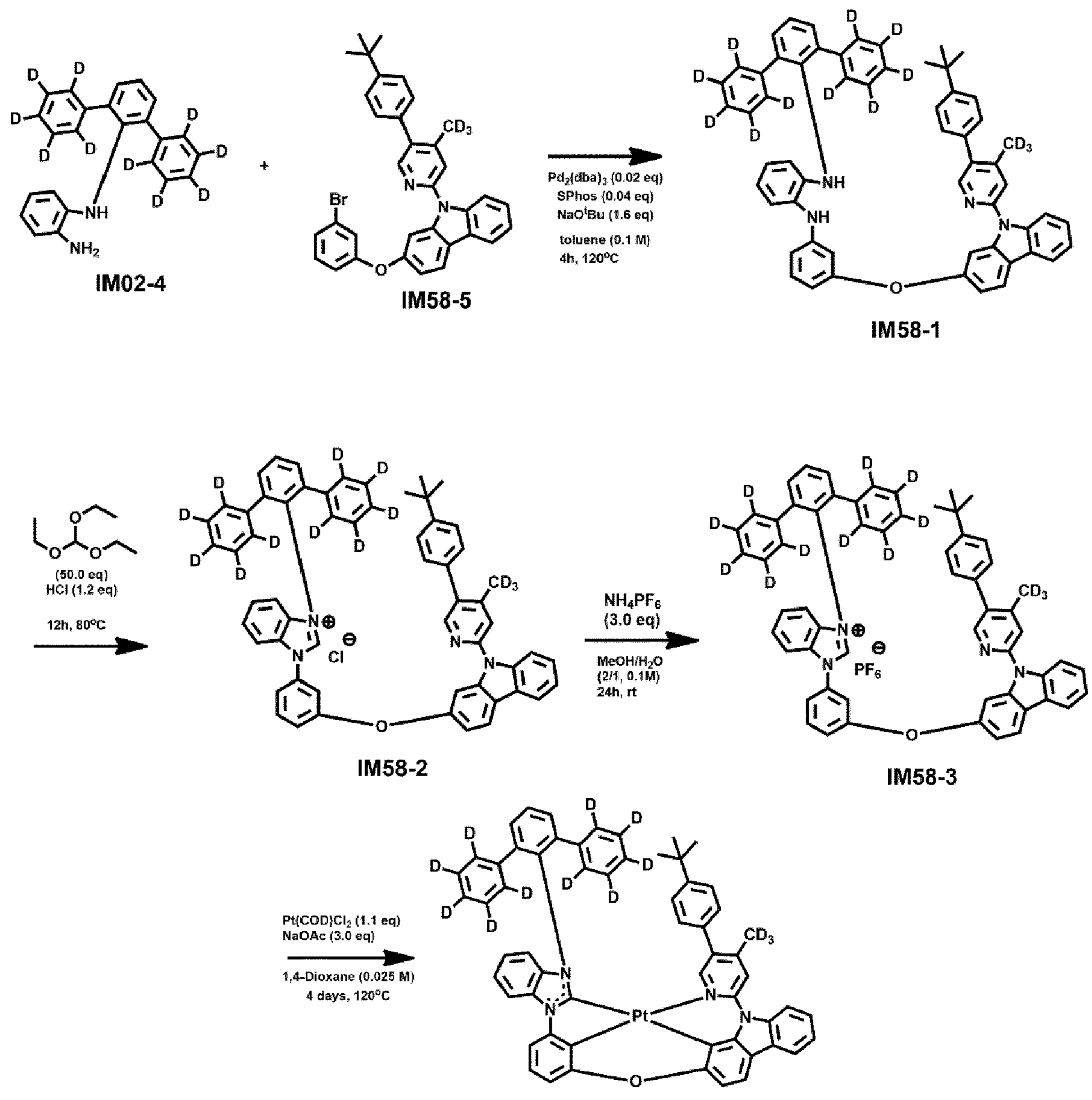


IM02-4 IM58-5 IM58-1

IM58-2 IM58-3

BD58

Compound BD58 (2.6 g, 2.6 mmol) was obtained in the yield of 37% in substantially the same manner as in Synthesis Example 1, except that 2-(3-bromophenoxy)-9-(5-(4-(tert-butyl)phenyl)-4-(methyl-$d_3$)pyridin-2-yl)-9*H*-carbazole (Intermediate IM58-5) (6.4 g, 11.4 mmol), Intermediate IM58-1, Intermediate IM58-2, and Intermediate IM58-3 were sequentially used instead of Intermediate IM02-5, Intermediate IM02-1, Intermediate IM02-2, and Intermediate IM02-3, respectively.

**Synthesis Example 5 (Synthesis of Compound BD71)**

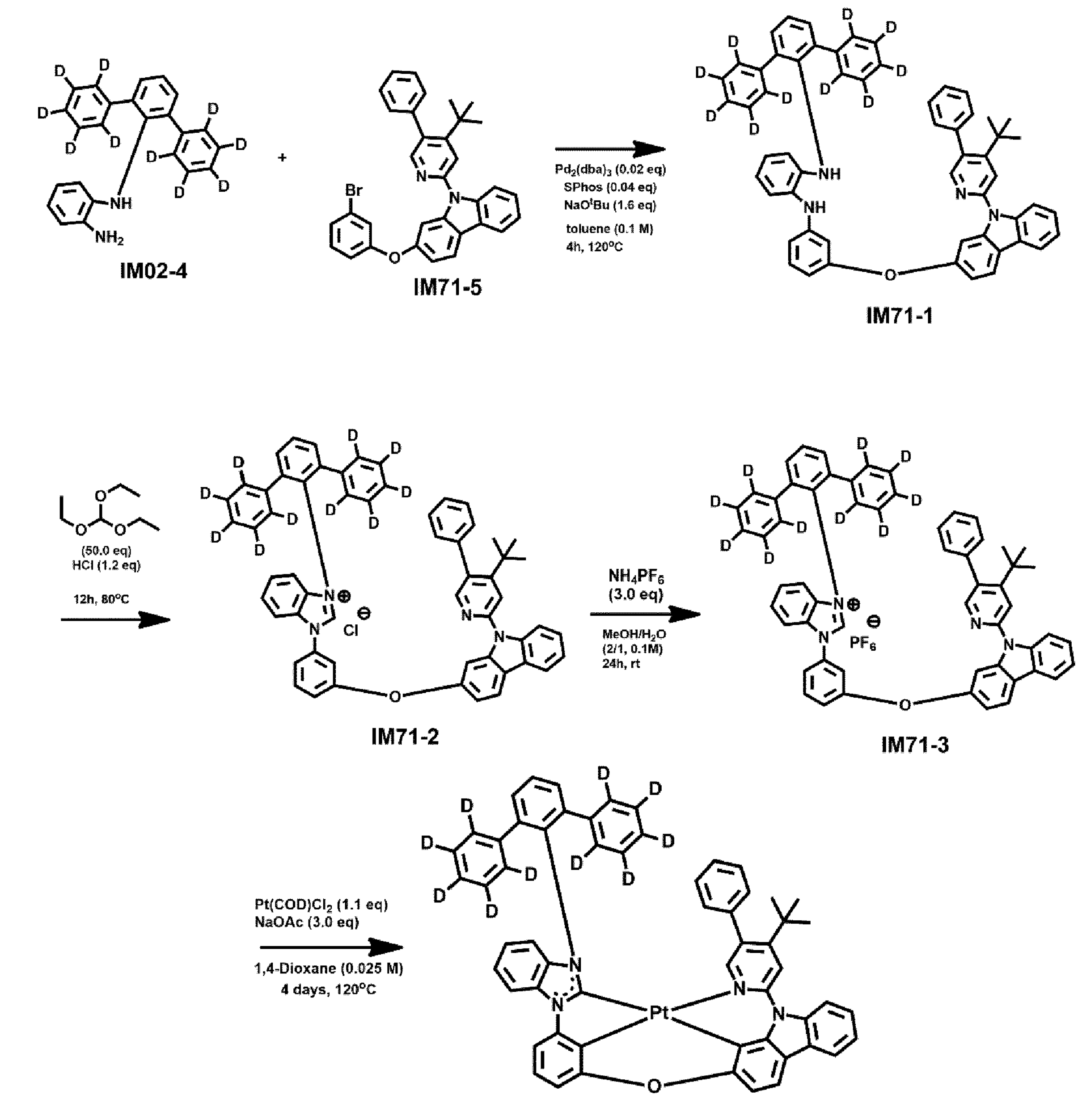


IM02-4

IM71-5

IM71-1

IM71-2

IM71-3

BD71

Compound BD71 (1.6 g, 1.6 mmol) was obtained in the yield of 23% in substantially the same manner as in Synthesis Example 1, except that 2-(3-bromophenoxy)-9-(4-(tert-butyl)-5-phenylpyridin-2-yl)-9*H*-carbazole (Intermediate IM71-5) (6.4 g, 11.4 mmol), Intermediate IM71-1, Intermediate IM71-2, and Intermediate IM71-3 were sequentially used instead of Intermediate IM02-5, Intermediate IM02-1, Intermediate IM02-2, and Intermediate IM02-3, respectively.

**Synthesis Example 6 (Synthesis of Compound BD72)**

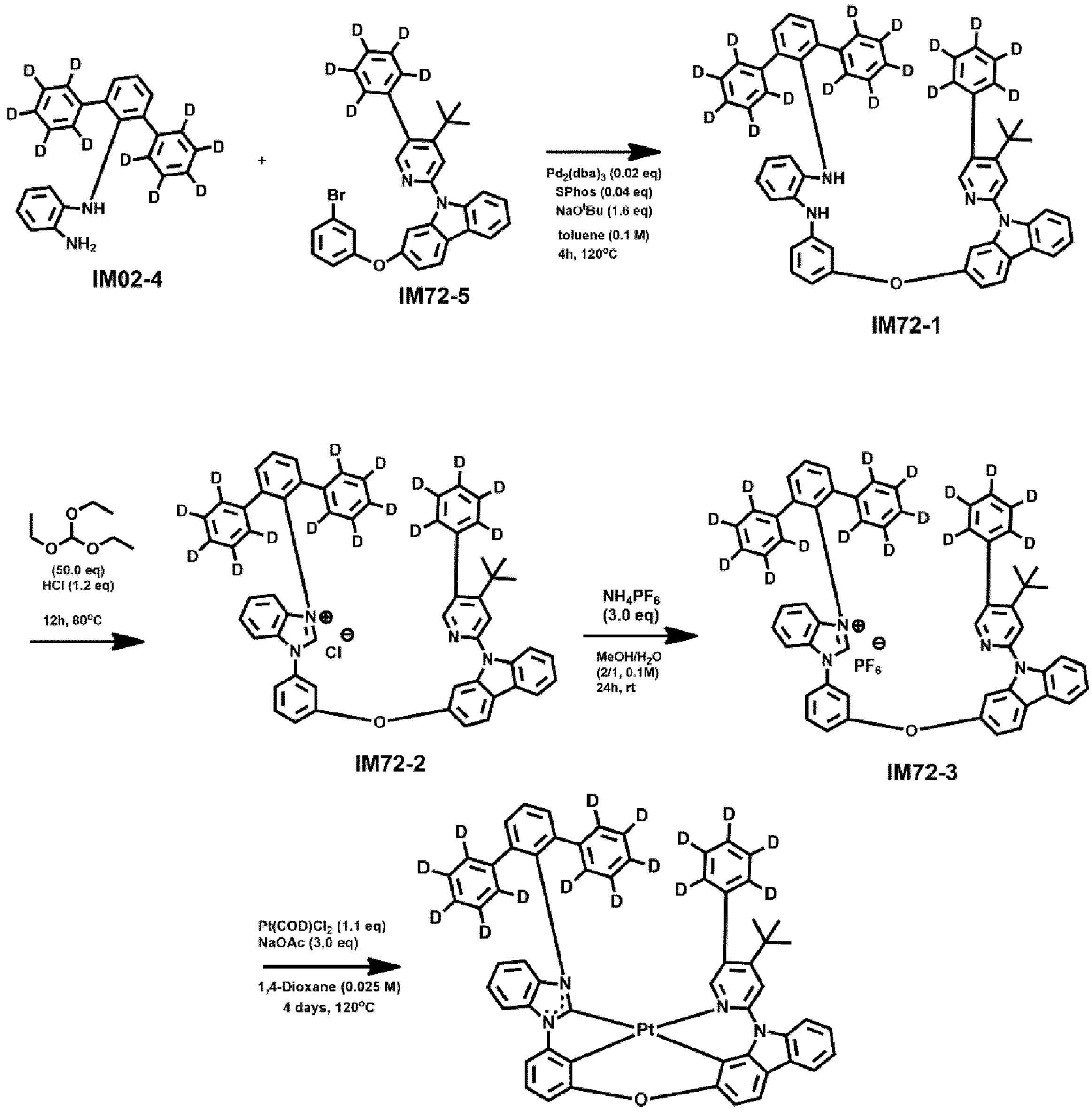


BD72

Compound BD72 (1.8 g, 1.7 mmol) was obtained in the yield of 25% in substantially the same manner as in Synthesis Example 1, except that 2-(3-bromophenoxy)-9-(4-(*tert*-butyl)-5-(phenyl-$d_5$)pyridin-2-yl)-9*H*-carbazole (Intermediate IM72-5) (6.3 g, 11.4 mmol), Intermediate IM72-1, Intermediate IM72-2, and Intermediate IM72-3 were sequentially used instead of Intermediate IM02-5, Intermediate IM02-1, Intermediate IM02-2, and Intermediate IM02-3, respectively.

**Synthesis Example 7 (Synthesis of Compound BD323)**

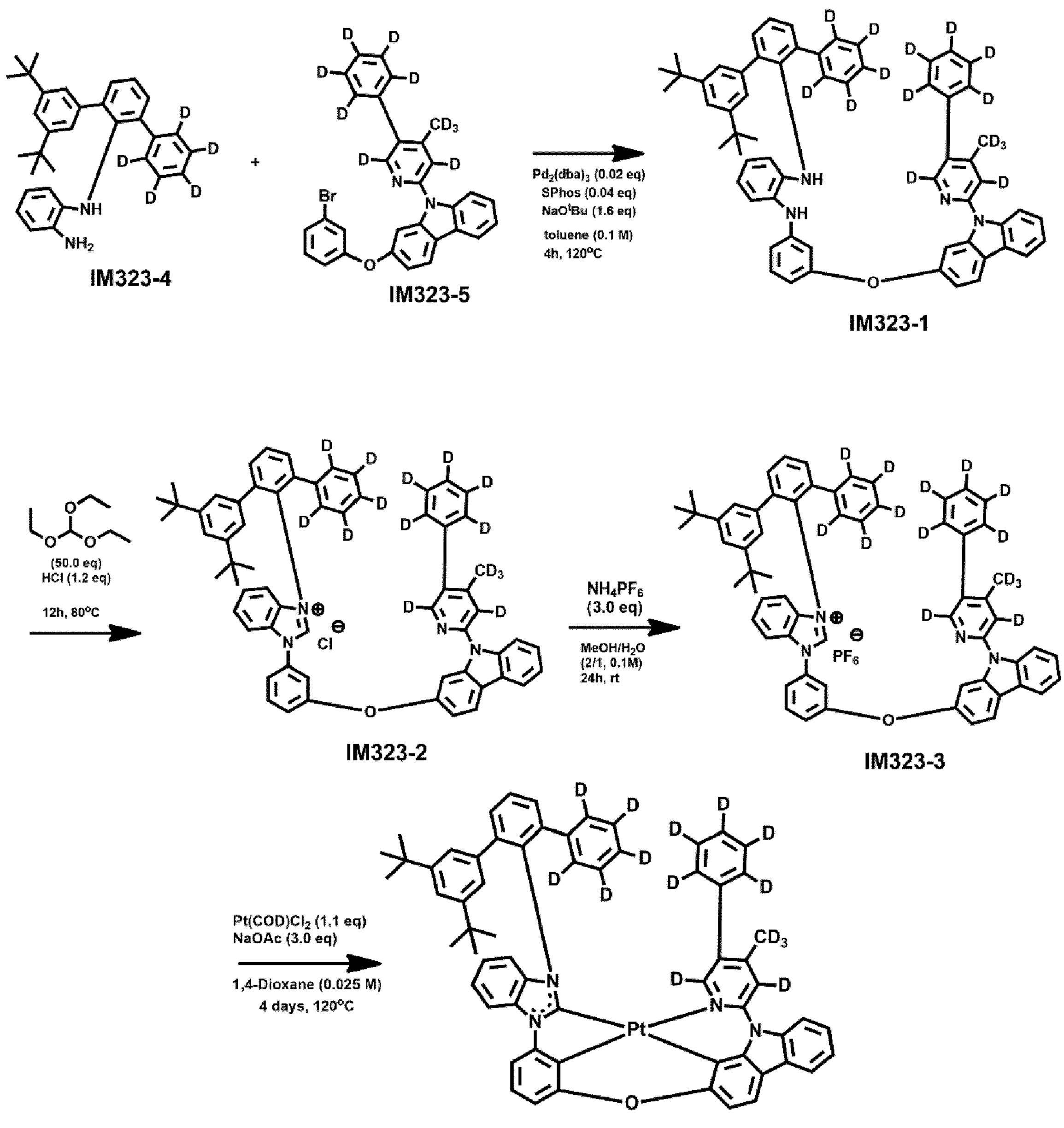


BD323

Compound BD323 (2.8 g, 2.6 mmol) was obtained in the yield of 37% in substantially the same manner as in Synthesis Example 1, except that *N*[1]-(3,5-di-*tert*-butyl-[1,1':3',1"-terphenyl]-2'-yl-2",3",4",5",6"-$d_5$)benzene-1,2-diamine(Intermediate IM323-4) (5.2 g, 11.4 mmol), 2-(3-bromophenoxy)-9-(4-(methyl-$d_3$)-5-(phenyl-$d_5$)pyridin-2-yl-3,6-$d_2$)-9*H*-carbazole (Intermediate IM323-5) (5.9 g, 11.4 mmol), Intermediate IM323-1, Intermediate IM323-2, and Intermediate IM323-3 were sequentially used instead of Intermediate IM02-4, Intermediate IM02-5, Intermediate IM02-1, Intermediate IM02-2, and Intermediate IM02-3, respectively.

**Synthesis Example 8 (Synthesis of Compound BD325)**

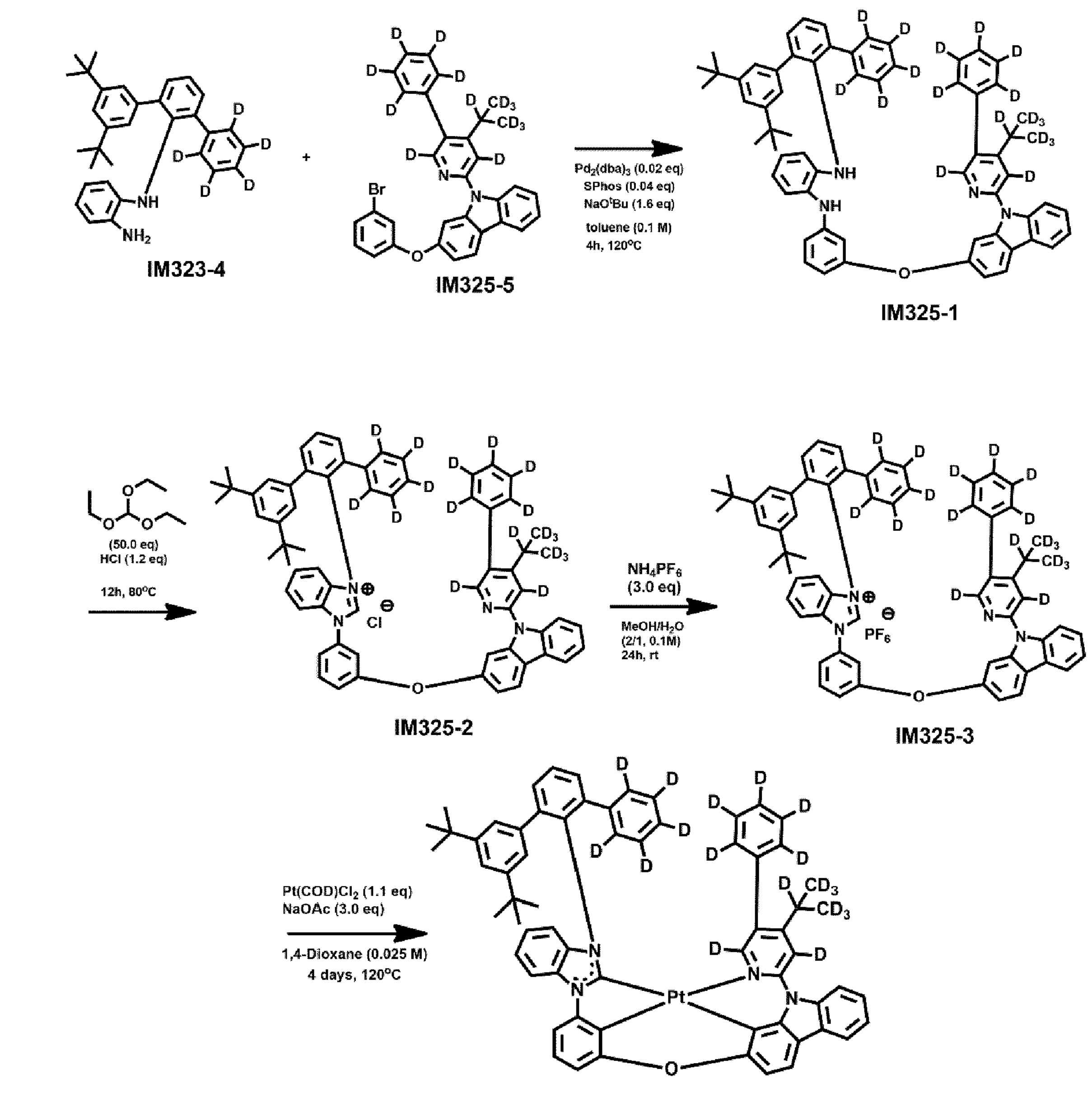


BD325

Compound BD325 (2.7 g, 2.4 mmol) was obtained in the yield of 35% in substantially the same manner as in Synthesis Example 7, except that 2-(3-bromophenoxy)-9-(5-(phenyl-$d_5$)-4-(propan-2-yl-$d_7$)pyridin-2-yl-3,6-d2)-9*H*-carbazole (Intermediate IM325-5) (6.2 g, 11.4 mmol), Intermediate IM325-1, Intermediate IM325-2, and Intermediate IM325-3 were sequentially used instead of Intermediate IM323-5, Intermediate IM323-1, Intermediate IM323-2, and Intermediate IM323-3, respectively.

**Synthesis Example 9 (Synthesis of Compound BD327)**

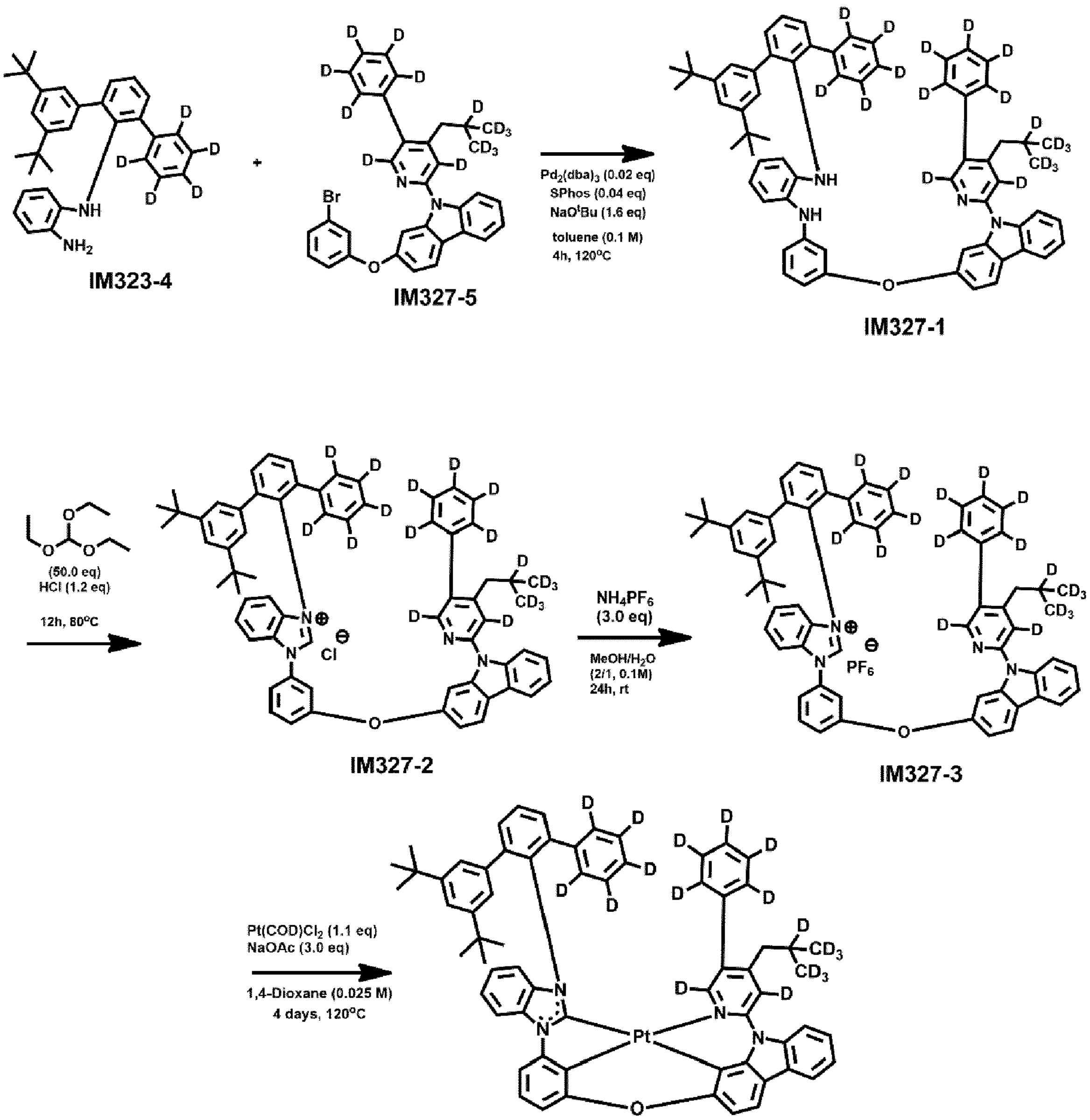


IM323-4 IM327-5 IM327-1

IM327-2 IM327-3

BD327

Compound BD327 (3.0 g, 2.6 mmol) was obtained in the yield of 38% in substantially the same manner as in Synthesis Example 7, except that 2-(3-bromophenoxy)-9-(4-(2-(methyl-$d_3$)propyl-2,3,3,3-d4)-5-(phenyl-$d_5$)pyridin-2-yl-3,6-$d_2$)-9H-carbazole (Intermediate IM327-5) (6.4 g, 11.4 mmol), Intermediate IM327-1, Intermediate IM327-2, and Intermediate IM327-3 were sequentially used instead of Intermediate IM323-5, Intermediate IM323-1, Intermediate IM323-2, and Intermediate IM323-3, respectively.

**Synthesis Example 10 (Synthesis of Compound BD329)**

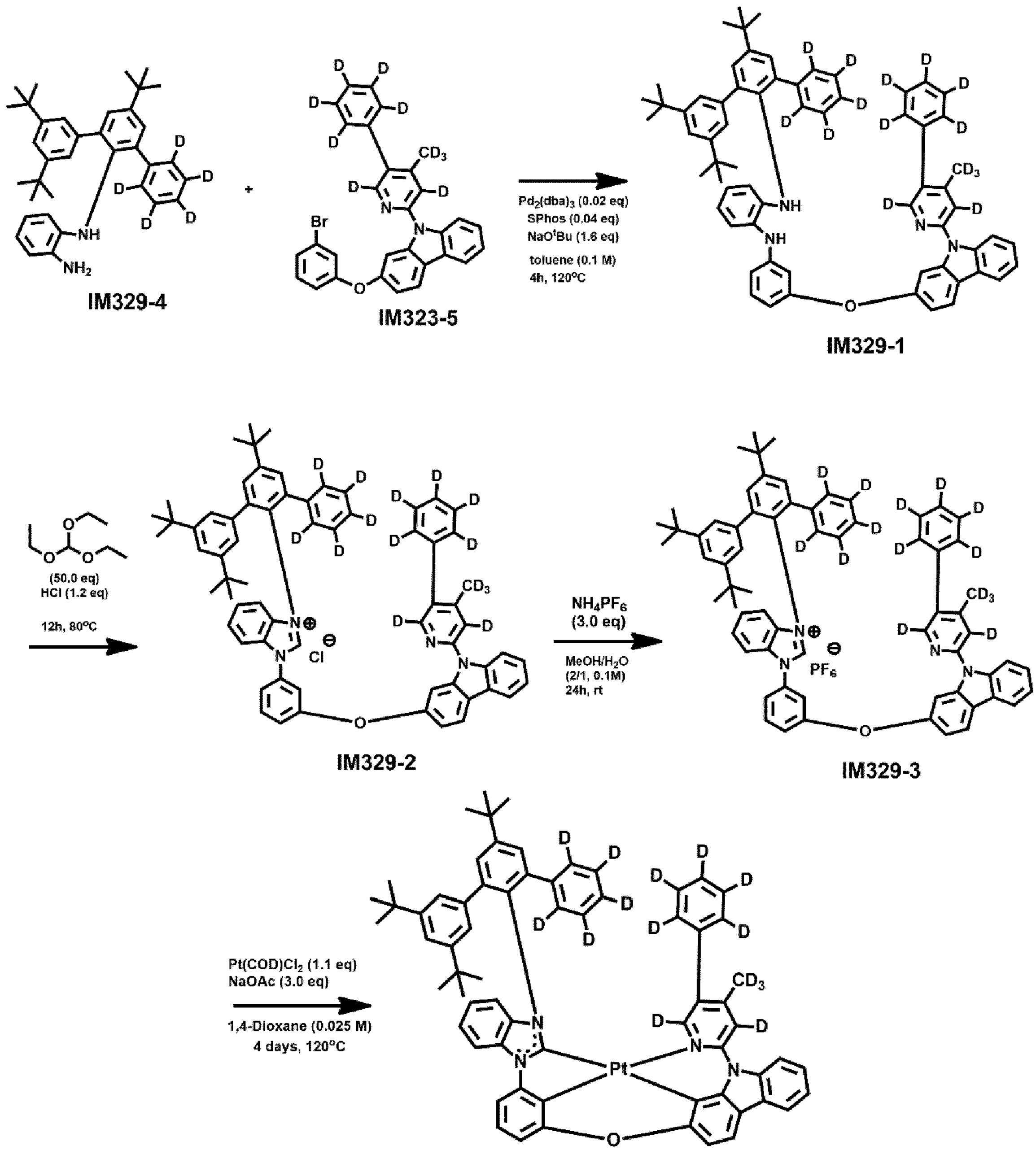


**BD329**

Compound BD329 (3.0 g, 2.6 mmol) was obtained in the yield of 38% in substantially the same manner as in Synthesis Example 1, except that *N*$^{1}$-(3,5,5'-tri-*tert*-butyl-[1,1':3',1"-terphenyl]-2'-yl-2",3",4",5",6"-$d_5$)benzene-1,2-diamine (Intermediate IM329-4) (5.8 g, 11.4 mmol), 2-(3-bromophenoxy)-9-(4-(methyl-$d_3$)-5-(phenyl-$d_5$)pyridin-2-yl-3,6-$d_2$)-9*H*-carbazole (Intermediate IM323-5) (5.9 g, 11.4 mmol), Intermediate IM329-1, Intermediate IM329-2, and Intermediate IM329-3 were sequentially used instead of Intermediate IM02-4, Intermediate IM02-5, Intermediate IM02-1, Intermediate IM02-2, and Intermediate IM02-3, respectively.

**Synthesis Example 11 (Synthesis of Compound BD331)**

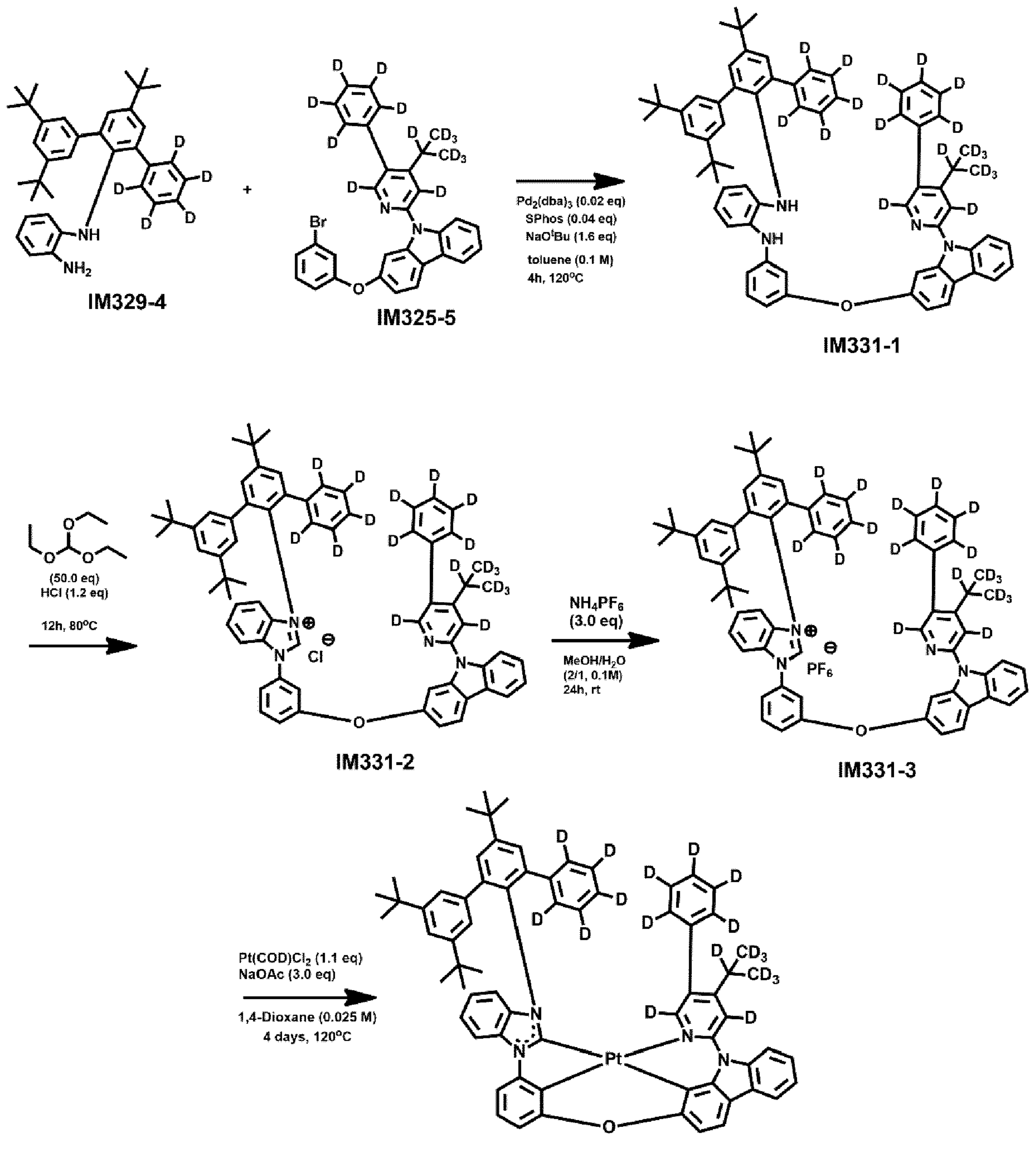


BD331

Compound BD331 (3.0 g, 2.6 mmol) was obtained in the yield of 37% in substantially the same manner as in Synthesis Example 10, except that 2-(3-bromophenoxy)-9-(5-(phenyl-*d*$_5$)-4-(propan-2-yl-*d*$_7$)pyridin-2-yl-3,6-d2)-9*H*-carbazole (Intermediate IM325-5) (6.2 g, 11.4 mmol), Intermediate IM331-1, Intermediate IM331-2, and Intermediate IM331-3 were sequentially used instead of Intermediate IM323-5, Intermediate IM329-1, Intermediate IM329-2, and Intermediate IM329-3, respectively.

**Synthesis Example 12 (Synthesis of Compound BD333)**

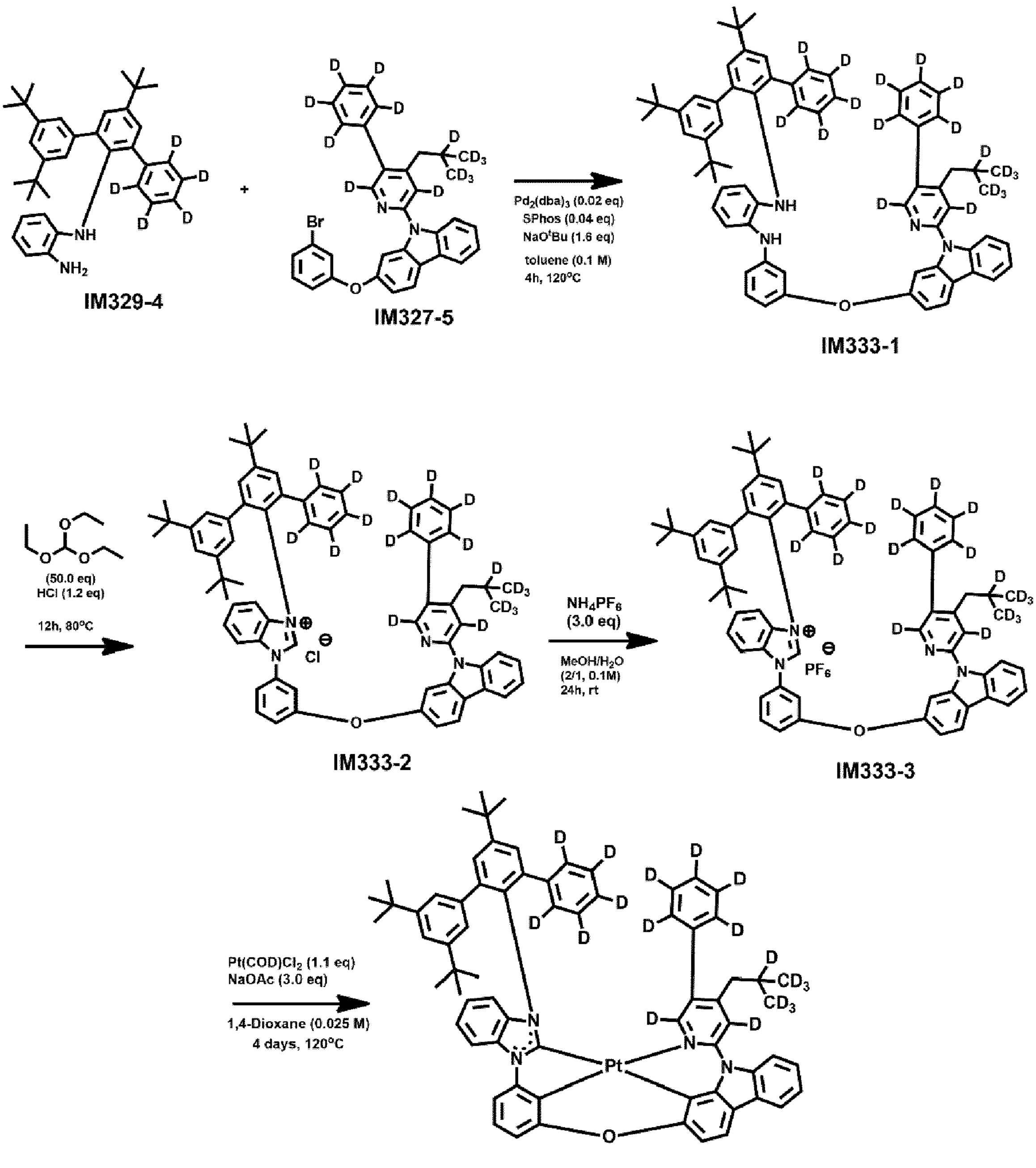


IM329-4 + IM327-5 → IM333-1 → IM333-2 → IM333-3 → BD333

Compound BD333 (3.0 g, 2.5 mmol) was obtained in the yield of 36% in substantially the same manner as in Synthesis Example 10, except that 2-(3-bromophenoxy)-9-(4-(2-(methyl-$d_3$)propyl-2,3,3,3-d4)-5-(phenyl-$d_5$)pyridin-2-yl-3,6-$d_2$)-9H-carbazole (Intermediate IM327-5) (6.4 g, 11.4 mmol), Intermediate IM333-1, Intermediate IM333-2, and Intermediate IM333-3 were sequentially used instead of Intermediate IM323-5, Intermediate IM329-1, Intermediate IM329-2, and Intermediate IM329-3, respectively.

**Comparative Synthesis Example A (Synthesis of Compound A)**

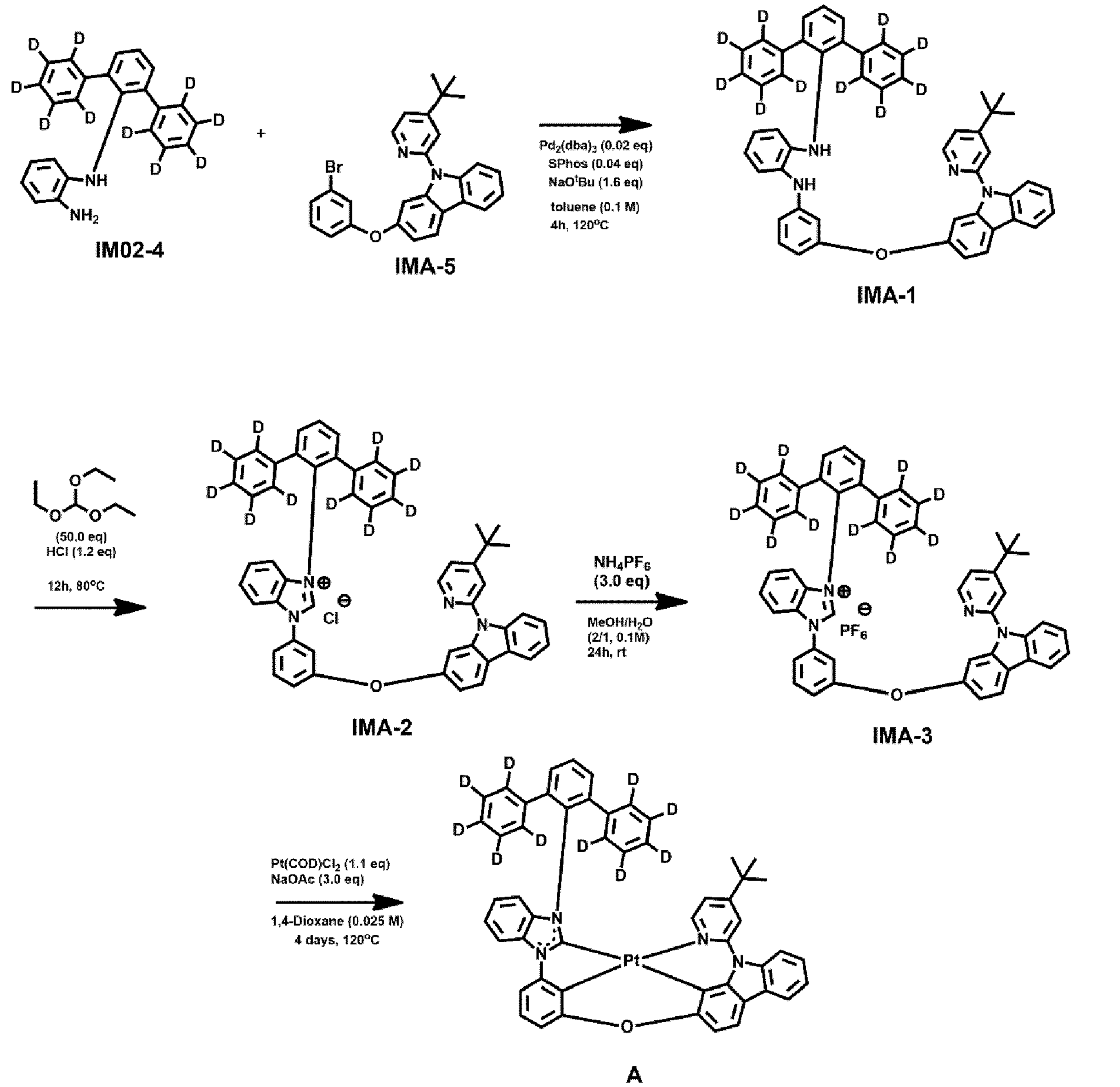


Compound A (2.1 g, 2.3 mmol) was obtained in the yield of 33% in substantially the same manner as in Synthesis Example 1, except that 2-(3-bromophenoxy)-9-(4-(*tert*-butyl)pyridin-2-yl)-9*H*-carbazole (Intermediate IMA-5) (5.4 g, 11.4 mmol), Intermediate IMA-1, Intermediate IMA-2, and Intermediate IMA-3 were sequentially used instead of Intermediate IM02-5, Intermediate IM02-1, Intermediate IM02-2, and Intermediate IM02-3, respectively.

**Comparative Synthesis Example B (Synthesis of Compound B)**

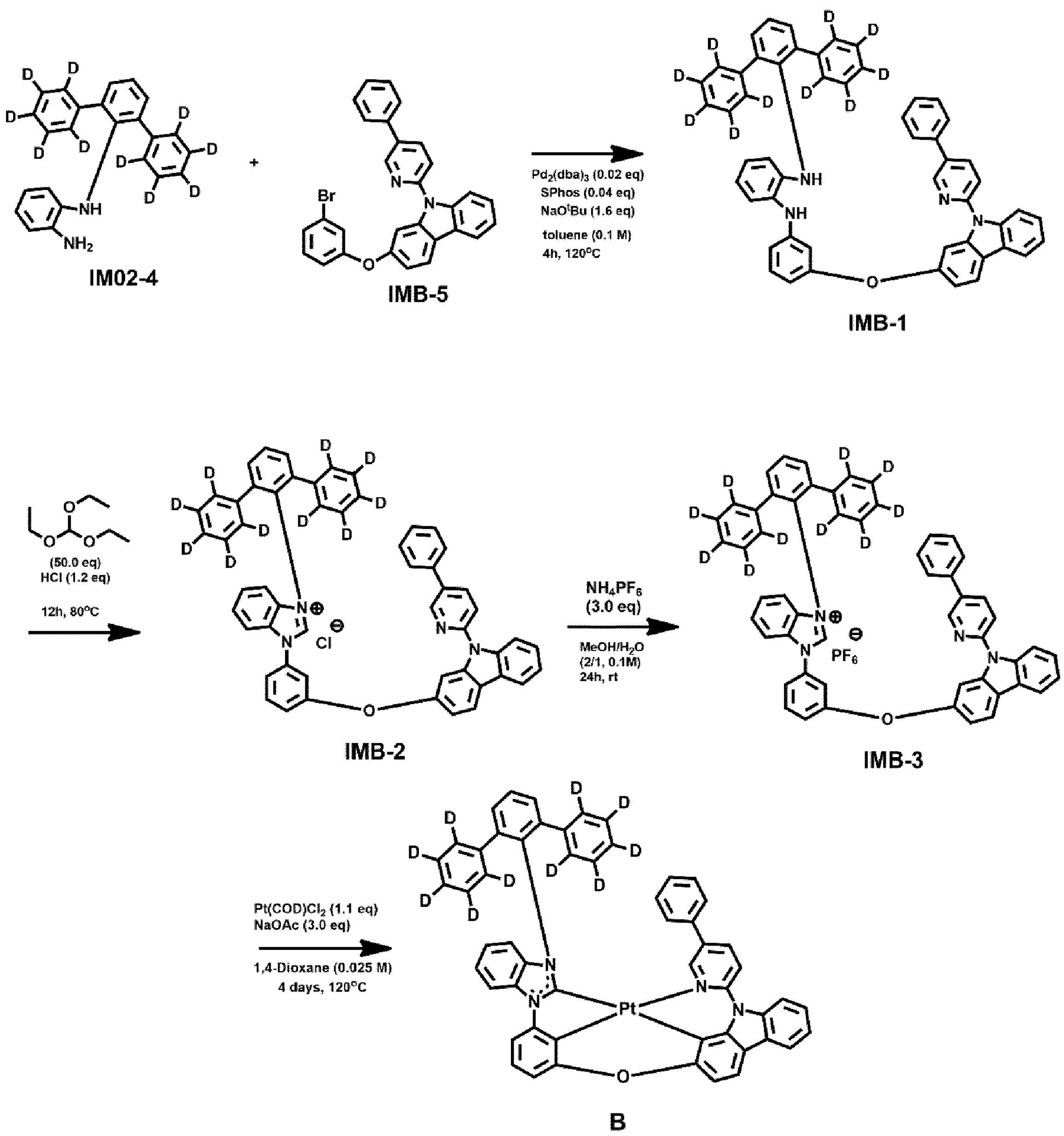


IM02-4 + IMB-5 → IMB-1 → IMB-2 → IMB-3 → B

Compound B (2.3 g, 2.4 mmol) was obtained in the yield of 35% in substantially the same manner as in Synthesis Example 1, except that 2-(3-bromophenoxy)-9-(5-phenylpyridin-2-yl)-9*H*-carbazole (Intermediate IMB-5) (5.6 g, 11.4 mmol), Intermediate IMB-1, Intermediate IMB-2, and Intermediate IMB-3 were sequentially used instead of Intermediate IM02-5, Intermediate IM02-1, Intermediate IM02-2, and Intermediate IM02-3, respectively.

**Comparative Synthesis Example C (Synthesis of Compound C)**

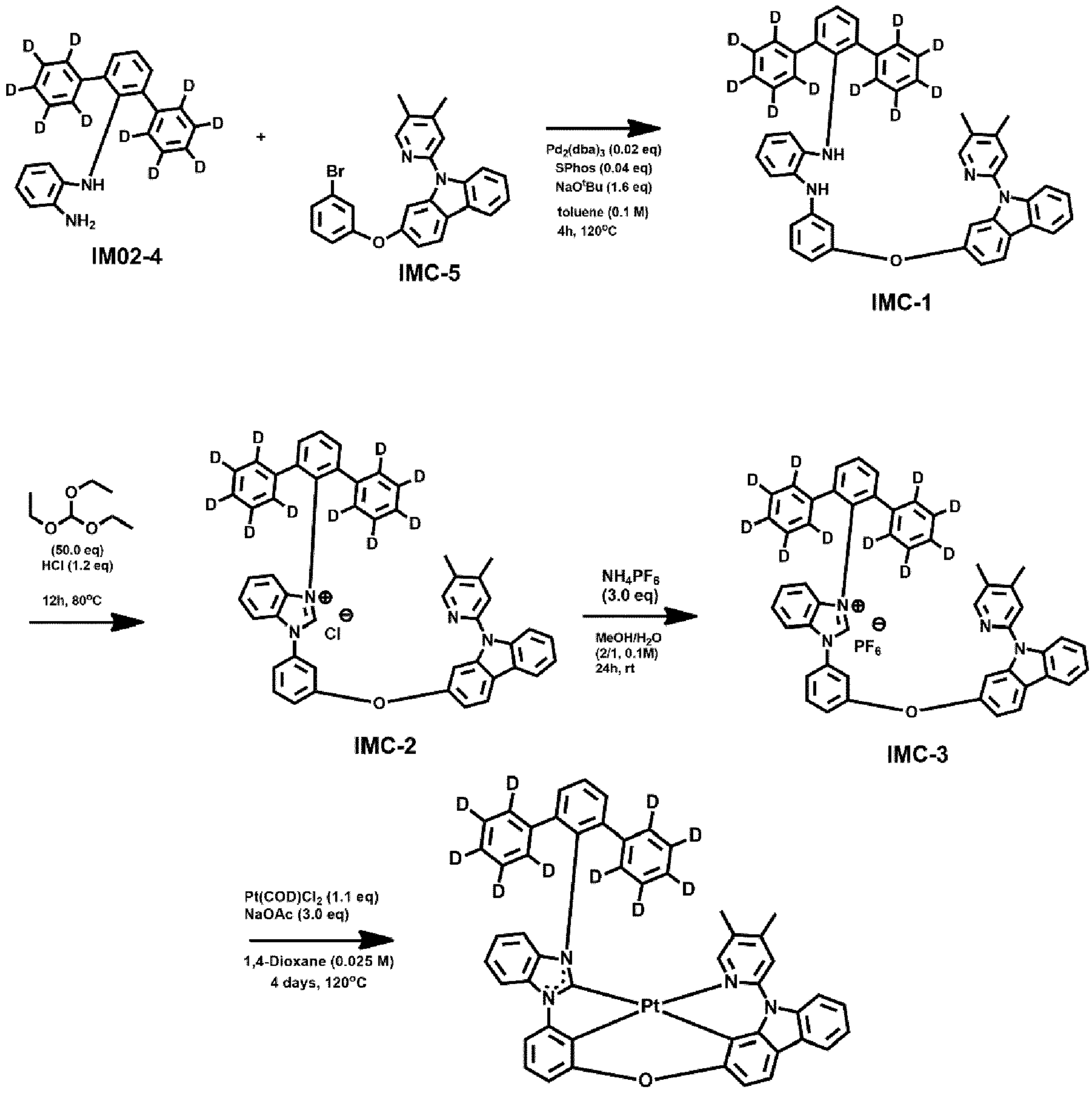


IM02-4, IMC-5, IMC-1, IMC-2, IMC-3

C

Compound C (1.9 g, 2.1 mmol) was obtained in the yield of 31% in substantially the same manner as in Synthesis Example 1, except that 2-(3-bromophenoxy)-9-(4,5-dimethylpyridin-2-yl)-9*H*-carbazole (Intermediate IMC-5) (5.1 g, 11.4 mmol), Intermediate IMC-1, Intermediate IMC-2, and Intermediate IMC-3 were sequentially used instead of Intermediate IM02-5, Intermediate IM02-1, Intermediate IM02-2, and Intermediate IM02-3, respectively.

Results of measuring $^1H$ NMR and high-resolution mass (HR-MS) of compounds synthesized in Synthesis Examples 1 to 12 and Comparative Synthesis Examples A to C were shown in Table 1. Synthesis methods of other compounds in addition to the compounds synthesized in Synthesis Examples 1 to 12 may be easily recognized by those skilled in the art by referring to the synthesis paths and source materials.

Table 1

| Compound | $^1$H NMR ($CDCl_3$ , 500 MHz) | HR-MS (m/z) [$M^+$] | |
|---|---|---|---|
| | | found | calc. |
| BD02 | $\delta$ 9.02 (s, 1H), 8.15 (d, $^3J_{H-H}$ = 8.1 Hz, 1H), 8.11 (d, $^3J_{H-H}$ = 7.0 Hz, 1H), 7.97 (d, $^3J_{H-H}$ = 8.3 Hz, 1H), 7.91 (s, 1H), 7.79 (d, $^3J_{H-H}$ = 8.2 Hz, 1H), 7.52-7.37 (m, 4H), 7.33-7.23 (m, 3H), 7.20 (t, $^3J_{H-H}$ = 7.8 Hz, $^4J_{H-H}$ = 1.0 Hz, 1H), 7.07 (dd, $^3J_{H-H}$ = 8.2 Hz, $^4J_{H-H}$ =0.9 Hz, 1H), 6.98 (t, $^3J_{H-H}$ = 7.4 Hz, 1H), 6.74 (d, $^3J_{H-H}$ = 7.8 Hz, 1H), 6.72 (dd, $^3J_{H-H}$ = 7.7 Hz, $^4J_{H-H}$ = 1.5 Hz, 1H), 2.27 (s, 3H). | 979.35379 | 979.35511 |
| BD04 | $\delta$ 9.03 (s, 1H), 8.31 (d, $^4J_{H-H}$ = 1.4 Hz, 1H), 8.20 (d, $^3J_{H-H}$ = 8.4 Hz, 1H), 7.97 (d, $^3J_{H-H}$ = 8.3 Hz, 1H), 7.93 (s, 1H), 7.84-7.82 (m, 3H), 7.75 (dd, $^3J_{H-H}$ = 8.4 Hz, $^4J_{H-H}$ =1.6 Hz, 1H), 7.54 (t, $^3J_{H-H}$ = 7.5 Hz, 2H), 7.49 (d, $^3J_{H-H}$ = 7.5 Hz, 1H), 7.42-7.38 (m, 2H), 7.35-7.31 (m, 1H), 7.27-7.24 (m, 1H), 7.19 (t, $^3J_{H-H}$ = 7.5 Hz, 2H), 7.08 (d, $^3J_{H-H}$ = 8.1 Hz, 1H), 6.97 (t, $^3J_{H-H}$ = 7.6 Hz, 1H), 6.74 (d, $^3J_{H-H}$ = 8.2 Hz, 1H), 6.72 (d, $^3J_{H-H}$ = 7.5 Hz, 1H), 2.28 (s, 3H). | 1055.38752 | 1054.37914 |
| BD23 | $\delta$ 9.02 (s, 1H), 8.15 (d, $^3J_{H-H}$ = 8.1 Hz, 1H), 8.11 (dd, $^3J_{H-H}$ = 7.6 Hz, $^4J_{H-H}$ =0.6 Hz, 1H), 7.97 (d, $^3J_{H-H}$ = 8.4 Hz, 1H), 7.89 (s, 1H), 7.78 (d, $^3J_{H-H}$ = 8.2 Hz, 1H), 7.52-7.48 (m, 2H), 7.43 (td, $^3J_{H-H}$ = 7.6 Hz, $^4J_{H-H}$ =0.8 Hz, 1H), 7.39 (t, $^3J_{H-H}$ = 7.7 Hz, 1H), 7.32 (d, $^3J_{H-H}$ = 8.2 Hz, 1H), 7.28-7.24 (m, 3H), 7.18 (td, $^3J_{H-H}$ = 8.2 Hz, $^4J_{H-H}$ = 1.0 Hz, 1H), 7.07 (td, $^3J_{H-H}$ = 7.6 Hz, $^4J_{H-H}$ =0.8 Hz, 1H), 6.98-6.94 (m, 4H), 6.73 (d, $^3J_{H-H}$ = 8.1 Hz, 1H), 6.62 (dd, $^3J_{H-H}$ = 7.6 Hz, $^4J_{H-H}$ = 1.5 Hz, 1H), 2.29 (s, 3H), 1.12 (s, 9H). | 1030.38623 | 1029.38633 |
| BD58 | $\delta$ 9.02 (s, 1H), 8.15 (d, $^3J_{H-H}$ = 8.1 Hz, 1H), 8.11 (dd, $^3J_{H-H}$ = 7.6 Hz, $^4J_{H-H}$ =0.6 Hz, 1H), 7.97 (d, $^3J_{H-H}$ = 8.4 Hz, 1H), 7.89 (s, 1H), 7.78 (d, $^3J_{H-H}$ = 8.2 Hz, 1H), 7.52-7.48 (m, 2H), 7.43 (td, $^3J_{H-H}$ = 7.6 Hz, $^4J_{H-H}$ =0.8 Hz, 1H), 7.39 (t, $^3J_{H-H}$ = 7.7 Hz, 1H), 7.32 (d, $^3J_{H-H}$ = 8.2 Hz, 1H), 7.28-7.24 (m, 3H), 7.18 (td, $^3J_{H-H}$ = 8.2 Hz, $^4J_{H-H}$ = 1.0 Hz, 1H), 7.07 (td, $^3J_{H-H}$ = 7.6 Hz, $^4J_{H-H}$ =0.8 Hz, 1H), 6.98-6.94 (m, 4H), 6.73 (d, $^3J_{H-H}$ = 8.1 Hz, 1H), 6.62 (dd, $^3J_{H-H}$ = 7.6 Hz, $^4J_{H-H}$ = 1.5 Hz, 1H), 1.12 (s, 9H). | 1033.38733 | 1032.39788 |
| BD71 | $\delta$ 8.85 (s, 1H), 8.15 (d, $^3J_{H-H}$ = 7.1 Hz, 1H), 8.11 (s, 1H), 8.09 (d, $^3J_{H-H}$ = 8.1 Hz, 1H), 7.94 (d, $^3J_{H-H}$ = 8.3 Hz, 1H), 7.82 (d, $^3J_{H-H}$ = 8.2 Hz, 1H), 7.60 (t, $^3J_{H-H}$ = 7.6 Hz, 1H), 7.56-7.48 (m, 4H), 7.43 (d, $^3J_{H-H}$ = 8.1 Hz, $^4J_{H-H}$ = 0.7 Hz, 2H), 7.37-7.33 (m, 3H), 7.32 (m, 2H), 7.22 (t, $^3J_{H-H}$ = 8.0 Hz, 1H), 7.18 (td, $^3J_{H-H}$ = 7.8 Hz, $^4J_{H-H}$ = 1.0 Hz, 1H), 7.04 (dd, $^3J_{H-H}$ = 8.1 Hz, $^4J_{H-H}$ = 0.8 Hz, 1H), 6.97 (td, $^3J_{H-H}$ = 7.6 Hz, $^4J_{H-H}$ = 0.6 Hz, 1H), 6.76 (d, $^3J_{H-H}$ = 8.0 Hz, 1H), 1.10 (s, 9H). | 1016.36847 | 1015.36340 |
| BD72 | $\delta$ 8.85 (s, 1H), 8.15 (d, $^3J_{H-H}$ = 7.1 Hz, 1H), 8.11 (s, 1H), 8.09 (d, $^3J_{H-H}$ = 8.1 Hz, 1H), 7.94 (d, $^3J_{H-H}$ = 8.3 Hz, 1H), 7.82 (d, $^3J_{H-H}$ = 8.2 Hz, 1H), 7.60 (t, $^3J_{H-H}$ = 7.6 Hz, 1H), 7.56-7.51 (m, 2H), 7.43 (d, $^3J_{H-H}$ = 8.1 Hz, $^4J_{H-H}$ = 0.7 Hz, 2H), 7.37 (dd, $^3J_{H-H}$ = 7.5 Hz, $^4J_{H-H}$ = 1.7 Hz, 1H), 7.32 (d, $^3J_{H-H}$ = 7.1 Hz, 1H), 7.22 (t, $^3J_{H-H}$ = 8.0 Hz, 1H), 7.18 (td, $^3J_{H-H}$ = 7.8 Hz, $^4J_{H-H}$ = 1.0 Hz, 1H), 7.04 (dd, $^3J_{H-H}$ = 8.1 Hz, $^4J_{H-H}$ = 0.8 Hz, 1H), 6.97 (td, $^3J_{H-H}$ = 7.6 Hz, $^4J_{H-H}$ = 0.6 Hz, 1H), 6.76 (d, $^3J_{H-H}$ = 8.0 Hz, 1H), 1.10 (s, 9H). | 1021.40159 | 1021.40206 |
| BD323 | $\delta$ 8.05 (d, $^3J_{H-H}$ = 7.5 Hz, 1H), 7.96 (d, $^3J_{H-H}$ = 8.3 Hz, 1H), 7.85-7.83 (m, 2H), 7.77 (d, $^3J_{H-H}$ = 8.2 Hz, 1H), 7.53 (t, $^3J_{H-H}$ = 7.2 Hz, 1H), 7.47-7.46 (m, 1H), 7.40-7.37 (m, 1H), 7.34-7.33 (m, 1H), 7.31 (d, $^3J_{H-H}$ = 8.2 Hz, 1H), 7.24-7.18 (m, 1H), 7.13 (t, $^3J_{H-H}$ = 7.6 Hz, 1H), 7.06-6.93 (m, 2H), 6.81 (t, $^3J_{H-H}$ = 7.5 Hz, 1H), 6.76 (s, 1H), 6.73 (d, $^3J_{H-H}$ = 8.1 Hz, 1H), 6.49 (s (br), 2H), 1.27 (s, 18H). | 1090.47312 | 1090.47194 |

(continued)

| Compound | $^1H$ NMR ($CDCl_3$ , 500 MHz) | HR-MS (m/z) [$M^+$] | |
|---|---|---|---|
| | | found | calc. |
| BD325 | $\delta$ 8.04 (*d,* $^3J_{H-H}$ = 7.6 Hz, 1H), 7.93 (*d,* $^3J_{H-H}$ = 8.3 Hz, 1H), 7.86-7.83 (m, 2H), 7.77 (*d,* $^3J_{H-H}$ = 8.2 Hz, 1H), 7.53 (*t,* $^3J_{H-H}$ = 7.2 Hz, 1H), 7.47-7.46 (m, 1H), 7.40-7.37 (m, 1H), 7.34-7.33 (m, 1H), 7.29 (*d,* $^3J_{H-H}$ = 8.2 Hz, 1H), 7.23-7.17 (m, 1H), 7.10 (*t,* $^3J_{H-H}$ = 7.6 Hz, 1H), 7.05-6.96 (m, 2H), 6.82 (*t,* $^3J_{H-H}$ = 7.5 Hz, 1H), 6.76 (s, 1H), 6.73 (*d,* $^3J_{H-H}$ = 8.1 Hz, 1H), 6.43 (*s (br),* 2H), 1.26 (s, 18H). | 1122.52968 | 1122.52835 |
| BD327 | $\delta$ 8.05 (*d,* $^3J_{H-H}$ = 7.6 Hz, 1H), 7.91 (*d,* $^3J_{H-H}$ = 8.3 Hz, 1H), 7.88-7.81 (m, 2H), 7.78 (*d,* $^3J_{H-H}$ = 8.2 Hz, 1H), 7.54 (*t,* $^3J_{H-H}$ = 7.2 Hz, 1H), 7.49-7.46 (m, 1H), 7.40-7.37 (m, 1H), 7.36-7.34 (m, 1H), 7.25 (*d,* $^3J_{H-H}$ = 8.2 Hz, 1H), 7.23-7.17 (m, 1H), 7.11 (*t,* $^3J_{H-H}$ = 7.6 Hz, 1H), 7.06-6.96 (m, 2H), 6.82 (*t,* $^3J_{H-H}$ = 7.5 Hz, 1H), 6.76 (s, 1H), 6.73 (*d,* $^3J_{H-H}$ = 8.1 Hz, 1H), 6.43 (s *(br)*, 2H), 2.49 (*d,* $^3J_{H-H}$ = 0.7 Hz, 2H), 1.25 (s, 18H). | 1136.54515 | 1136.54400 |
| BD329 | $\delta$ 8.05 (*d,* $^3J_{H-H}$ = 7.5 Hz, 1H), 7.95 (*d,* $^3J_{H-H}$ = 8.3 Hz, 1H), 7.89 (*t,* $^3J_{H-H}$ = 8.5 Hz, 1H), 7.77 (*d,* $^3J_{H-H}$ = 8.2 Hz, 1H), 7.53 *(t,* $^3J_{H-H}$ = 7.2 Hz, 1H), 7.47-7.43 (m, 1H), 7.40-7.37 (m, 1H), 7.34-7.33 (m, 1H), 7.31 (*d,* $^3J_{H-H}$ = 8.2 Hz, 1H), 7.24-7.18 (m, 1H), 7.13 (*t,* $^3J_{H-H}$ = 7.6 Hz, 1H), 7.05-6.93 (m, 2H), 6.81 (*t,* $^3J_{H-H}$ = 7.5 Hz, 1H), 6.76 (s, 1H), 6.73 (*d,* $^3J_{H-H}$ = 8.1 Hz, 1H), 6.49 (s *(br),* 2H), 1.47 (s, 9H), 1.06 (s, 9H), 0.34 (s, 9H). | 1146.53467 | 1146.53454 |
| BD331 | $\delta$ 8.04 (*d,* $^3J_{H-H}$ = 7.5 Hz, 1H), 7.96 (*d,* $^3J_{H-H}$ = 8.3 Hz, 1H), 7.90 (*t,* $^3J_{H-H}$ = 8.5 Hz, 1H), 7.77 (*d,* $^3J_{H-H}$ = 8.2 Hz, 1H), 7.53 (*t,* $^3J_{H-H}$ = 7.2 Hz, 1H), 7.48-7.43 (m, 1H), 7.40-7.37 (m, 1H), 7.35-7.33 (m, 1H), 7.32 (*d,* $^3J_{H-H}$ = 8.2 Hz, 1H), 7.25-7.19 (m, 1H), 7.12 (*t,* $^3J_{H-H}$ = 7.6 Hz, 1H), 7.04-6.92 (m, 2H), 6.80 (*t,* $^3J_{H-H}$ = 7.5 Hz, 1H), 6.78 (s, 1H), 6.74 (*d,* $^3J_{H-H}$ = 8.1 Hz, 1H), 6.48 (s *(br),* 2H), 1.47 (s, 9H), 1.06 (s, 9H), 0.34 (s, 9H). | 1178.59216 | 1178.59095 |
| BD333 | $\delta$ 8.06 (*d,* $^3J_{H-H}$ = 7.5 Hz, 1H), 7.94 (*d,* $^3J_{H-H}$ = 8.3 Hz, 1H), 7.90 (*t,* $^3J_{H-H}$ = 8.5 Hz, 1H), 7.77 (*d,* $^3J_{H-H}$ = 8.2 Hz, 1H), 7.53 *(t,* $^3J_{H-H}$ = 7.2 Hz, 1H), 7.47-7.43 (m, 1H), 7.40-7.37 (m, 1H), 7.37-7.36 (m, 1H), 7.30 (*d,* $^3J_{H-H}$ = 8.2 Hz, 1H), 7.24-7.18 (m, 1H), 7.13 (*t,* $^3J_{H-H}$ = 7.6 Hz, 1H), 7.05-6.93 (m, 2H), 6.81 (*t,* $^3J_{H-H}$ = 7.5 Hz, 1H), 6.77 (s, 1H), 6.72 (*d,* $^3J_{H-H}$ = 8.1 Hz, 1H), 6.49 (s *(br),* 2H), 2.50 (*d,* $^3J_{H-H}$ = 0.7 Hz, 2H), 1.47 (s, 9H), 1.06 (s, 9H), 0.34 (s, 9H). | 1192.60701 | 1192.60660 |
| A | $\delta$ 9.00 (*d,* $^3J_{H-H}$ = 5.9 Hz, 1H), 8.09-8.08 (m, 3H), 7.99 (*d,* $^3J_{H-H}$ = 8.2 Hz, 1H), 7.76 (*d,* $^3J_{H-H}$ = 5.9 Hz, 1H), 7.52-7.48 (m, 3H), 7.42 (*t,* $^3J_{H-H}$ = 7.1 Hz, 1H), 7.32 (*d,* $^3J_{H-H}$ = 8.6 Hz, 1H), 7.26-7.23 (m, 4H), 7.07 (*d,* $^3J_{H-H}$ = 8.8 Hz, 1H), 7.04 (*d,* $^3J_{H-H}$ = 7.1 Hz, 1H), 6.87 (*d,* $^3J_{H-H}$ = 8.1 Hz, 1H), 6.19 *(d,* $^3J_{H-H}$ = 6.2 Hz, 1H), 1.29 (s, 9H). | 939.33591 | 939.33210 |
| B | $\delta$ 9.01 (s, 1H), 8.04-8.00 (m, 3H), 7.98 (*d,* $^3J_{H-H}$ = 8.2 Hz, 1H), 7.76 (*d,* $^3J_{H-H}$ = 5.9 Hz, 1H), 7.52-7.48 (m, 5H), 7.41-7.32 (m, 3H), 7.26-7.23 (m, 6H), 7.07 (*d,* $^3J_{H-H}$ = 8.8 Hz, 1H), 7.04 (*d,* $^3J_{H-H}$ = 7.1 Hz, 1H), 6.87 (*d,* $^3J_{H-H}$ = 8.1 Hz, 1H), 6.19 *(d,* $^3J_{H-H}$ = 6.2 Hz, 1H). | 959.30066 | 959.30025 |
| C | $\delta$ 8.7 (*d,* $^3J_{H-H}$ = 6.0 Hz, 1H), 8.07-8.05 (m, 2H), 7.98 (*d,* $^3J_{H-H}$ = 8.2 Hz, 1H), 7.76 (*d,* $^3J_{H-H}$ = 5.9 Hz, 1H), 7.75 (s, 1H) 7.51-7.48 (m, 2H), 7.40 (*t,* $^3J_{H-H}$ = 7.1 Hz, 1H), 7.33 (*d,* $^3J_{H-H}$ = 8.6 Hz, 1H), 7.26-7.23 (m, 4H), 7.08 (*d,* $^3J_{H-H}$ = 8.8 Hz, 1H), 7.04 (*d,* $^3J_{H-H}$ = 7.1 Hz, 1H), 6.86 (*d,* $^3J_{H-H}$ = 8.1 Hz, 1H), 6.19 (*d,* $^3J_{H-H}$ = 6.2 Hz, 1H), 2.40 (s, 3H), 2.37 (s, 3H). | 910.30478 | 910.30080 |

**Evaluation Example 1**

HOMO and LUMO energy levels of each of Compounds BD02, BD04, BD23, BD58, BD71, BD72, BD323,

BD325, BD327, BD329, BD331, BD333, A, B, and C were evaluated according to methods in Table 2, and results are shown in Table 3.

Table 2

| | |
|---|---|
| HOMO energy level evaluation method | By using cyclic voltammetry (CV) (electrolyte: 0.1 M $Bu_4NPF_6$ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By using cyclic voltammetry (CV) (electrolyte: 0.1 M $Bu_4NPF_6$ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |

Table 3

| Compound No. | HOMO (eV) | LUMO (eV) |
|---|---|---|
| BD02 | -5.28 | -2.12 |
| BD04 | -5.29 | -2.13 |
| BD23 | -5.28 | -1.97 |
| BD58 | -5.28 | -1.97 |
| BD71 | -5.29 | -2.06 |
| BD72 | -5.29 | -2.06 |
| BD323 | -5.29 | -1.96 |
| BD325 | -5.30 | -2.11 |
| BD327 | -5.29 | -2.14 |
| BD329 | -5.28 | -1.93 |
| BD331 | -5.30 | -2.11 |
| BD333 | -5.29 | -2.13 |
| A | -5.28 | -2.11 |
| B | -5.30 | -2.15 |
| C | -5.29 | -2.08 |

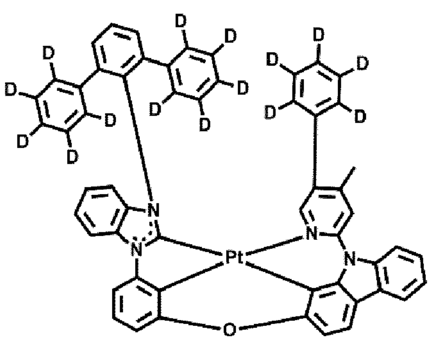

**BD02**

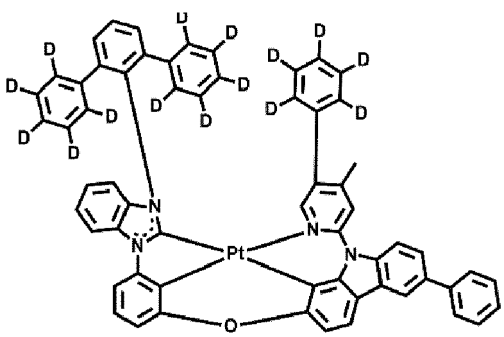

**BD04**

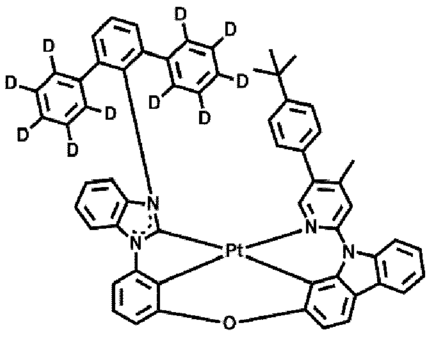

BD23

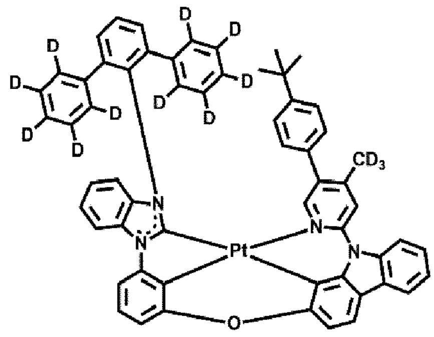

BD58

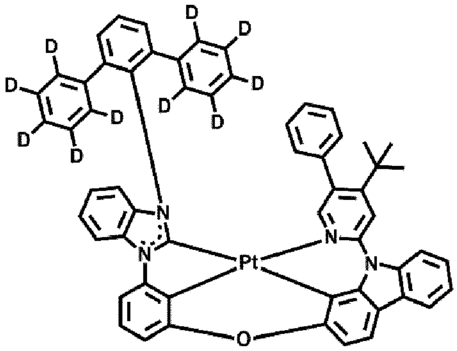

BD71

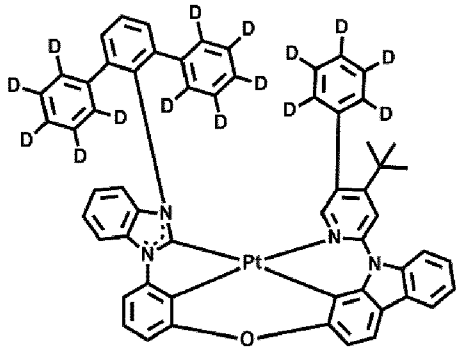

BD72

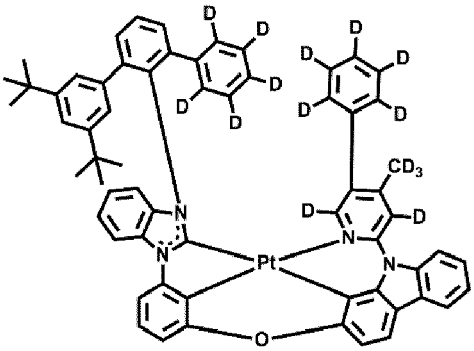

BD323

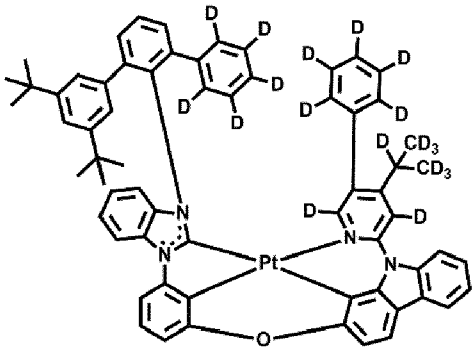

BD325

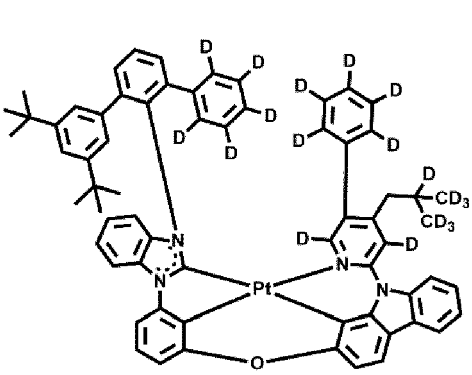

BD327

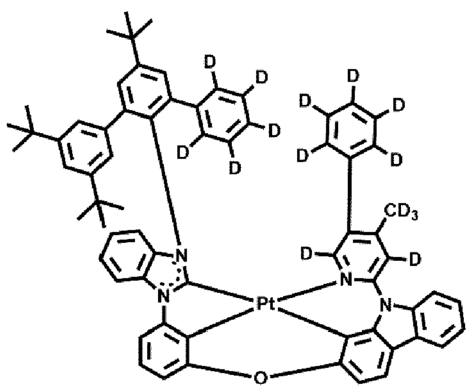

BD329

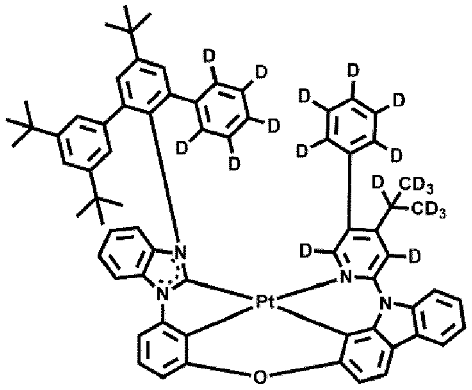

BD331

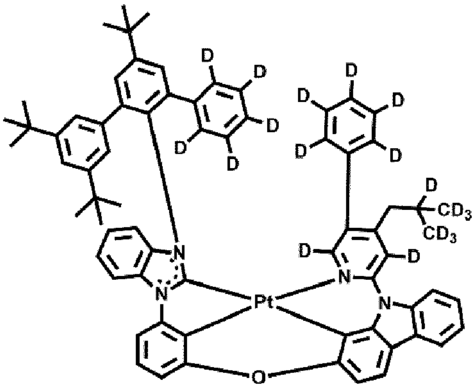

BD333

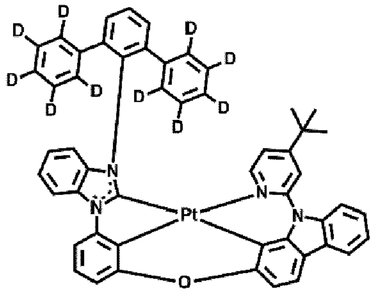

A

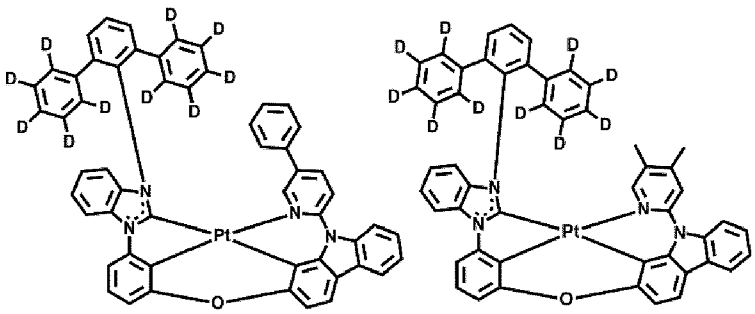

B

C

**Evaluation Example 2**

After PMMA in $CH_2Cl_2$ solution and Compound BD02 (4 wt% in PMMA) were mixed, the result obtained therefrom was coated on a quartz substrate by using a spin coater and then heat-treated in an oven at 80 °C, followed by cooling to room temperature, thereby manufacturing Film BD02 having a thickness of 40 nm. Next, Films BD04, BD23, BD58, BD71, BD72, BD323, BD325, BD327, BD329, BD331, BD333, A, B, and C were manufactured in substantially the same manner as used to obtain Film BD02, except that each of Compounds BD04, BD23, BD58, BD71, BD72, BD323, BD325, BD327, BD329, BD331, BD333, A, B, and C were used instead of Compound BD02.

A photoluminescence (PL) spectrum of each of Films BD02, BD04, BD23, BD58, BD71, BD72, BD323, BD325, BD327, BD329, BD331, BD333, A, B, and C were measured by using a quantaurus-QY absolute PL quantum yield spectrometer (on which a xenon light source, a monochromator, a photonic multichannel analyzer, and an integrating sphere were mounted and which includes photoluminescence quantum yield (PLQY) measurement software (Hamamatsu Photonics, Ltd., Shizuoka)) manufactured by Hamamatsu Inc. During the measurement, an excitation wavelength was scanned from 320 nm to 380 nm at intervals of 10 nm, and a spectrum measured at the excitation wavelength of 340 nm was taken to obtain a maximum emission wavelength (emission peak wavelength) and emission FWHM of an organometallic compound included in each film, which were shown in Table 4 below.

Next, a photoluminescence quantum yield (PLQY) of each of Films BD02, BD04, BD23, BD58, BD71, BD72, BD323, BD325, BD327, BD329, BD331, BD333, A, B, and C were measured by scanning an excitation wavelength from 320 nm to 380 nm at intervals of 10 nm by using the quantaurus-QY absolute PL quantum yield spectrometer manufactured by Hamamatsu Inc., and then the PLQY measured at the excitation wavelength of 340 nm was taken to obtain a PLQY of the organometallic compound included in each film, which were shown in Table 4.

Table 4

| Film no. | Organometallic compound included in film (4 wt% in PMMA) | Maximum emission wavelength (nm) | Emission FWHM (nm) | PLQY (%) |
|---|---|---|---|---|
| BD02 | BD02 | 455 | 21 | 91 |
| BD04 | BD04 | 457 | 21 | 95 |

(continued)

| Film no. | Organometallic compound included in film (4 wt% in PMMA) | Maximum emission wavelength (nm) | Emission FWHM (nm) | PLQY (%) |
|---|---|---|---|---|
| BD23 | BD23 | 455 | 21 | 93 |
| BD58 | BD58 | 455 | 21 | 96 |
| BD71 | BD71 | 456 | 21 | 90 |
| BD72 | BD72 | 456 | 21 | 91 |
| BD323 | BD323 | 455 | 20 | 93 |
| BD325 | BD325 | 456 | 20 | 96 |
| BD327 | BD327 | 456 | 20 | 97 |
| BD329 | BD329 | 455 | 20 | 96 |
| BD331 | BD331 | 456 | 20 | 97 |
| BD333 | BD333 | 456 | 20 | 97 |
| A | A | 456 | 41 | 90 |
| B | B | 458 | 48 | 82 |
| C | C | 456 | 43 | 87 |

From Table 4, it can be seen that Compounds BD02, BD04, BD23, BD58, BD71, BD72, BD323, BD325, BD327, BD329, BD331, and BD333 had equal or excellent PLQY and emitted blue light having relatively smaller emission FWHM as compared to those of Compounds A to C.

**Evaluation Example 3**

Compound BD02, Compound ETH2, and Compound HTH29 were vacuum-codeposited on a quartz substrate at a vacuum degree of $10^{-7}$ torr to prepare Film 1 having a thickness of 40 nm. Here, an amount of each compound was adjusted so that a weight ratio of Compound ETH2 to Compound HTH29 was 3 : 7, and an amount of Compound BD02 was 10 parts by weight based on 100 parts by weight of a film. Next, Films 2 to 12, A1, B1, and C1 were manufactured in substantially the same manner as used to obtain Film 1, except that each of Compounds BD04, BD23, BD58, BD71, BD72, BD323, BD325, BD327, BD329, BD331, BD333, A, B, and C was used instead of Compound BD02.

A PL spectrum of each of Films 1 to 12, A1, B1, and C1 was measured at room temperature by using FluoTime 300, which is a TRPL measurement system manufactured by PicoQuant Inc. and PLS340 (excitation wavelength = 340 nm, spectral width = 20 nm), which is a pumping source of PicoQuant Inc. Then, the wavelength of the main peak of each spectrum was identified, and the number of photons emitted at the wavelength of the main peak from each of Films 1 to 12, A1, B1, and C1 by photon pulse (pulse width = 500 picoseconds) applied by PLS340 to each of Films 1 to 12, A1, B1, and C1 was repeatedly measured based on time-correlated single photon counting (TCSPC) according to time, thereby obtaining a TRPL curve sufficient for fitting. One or more exponential decay functions were fitted to the result obtained therefrom, thereby obtaining $T_{decay}$(Ex), that is, decay time, of each of Films 1 to 12, A1, B1, and C1, and results thereof are shown in Table 5. A function used for fitting is as shown in Equation 20, and from among $T_{decay}$ values obtained from each exponential decay function used for fitting, the largest $T_{decay}$ was obtained as $T_{decay}$ (Ex). In this regard, the same measurement was performed during the same measurement time as that for obtaining TRPL curve in the dark state (in which pumping signals entering each of the films are blocked) to obtain a baseline or a background signal curve for use as a baseline for fitting.

Equation 20

$$f(t) = \sum_{i=1}^{n} A_i \, exp(-t/T_{decay,i})$$

Table 5

| Film no. | Organometallic compound included in film | $\tau$ ($\mu$s) |
|---|---|---|
| 1 | BD02 | 2.42 |
| 2 | BD04 | 2.64 |
| 3 | BD23 | 2.87 |
| 4 | BD58 | 2.64 |
| 5 | BD71 | 2.68 |
| 6 | BD72 | 2.67 |
| 7 | BD323 | 2.61 |
| 8 | BD325 | 2.66 |
| 9 | BD327 | 2.62 |
| 10 | BD329 | 2.63 |
| 11 | BD331 | 2.62 |
| 12 | BD333 | 2.61 |
| A1 | A | 2.40 |
| B1 | B | 2.13 |
| C1 | C | 2.42 |

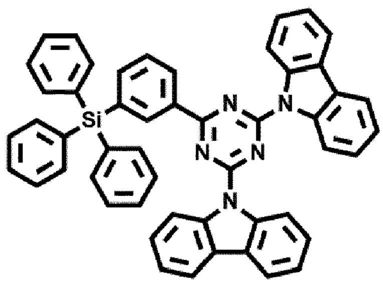

ETH2

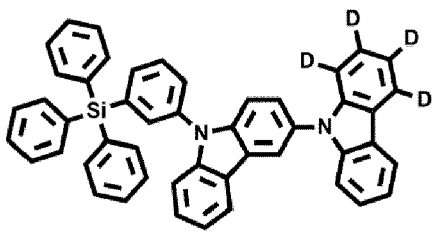

HTH29

From Table 5, it can be seen that Compounds BD04, BD23, BD58, BD71, BD72, BD323, BD325, BD327, BD329, BD331, and BD333 had longer decay time (that is, higher radiative decay rate (Kr)) as compared to that of Compounds A to C.

**Evaluation Example 4**

$TS_{M(migration)}$ energy (kcal/mol) that is energy barrier for ligand migration of each of Compounds BD23, BD58, BD323, BD325, BD327, BD329, BD331, BD333, A, B, and C was calculated (using a density functional theory (DFT) method of the Gaussian program (with the structure optimization at the level of M06/6-311g**/LAN2DZ, that is, using the Gaussian program from Gaussian, Inc. with an M06 functional and a 6-311g** and LAN2DZ mixed basis set) based on the lowest excitation triplet ($T_1$) energy of each compound, and results are shown in Table 6.

Table 6

| Compound No. | $TS_{M(migration)}$ energy (kcal/mol) |
|---|---|
| BD23 | 30.57 |
| BD58 | 29.10 |

(continued)

| Compound No. | $TS_{M(migration)}$ energy (kcal/mol) |
|---|---|
| BD323 | 29.83 |
| BD325 | 29.36 |
| BD327 | 29.67 |
| BD329 | 29.32 |
| BD331 | 29.48 |
| BD333 | 29.11 |
| A | 27.14 |
| B | 20.74 |
| C | 20.04 |

From Table 6, it can be seen that each of Compounds BD23, BD58, BD323, BD325, BD327, BD329, BD331, and BD333 had higher $TS_{M(migration)}$ energy than that of each of Compounds A, B, and C.

**Evaluation Example 5**

A phase transition diagram (see FIG. 4) of each of i) Compound ETH18, ii) Compound BD02, and iii) a mixture in which Compound ETH18 and Compound BD02 were mixed together at a weight ratio of 2.7 : 1 was evaluated using the SETSYS evolution TG-DTA device manufactured by Setaram, and a phase transition temperature (at $3.5 \times 10^{-3}$ torr) of each of i) Compound ETH18, ii) Compound BD02, and iii) the mixture in which Compound ETH18 and Compound BD02 were mixed together at a weight ratio of 2.7 : 1 was evaluated and shown in Table 7.

Table 7

| | Phase transition temperature (Tp, at $3.5 \times 10^{-3}$ torr) (°C) |
|---|---|
| Compound ETH18 | 372.7 |
| Compound BD02 | 368.4 |
| Mixture in which Compound ETH18 and Compound BD02 were mixed together at a weight ratio of 2.7 : 1 | 368.6 |

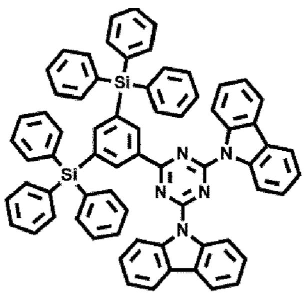

ETH18

From Table 7, an absolute value of a difference between phase transition temperatures of Compound ETH18 and Compound BD02 was 4.3 °C, and thus, Compound ETH18 and Compound BD02 in the mixture in which Compound ETH18 and Compound BD02 were mixed together at a weight ratio of 2.7 : 1 may be expected to vaporize at substantially the same temperature.

**Example 1**

As an anode, a glass substrate with a 15 Ω/cm$^2$ (1,200 Å) ITO formed thereon (available from Corning Co., Ltd) was cut to a size of 50 mmx50 mm×0.7 mm, sonicated by using isopropyl alcohol and pure water for 5 minutes in each solvent, washed by irradiation of ultraviolet rays and exposure of ozone thereto for 30 minutes, and was mounted on a vacuum deposition apparatus.

2-TNATA was vacuum-deposited on the anode to form a hole injection layer having a thickness of 600 Å, and 4,4'-bis[N-(1-naphthyl)-N-phenylamino]biphenyl (hereinafter, referred as "NPB") was vacuum-deposited on the hole injection layer to form a hole transport layer having a thickness of 300 Å.

Compound BD02 (organometallic compound represented by Formula 1), Compound ETH2 (second compound), and Compound HTH29 (third compound) were vacuum-deposited on the hole transport layer to form an emission layer having a thickness of 350 Å. Here, an amount of Compound BD02 was 13 wt% based on the total weight (100 wt%) of the emission layer, and a weight ratio of Compound ETH2 to Compound HTH29 was adjusted to 3.5 : 6.5.

Compound ETH34 was vacuum-deposited on the emission layer to form a hole blocking layer having a thickness of 50 Å, and ET46 and Liq were vacuum-deposited on the hole blocking layer at a weight ratio of 4 : 6 to form an electron transport layer having a thickness of 310 Å. Next, Yb was vacuum-deposited on the electron transport layer to form an electron injection layer having a thickness of 15 Å, and then Mg was vacuum-deposited thereon to form a cathode having a thickness of 800 Å, thereby completing manufacture of an organic light-emitting device.

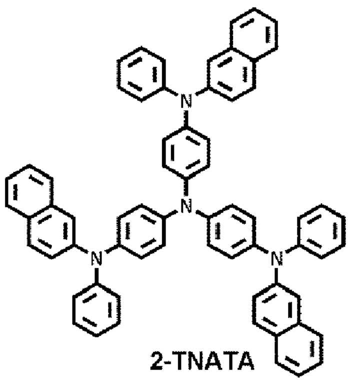

2-TNATA

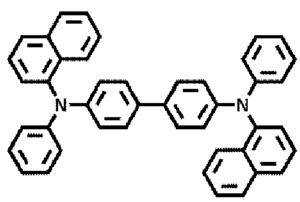

NPB

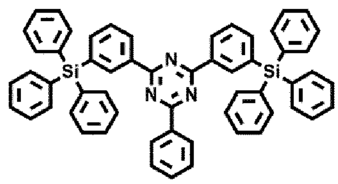

ETH34

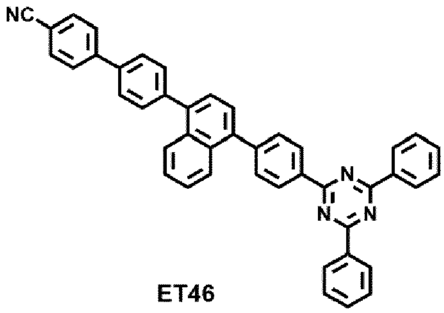

ET46

**Examples 2 to 13 and Comparative Examples A to C**

Organic light-emitting devices were manufactured in substantially the same manner as in Example 1, except that, in forming the emission layer, compounds shown in Table 8 were used as the organometallic compound represented by Formula 1, the second compound, the third compound, and/or the fourth compound.

**Evaluation Example 6**

The color purity CIE(x,y), luminescence efficiency (cd/A), color conversion efficiency (cd/A/y), maximum emission wavelength (nm), lifespan ($T_{95}$), and driving voltage (V) at 1,000cd/m$^2$ of the organic light-emitting devices manufactured in Examples 1 to 13 and Comparative Examples A to C were measured using the Keithley MU 236 and the luminance meter PR650, and results are shown in Tables 8 and 9. The lifespan ($T_{95}$) in Table 9 indicates a time (hr) for the luminance to decline to 95% of its initial luminance. In Table 8, a weight (wt%) per 100 wt% of emission layer of each of the organometallic compound represented by Formula 1 and the fourth compound and an absolute value (ΔCS, Hz) of a difference between a chemical shift value of $R_{44}$ and a chemical shift value of $R_{41}$, as measured by proton nuclear

magnetic resonance (NMR) spectroscopy, in the organometallic compound represented by Formula 1 were also shown. Electroluminescence spectra, graphs of luminance versus luminescence efficiency, and graphs of time versus luminance of Examples 1 to 13 and Comparative Examples A to C are understood by referring to FIGS. 5 to 19. Some graphs of FIGS. 5 to 19 are substantially the same, and thus may be indistinguishable as they overlap each other (for example, EL spectra of Examples 9 and 11 of FIG. 7).

Table 8

| No. | Organometallic compound represented by Formula 1 | Second compound | Third compound | Fourth compound | ΔCS (Hz) | Weight ratio of Second compound to Third compound |
|---|---|---|---|---|---|---|
| Example 1 | BD02 (13 wt%) | ETH2 | HTH29 | - | 559 | 3.5 : 6.5 |
| Example 2 | BD04 (13 wt%) | ETH2 | HTH29 | - | 553 | 3.5 : 6.5 |
| Example 3 | BD23 (13 wt%) | ETH2 | HTH29 | - | 565 | 3.5 : 6.5 |
| Example 4 | BD58 (13 wt%) | ETH2 | HTH29 | - | 565 | 3.5 : 6.5 |
| Example 5 | BD327 (13 wt%) | ETH2 | HTH29 | - | 570 | 3.5 : 6.5 |
| Example 6 | BD325 (13 wt%) | ETH2 | HTH29 | - | 517 | 3.5 : 6.5 |
| Example 7 | BD323 (13 wt%) | ETH2 | HTH29 | - | 584 | 3.5 : 6.5 |
| Example 8 | BD333 (13 wt%) | ETH2 | HTH29 | - | 573 | 3.5 : 6.5 |
| Example 9 | BD331 (13 wt%) | ETH2 | HTH29 | - | 520 | 3.5 : 6.5 |
| Example 10 | BD329 (13 wt%) | ETH2 | HTH29 | - | 590 | 3.5 : 6.5 |
| Example 11 | BD329 (13 wt%) | ETH18 | HTH29 | - | 590 | 4 : 6 |
| Example 12 | BD329 (13 wt%) | ETH18 | HTH29 | DFD7 (0.4 wt%) | 590 | 4 : 6 |
| Example 13 | BD329 (13 wt%) | ETH18 | HTH29 | DFD29 (1.2 wt%) | 590 | 4 : 6 |
| Comparative Example A | A (13 wt%) | ETH2 | HTH29 | - | 460 | 3.5 : 6.5 |
| Comparative Example B | B (13 wt%) | ETH2 | HTH29 | - | 452 | 3.5 : 6.5 |
| Comparative Example C | C (13 wt%) | ETH2 | HTH29 | - | 474 | 3.5 : 6.5 |

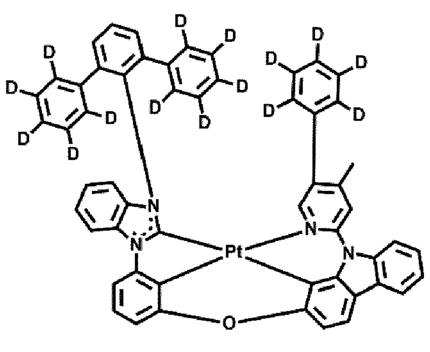

BD02

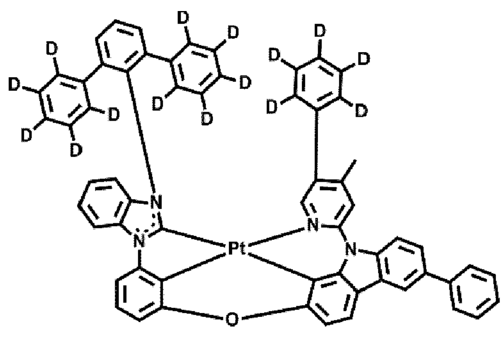

BD04

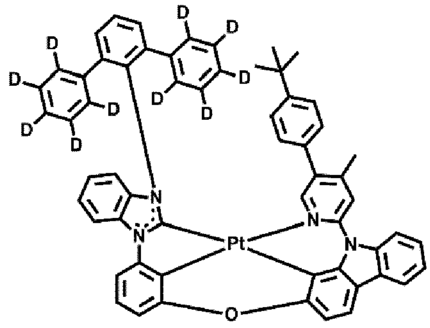

BD23

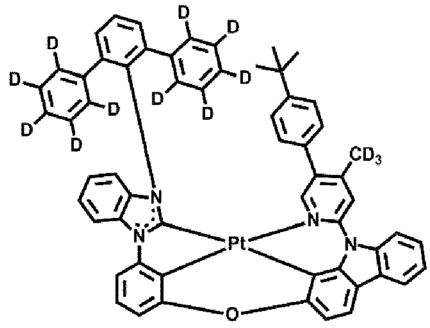

BD58

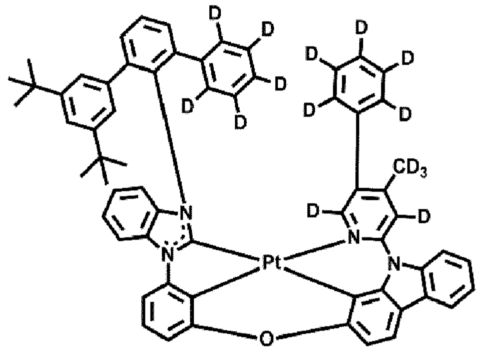

BD323

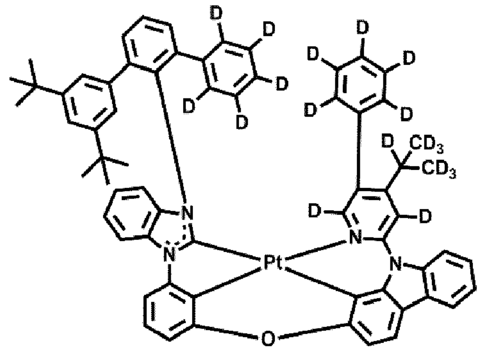

BD325

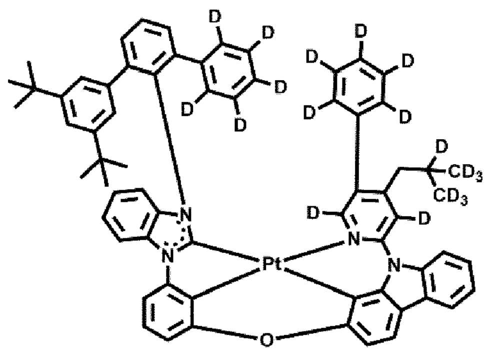

BD327

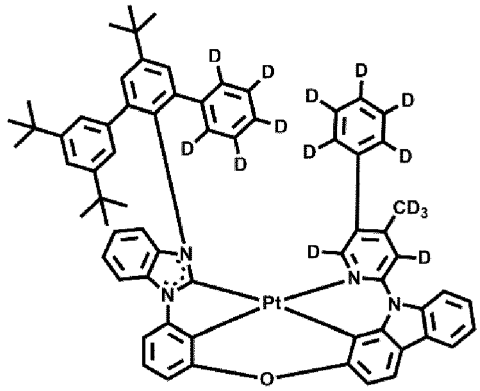

BD329

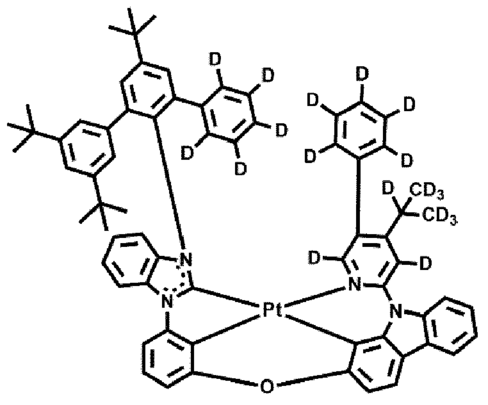

BD331

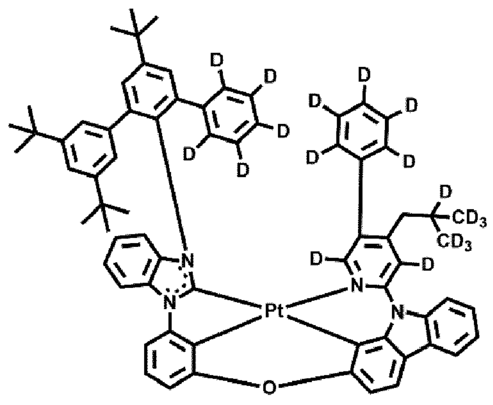

BD333

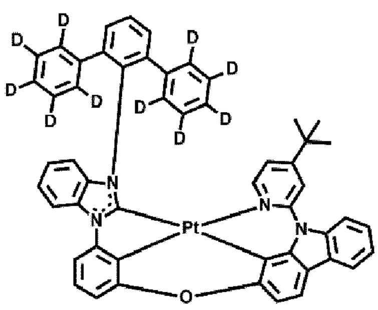

A

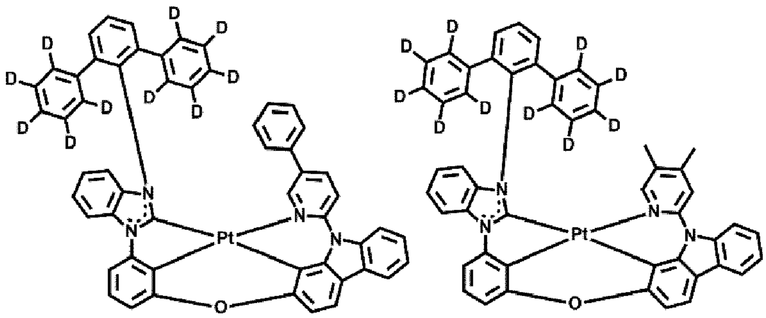

B

C

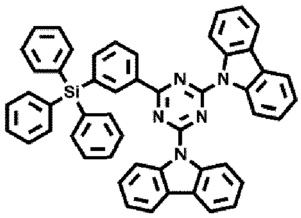

ETH2

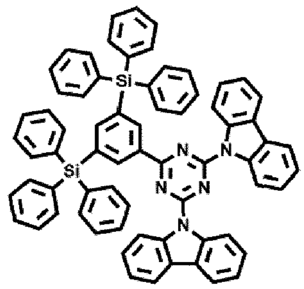

ETH18

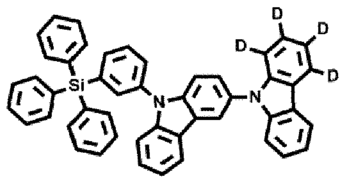

HTH29

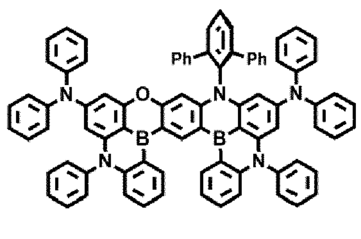

DFD7

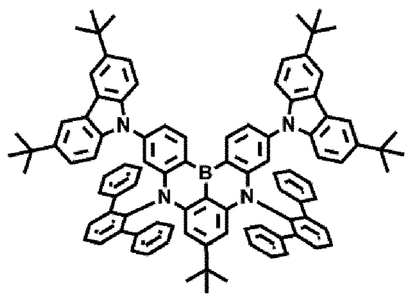

DFD29

Table 9

| No. | ΔCS (Hz) | Driving voltage (V) | CIE(x, y) | Luminiscence Efficiency (cd/A) | Color conversion efficiency (cd/A/y) | Maximum emission wavelength (nm) | Lifespan ($T_{95}$, hr) |
|---|---|---|---|---|---|---|---|
| Example 1 | 559 | 4.4 | 0.137, 0.180 | 22.7 | 126.0 | 462 | 103.8 |
| Example 2 | 553 | 4.3 | 0.133, 0.167 | 23.0 | 137.6 | 464 | 119.0 |
| Example 3 | 565 | 4.1 | 0.136, 0.174 | 22.6 | 129.8 | 462 | 121.0 |
| Example 4 | 565 | 4.0 | 0.136, 0.156 | 22.8 | 145.9 | 461 | 131.0 |
| Example 5 | 570 | 4.0 | 0.137, 0.154 | 21.8 | 142.0 | 461 | 145.0 |

(continued)

| No. | ΔCS (Hz) | Driving voltage (V) | CIE(x, y) | Luminiscence Efficiency (cd/A) | Color conversion efficiency (cd/A/y) | Maximum emission wavelength (nm) | Lifespan ($T_{95}$, hr) |
|---|---|---|---|---|---|---|---|
| Example 6 | 517 | 4.1 | 0.133, 0.148 | 23.1 | 156.1 | 461 | 149.0 |
| Example 7 | 584 | 4.1 | 0.134, 0.164 | 23.3 | 142.2 | 462 | 154.8 |
| Example 8 | 573 | 4.0 | 0.137, 0.157 | 22.2 | 141.0 | 461 | 163.0 |
| Example 9 | 520 | 4.1 | 0.132, 0.154 | 22.1 | 142.9 | 461 | 152.0 |
| Example 10 | 590 | 4.1 | 0.134, 0.164 | 23.2 | 141.8 | 462 | 163.0 |
| Example 11 | 590 | 4.1 | 0.133, 0.147 | 22.8 | 154.7 | 461 | 164.4 |
| Example 12 | 590 | 4.1 | 0.136, 0.119 | 23.8 | 171.1 | 461 | 192.4 |
| Example 13 | 590 | 4.1 | 0.132, 0.121 | 25.2 | 177.9 | 464 | 195.0 |
| Comparative Example A | 460 | 4.2 | 0.137, 0.204 | 23.4 | 114.8 | 463 | 99.4 |
| Comparative Example B | 452 | 4.8 | 0.141, 0.213 | 15.4 | 72.4 | 463 | 87.4 |
| Comparative Example C | 474 | 4.5 | 0.136, 0.199 | 22.3 | 112.3 | 463 | 81.4 |

From Table 9, it can be seen that the organic light-emitting device of Example 1 to 13 emitted deep blue light and had excellent driving voltage, color purity, luminescence efficiency, color conversion efficiency, and lifespan characteristics, as compared to the organic light-emitting devices of Comparative Examples A to C.

The organometallic compound has excellent electrical characteristics, and thus, a light-emitting device including the organometallic compound may have high luminescence efficiency and long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

**1.** A composition comprising: i) an organometallic compound represented by Formula 1; and

a second compound comprising at least one π electron-deficient nitrogen-containing $C_1$-$C_{60}$ cyclic group, a third compound comprising a group represented by Formula 3, a fourth compound capable of emitting delayed fluorescence, or any combination thereof,

wherein the organometallic compound, the second compound, the third compound, and the fourth compound are different from each other;

wherein Formula 1 is:

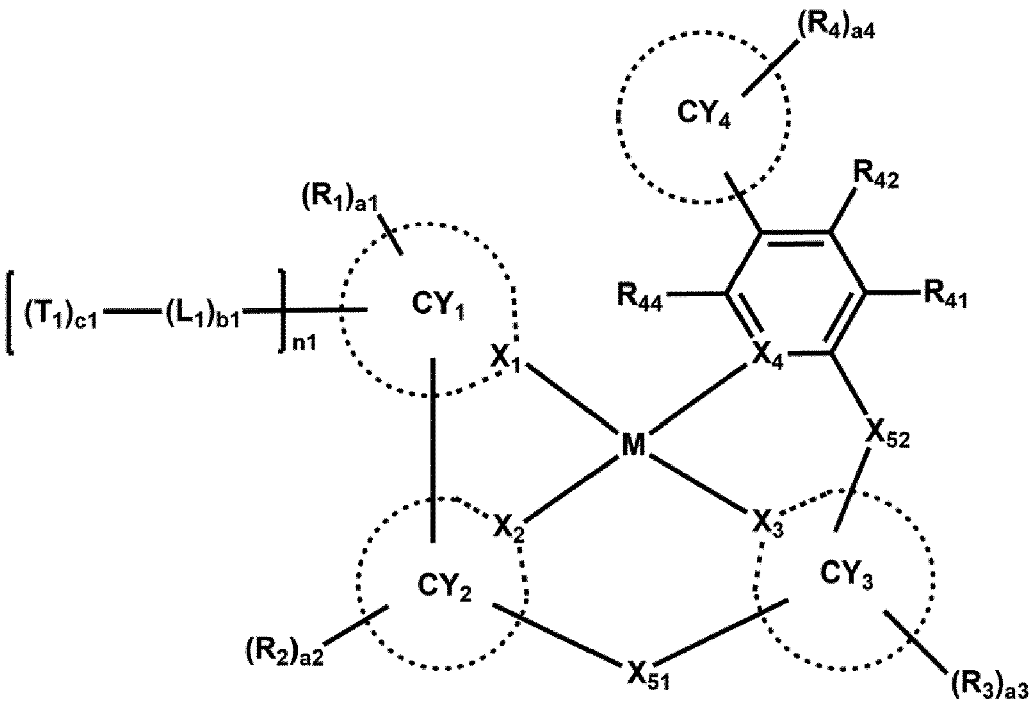

wherein, in Formula 1,

M is platinum (Pt), palladium (Pd), gold (Au), nickel (Ni), silver (Ag), or copper (Cu),

$X_1$ to $X_4$ are each independently C or N,

i) a bond between $X_1$ and M is a coordinate bond, and ii) one selected from a bond between $X_2$ and M, a bond between $X_3$ and M, and a bond between $X_4$ and M is a coordinate bond, and the other two are each a covalent bond,

rings $CY_1$, $CY_2$, $CY_3$, and $CY_4$ are each independently a $C_3$-$C_{60}$ carbocyclic group or a $C_1$-$C_{60}$ heterocyclic group,

$X_{51}$ is a single bond, *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', *-O-*', *-C(=O)-*', *-S(=O)-*', *-S(=O)2-*', *-C($R_{51a}$)=*', *=C($R_{51a}$)-*', *-C($R_{51a}$)=C($R_{51b}$)-*', *-C(=S)-*', or *-C≡C-*',

$X_{52}$ is a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', *-O-*', *-C(=O)-*', *-S(=O)-*', *-S(=O)2-*', *-C($R_{52a}$)=*', *=C($R_{52a}$)-*', *-C($R_{52a}$)=C($R_{52b}$)-*', *-C(=S)-*', or *-C≡C-*',

$L_1$ is a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

b1 is an integer selected from 1 to 5,

R1 to R4, $R_{51a}$, $R_{51b}$, $R_{52a}$, $R_{52b}$, and $T_1$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),

R42 is -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$),

$-B(Q_1)(Q_2)$, $-C(=O)(Q_1)$, $-S(=O)_2(Q_1)$, or $-P(=O)(Q_1)(Q_2)$,
$R_{41}$ and $R_{44}$ are each independently hydrogen or deuterium,
a1, a2, a3, a4, c1, and n1 are each independently an integer selected from 0 to 20,
when a1 is an integer from 2 to 20, two or more of $R_1$(s) in the number of a1 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a2 is an integer from 2 to 20, two or more of $R_2$(s) in the number of a2 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a3 is an integer from 2 to 20, two or more of $R_3$(s) in the number of a3 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a4 is an integer from 2 to 20, two or more of $R_4$(s) in the number of a4 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
two or more of R1 to R4, $R_{51a}$, $R_{51b}$, $R_{52a}$, and $R_{52b}$ are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$R_{10a}$ is:

deuterium (-D), -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a C2-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, or $-P(=O)(Q_{31})(Q_{32})$, and

Q1 to Q3, Q11 to $Q_{13}$, $Q_{21}$ to $Q_{23}$, and $Q_{31}$ to $Q_{33}$ are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof
wherein Formula 3 is:

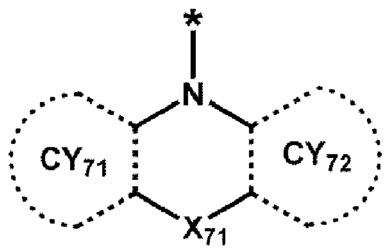

wherein, in Formula 3,
ring $CY_{71}$ and ring $CY_{72}$ are each independently a $\pi$ electron-rich $C_3$-$C_{60}$ cyclic group or a pyridine group,
$X_{71}$ is a single bond or a linking group including O, S, N, B, C, Si, or any combination thereof, and
* indicates a binding site to a neighboring atom in Formula 3.

**2.** The composition of claim 1, comprising:

the organometallic compound represented by Formula 1; and
the second compound; and/or
wherein an absolute value of a difference between a phase transition temperature of the organometallic compound represented by Formula 1 under a pressure of $5.0 \times 10^{-5}$ torr to $1.0 \times 10^{-3}$ torr and a phase transition temperature of the second compound under a pressure of $5.0 \times 10^{-5}$ torr to $1.0 \times 10^{-3}$ torr is 10 °C or less.

**3.** A light-emitting device comprising: a first electrode;

a second electrode facing the first electrode;
an interlayer between the first electrode and the second electrode and comprising an emission layer; and
an organometallic compound represented by Formula 1:

Formula 1

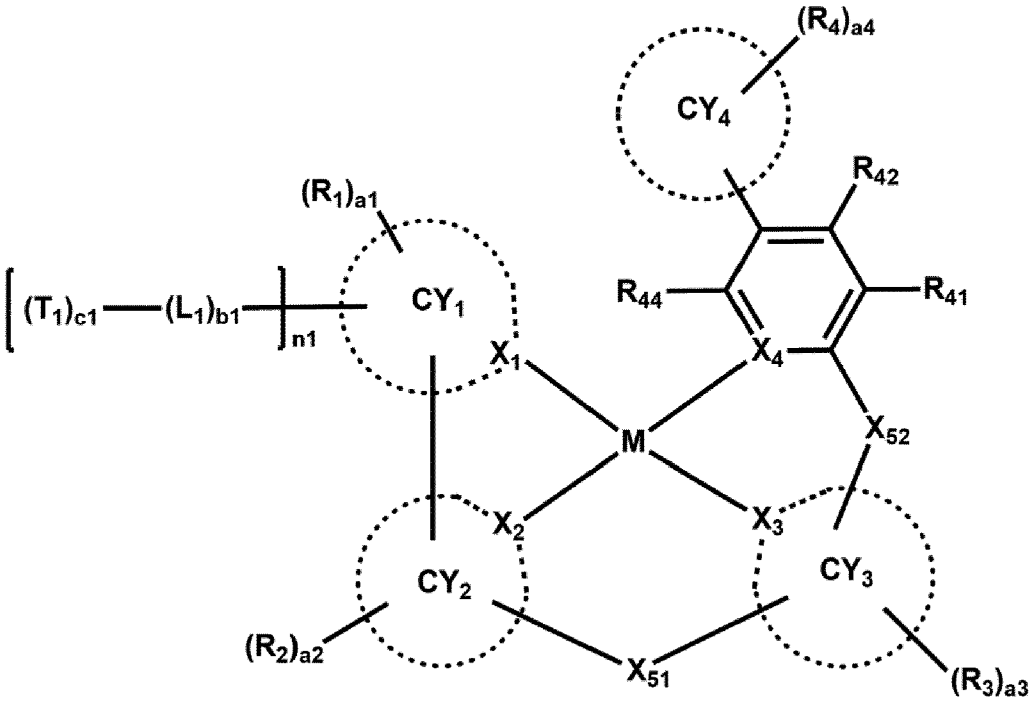

wherein, in Formula 1,
M is platinum (Pt), palladium (Pd), gold (Au), nickel (Ni), silver (Ag), or copper(Cu),
$X_1$ to $X_4$ are each independently C or N,
i) a bond between $X_1$ and M is a coordinate bond, and ii) one selected from a bond between $X_2$ and M, a bond between $X_3$ and M, and a bond between $X_4$ and M is a coordinate bond, and the other two are each a covalent bond,
rings $CY_1$, $CY_2$, $CY_3$, and $CY_4$ are each independently a $C_3$-$C_{60}$ carbocyclic group or a $C_1$-$C_{60}$ heterocyclic group,
$X_{51}$ is a single bond, *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', *-O-*', *-C(=O)-*', *-S(=O)-*', *-S(=O)2-*', *-C($R_{51a}$)=*', *=C($R_{51a}$)-*', *-C($R_{51a}$)=C($R_{51b}$)-*', *-C(=S)-*', or *-C≡C-*',
$X_{52}$ is a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', *-O-*', *-C(=O)-*', *-S(=O)-*', *-S(=O)2-*', *-C($R_{52a}$)=*', *=C($R_{52a}$)-*', *-C($R_{52a}$)=C($R_{52b}$)-*', *-C(=S)-*', or *-C≡C-*',
$L_1$ is a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
b1 is an integer selected from 1 to 5,
R1 to R4, $R_{51a}$, $R_{51b}$, $R_{52a}$, $R_{52b}$, and $T_1$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a

$C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, $-C(Q_1)(Q_2)(Q_3)$, - $Si(Q_1)(Q_2)(Q_3)$, $-N(Q_1)(Q_2)$, -B(Qi)($Q_2$), $-C(=O)(Q_1)$, $-S(=O)_2(Q_1)$, or $-P(=O)(Q_1)(Q_2)$,

R42 is -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, $-C(Q_1)(Q_2)(Q_3)$, - $Si(Q_1)(Q_2)(Q_3)$, $-N(Q_1)(Q_2)$, -B(Qi)($Q_2$), $-C(=O)(Q_1)$, $-S(=O)_2(Q_1)$, or $-P(=O)(Q_1)(Q_2)$,

$R_{41}$ and $R_{44}$ are each independently hydrogen or deuterium,

a1, a2, a3, a4, c1, and n1 are each independently an integer selected from 0 to 20,

when a1 is an integer from 2 to 20, two or more of $R_1$(s) in the number of a1 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

when a2 is an integer from 2 to 20, two or more of $R_2$(s) in the number of a2 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

when a3 is an integer from 2 to 20, two or more of $R_3$(s) in the number of a3 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

when a4 is an integer from 2 to 20, two or more of $R_4$(s) in the number of a4 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

two or more of R1 to R4, $R_{51a}$, $R_{51b}$, $R_{52a}$, and $R_{52b}$ are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$R_{10a}$ is:

deuterium (-D), -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, - $C(=O)(Q_{11})$, $-S(=O)_2(Q_{11})$, $-P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a C2-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, - $S(=O)_2(Q_{21})$, $-P(=O)(Q_{21})(Q_{22})$, or any combination thereof; or

$-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, - $C(=O)(Q_{31})$, $-S(=O)_2(Q_{31})$, or $-P(=O)(Q_{31})(Q_{32})$, and

Q1 to Q3, Q11 to Q13, $Q_{21}$ to Q23, and $Q_{31}$ to Q33 are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

**4.** The light-emitting device of claim 3, further comprising a second compound including at least one π electron-deficient nitrogen-containing $C_1$-$C_{60}$ cyclic group, a third compound including a group represented by Formula 3, a fourth compound capable of emitting delayed fluorescence, or any combination thereof,

wherein the organometallic compound, the second compound, the third compound, and the fourth compound are different from each other:

Formula 3

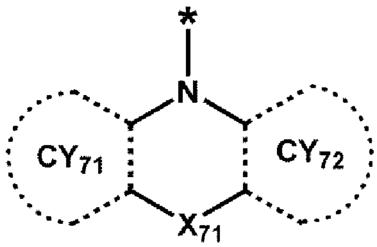

wherein, in Formula 3,
ring $CY_{71}$ and ring $CY_{72}$ are each independently a π electron-rich $C_3$-$C_{60}$ cyclic group or a pyridine group,
$X_{71}$ is a single bond or a linking group including O, S, N, B, C, Si, or any combination thereof, and
* indicates a binding site to a neighboring atom in Formula 3; optionally
wherein the second compound comprises a pyridine group, a pyrimidine group, a pyrazine group, a pyridazine group, a triazine group, or any combination thereof; and/or
wherein the fourth compound is a compound comprising at least one cyclic group comprising each of boron (B) and nitrogen (N) as a ring-forming atom.

**5.** The light-emitting device of claim 4, wherein the emission layer comprises: i) the organometallic compound; and ii) the second compound, the third compound, the fourth compound, or any combination thereof, and

the emission layer emits blue light; optionally
wherein the emission layer emits blue light, and
a maximum emission wavelength of the blue light is in a range of 430 nm to 475 nm, and an emission full width at half maximum (FWHM) of the blue light is less than or equal to 40 nm.

**6.** An electronic apparatus comprising the light-emitting device of any one of claims 3 to 5; optionally

further comprising a thin-film transistor,
wherein the thin-film transistor comprises a source electrode and a drain electrode, and
the first electrode of the light-emitting device is electrically connected to at least one selected from the source electrode and the drain electrode of the thin-film transistor; optionally
further comprising a color filter, a color conversion layer, a touch screen layer, a polarizing layer, or any combination thereof.

**7.** A consumer product comprising the light-emitting device of any one of claims 3 to 5; optionally
wherein the consumer product is one selected from a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.

**8.** An organometallic compound represented by Formula 1 below:

Formula 1

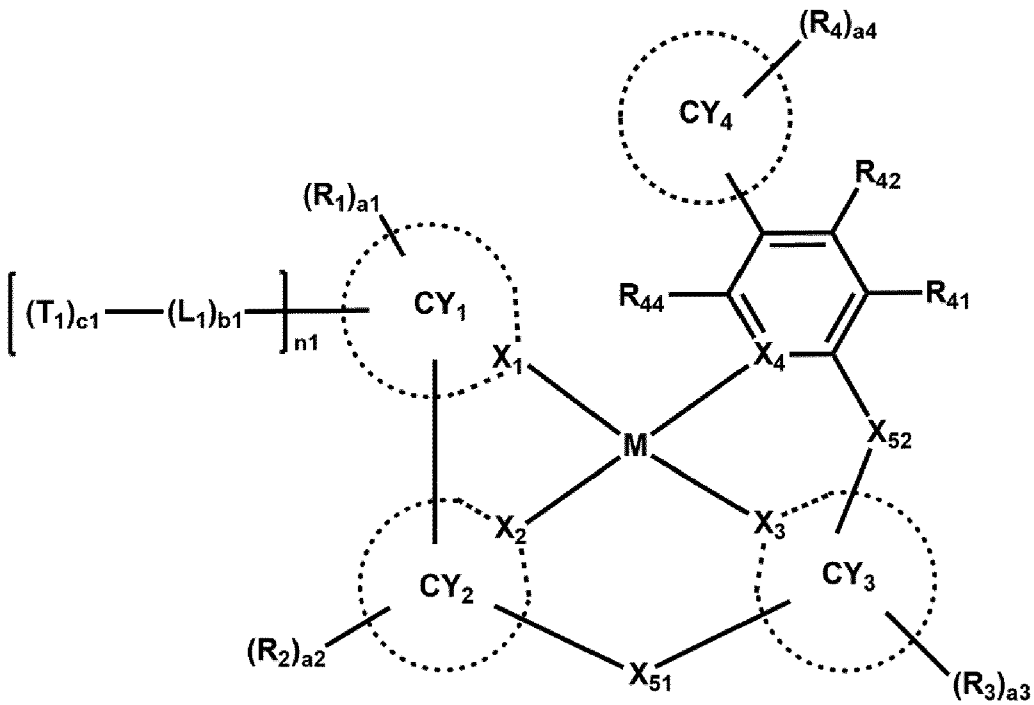

wherein, in Formula 1,

M is platinum (Pt), palladium (Pd), gold (Au), nickel (Ni), silver (Ag), or copper (Cu),

$X_1$ to $X_4$ are each independently C or N,

i) a bond between $X_1$ and M is a coordinate bond, and ii) one selected from a bond between $X_2$ and M, a bond between $X_3$ and M, and a bond between $X_4$ and M is a coordinate bond, and the other two are each a covalent bond,

rings $CY_1$, $CY_2$, $CY_3$, and $CY_4$ are each independently a $C_3$-$C_{60}$ carbocyclic group or a $C_1$-$C_{60}$ heterocyclic group,

$X5_1$ is a single bond, *-N($R_{51a}$)-*', *-B($R_{51a}$)-*', *-P($R_{51a}$)-*', *-C($R_{51a}$)($R_{51b}$)-*', *-Si($R_{51a}$)($R_{51b}$)-*', *-Ge($R_{51a}$)($R_{51b}$)-*', *-S-*', *-Se-*', *-O-*', *-C(=O)-*', *-S(=O)-*', *-S(=O)$_2$-*', *-C($R_{51a}$)=*', *=C($R_{51a}$)-*' *-C($R_{51a}$)=C($R_{51b}$)-*', *-C(=S)-*', or *-C≡C-*',

$X_{52}$ is a single bond, *-N($R_{52a}$)-*', *-B($R_{52a}$)-*', *-P($R_{52a}$)-*', *-C($R_{52a}$)($R_{52b}$)-*', *-Si($R_{52a}$)($R_{52b}$)-*', *-Ge($R_{52a}$)($R_{52b}$)-*', *-S-*', *-Se-*', *-O-*', *-C(=O)-*', *-S(=O)-*', *-S(=O)$_2$-*', *-C($R_{52a}$)=*', *=C($R_{52a}$)-*', *-C($R_{52a}$)=C($R_{52b}$)-*', *-C(=S)-*', or *-C≡C-*',

$L_1$ is a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

b1 is an integer selected from 1 to 5,

R1 to R4, $R_{51a}$, $R_{51b}$, $R_{52a}$, $R_{52b}$, and $T_1$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$), -B(Qi)($Q_2$), -C(=O)($Q_1$), -S(=O)$_2$($Q_1$), or -P(=O)($Q_1$)($Q_2$),

R42 is -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_7$-$C_{60}$ aryl alkyl group unsubstituted or substituted with at least one $R_{10a}$, a $C_2$-$C_{60}$ heteroaryl alkyl group unsubstituted or substituted with at least one $R_{10a}$, -C($Q_1$)($Q_2$)($Q_3$), - Si($Q_1$)($Q_2$)($Q_3$), -N($Q_1$)($Q_2$),

-B(Qi)($Q_2$), -C(=O)($Q_1$), -S(=O)$_2$($Q_1$), or -P(=O)($Q_1$)($Q_2$),
$R_{41}$ and $R_{44}$ are each independently hydrogen or deuterium,
a1, a2, a3, a4, c1, and n1 are each independently an integer selected from 0 to 20,
when a1 is an integer from 2 to 20, two or more of $R_1$(s) in the number of a1 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a2 is an integer from 2 to 20, two or more of $R_2$(s) in the number of a2 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a3 is an integer from 2 to 20, two or more of $R_3$(S) in the number of a3 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
when a4 is an integer from 2 to 20, two or more of $R_4$(s) in the number of a4 are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
two or more of $R_1$ to $R_4$, $R_{51a}$, $R_{51b}$, $R_{52a}$, and $R_{52b}$ are optionally bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$R_{10a}$ is:

deuterium (-D), -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{11}$)($Q_{12}$)($Q_{13}$), -N($Q_{11}$)($Q_{12}$), -B($Q_{11}$)($Q_{12}$), - C(=O)($Q_{11}$), -S(=O)$_2$($Q_{11}$), -P(=O)($Q_{11}$)($Q_{12}$), or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a C2-$C_{60}$ heteroaryl alkyl group, -Si($Q_{21}$)($Q_{22}$)($Q_{23}$), -N($Q_{21}$)($Q_{22}$), -B($Q_{21}$)($Q_{22}$), -C(=O)($Q_{21}$), - S(=O)$_2$($Q_{21}$), -P(=O)($Q_{21}$)($Q_{22}$), or any combination thereof; or
-O($Q_{31}$), -S(Q31), -Si($Q_{31}$)($Q_{32}$)($Q_{33}$), -N($Q_{31}$)($Q_{32}$), -B($Q_{31}$)($Q_{32}$), -P(Q31)(Q32), - C(=O)($Q_{31}$), -S(=O)$_2$($Q_{31}$), or -P(=O)($Q_{31}$)($Q_{32}$), and

Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

**9.** The composition of claim 1 or 2, the light-emitting device of any one of claims 3 to 5, the electronic apparatus of claim 6, the consumer product of claim 7, or the organometallic compound of claim 8, wherein ring $CY_1$ is i) an $X_1$-containing 5-membered ring, ii) an $X_1$-containing 5-membered ring in which at least one 6-membered ring is condensed, or iii) an Xi-containing 6-membered ring,

the $X_1$-containing 5-membered ring is a pyrrole group, a pyrazole group, an imidazole group, a triazole group, an oxazole group, an iso-oxazole group, a thiazole group, an isothiazole group, an oxadiazole group, or a thiadiazole group, and
the Xi-containing 6-membered ring and the 6-membered ring which is optionally condensed to the Xi-containing 5-membered ring are each independently a benzene group, a pyridine group, or a pyrimidine group; optionally wherein ring $CY_1$ is an imidazole group, a triazole group, a benzimidazole group, or an imidazopyridine group.

**10.** The composition of claim 1 or 2, the light-emitting device of any one of claims 3 to 5, the electronic apparatus of claim 6, the consumer product of claim 7, or the organometallic compound of claim 8 or 9, wherein rings $CY_2$, $CY_3$, and $CY_4$ are each independently a benzene group, a pyridine group, a pyrimidine group, a naphthalene group, a dibenzofuran group, a dibenzothiophene group, a carbazole group, a fluorene group, a dibenzosilole group, a

naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group; optionally
wherein

i) $X_{52}$ is a single bond, and a group represented by

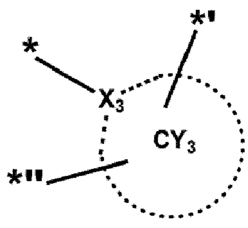

in

Formula 1 is a group represented by Formula CY3A or CY3B,
ii) $X_{52}$ is not a single bond, and a group represented by

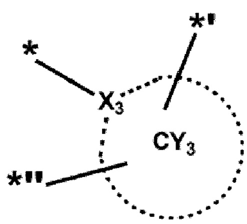

in Formula 1 is a group represented by Formula CY3C, or
iii) $X_{52}$ is *-N($R_{52a}$)-*', and $R_{52a}$ and R3 are bonded to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$:

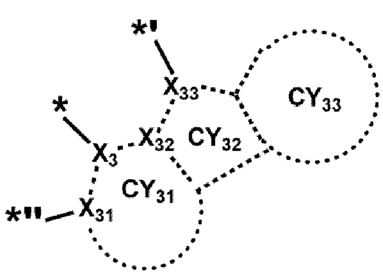

CY3A

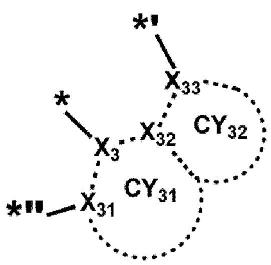

CY3B

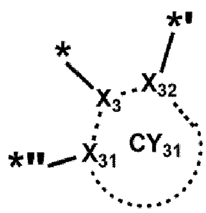

CY3C

wherein, in Formulae CY3A to CY3C,
$X_3$ and $X_{31}$ to $X_{33}$ are each independently C or N,
rings $CY_{31}$, $CY_{32}$, and $CY_{33}$ are respectively the same as described in connection with ring $CY_3$ in claim 8,
a bond between $X_{31}$ and $X_3$, a bond between $X_3$ and $X_{32}$, and a bond between $X_{32}$ and $X_{33}$ are each a chemical bond,
*" indicates a binding site to $X_{51}$,
* indicates a binding site to M in Formula 1, and
*' indicates a binding site to $X_{52}$.

**11.** The composition of claim 1 or 2, the light-emitting device of any one of claims 3 to 5, the electronic apparatus of claim 6, the consumer product of claim 7, or the organometallic compound of any one of claims 8 to 10, wherein $R_1$ to $R_4$, $R_{51a}$, $R_{51b}$, $R_{52a}$, $R_{52b}$, and $T_1$ are each independently:

hydrogen, deuterium, -F, or a cyano group;
a $C_1$-$C_{20}$ alkyl group or a $C_3$-$C_{10}$ cycloalkyl group, each unsubstituted or substituted with deuterium, -F, a cyano group, or any combination thereof; or
a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl) phenyl group, or any combination thereof.

**12.** The composition of claim 1 or 2, the light-emitting device of any one of claims 3 to 5, the electronic apparatus of claim 6, the consumer product of claim 7, or the organometallic compound of any one of claims 8 to 11, wherein $R_{42}$ is a $C_1$-$C_{20}$ alkyl group unsubstituted or substituted with deuterium, -F, a cyano group, or any combination thereof; or

wherein R42 is a group represented by *-C($R_{42a}$)($R_{42b}$)($R_{42c}$), and
$R_{42a}$, $R_{42b}$, and $R_{42c}$ are each independently a $C_1$-$C_{20}$ alkyl group unsubstituted or substituted with deuterium, -F, a cyano group, or any combination thereof, and at least one selected from $R_{42a}$, $R_{42b}$, and R42c is hydrogen or deuterium.

**13.** The composition of claim 1 or 2, the light-emitting device of any one of claims 3 to 5, the electronic apparatus of claim 6, the consumer product of claim 7, or the organometallic compound of any one of claims 8 to 12, wherein a group represented by *-$(L_1)_{b1}$-$(T_1)_{c1}$ in Formula 1 is a group represented by Formula CY1A below:

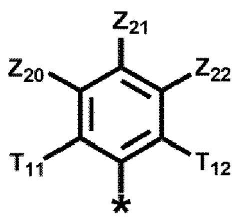

**CY1A**

wherein, in Formula CY1A,
$Z_{20}$ to $Z_{22}$ are each independently hydrogen, or are respectively the same as described in connection with $R_{10a}$ in claim 8,
T11 and $T_{12}$ are respectively the same as described in connection with $T_1$ in claim 8, and
* indicates a binding site to ring $CY_1$; optionally
wherein $T_{11}$ and $T_{12}$ are each independently a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof.

**14.** The composition of claim 1 or 2, the light-emitting device of any one of claims 3 to 5, the electronic apparatus of claim 6, the consumer product of claim 7, or the organometallic compound of any one of claims 8 to 13, wherein the organometallic compound is represented by Formula 1-1 or 1-2:

Formula 1-1

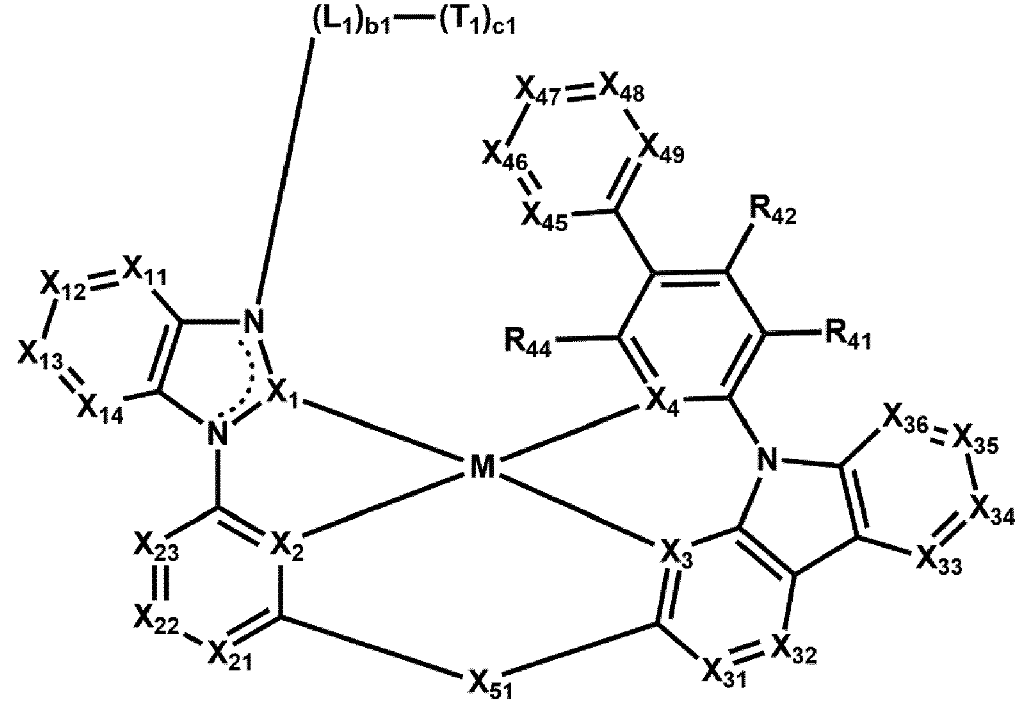

Formula 1-2

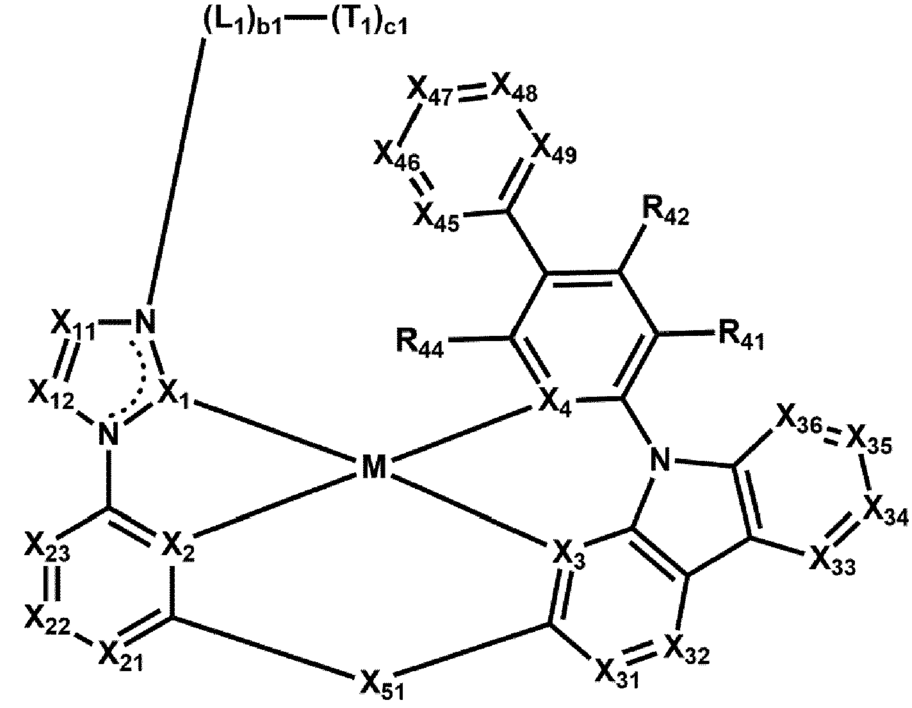

wherein, in Formulae 1-1 and 1-2,

M, $X_1$ to $X_4$, $X_{51}$, $L_1$, b1, $T_1$, c1, R41, R42, and R44 are respectively the same as described in claim 8,

X11 is $C(R_{11})$ or N, $X_{12}$ is $C(R_{12})$ or N, $X_{13}$ is $C(R_{13})$ or N, and $X_{14}$ is $C(R_{14})$ or N,

R11 to R14 are respectively the same as described in connection with R1 in claim 8, and two or more of $R_{11}$ to $R_{14}$ are optionally bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

X21 is $C(R_{21})$ or N, $X_{22}$ is $C(R_{22})$ or N, and $X_{23}$ is $C(R_{23})$ or N,

R21 to R23 are respectively the same as described in connection with R2 in claim 8, and two or more of R21

to R23 are optionally bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{31}$ is C($R_{31}$) or N, $X_{32}$ is C($R_{32}$) or N, $X_{33}$ is C($R_{33}$) or N, $X_{34}$ is C($R_{34}$) or N, $X_{35}$ is C($R_{35}$) or N, and $X_{36}$ is C($R_{36}$) or N,
$R_{31}$ to $R_{36}$ are respectively the same as described in connection with R3 in claim 8, and two or more of $R_{31}$ to $R_{36}$ are optionally bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
X45 is C($R_{45}$) or N, $X_{46}$ is C($R_{46}$) or N, $X_{47}$ is C($R_{47}$) or N, $X_{48}$ is C($R_{48}$) or N, and X49 is C($R_{49}$) or N, and
R45 to R49 are respectively the same as described in connection with R4 in claim 8, and two or more of R45 to R49 are optionally bonded together to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$.; and/or
wherein an absolute value of a difference between a chemical shift value of $R_{44}$ and a chemical shift value of $R_{41}$ of the organometallic compound, as measured by proton nuclear magnetic resonance (NMR) spectroscopy, is in a range of 480 Hz to 600 Hz; and/or
wherein $TS_{M(migration)}$ energy, which is an energy barrier for ligand migration of the organometallic compound, is greater than or equal to 28 kcal/mol, and the $TS_{M(migration)}$ energy is evaluated based on a lowest excitation triplet ($T_1$) energy of the organometallic compound.

**15.** An organometallic compound comprising: platinum (Pt); and

a tetradentate ligand,
wherein the tetradentate ligand comprises:

a pyridine group; and
a carbazole group or an azacarbazole group,
N in the pyridine group is bonded to the platinum,
N in the carbazole group or the azacarbazole group is bonded to a carbon in the 2-position of the pyridine group,
a carbon in the 3-position and a carbon in the 6-position of the pyridine group are each bonded to hydrogen or deuterium,
a substituent bonded to a carbon in the 4-position of the pyridine group is neither hydrogen nor deuterium,
a substituent bonded to a carbon in the 5-position of the pyridine group is a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl)phenyl group, or any combination thereof, and
an absolute value ($\Delta$CS) of a difference between a chemical shift value of hydrogen or deuterium bonded to the carbon in the 6-position of the pyridine group and a chemical shift value of hydrogen or deuterium bonded to the carbon in the 3-position of the pyridine group of the organometallic compound, as measured by proton nuclear magnetic resonance (NMR) spectroscopy, is in a range of 480 Hz to 600 Hz; optionally

wherein the tetradentate ligand further comprises a carbene-containing cyclic group having 3 to 60 carbon atoms, and C of carbene in the carbene-containing cyclic group having 3 to 60 carbon atoms is bonded to the platinum.

FIG. 1

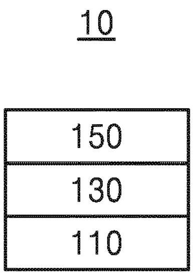
10
150
130
110

FIG. 2

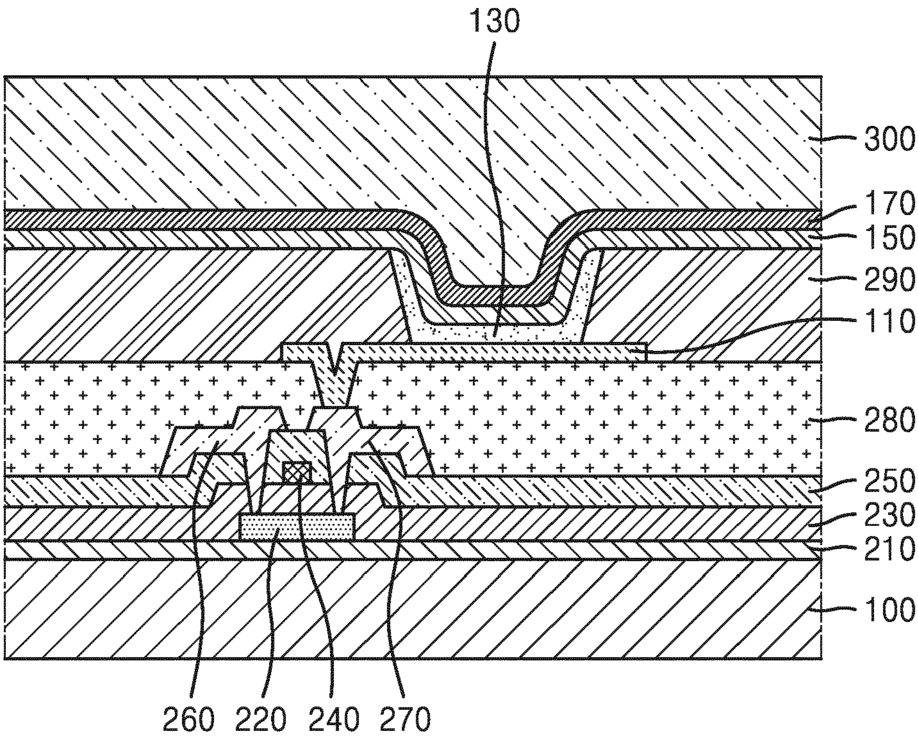
130
300
170
150
290
110
280
250
230
210
100
260
220
240
270

# FIG. 3

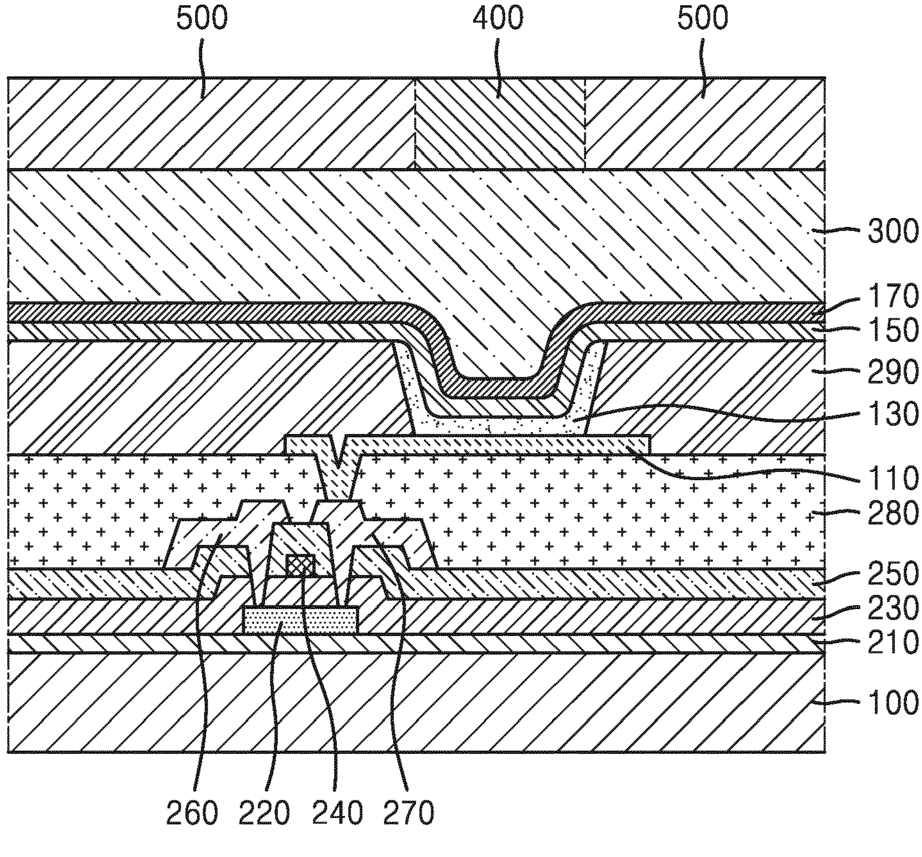
500
400
500
300
170
150
290
130
110
280
250
230
210
100
260
220
240
270

FIG. 4

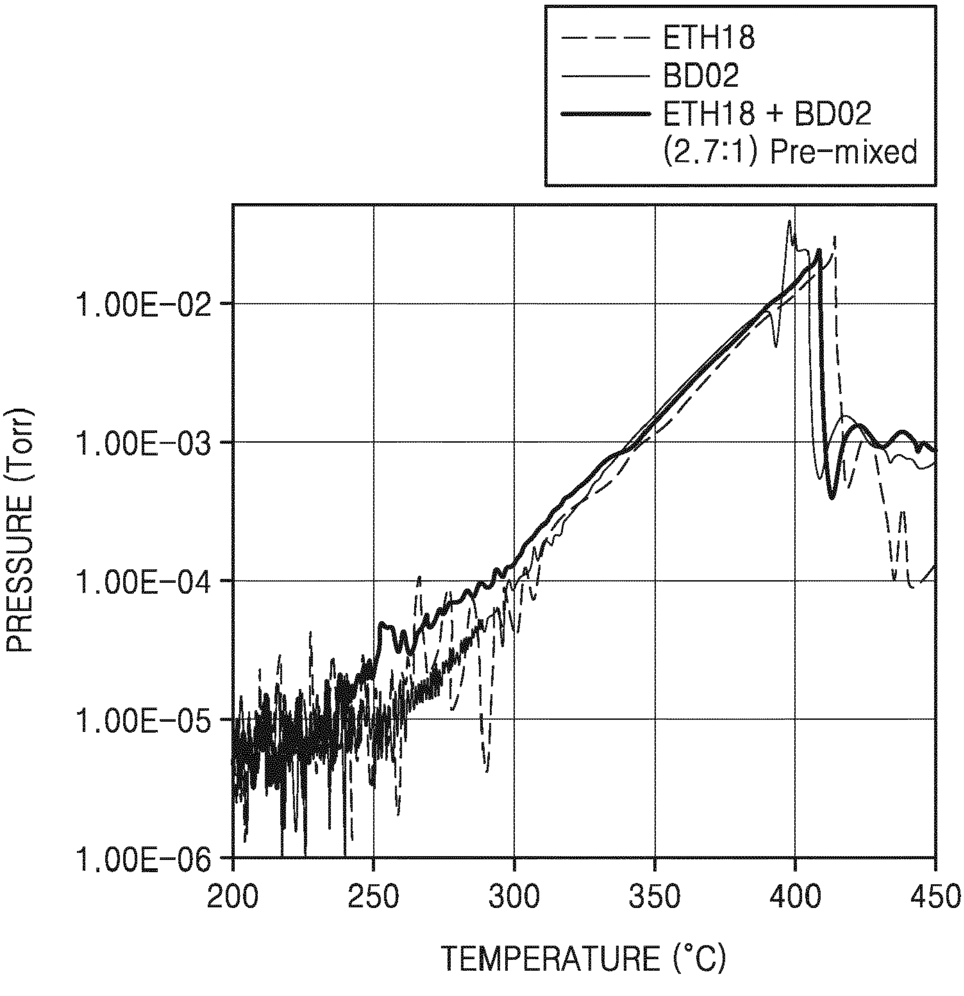
ETH18
BD02
ETH18 + BD02
(2.7:1) Pre-mixed
1.00E-02
1.00E-03
1.00E-04
1.00E-05
1.00E-06
PRESSURE (Torr)
200
250
300
350
400
450
TEMPERATURE (°C)

FIG. 5

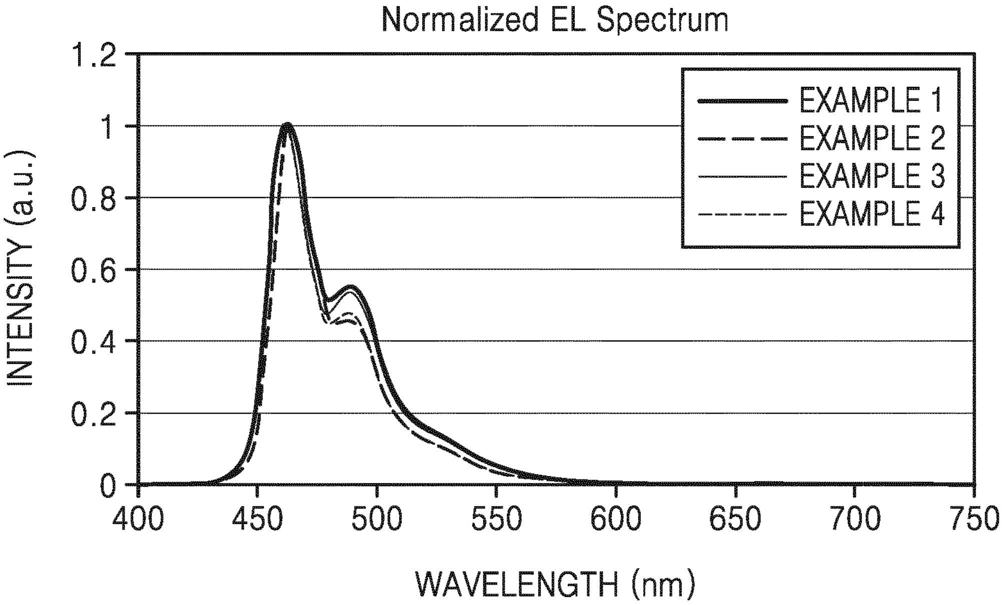
Normalized EL Spectrum
INTENSITY (a.u.)
1.2
1
0.8
0.6
0.4
0.2
0
400
450
500
550
600
650
700
750
WAVELENGTH (nm)
EXAMPLE 1
EXAMPLE 2
EXAMPLE 3
EXAMPLE 4

FIG. 6

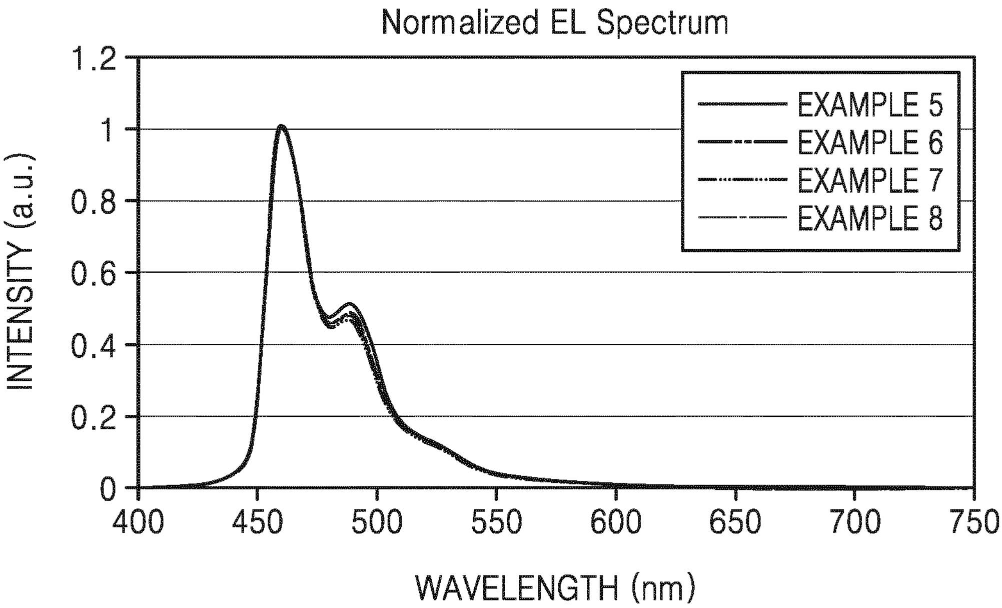
Normalized EL Spectrum
INTENSITY (a.u.)
1.2
1
0.8
0.6
0.4
0.2
0
400
450
500
550
600
650
700
750
WAVELENGTH (nm)
EXAMPLE 5
EXAMPLE 6
EXAMPLE 7
EXAMPLE 8

# FIG. 7

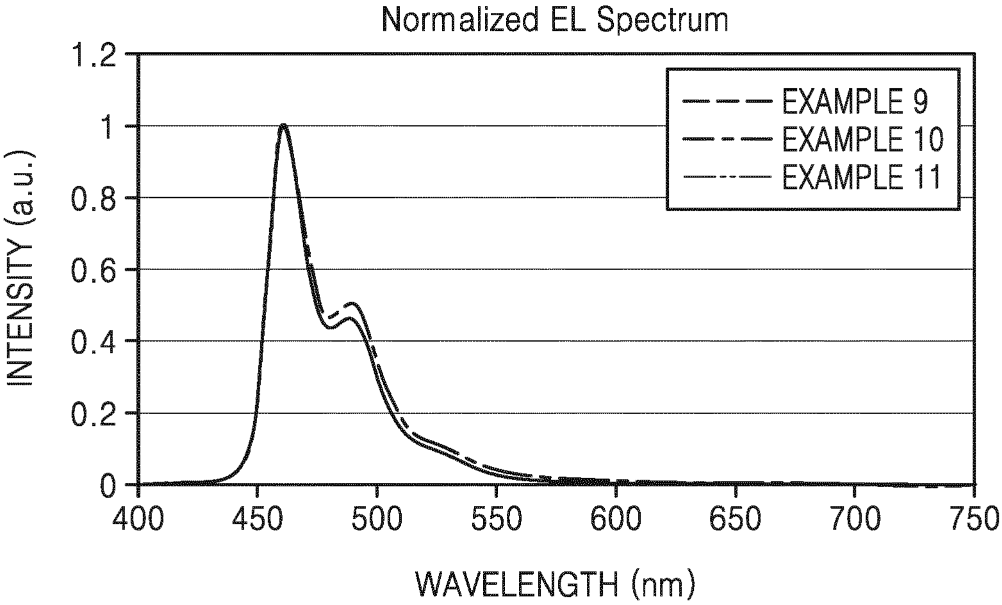
Normalized EL Spectrum
INTENSITY (a.u.)
1.2
1
0.8
0.6
0.4
0.2
0
400
450
500
550
600
650
700
750
WAVELENGTH (nm)
EXAMPLE 9
EXAMPLE 10
EXAMPLE 11

# FIG. 8

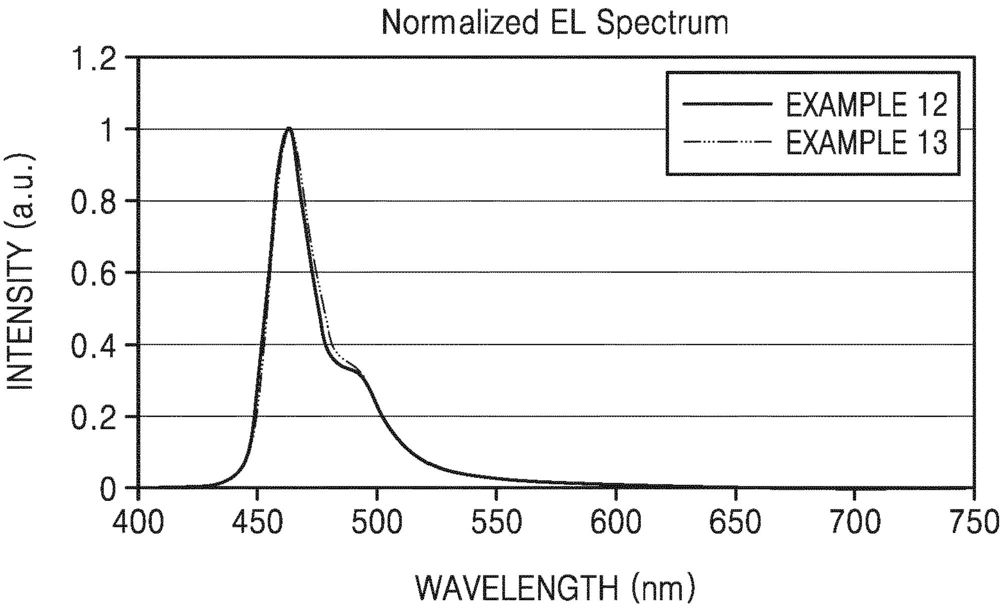
Normalized EL Spectrum
INTENSITY (a.u.)
1.2
1
0.8
0.6
0.4
0.2
0
400
450
500
550
600
650
700
750
WAVELENGTH (nm)
EXAMPLE 12
EXAMPLE 13

FIG. 9

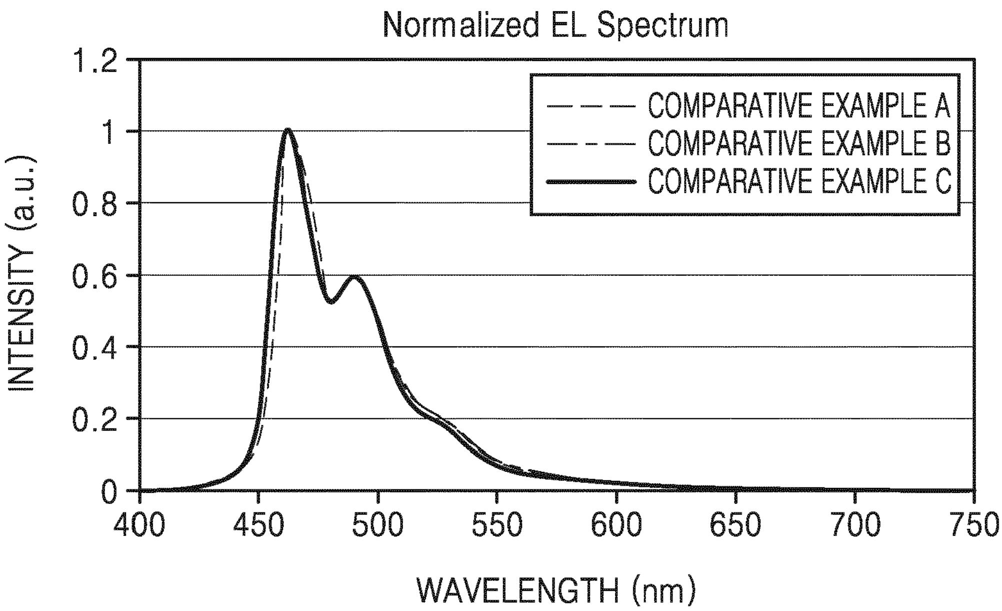
Normalized EL Spectrum
INTENSITY (a.u.)
1.2
1
0.8
0.6
0.4
0.2
0
400
450
500
550
600
650
700
750
WAVELENGTH (nm)
COMPARATIVE EXAMPLE A
COMPARATIVE EXAMPLE B
COMPARATIVE EXAMPLE C

FIG. 10

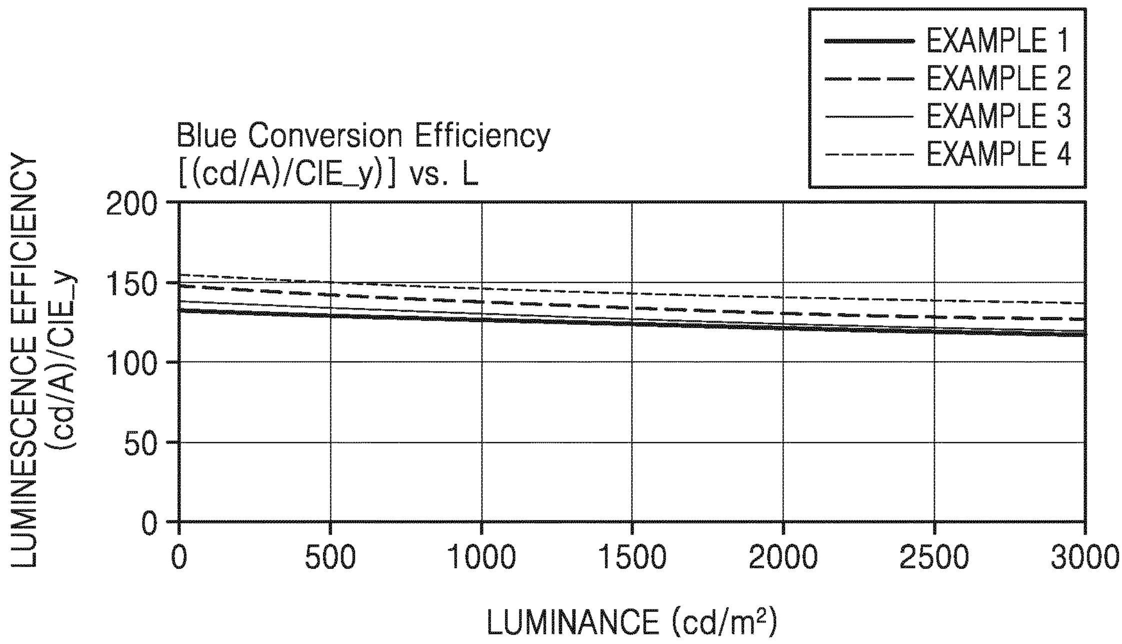
EXAMPLE 1
EXAMPLE 2
EXAMPLE 3
EXAMPLE 4
Blue Conversion Efficiency
[(cd/A)/CIE_y)] vs. L
LUMINESCENCE EFFICIENCY
(cd/A)/CIE_y
200
150
100
50
0
0
500
1000
1500
2000
2500
3000
LUMINANCE (cd/m2)

# FIG. 11

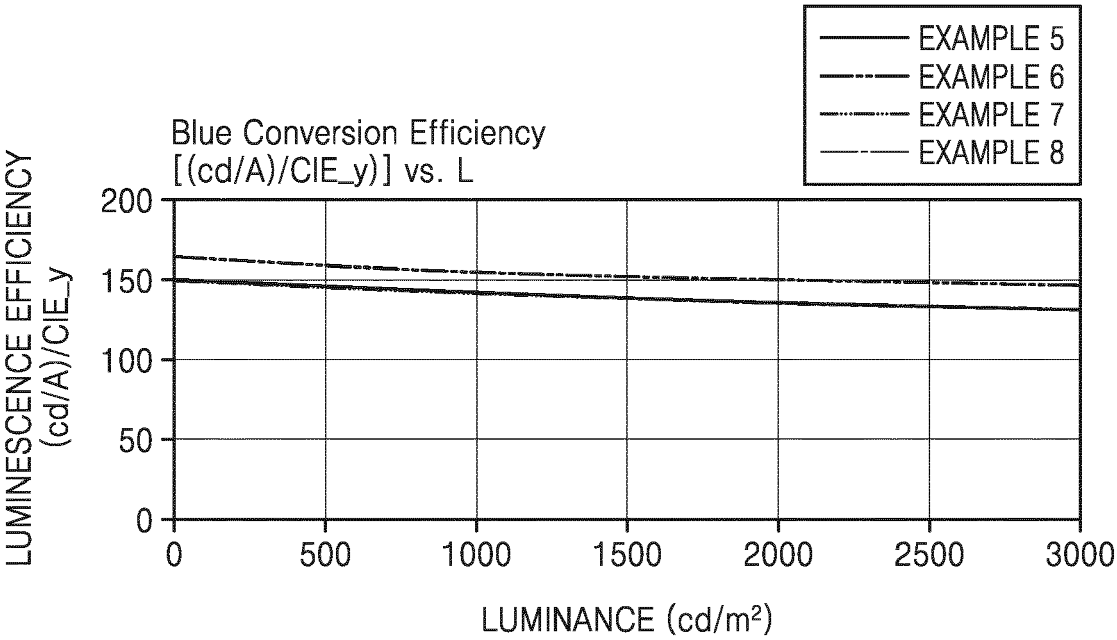
EXAMPLE 5
EXAMPLE 6
EXAMPLE 7
EXAMPLE 8
Blue Conversion Efficiency
[(cd/A)/CIE_y)] vs. L
LUMINESCENCE EFFICIENCY
(cd/A)/CIE_y
200
150
100
50
0
0
500
1000
1500
2000
2500
3000
LUMINANCE (cd/m2)

# FIG. 12

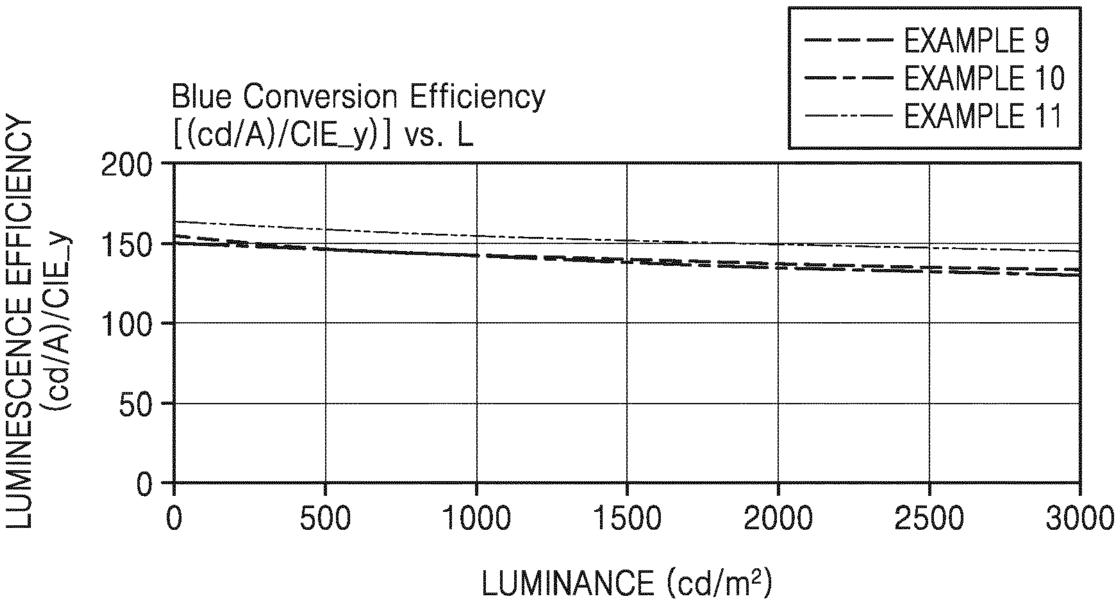
EXAMPLE 9
EXAMPLE 10
EXAMPLE 11
Blue Conversion Efficiency
[(cd/A)/CIE_y)] vs. L
LUMINESCENCE EFFICIENCY
(cd/A)/CIE_y
200
150
100
50
0
0
500
1000
1500
2000
2500
3000
LUMINANCE (cd/m2)

# FIG. 13

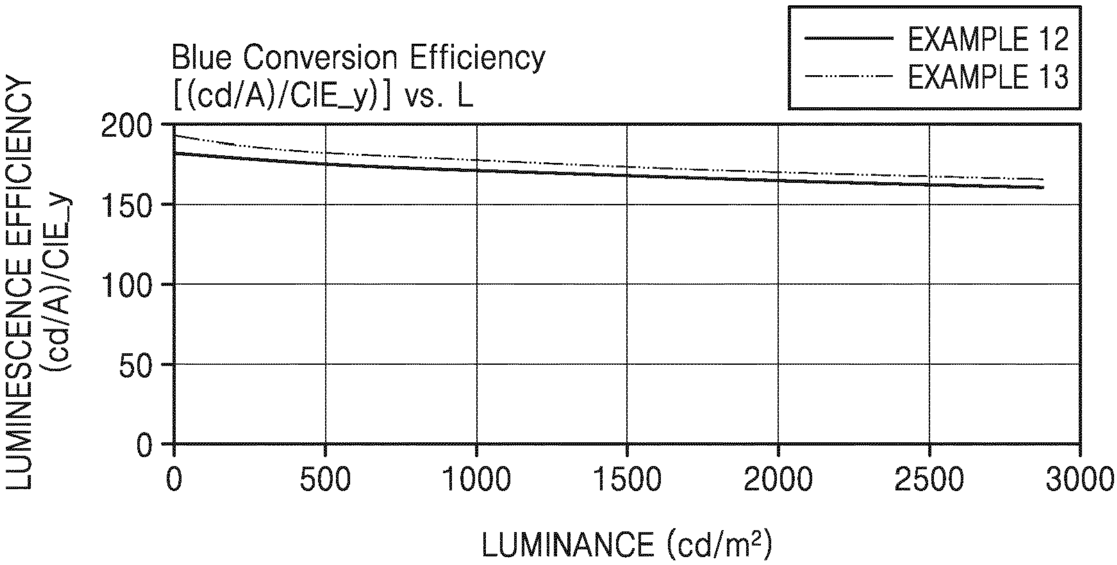
EXAMPLE 12
EXAMPLE 13
Blue Conversion Efficiency
[(cd/A)/CIE_y)] vs. L
LUMINESCENCE EFFICIENCY
(cd/A)/CIE_y
200
150
100
50
0
0
500
1000
1500
2000
2500
3000
LUMINANCE (cd/m²)

# FIG. 14

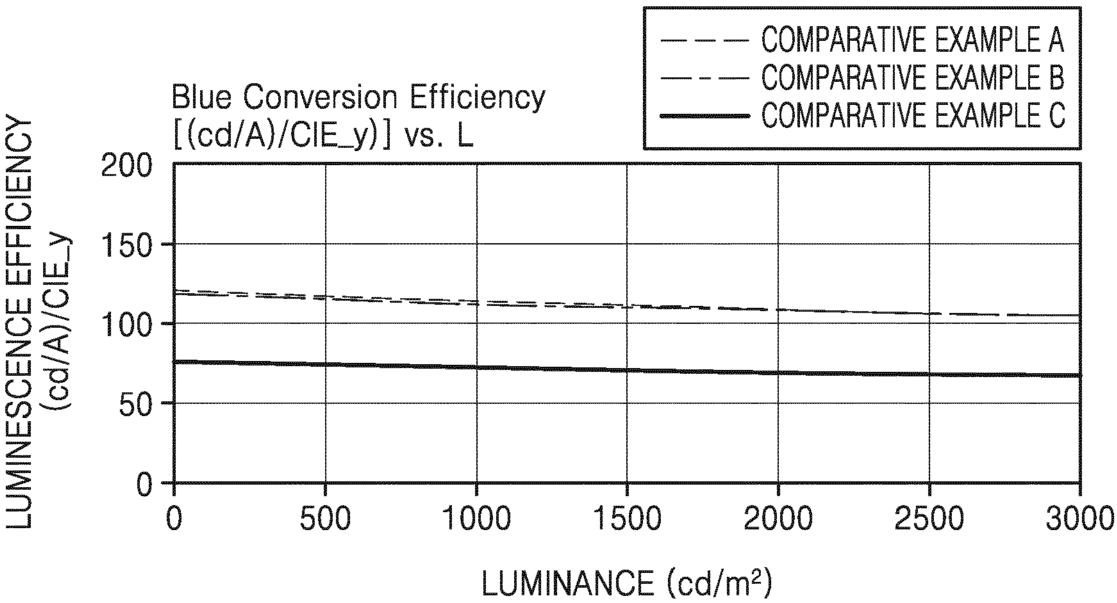
COMPARATIVE EXAMPLE A
COMPARATIVE EXAMPLE B
COMPARATIVE EXAMPLE C
Blue Conversion Efficiency
[(cd/A)/CIE_y)] vs. L
LUMINESCENCE EFFICIENCY
(cd/A)/CIE_y
200
150
100
50
0
0
500
1000
1500
2000
2500
3000
LUMINANCE (cd/m²)

FIG. 15

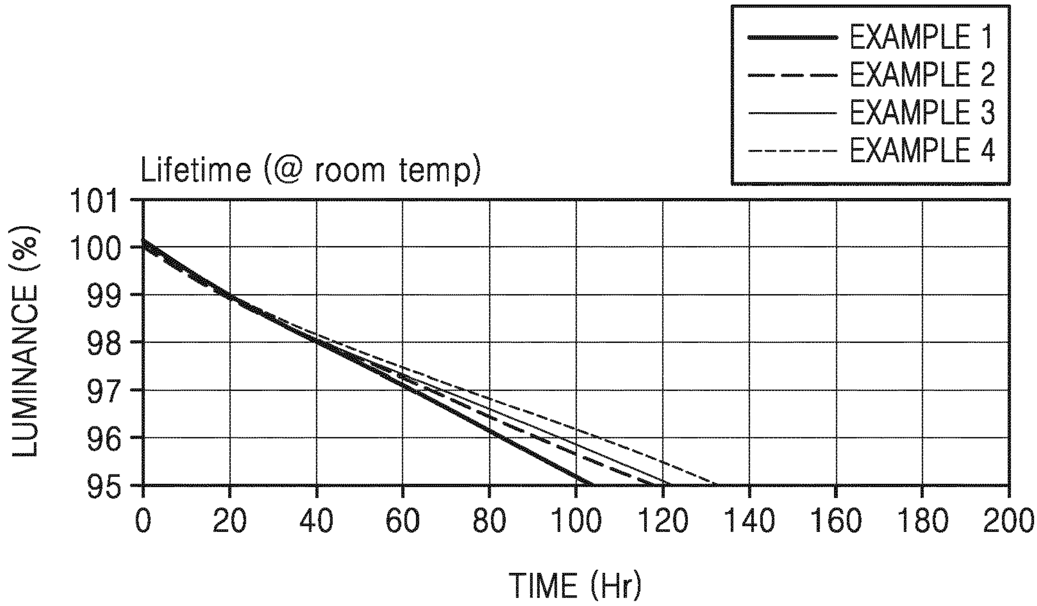
EXAMPLE 1
EXAMPLE 2
EXAMPLE 3
EXAMPLE 4
Lifetime (@ room temp)
LUMINANCE (%)
101
100
99
98
97
96
95
0
20
40
60
80
100
120
140
160
180
200
TIME (Hr)

FIG. 16

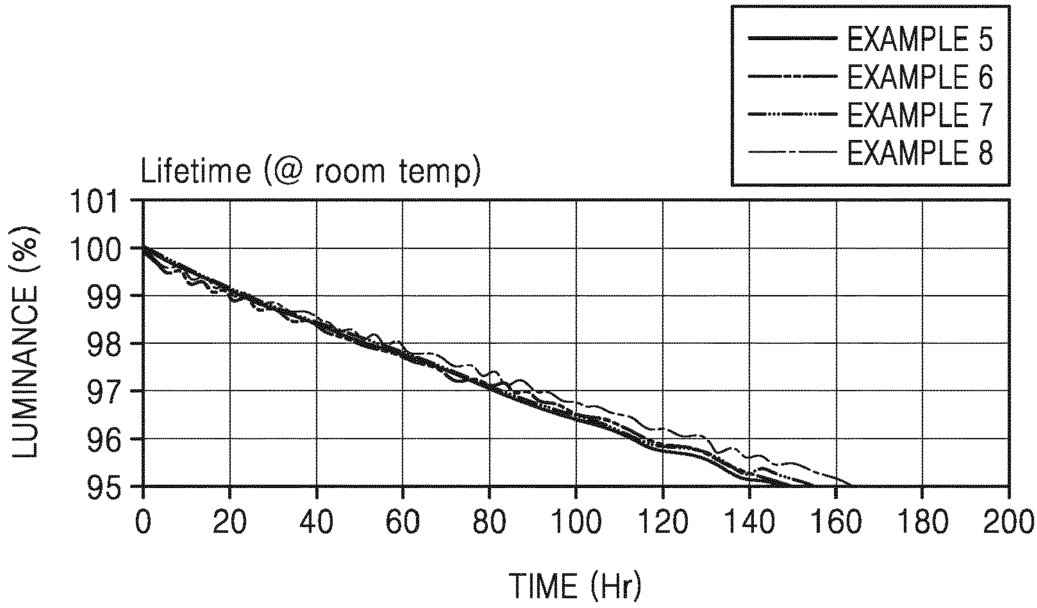
EXAMPLE 5
EXAMPLE 6
EXAMPLE 7
EXAMPLE 8
Lifetime (@ room temp)
LUMINANCE (%)
101
100
99
98
97
96
95
0
20
40
60
80
100
120
140
160
180
200
TIME (Hr)

# FIG. 17

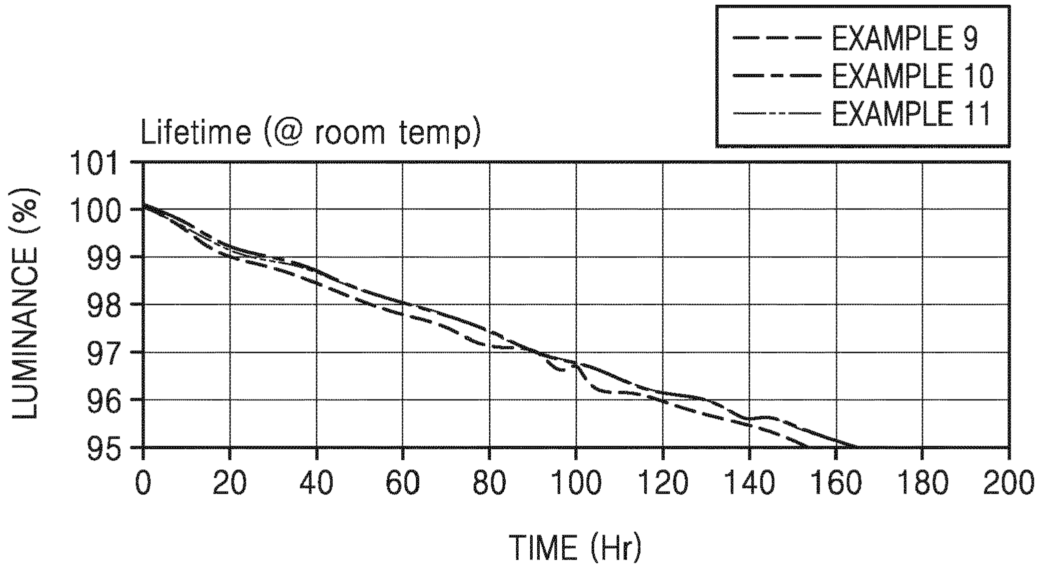
EXAMPLE 9
EXAMPLE 10
EXAMPLE 11
Lifetime (@ room temp)
LUMINANCE (%)
101
100
99
98
97
96
95
0
20
40
60
80
100
120
140
160
180
200
TIME (Hr)

# FIG. 18

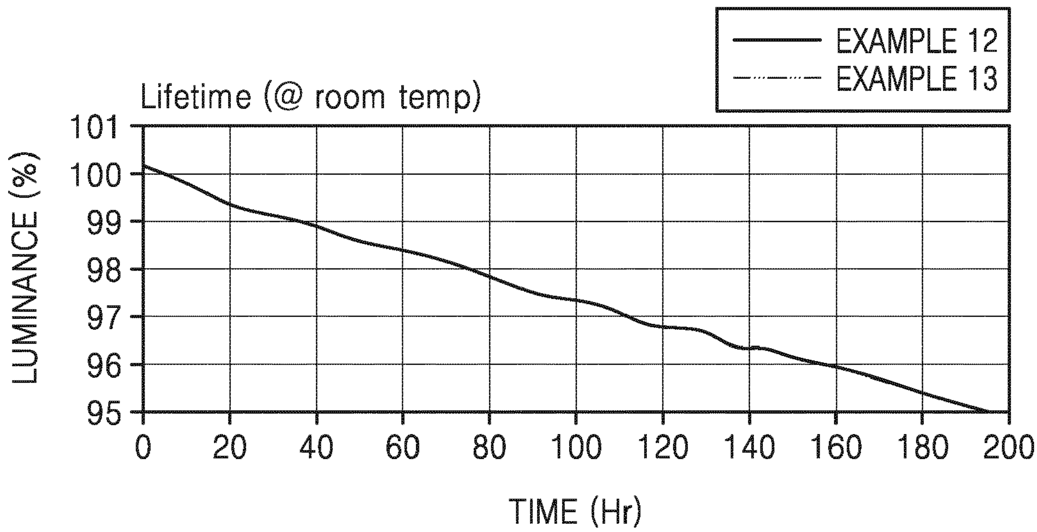
EXAMPLE 12
EXAMPLE 13
Lifetime (@ room temp)
LUMINANCE (%)
101
100
99
98
97
96
95
0
20
40
60
80
100
120
140
160
180
200
TIME (Hr)

FIG. 19

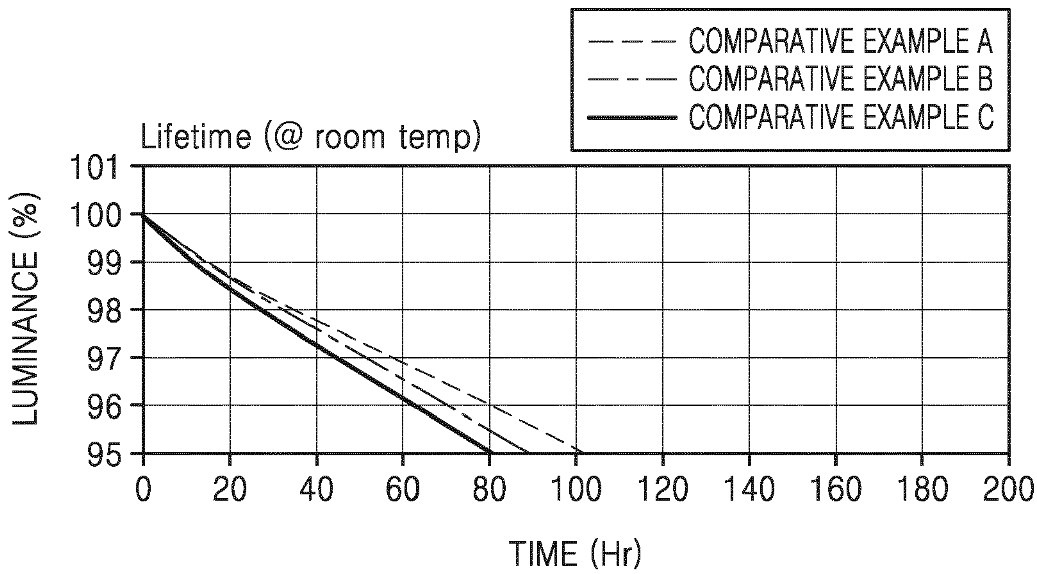
COMPARATIVE EXAMPLE A
COMPARATIVE EXAMPLE B
COMPARATIVE EXAMPLE C
Lifetime (@ room temp)
LUMINANCE (%)
101
100
99
98
97
96
95
0
20
40
60
80
100
120
140
160
180
200
TIME (Hr)

Europäisches Patentamt
European Patent Office
Office européen des brevets

# EUROPEAN SEARCH REPORT

Application Number
EP 22 20 9463

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 4 119 633 A1 (SAMSUNG ELECTRONICS CO LTD [KR]) 18 January 2023 (2023-01-18)<br>* claims 10-15 *<br>----- | 1-15 | INV.<br>C09K11/00<br>H10K85/00<br>C07F15/00 |
| X,P | EP 3 971 261 A1 (SAMSUNG ELECTRONICS CO LTD [KR]) 23 March 2022 (2022-03-23)<br>* paragraph [0273] *<br>* claims 10-14 *<br>----- | 1-15 | |
| X | US 2020/411775 A1 (CHEN HSIAO-FAN [US] ET AL) 31 December 2020 (2020-12-31)<br>* claim 15 *<br>----- | 1-15 | |
| X | US 2020/140471 A1 (CHEN HSIAO-FAN [US] ET AL) 7 May 2020 (2020-05-07)<br>* claim 12 *<br>* page 189 - page 190 *<br>* page 196 - page 202 *<br>* claim 14 *<br>* page 249 *<br>* page 260 - page 266 *<br>* abstract *<br>----- | 1-15 | TECHNICAL FIELDS SEARCHED (IPC)<br>H05B<br>C09K<br>H10K<br>C07F |

The present search report has been drawn up for all claims

1

| Place of search | Date of completion of the search | Examiner |
|---|---|---|
| The Hague | 3 April 2023 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 20 9463

This annex lists the patent family members relating to the patent documents cited in the above-mentioned European search report. The members are as contained in the European Patent Office EDP file on
The European Patent Office is in no way liable for these particulars which are merely given for the purpose of information.

03-04-2023

| Patent document cited in search report | | Publication date | Patent family member(s) | | | Publication date |
|---|---|---|---|---|---|---|
| EP 4119633 | A1 | 18-01-2023 | CN | 115611949 | A | 17-01-2023 |
| | | | EP | 4119633 | A1 | 18-01-2023 |
| | | | KR | 20230012369 | A | 26-01-2023 |
| | | | US | 2023101854 | A1 | 30-03-2023 |
| EP 3971261 | A1 | 23-03-2022 | CN | 114195829 | A | 18-03-2022 |
| | | | EP | 3971261 | A1 | 23-03-2022 |
| | | | US | 2022106345 | A1 | 07-04-2022 |
| US 2020411775 | A1 | 31-12-2020 | NONE | | | |
| US 2020140471 | A1 | 07-05-2020 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020210169402